# EUROPEAN PATENT APPLICATION

(11) **EP 2 085 450 A1**
(43) Date of publication of application: **05.08.2009**
(21) Application number: 09151358.0
(22) Date of filing: 26.01.2009
(51) Int. Cl.: C09K 11/06

(54) **Novel organic electroluminescent compounds and organic electroluminescent device using the same**

(30) Priority: 29.01.2008 KR 20080008963
(71) Applicant: Gracel Display Inc., Seoul 133-833 (KR)
(72) Inventor: Kim, Jin Ho, Seongdong-gu Seoul (KR); Cho, Young Jun, 136-060 Seoul (KR); Kwon, Hyuck Joo, Dongdaemun-gu 130-100 Seoul (KR); Kim, Bong Ok, 135-090 Seoul (KR); Kim, Sung Min, 157-886 Seoul (KR); Yoon, Seung Soo, 135-884 Seoul (KR)
(74) Representative: Kent, Venetia Katherine

(57) **Abstract**

The present invention relates to novel organic electroluminescent compounds exhibiting high luminous efficiency, and organic electroluminescent devices comprising the same. The novel organic electroluminescent compounds according to the invention are represented by Chemical Formula (1) :

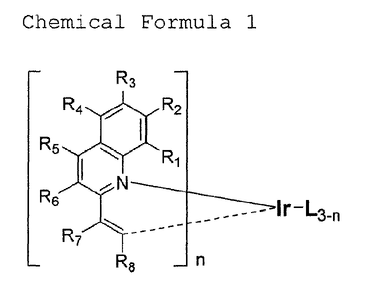

## Description

### FIELD OF THE INVENTION

The present invention relates to novel organic electroluminescent compounds exhibiting high luminous efficiency, and organic electroluminescent devices comprising the same.

### BACKGROUND OF THE INVENTION

The most important factor to determine luminous efficiency in an OLED (organic light-emitting diode) is the type of electroluminescent material. Though fluorescent materials has been widely used as an electroluminescent material up to the present, development of phosphorescent materials is one of the best methods to improve the luminous efficiency theoretically up to four(4) times, in view of electroluminescent mechanism.

Up to now, iridium (III) complexes are widely known as phosphorescent material, including (acac)Ir(btp)₂, Ir(ppy)₃ and Firpic, as the red, green and blue one, respectively. In particular, a lot of phosphorescent materials have been recently investigated in Japan, Europe and America.

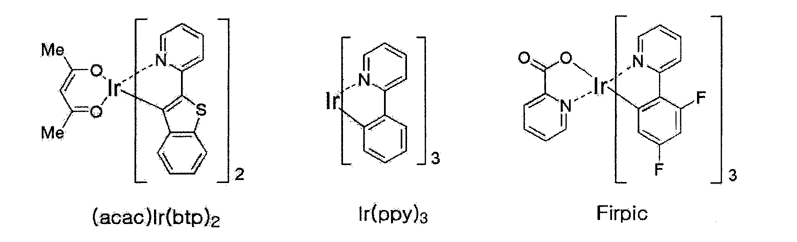

Among conventional red phosphorescent materials, several materials have been reported to have good EL (electroluminescence) properties. However, very rare materials among them have reached the level of commercialization. As the most preferable material, an iridium complex of 1-phenyl isoquinoline may be mentioned, which is known to have excellent EL property and to exhibit color purity of dark red with high luminous efficiency. [See A. Tsuboyama et al., J. Am. Chem. Soc. 2003, 125(42), 12971-12979.]

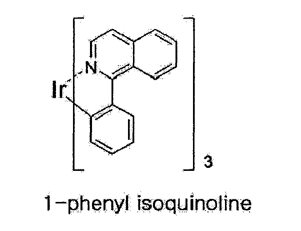

Moreover, the red materials, having no significant problem of lifetime, have tendency of easy commercialization if they have good color purity or luminous efficiency. Thus, the above-mentioned iridium complex is a material having noticeable viability of commercialization due to its excellent color purity and luminous efficiency.

However, the iridium complex is still construed as a material which is merely applicable to small displays, while higher levels of EL properties than those of known materials are practically required for an OLED panel of medium to large size.

### SUMMARY OF THE INVENTION

The present invention relates to novel organic electroluminescent compounds and organic electroluminescent devices comprising the same. Specifically, the organic electroluminescent compounds according to the invention are characterized in that they are represented by Chemical Formula (1): 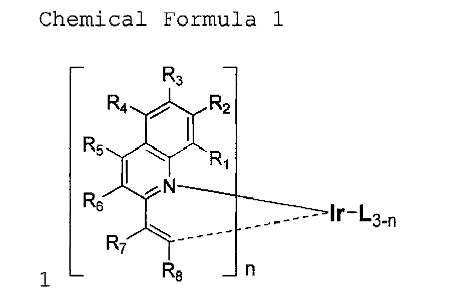 wherein, L is an organic ligand;

R₁ through R₆ independently represent hydrogen, deuterium, fluorine-substituted (C1-C60)alkyl, fluorine-substituted (C1-C60)alkoxy, fluorine-substituted (C3-C60)cycloalkyl or fluorine;

R₇ and R₈ independently represent hydrogen, deuterium, (C1-C60)alkyl with or without halogen substituent(s), (C6-C60)aryl, halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino or mono- or di(C6-C60)arylamino, or R₇ and R₈ may may be linked via (C3-C12)alkylene or (C3-C12)alkenylene with or without a fused ring to form an alicyclic ring, or a monocyclic or polycyclic aromatic ring;
the alkyl or aryl of R₇ and R₈, or the alicyclic ring, or the monocyclic or polycyclic aromatic ring formed therefrom by linkage via (C3-C12) alkylene or (C3-C12)alkenylene with or without a fused ring may be further substituted by one or more substituent(s) selected from deuterium, (C1-C60)alkyl with or without halogen substituent(s), halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino, mono- or di(C6-C60)arylamino, phenyl, naphthyl, anthryl, fluorenyl, spirobifluorenyl and 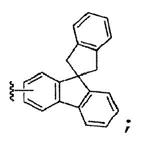 and
n is an integer from 1 to 3;
provided that R₁ through R₆ are not hydrogens at the same time.

### BRIEF DESCRIPTION OF THE DRAWINGS

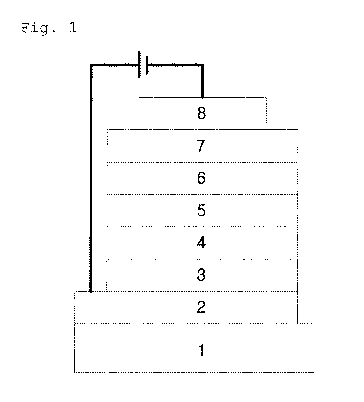

Fig. 1 is a cross-sectional view of an OLED.

### DETAILED DESCRIPTION OF THE INVENTION

Referring now to the Drawings, Fig. 1 illustrates a cross-sectional view of an OLED of the present invention comprising a Glass 1, a Transparent electrode 2, a Hole injection layer 3, a Hole transport layer 4, an Electroluminescent layer 5, an Electron transport layer 6, an Electron injection layer 7 and an Al cathode 8.

The term "alkyl" described herein and any substituents comprising "alkyl" moiety include both linear and branched species.

The term "aryl" described herein means an organic radical derived from aromatic hydrocarbon via elimination of one hydrogen atom. Each ring comprises a monocyclic or fused ring system containing from 4 to 7, preferably from 5 to 6 cyclic atoms. Specific examples include phenyl, naphthyl, biphenyl, anthryl, indenyl, fluorenyl, phenanthryl, triphenylenyl, pyrenyl, perylenyl, chrysenyl, naphthacenyl and fluoranthenyl, but they are not restricted thereto.

The term "heteroaryl" described herein means an aryl group containing from 1 to 4 heteroatom(s) selected from N, O and S as the aromatic cyclic backbone atom(s), and carbon atom(s) for remaining aromatic cyclic backbone atoms. The heteroaryl may be a 5- or 6-membered monocyclic heteroaryl or a polycyclic heteroaryl which is fused with one or more benzene ring(s), and may be partially saturated. The heteroaryl group may comprise a bivalent aryl group, of which the heteroatoms may be oxidized or quaternized to form N-oxide and quaternary salt. Specific examples include monocyclic heteroaryl groups such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl; polycyclic heteroaryl groups such as benzofuranyl, benzothiophenyl, isobenzofuranyl, benzimidazolyl, benzothiazolyl, benzisothiazolyl, benzisoxazolyl, benzoxazolyl, isoindolyl, indolyl, indazolyl, benzothiadiazolyl, quinolyl, isoquinolyl, cinnolinyl, quinazolinyl, quinoxalinyl, carbazolyl, phenanthridinyl and benzodioxolyl; and corresponding N-oxides (for example, pyridyl N-oxide, quinolyl N-oxide) and quaternary salts thereof; but they are not restricted thereto.

The naphthyl of Chemical Formula (1) may be 1-naphthyl or 2-naphthyl; the anthryl may be 1-anthryl, 2-anthryl or 9-anthryl; and the fluorenyl may be 1-fluorenyl, 2-fluorenyl, 3-fluorenyl, 4-fluorenyl or 9-fluorenyl.

The substituents comprising "(C1-C60)alkyl" moiety described herein may contain 1 to 60 carbon atoms, 1 to 20 carbon atoms, or 1 to 10 carbon atoms. The substituents comprising "(C6-C60)aryl" moiety may contain 6 to 60 carbon atoms, 6 to 20 carbon atoms, or 6 to 12 carbon atoms. The substituents comprising "(C3-C60)heteroaryl" moiety may contain 3 to 60 carbon atoms, 4 to 20 carbon atoms, or 4 to 12 carbon atoms. The substituents comprising "(C3-C60)cycloalkyl" moiety may contain 3 to 60 carbon atoms, 3 to 20 carbon atoms, or 3 to 7 carbon atoms. The substituents comprising "(C2-C60)alkenyl or alkynyl" moiety may contain 2 to 60 carbon atoms, 2 to 20 carbon atoms, or 2 to 10 carbon atoms.

In the compounds represented by Chemical Formula (1), the alicyclic ring, or the monocyclic or polycyclic aromatic ring formed from R₇ and R₈ by linkage via (C3-C12) alkylene or (C3-C12)alkenylene may be benzene, naphthalene, anthracene, fluorene, indene or phenanthrene. The compound within the square bracket ([]) in Chemical Formula (1) serves as a primary ligand of iridium, and L serves as a subsidiary ligand. The organic electroluminescent compounds according to the present invention also include the complex with the ratio of primary ligand: subsidiary ligand = 2:1 (n=2) and the complex with the ratio of primary ligand: subsidiary ligand - 1:2 (n=1), as well as the tris-chelated complexes without subsidiary ligand (L) (n=3).

The organic electroluminescent compounds according to the present invention can be specifically exemplified by the compounds represented by one of Chemical Formulas (2) to (7): 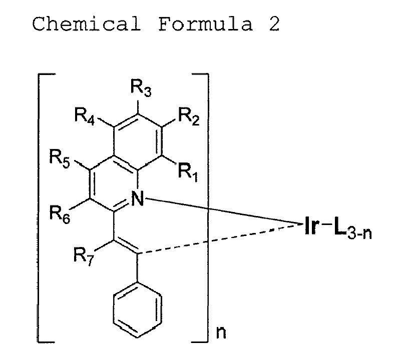 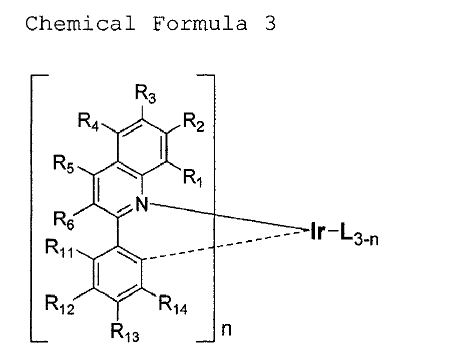 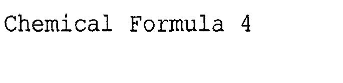 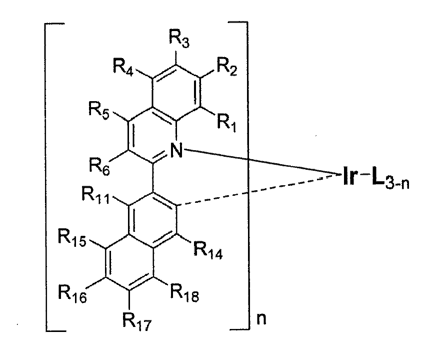 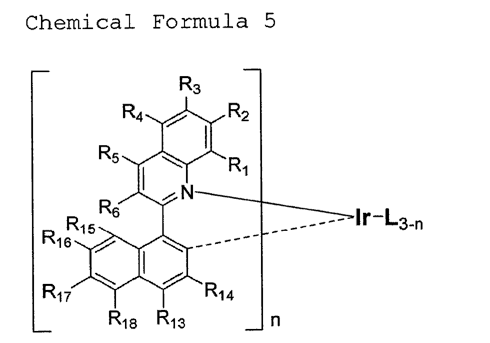 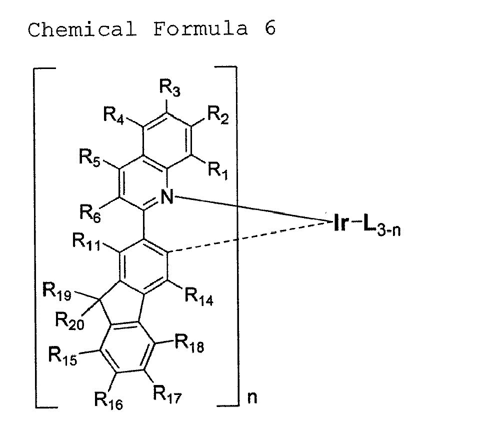 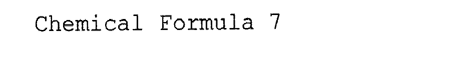 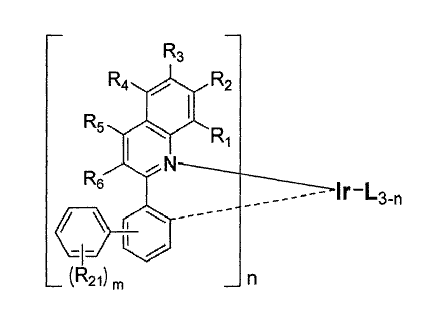 wherein, L, R₁, R₂, R₃, R₄, R₅, R₆, R₇ and n are defined as in Chemical Formula (1);
R₁₁ through R₁₈ independently represent hydrogen, deuterium, (C1-C60)alkyl, halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino, mono- or di(C6-C60)arylamino, phenyl, naphthyl, anthryl, fluorenyl, spirobifluorenyl or 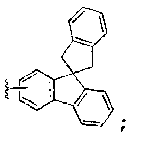 the alkyl, phenyl, naphthyl, anthryl or fluorenyl of R₁₁ through R₁₈ may be further substituted by one or more substituent(s) selected from deuterium, (C1-C60)alkyl with or without halogen substituent(s), (C1-C60)alkoxy, halogen, tri(C1-C60)alkylsilyl, tri(C6-C60)arylsilyl, (C1-C60)alkylcarbonyl, (C6-C60)arylcarbonyl, mono- or di(C1-C60)alkylamino, mono- or di(C6-C60)arylamino and (C6-C60)aryl;
R₁₉ and R₂₀ independently represent hydrogen, deuterium, (C1-C60)alkyl or (C6-C60)aryl, or R₁₉ and R₂₀ may be linked via (C3-C12)alkylene or (C3-C12)alkenylene with or without a fused ring to form an alicyclic ring, a monocyclic or polycyclic aromatic ring;
R₂₁ represents deuterium, (C1-C60)alkyl, halogen, cyano, tri(C1-C60)alkylsilyl, tri(C6-C60)arylsilyl, (C1-C60)alkoxy, (C1-C60)alkylcarbonyl, (C6-C60)arylcarbonyl, phenyl, mono- or di(C1-C60)alkylamino, mono- or di(C6-C60)arylamino, naphthyl, 9,9-di(C1-C60)alkylfluorenyl or 9,9-di(C6-C60)arylfluorenyl; and
m is an integer from 1 to 5.
R₁₁ through R₁₈ may independently represent hydrogen, deuterium, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, trifluoromethyl, fluoro, cyano, trimethylsilyl, tripropylsilyl, tri(t-butyl)silyl, t-butyldimethylsilyl, triphenylsilyl, methoxy, ethoxy, butoxy, methylcarbonyl, ethylcarbonyl, t-butylcarbonyl, phenylcarbonyl, dimethylamino, diphenylamino, phenyl, naphthyl, anthryl, fluorenyl or 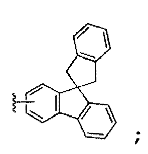 and the fluorenyl may be further substituted by deuterium, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, phenyl, naphthyl, anthryl, trimethylsilyl, tripropylsilyl, tri(t-butyl)silyl, t-butyldimethylsilyl or triphenylsilyl.

Preferably, R₁ through R₆ of Chemical Formula (1) independently represent hydrogen, deuterium, fluoro, trifluoromethyl, perfluoroethyl, trifluoroethyl, perfluoropropyl, perfluorobutyl, trifluoromethoxy, perfluoroethoxy, fluorobutoxy, fluorocyclopropyl, fluorocyclohexyl or fluorocycloheptyl, provided that R₁ through R₆ are not hydrogens at the same time.

The organic electroluminescent compounds according to the present invention can be specifically exemplified by the following compounds, but are not restricted thereto: 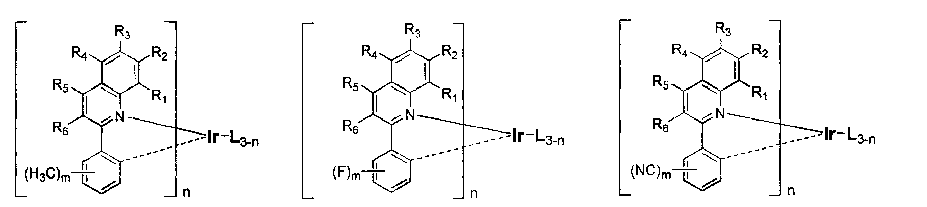 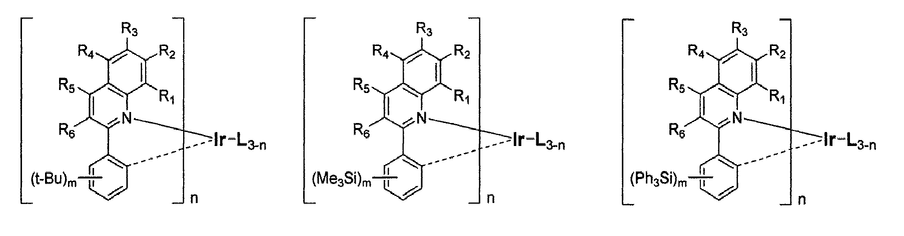 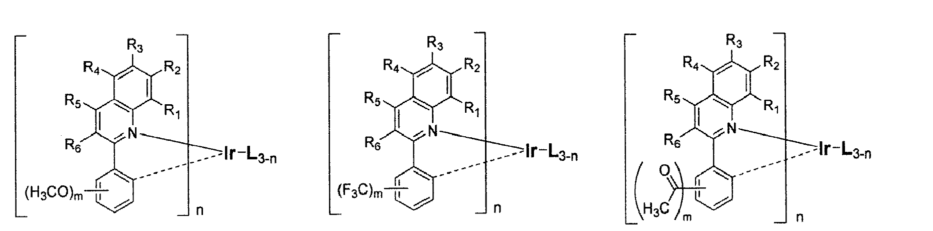 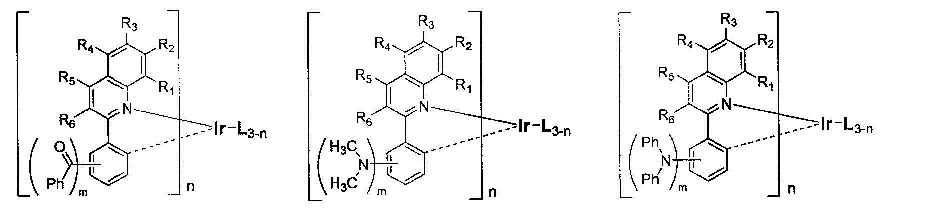 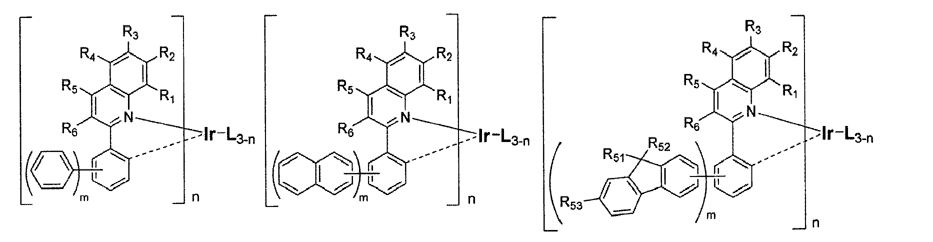 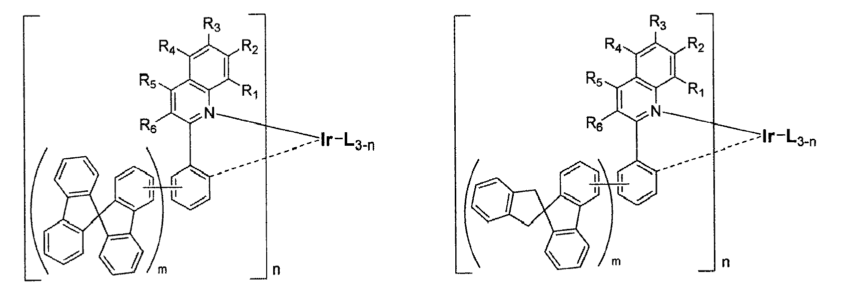 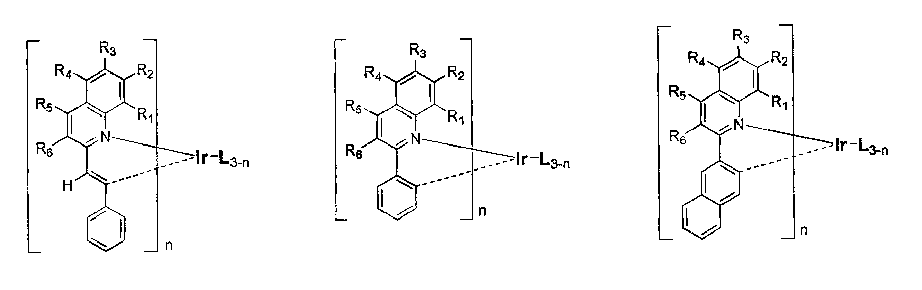 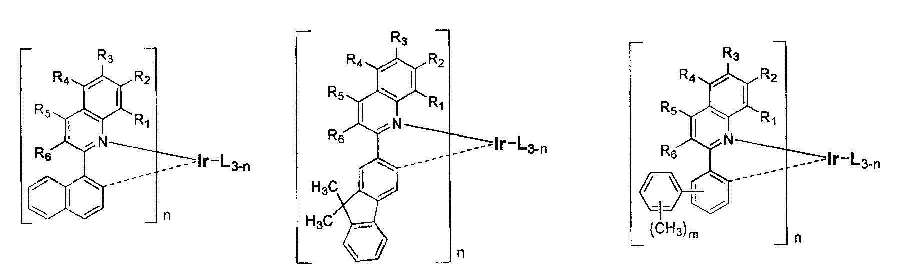 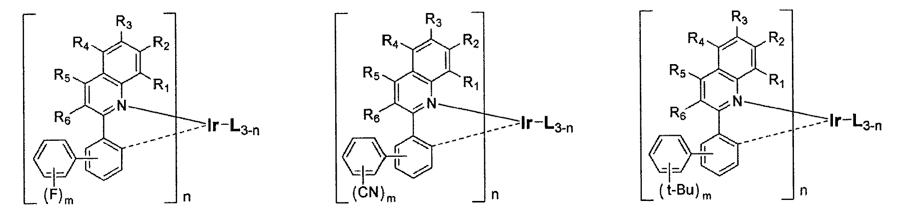 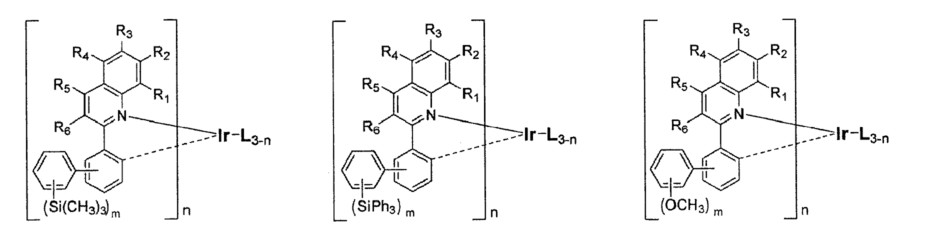 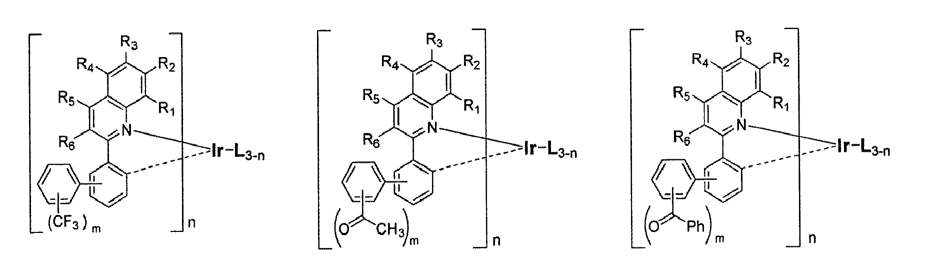 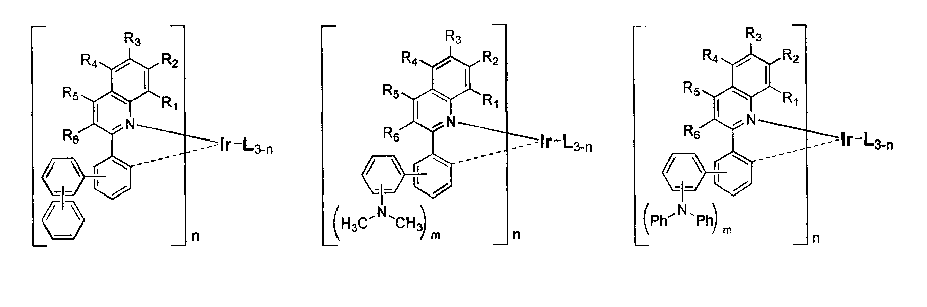 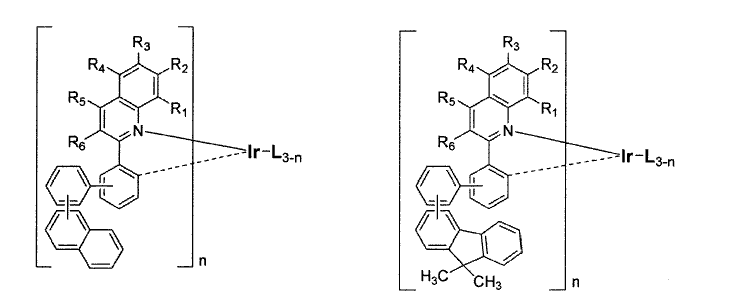 wherein, L represents organic ligand;
R₁ through R₆ independently represent hydrogen, deuterium or fluorine, provided that R₁ through R₆ are not hydrogens at the same time;
R₅₁ and R₅₂ independently represent deuterium, methyl, ethyl, n-propyl, i-propyl, n-butyl, i-butyl, t-butyl, n-pentyl, i-pentyl, n-hexyl, n-heptyl, n-octyl, ethylhexyl, phenyl or naphthyl, or R₅₁ and R₅₂ may be linked via (C3-C12)alkylene or (C3-C12)alkenylene with or without a fused ring to form an alicyclic or a monocyclic or polycyclic aromatic ring;
R₅₃ represents hydrogen, deuterium, methyl, ethyl, n-propyl, i-propyl, n-butyl, i-butyl, t-butyl, n-pentyl, i-pentyl, n-hexyl, n-heptyl, n-octyl, 2-ethylhexyl, trimethylsilyl, tripropylsilyl, tri(t-butyl)silyl, t-butyldimethylsilyl, triphenylsilyl, phenyl or naphthyl;
m is an integer from 1 to 5; and
n is an integer from 1 to 3.

The subsidiary ligands (L) of the organic electroluminescent compounds according to the present invention include the following structures: 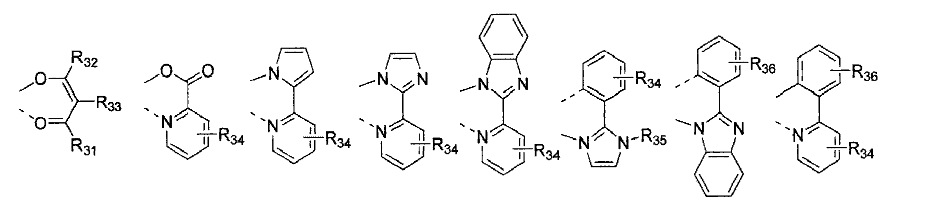 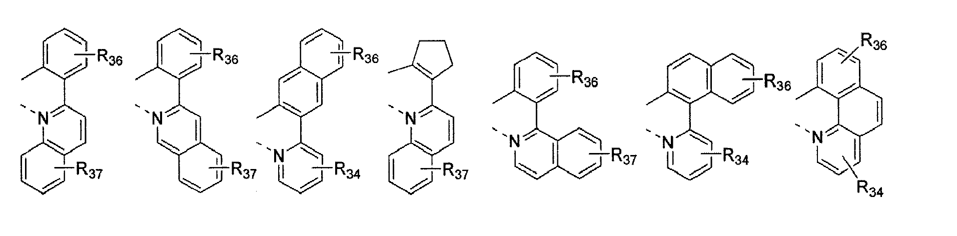 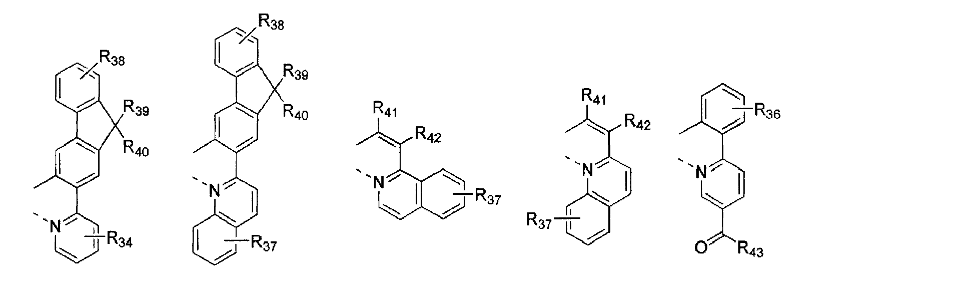 wherein, R₃₁ and R₃₂ independently represent hydrogen, deuterium, (C1-C60)alkyl with or without halogen substituent(s), phenyl with or without (C1-C60)alkyl substituent(s), or halogen;
R₃₃ through R₃₈ independently represent hydrogen, deuterium, (C1-C60)alkyl, phenyl with or without (C1-C60)alkyl substituent(s), tri(C1-C60)alkylsilyl or halogen;
R₃₉ through R₄₂ independently represent hydrogen, deuterium, (C1-C60)alkyl, phenyl with or without (C1-C60)alkyl substituent(s); and
R₄₃ represents deuterium, (C1-C60)alkyl, phenyl with or without (C1-C60)alkyl substituent(s), or halogen.

The subsidiary ligands (L) of the organic electroluminescent compounds according to the present invention can be exemplified by the following structures, but they are not restricted thereto:

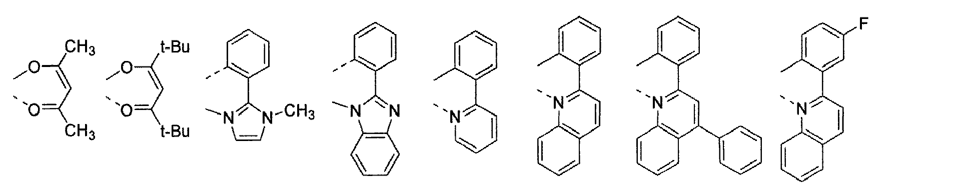

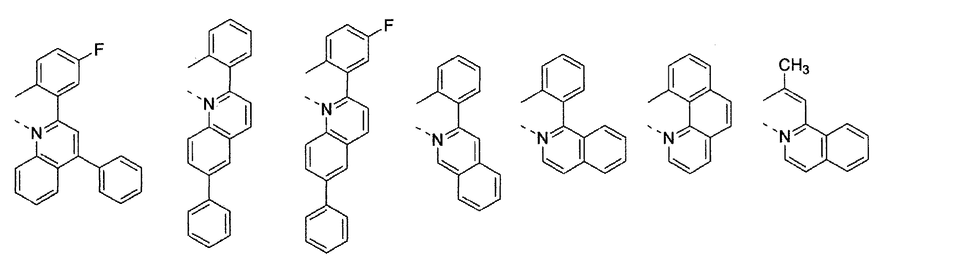

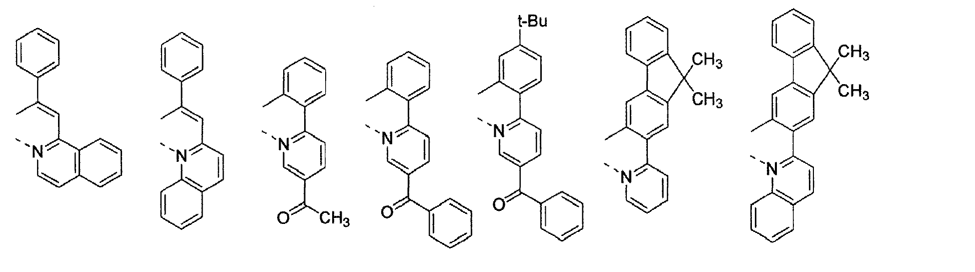

The processes for preparing the organic phosphorescent compounds according to the present invention are described by referring to Reaction Schemes (1) to (3) shown below: 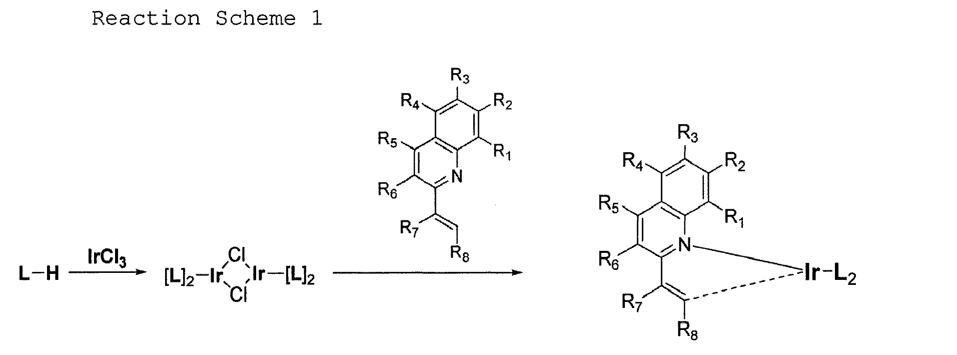 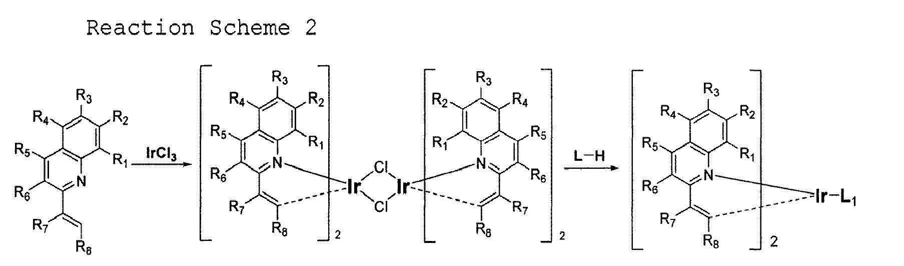 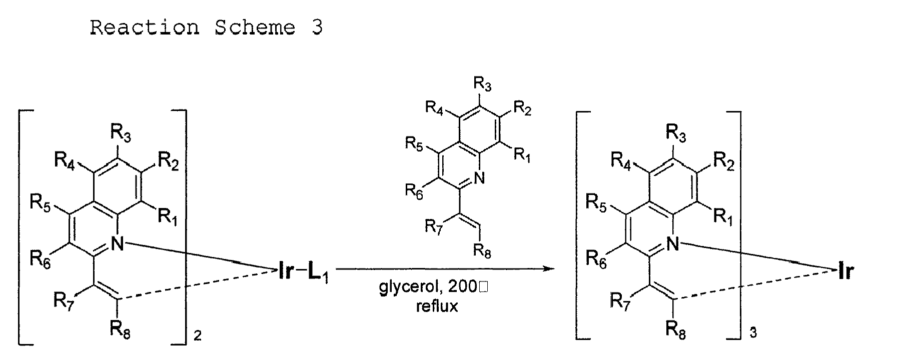 wherein, R₁, R₂, R₃, R₄, R₅, R₆, R₇, R₈ and L are defined as in Chemical Formula (1).

Reaction Scheme (1) provides a compound of Chemical Formula (1) with n=1, in which iridium trichloride (IrCl₃) and subsidiary ligand compound (L-H) are mixed in a solvent at a molar ratio of 1:2∼3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with a primary ligand compound in organic solvent to provide an organic phosphorescent iridium compound having the ratio of primary ligand: subsidiary ligand of 1:2 as the final product. The reaction is carried out with AgCF₃SO₃, Na₂CO₃ or NaOH being admixed with organic solvent such as 2-ethoxyethanol and 2-methoxyethylether.

Reaction Scheme (2) provides a compound of Chemical Formula (1) with n=2, in which iridium trichloride (IrCl₃) and a primary ligand compound are mixed in a solvent at a molar ratio of 1:2∼3, and the mixture is heated under reflux before isolating diiridium dimer. In the reaction stage, preferable solvent is alcohol or a mixed solvent of alcohol/water, such as 2-ethoxyethanol, and 2-ethoxyethanol/water mixtures. The isolated diiridium dimer is then heated with the subsidiary ligand compound (L-H) in organic solvent to provide an organic phosphorescent iridium compound having the ratio of primary ligand: subsidiary ligand of 2:1 as the final product. The molar ratio of the primary ligand compound and the subsidiary ligand (L) in the final product is determined by appropriate molar ratio of the reactant depending on the composition. The reaction may be carried out with AgCF₃SO₃, Na₂CO₃ or NaOH being admixed with organic solvent such as 2-ethoxyethanol, 2-methoxyethylether and 1,2-dichloroethane.

Reaction Scheme (3) provides a compound of Chemical Formula (1) with n=3, in which iridium complex prepared according to Reaction Scheme (2) and the primary ligand compound are mixed in glycerol at a molar ratio of 1:2∼3, and the mixture is heated under reflux to obtain organic phosphorescent iridium complex coordinated with three primary ligands.

The compounds employed as a primary ligand in the present invention can be prepared according to Reaction Scheme (4), on the basis of conventional processes, but it is not restrictive: 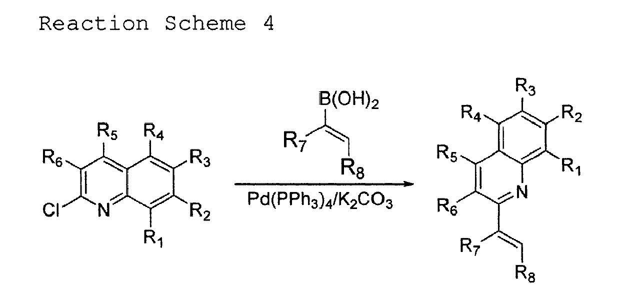 wherein, R₁ through R₈ are defined as in Chemical Formula (1).

The present invention also provides organic solar cells, which comprises one or more organic electroluminescent compound(s) represented by Chemical Formula (1).

The present invention also provides an organic electroluminescent device which is comprised of a first electrode; a second electrode; and at least one organic layer(s) interposed between the first electrode and the second electrode; wherein the organic layer comprises one or more compound(s) represented by Chemical Formula (1).

The organic electroluminescent device according to the present invention is characterized in that the organic layer comprises an electroluminescent region, which comprises one or more organic electroluminescent compound(s) represented by Chemical Formula (1) as electroluminescent dopant in an amount of 0.01 to 10% by weight, and one or more host(s). The host applied to the organic electroluminescent device according to the invention is not particularly restricted, but may be exemplified by 1,3,5-tricarbazolylbenzene, polyvinylcarbazole, m-biscarbazolylphenyl, 4,4'4"-tri(N-carbazolyl)triphenylamine, 1,3,5-tri(2-carbazolylphenyl)benzene, 1,3,5-tris(2-carbazolyl-5-methoxyphenyl) benzene, bis(4-carbazolylphenyl)silane or the compounds represented by one of Chemical Formulas (8) to (11).

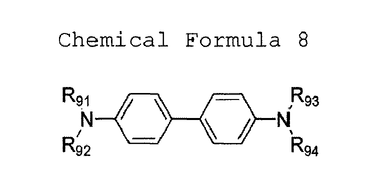

In Chemical Formula (8), R₉₁ through R₉₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl. 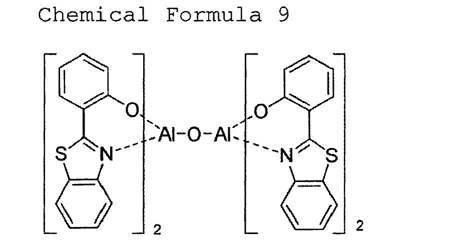 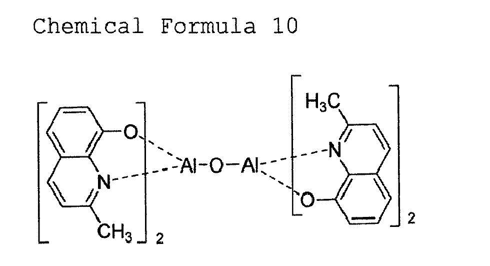 Chemical Formula 11 **L¹L²M¹(Q)_{y}**

In Chemical Formula (11), the ligands, L¹ and L² are independently selected from the following structures: 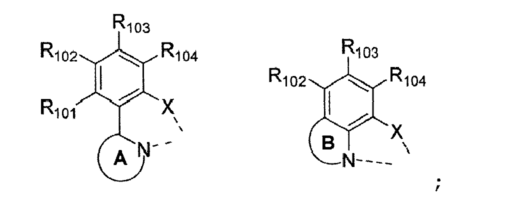
M¹ is a bivalent or trivalent metal;
y is 0 when M¹ is a bivalent metal, while y is 1 when M¹ is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by deuterium, (C1-C60)alkyl, or phenyl or naphthyl with or without (C1-C60)alkyl substituent(s);
R₁₀₁ through R₁₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and the pyridine or quinoline may form a chemical bond with R₁₀₁ to form a fused ring;
   the ring A and alkyl, alkenyl, alkynyl, cycloalkyl, heterocycloalkyl, aryl, heteroaryl, arylsilyl, alkylsilyl, alkylamino, or arylamino of R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

The ligands, L¹ and L² are independently selected from the following structures: 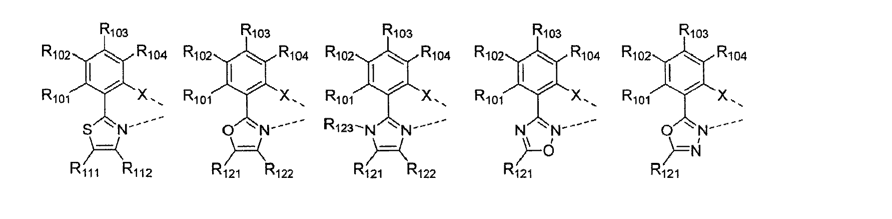 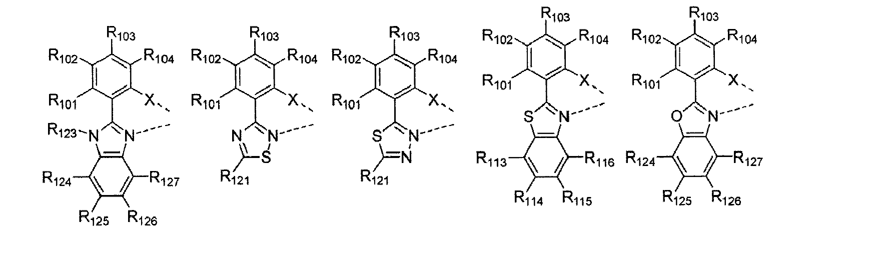 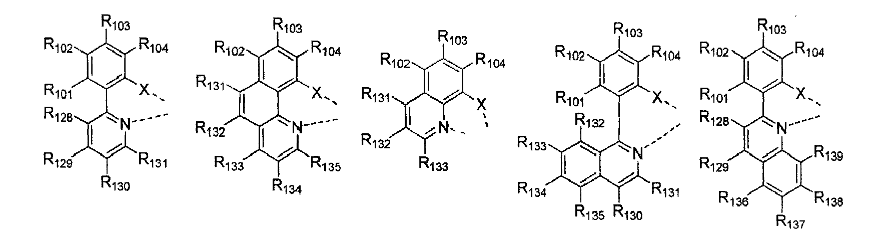 wherein, X represents O, S or Se;
R₁₀₁ through R₁₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring;
R₁₁₁ through R₁₁₆ and R₁₂₁ through R₁₃₉ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₁₁ through R₁₁₆ and R₁₂₁ through R₁₃₉ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₁₀₁ through R₁₀₄, R₁₁₁ through R₁₁₆, and R₁₂₁ through R₁₃₉, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

In Chemical Formula (11), M¹ is a bivalent metal selected from Be, Zn, Mg, Cu and Ni, or a trivalent metal selected from Al, Ga, In and B, and Q is selected from the following structures.

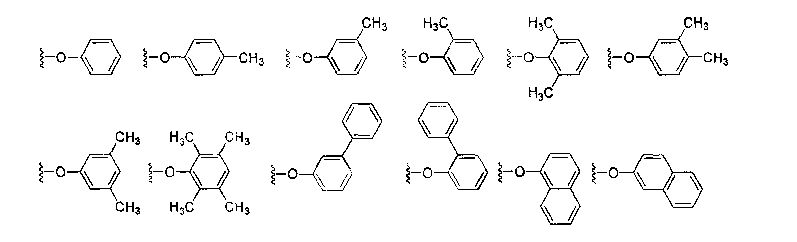

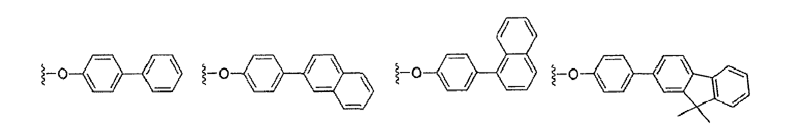

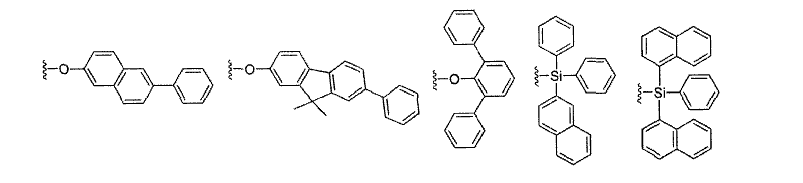

The compounds of Chemical Formula (8) may be specifically exemplified by the compounds represented by the following structures, but they are not restricted thereto.

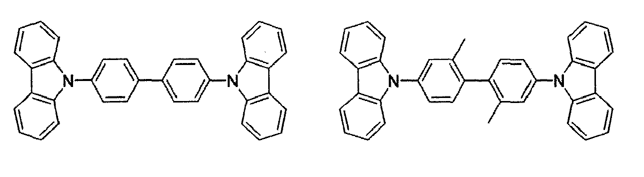

The compounds represented by Chemical Formula (11) may be specifically exemplified by the compounds with one of the following structures, but they are not restricted thereto.

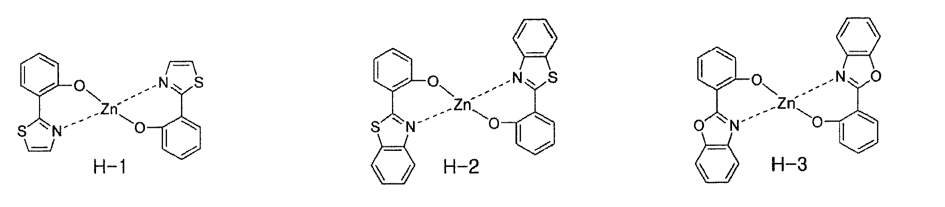

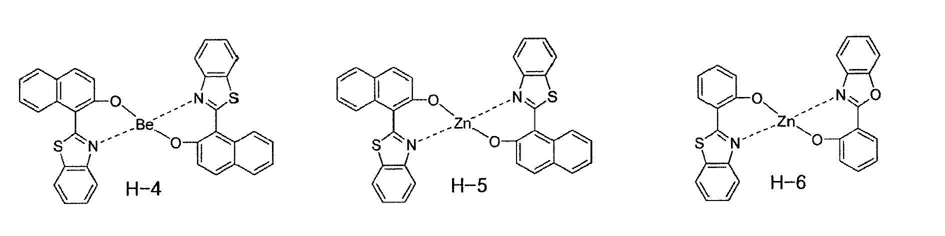

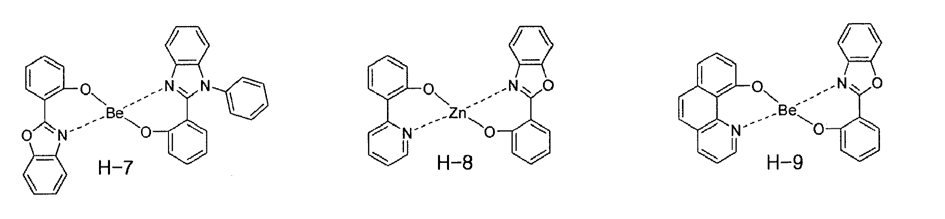

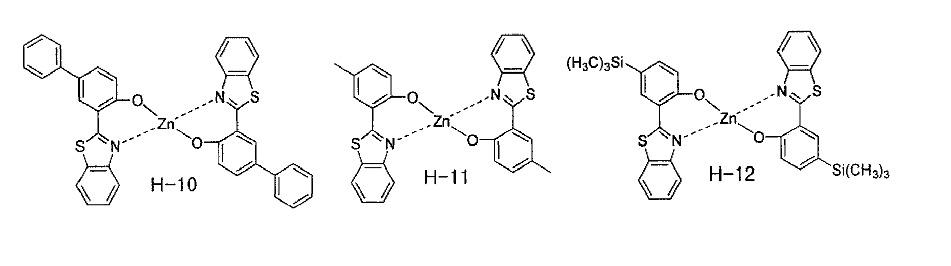

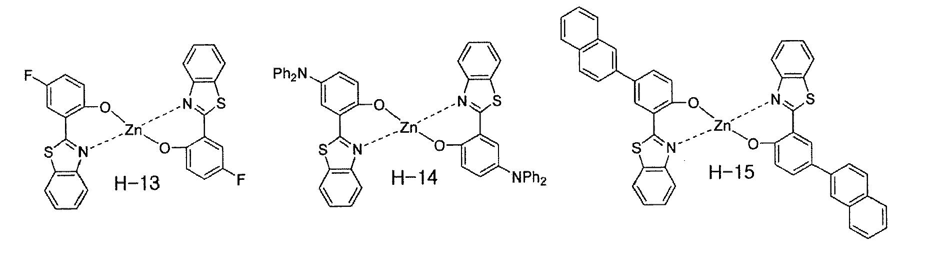

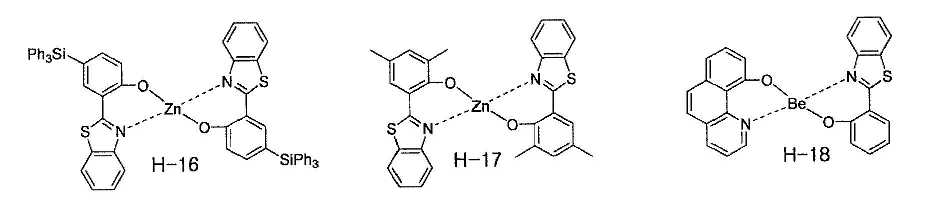

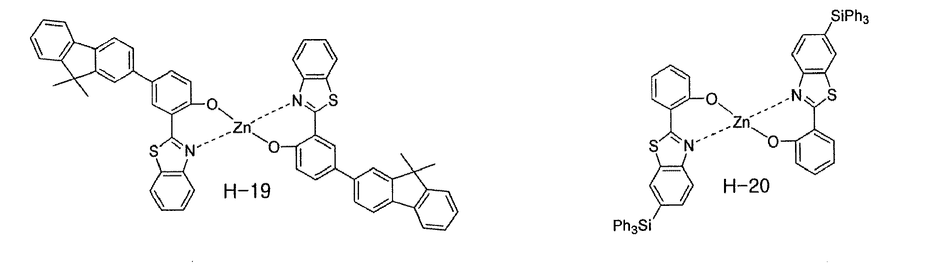

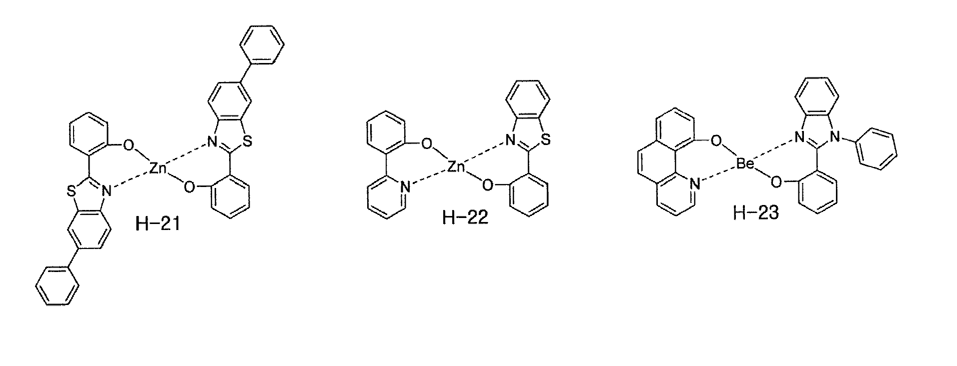

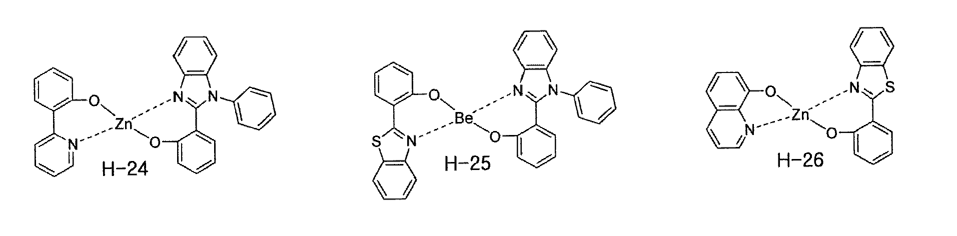

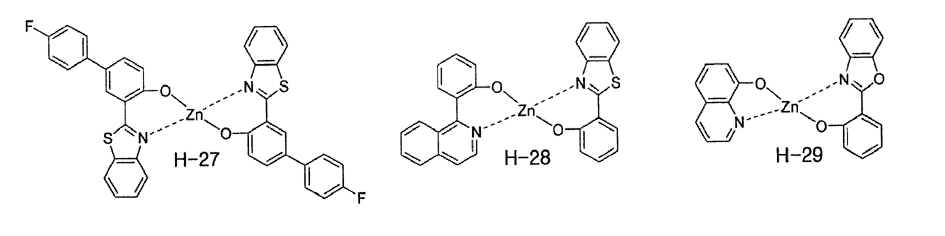

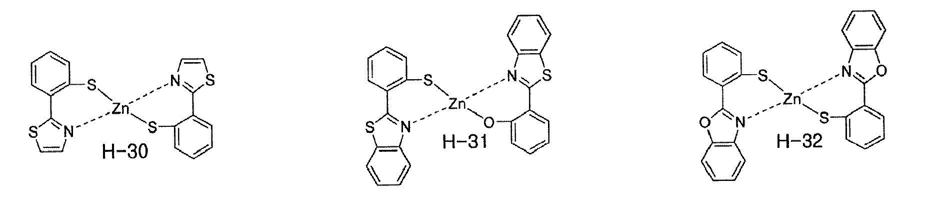

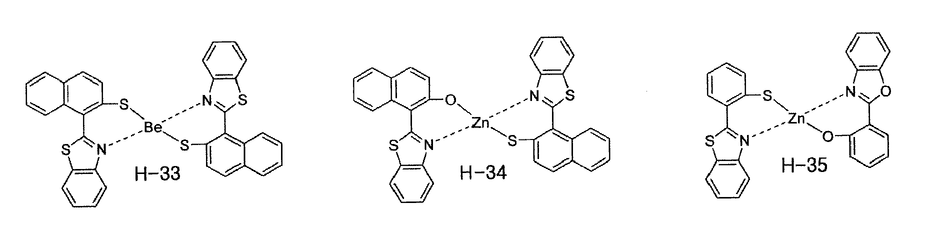

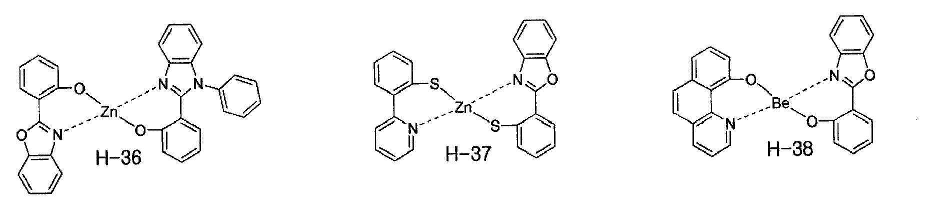

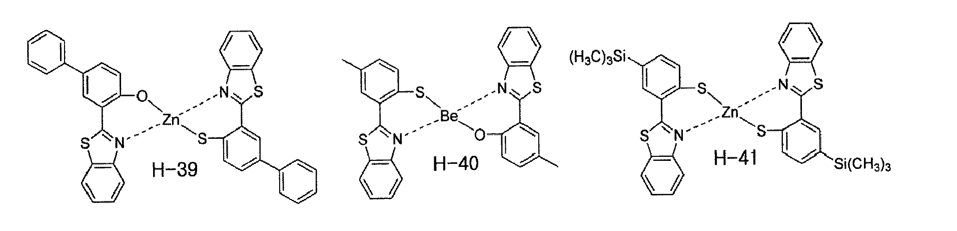

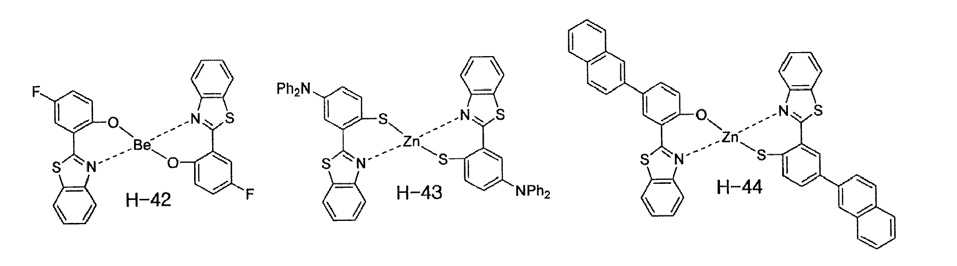

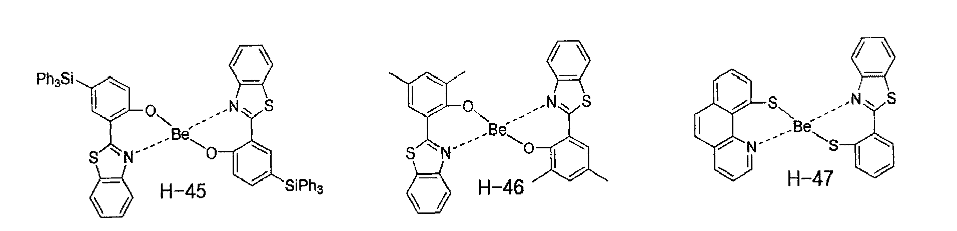

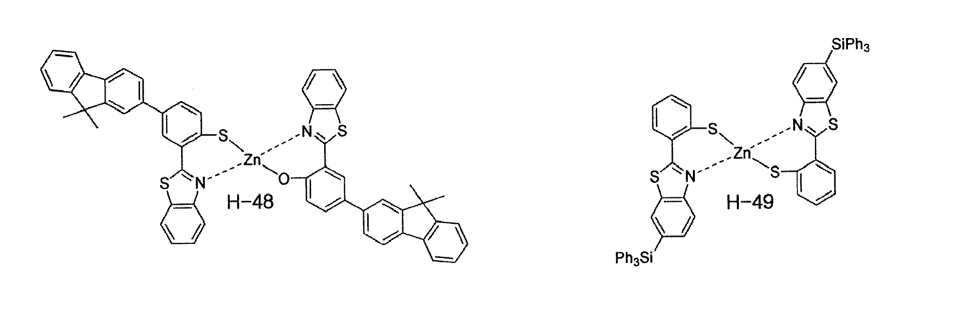

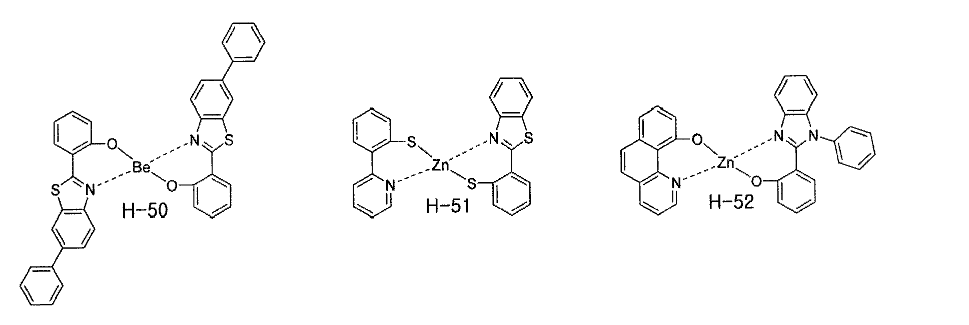

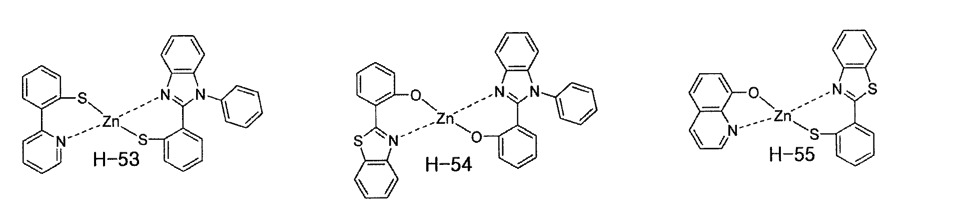

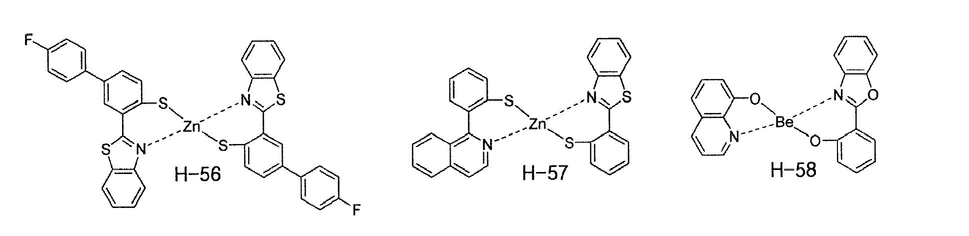

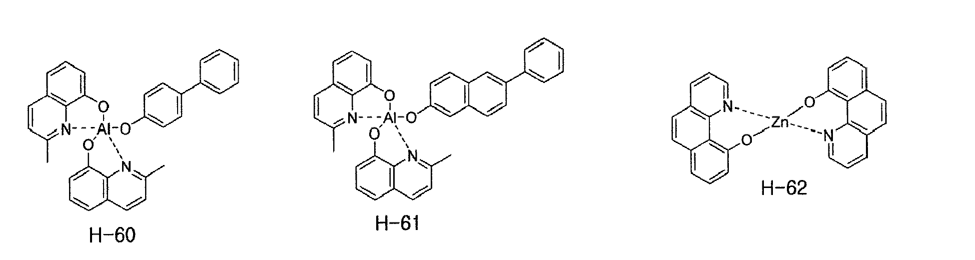

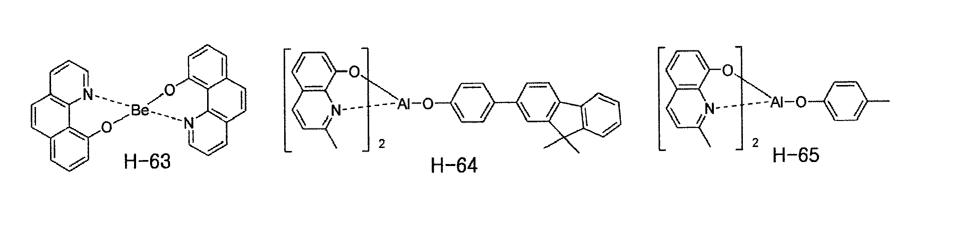

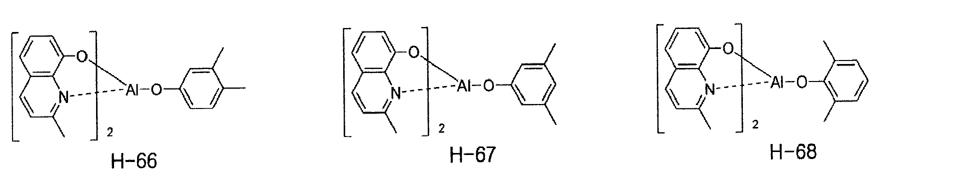

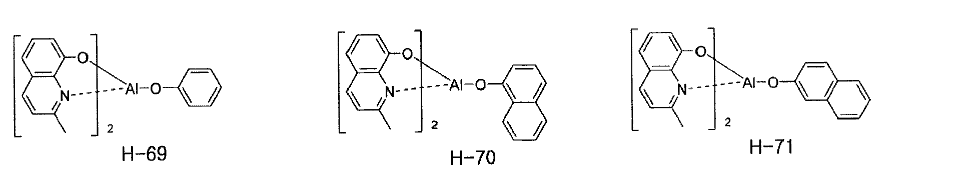

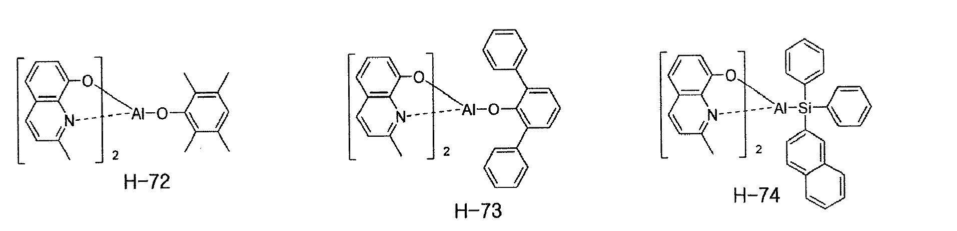

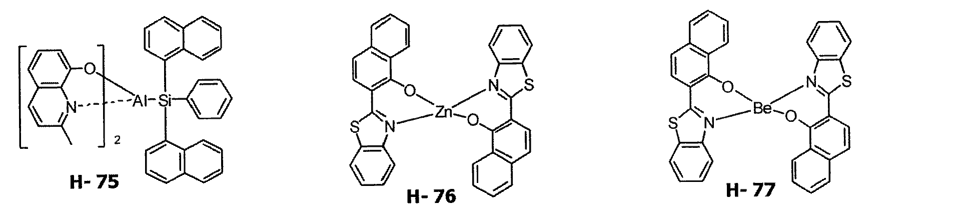

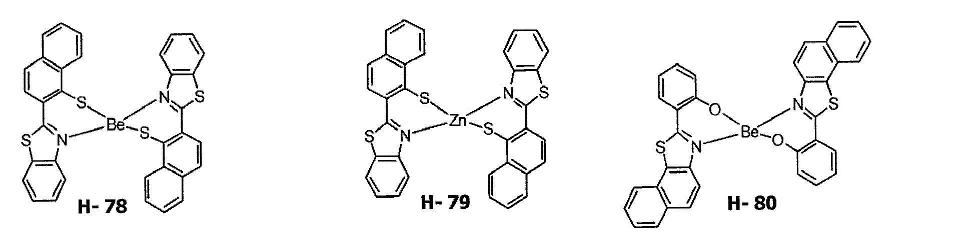

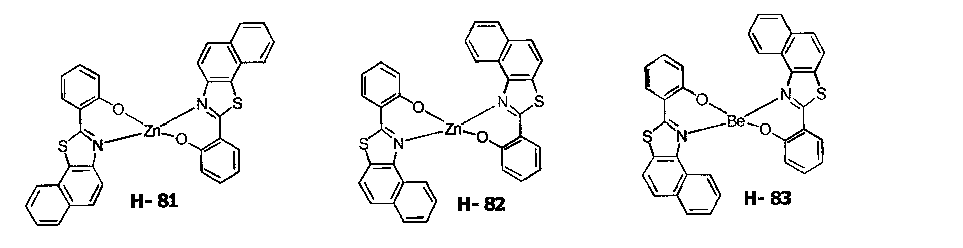

The organic electroluminescent device according to the invention may further comprise one or more compound(s) selected from arylamine compounds and styrylarylamine compounds, as well as the organic electroluminescent compound represented by Chemical Formula (1). Examples of arylamine or styrylarylamine compounds include the compounds represented by Chemical Formula (12), but they are not restricted thereto: 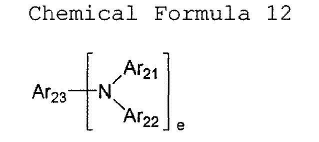 wherein, Ar₂₁ and Ar₂₂ independently represent hydrogen, deuterium, halogen, (C1-C60)alkyl, (C6-C60)aryl, (C4-C60)heteroaryl, mono- or di(C6-C60)arylamino, mono- or di(C1-C60)alkylamino, a 5- or 6-membered heterocycloalkyl containing one or more heteroatom(s) selected from N, O and S, or (C3-C60)cycloalkyl, or Ar₂₁ and Ar₂₂ may be linked via (C3-C60)alkylene or (C3-C60)alkenylene with or without a fused ring to form an alicyclic ring, or a monocyclic or polycyclic aromatic ring;
when e is 1, Ar₂₃ represents (C6-C60)aryl, (C4-C60)heteroaryl, or a substituent represented by one of the following structural formulas: 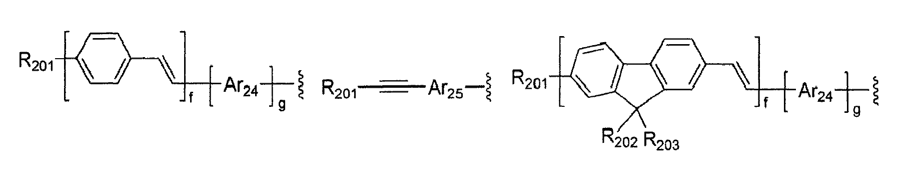 when e is 2, Ar₂₃ represents (C6-C60)arylene, (C4-C60)heteroarylene, or a substituent represented by one of the following structural formulas: 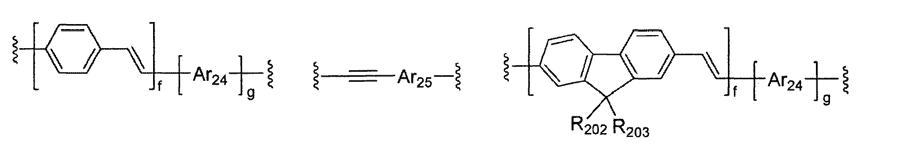 Ar₂₄ and Ar₂₅ independently represent (C6-C60)arylene or (C4-C60)heteroarylene;
R₂₀₁ through R₂₀₃ independently represent hydrogen, halogen, deuterium, (C1-C60)alkyl or (C6-C60)aryl;
f is an integer from 1 to 4, g is an integer of 0 or 1; and
the alkyl, aryl, heteroaryl, arylamino, alkylamino, cycloalkyl or heterocycloalkyl of Ar₂₁ and Ar₂₂, or the aryl, heteroaryl, arylene or heteroarylene of Ar₂₃, or the arylene or heteroarylene of Ar₂₄ and Ar₂₅, or the alkyl or aryl of R₂₀₁ through R₂₀₃ may be further substituted by one or more substituent(s) selected from a group consisting of halogen, deuterium, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

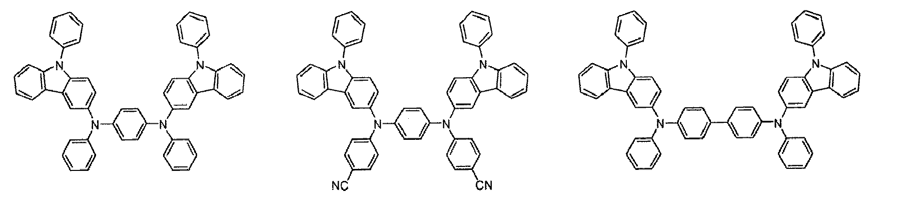

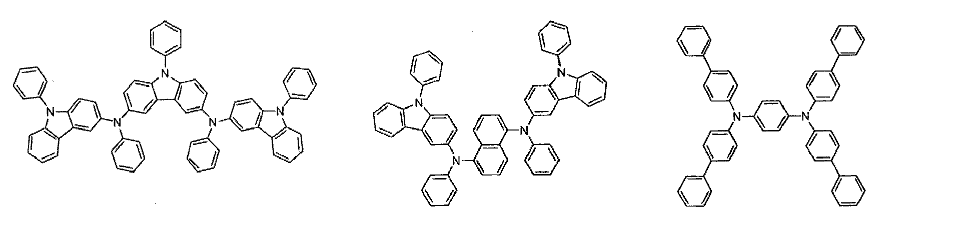

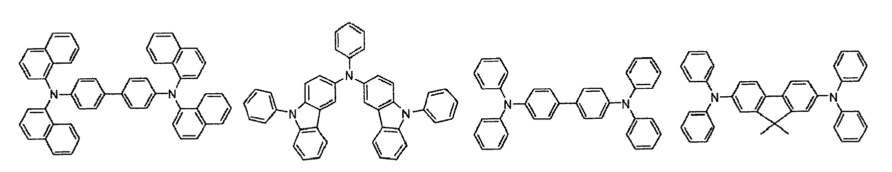

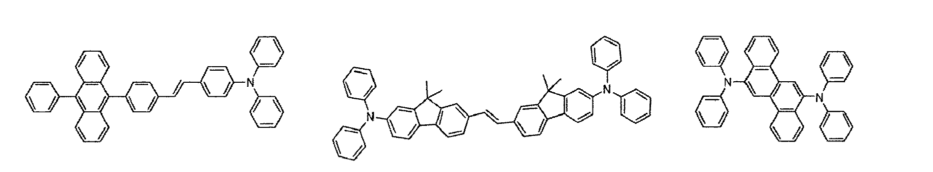

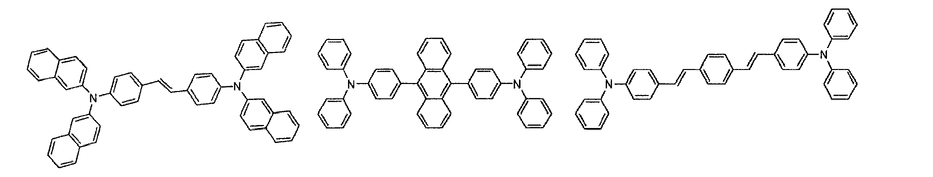

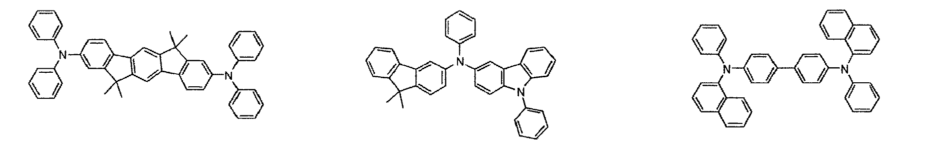

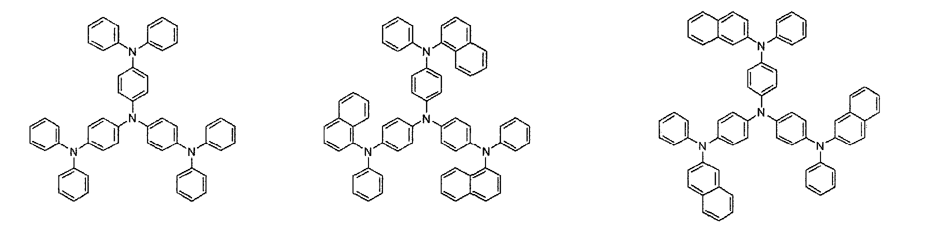

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements, as well as the organic electroluminescent compound represented by Chemical Formula (1). The organic layer may comprise a charge generating layer in addition to the electroluminescent layer.

The present invention can realize an electroluminescent device having a pixel structure of independent light-emitting mode, which comprises an organic electroluminescent device containing the compound of Chemical Formula (1) as a sub-pixel, and one or more sub-pixel (s) comprising one or more compound(s) selected from a group consisting of arylamine compounds and styrylarylamine compounds, patterned in parallel at the same time.

Further, the organic electroluminescent device is an organic display which comprises one or more compound(s) selected from compounds having electroluminescent peak of wavelength of blue or green, at the same time. The compounds having electroluminescent peak of wavelength of blue or green may be exemplified by the compounds represented by one of Chemical Formulas (13) to (17), but they are not restricted thereto.

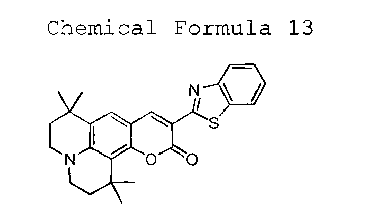

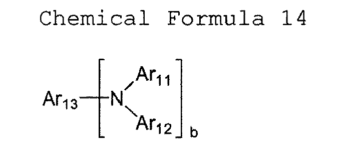

In Chemical Formula (14), Ar₁₁ and Ar₁₂ independently represent hydrogen, deuterium, halogen, (C1-C60)alkyl, (C6-C60)aryl, (C4-C60)heteroaryl, mono- or di(C6-C60)arylamino, mono- or di(C1-C60)alkylamino, a 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when b is 1, Ar₁₃ represents (C6-C60)aryl, (C4-C60)heteroaryl, or a substituent represented by one of the following structural formulas: 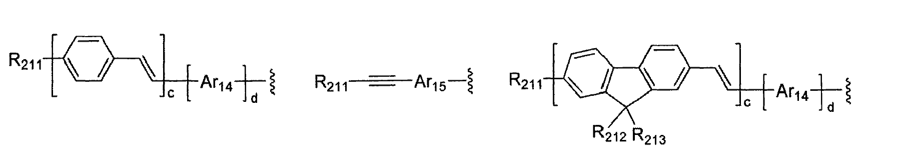 when b is 2, Ar₅₃ represents (C6-C60)arylene, (C4-C60)heteroarylene, or a substituent represented by one of the following structural formulas: 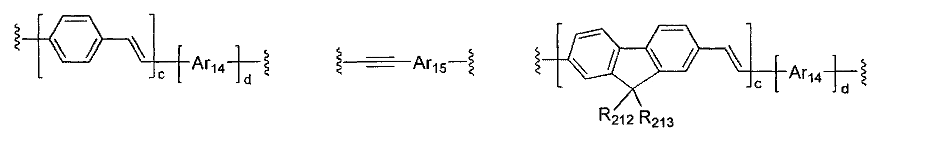 Ar₁₄ and Ar₁₅ independently represent (C6-C60)arylene or (C4-C60)heteroarylene;
R₂₁₁ through R₂₁₃ independently represent hydrogen, deuterium, (C1-C60)alkyl or (C6-C60)aryl;
c is an integer from 1 to 4, d is an integer of 0 or 1; and
the alkyl, aryl, heteroaryl, arylamino, alkylamino, cycloalkyl or heterocycloalkyl of Ar₁₁ and Ar₁₂, or the aryl, heteroaryl, arylene or heteroarylene of Ar₁₃, or the arylene or heteroarylene of Ar₁₄ and Ar₁₅, or the alkyl or aryl of R₂₁₁ through R₂₁₃ may be further substituted by one or more substituent(s) selected from a group consisting of halogen, deuterium, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

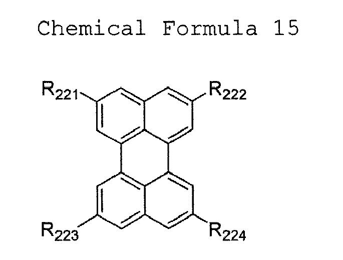

In Chemical Formula (15), R₂₂₁ through R₂₂₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₂₂₁ through R₂₂₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₂₂₁ through R₂₂₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.

Chemical Formula 16 (Ar₃₀₁)ₚ-L₁₁-(Ar₃₀₂)_{q}

Chemical Formula 17 (Ar₃₀₃)ᵣ-L₁₂-(Ar₃₀₄)ₛ

In Chemical Formulas (16) and (17),
L₁₁ represents (C6-C60)arylene or (C4-C60)heteroarylene;
L₁₂ represents anthracenylene;
Ar₃₀₁ through Ar₃₀₄ are independently selected from hydrogen, deuterium, (C1-C60)alkyl, (C1-C60)alkoxy, halogen, (C4-C60)heteroaryl, (C5-C60)cycloalkyl and (C6-C60)aryl, and the cycloalkyl, aryl or heteroaryl of Ar₃₀₁ through Ar₃₀₄ may be further substituted by one or more substituent(s) selected from a group consisting of (C6-C60)aryl or (C4-C60)heteroaryl with or without at least one substituent(s) selected from a group consisting of deuterium, (C1-C60)alkyl with or without halogen substituent(s), (C1-C60)alkoxy, (C3-C60)cycloalkyl,
halogen, cyano, tri(C1-C60)alkylsilyl, di(C1-C60)alkyl(C6-C60)arylsilyl and tri(C6-C60)arylsilyl; deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl; and
p, q, r and s independently represent an integer from 0 to 4.

The compounds represented by Chemical Formula (16) or (17) may be exemplified by the derivatives represented by one of Chemical Formulas (18) to (21).

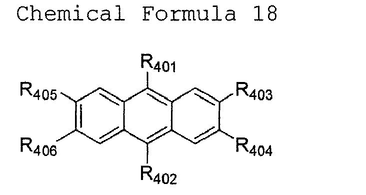

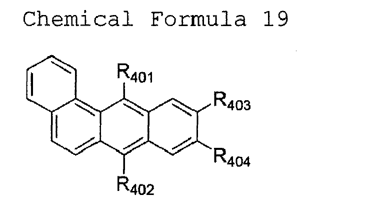

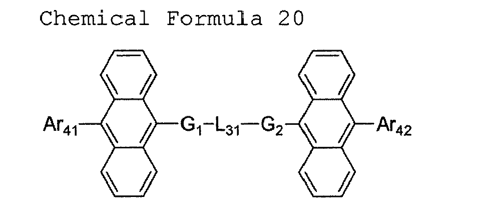

In Chemical Formulas (18) to (20), R₄₀₁ and R₄₀₂ independently represent (C6-C60)aryl, (C4-C60)heteroaryl or a 5- or 6-membered heterocycloalkyl containing one or more heteroatom(s) selected from N, O and S, or (C3-C60)cycloalkyl, and the aryl or heteroaryl of R₄₀₁ and R₄₀₂ may be further substituted by one or more substituent(s) selected from a group consisting of deuterium, (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₄₀₃ through R₄₀₆ independently represent hydrogen, deuterium, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₄₀₃ through R₄₀₆ may be further substituted by one or more substituent(s) selected from a group consisting of deuterium, (C1-C60)alkyl, halo(C1-C60)alkyl, (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from deuterium, (C1-C60)alkyl, (C1-C60)alkoxy, (C6-C60)aryl, (C4-C60)heteroaryl and halogen;
Ar₄₁ and Ar₄₂ represent an aryl selected from the following structures, or (C4-C60)heteroaryl: 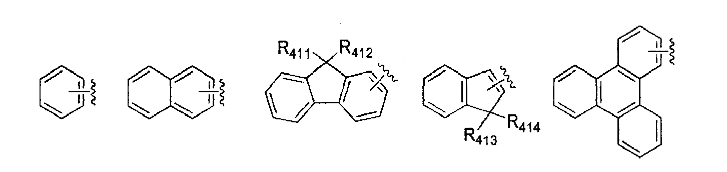 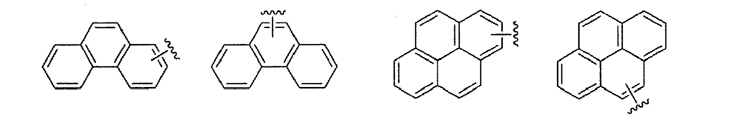 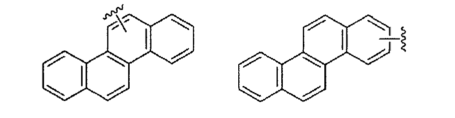 the aryl or heteroaryl of Ar₄₁ and Ar₄₂ may be substituted by one or more substituent(s) selected from deuterium, (C1-C60)alkyl, (C1-C60)alkoxy, (C6-C60)aryl and (C4-C60)heteroaryl;
L₃₁ represents (C6-C60)arylene, (C4-C60)heteroarylene or a compound represented by the following structure: 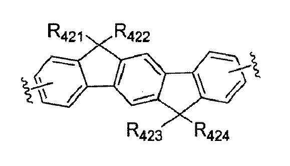 the arylene or heteroarylene of L₃₁ may be substituted by one or more substituent(s) selected from deuterium, (C1-C60)alkyl, (C1-C60)alkoxy, (C6-C60)aryl, (C4-C60)heteroaryl and halogen;
R₄₁₁, R₄₁₂, R₄₁₃ and R₄₁₄ independently represent hydrogen, deuterium, halogen, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₄₂₁, R₄₂₂, R₄₂₃ and R₄₂₄ independently represent hydrogen, deuterium, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

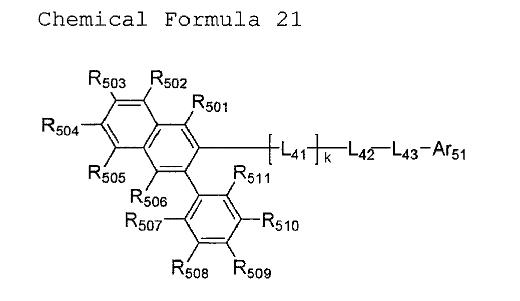

In Chemical Formula 21,
L₄₁ represents (C6-C60)arylene, (C3-C60)heteroarylene containing one or more heteroatom(s) selected from N, O and S, or a divalent group selected from the following structures: 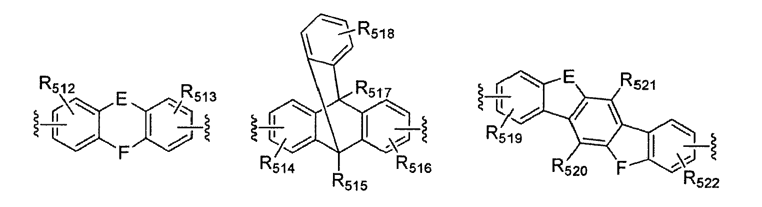 L₄₂ and L₄₃ independently represent a chemical bond, (C1-C60)alkyleneoxy, (C1-C60)alkylenethio, (C6-C60)aryleneoxy, (C6-C60)arylenethio, (C6-C60)arylene, or (C3-C60)heteroarylene containing one or more heteroatom(s) selected from N, O and S;
Ar₅₁ represents NR₅₂₃R₅₂₄, (C6-C60)aryl, (C3-C60)heteroaryl containing one or more heteroatom(s) selected from N, O and S, 5- or 6-membered heterocycloalkyl containing one or more heteroatom(s) selected from N, O and S, (C3-C60)cycloalkyl, adamantyl, (C7-C60)bicycloalkyl, or a substituent selected from the following structures: 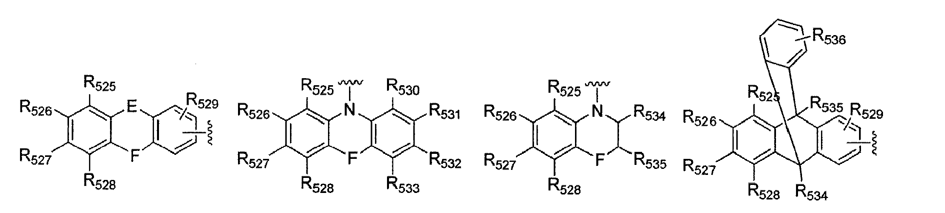 R₅₀₁ through R₅₁₁ independently represent hydrogen, deuterium, halogen, (C1-C60)alkyl, (C6-C60) aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₅₀₁ through R₅₁₁ may be linked to an adjacent substituent via (C3-C60)alkylene or (C3-C60)alkenylene with or without a fused ring to form an alicyclic ring, or a monocyclic or polycyclic aromatic ring;
R₅₁₂ through R₅₂₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₅₁₂ through R₅₂₂ may be linked to an adjacent substituent via (C3-C60)alkylene or (C3-C60)alkenylene with or without a fused ring to form an alicyclic ring, or a monocyclic or polycyclic aromatic ring;
R₅₂₃ and R₅₂₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₂₃ and R₅₂₄ may be linked via (C3-C60)alkylene or (C3-C60)alkenylene with or without a fused ring to form an alicyclic ring, or a monocyclic or polycyclic aromatic ring;
R₅₂₅ through R₅₃₆ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60) arylcarbonyl, carboxyl, nitro or hydroxyl, or each of R₅₂₅ through R₅₃₆ may be linked to an adjacent substituent via (C3-C60)alkylene or (C3-C60)alkenylene with or without a fused ring to form an alicyclic ring, or a monocyclic or polycyclic aromatic ring;
E and F independently represent a chemical bond,-(CR₅₃₇R₅₃₈)ₗ-, -N(R₅₃₉)-, -S-, -O-, -Si(R₅₄₀) (R₅₄₁)-, -P(R₅₄₂)-,-C(=O)-, -B(R₅₄₃)-, -In(R₅₄₄)-, -Se-, -Ge(R₅₄₅)(R₅₄₆)-,-Sn(R₅₄₇)(R₅₄₈)-, -Ga(R₅₄₉)- or -(R₅₅₀)C=C(R₅₅₁)-;
R₅₃₇ through R₅₅₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₅₃₇ and R₅₃₈, R₅₄₀ and R₅₄₁, R₅₄₅ and R₅₄₆, R₅₄₇ and R₅₄₈, and R₅₅₀ and R₅₅₁ may be linked via (C3-C60)alkylene or (C3-C60)alkenylene with or without a fused ring to form an alicyclic ring, or a monocyclic or polycyclic aromatic ring;
the arylene or heteroarylene of L₄₁ through L₄₃, the aryl or heteroaryl of Ar₅₁, or the alkyl, aryl, heteroaryl, heterocycloalkyl, cycloalkyl, trialkylsilyl, dialkylarylsilyl, triarylsilyl, alkenyl, alkynyl, alkylamino or arylamino of R₅₀₁ through R₅₁₁, R₅₁₂ through R₅₂₂, R₅₂₃, R₅₂₄, R₅₂₅ through R₅₃₆, and R₅₃₇ through R₅₅₁ may be further substituted independently by one or more substituent(s) selected from deuterium, halogen, (C1-C60)alkyl, halo(C1-C60)alkyl, (C6-C60) aryl, (C3-C60)heteroaryl containing one or more heteroatom(s) selected from N, O and S with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro, hydroxyl, 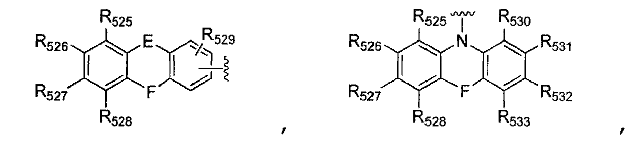 and 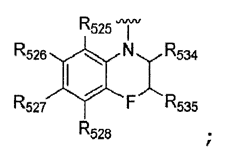 1 is an integer from 1 to 4; and
k is an integer from 1 to 4.

The organic compounds with green or blue electroluminescence can be more specifically exemplified by the following compounds, but they are not restricted thereto.

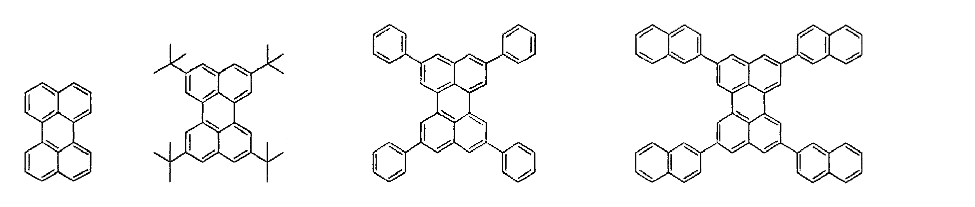

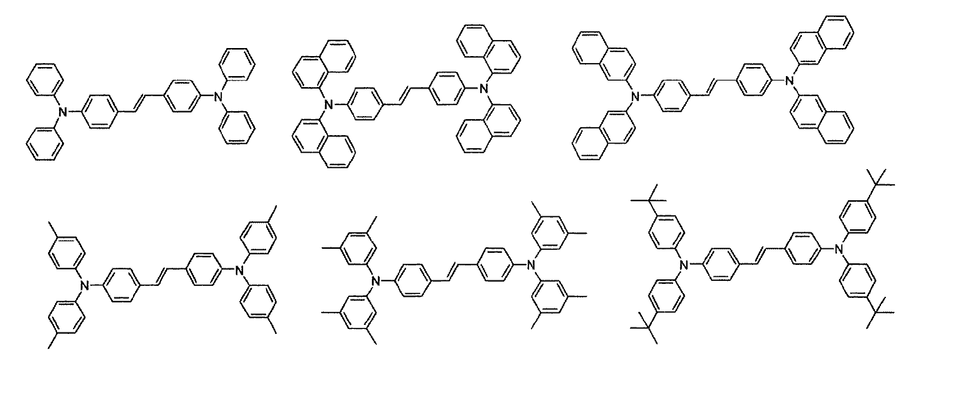

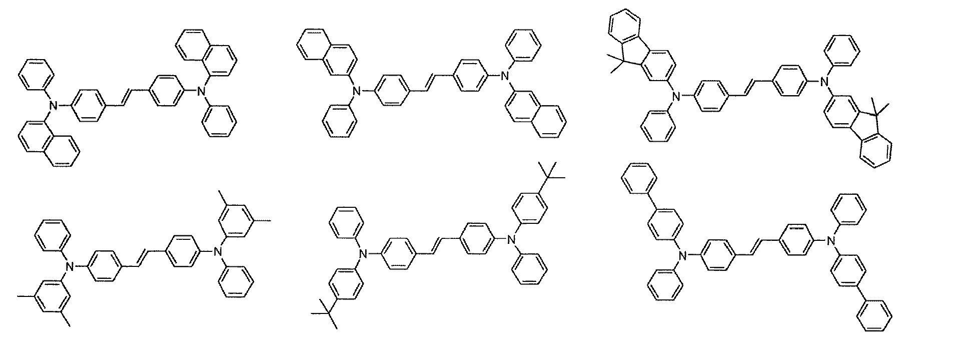

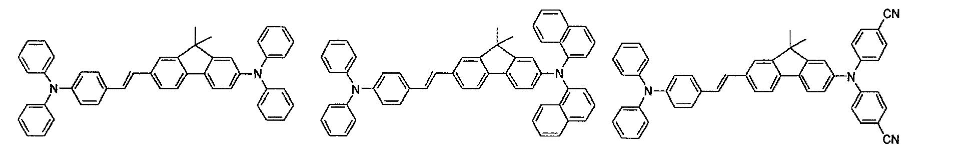

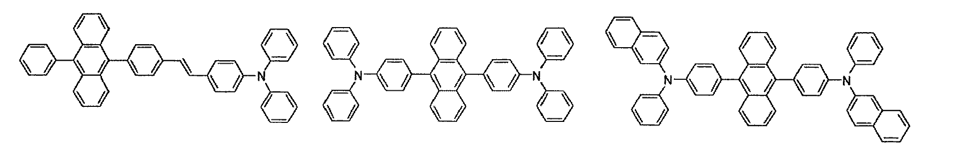

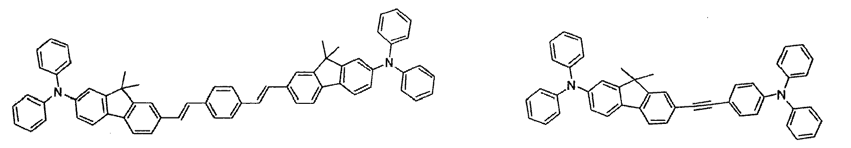

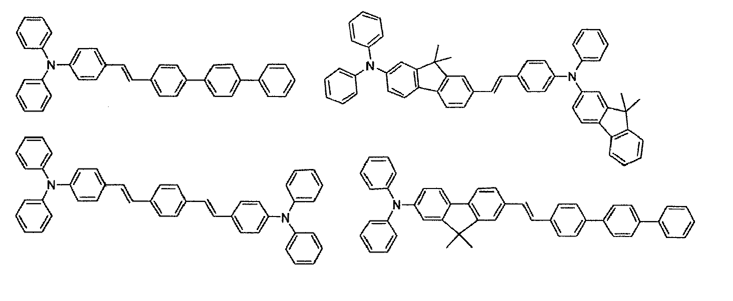

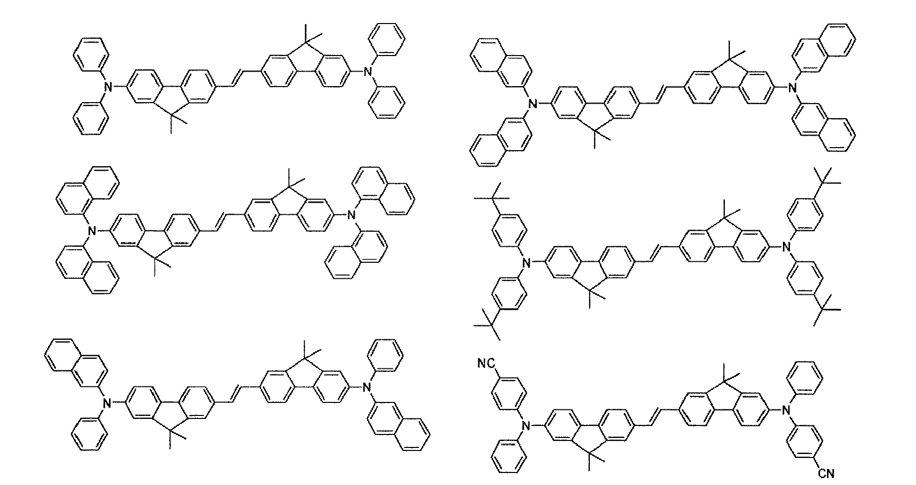

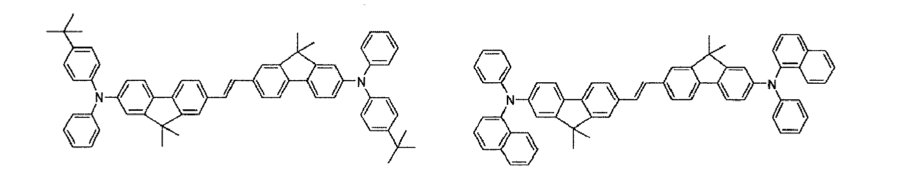

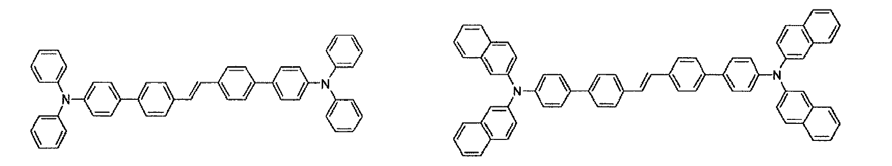

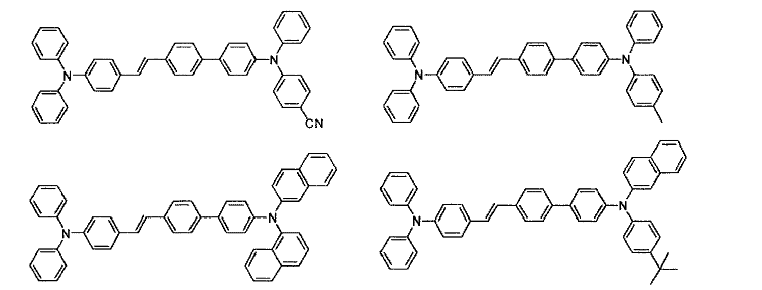

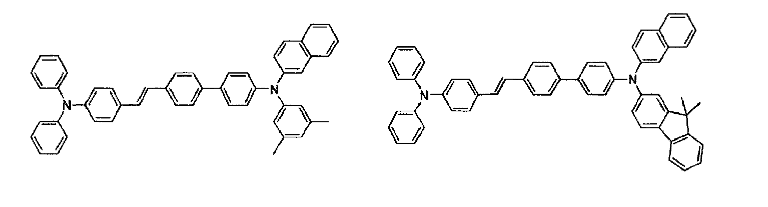

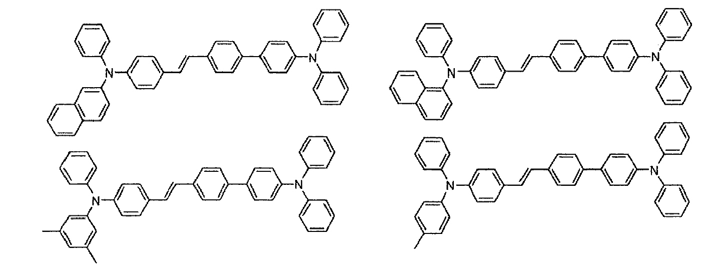

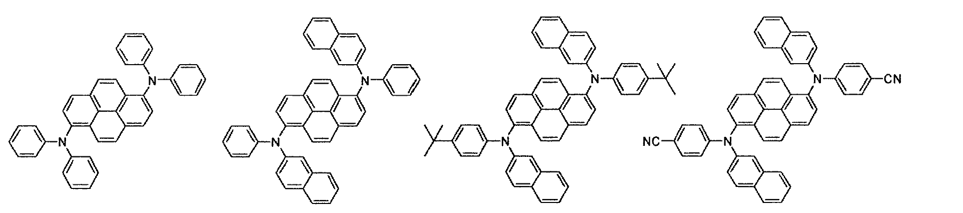

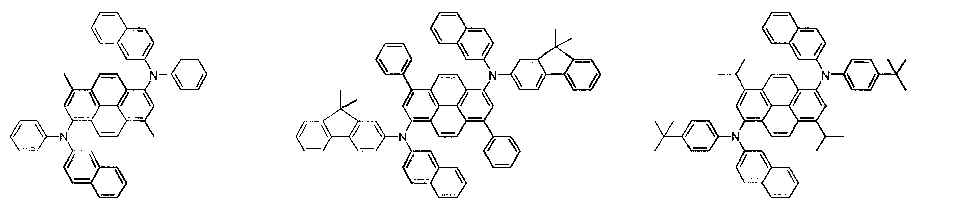

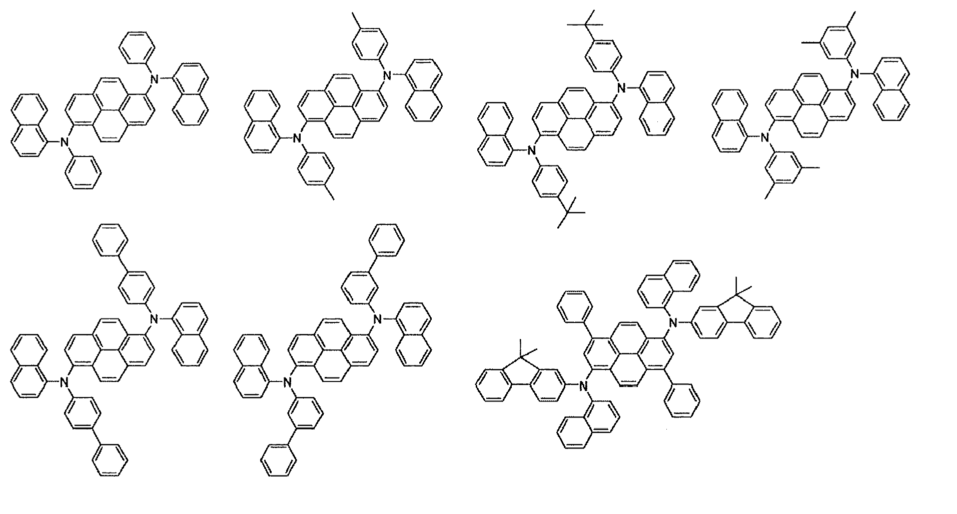

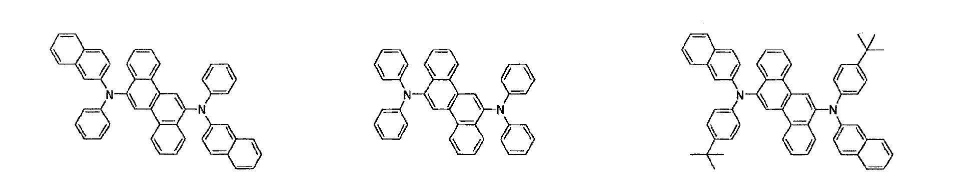

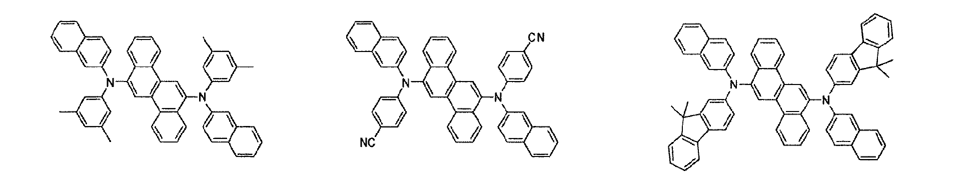

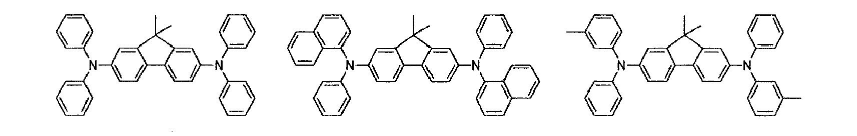

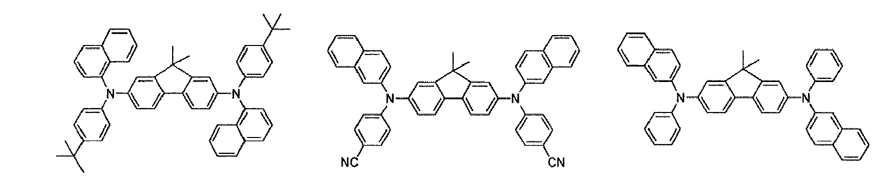

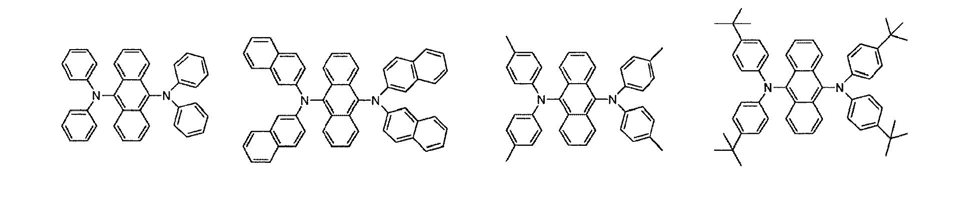

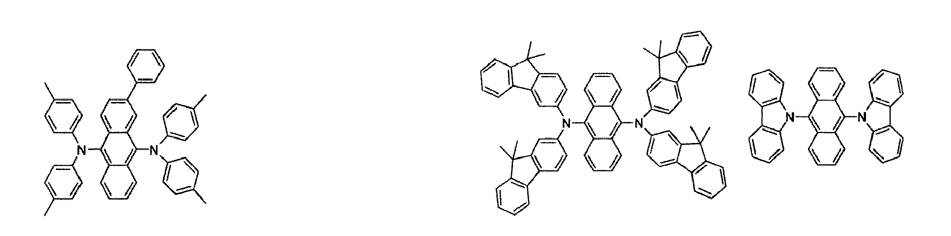

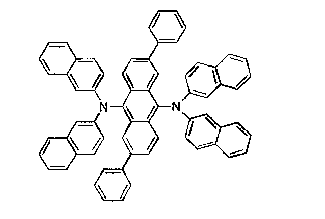

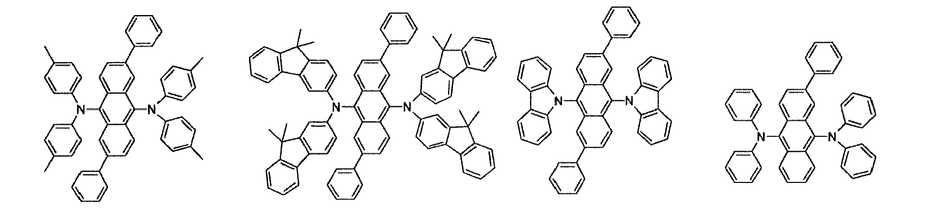

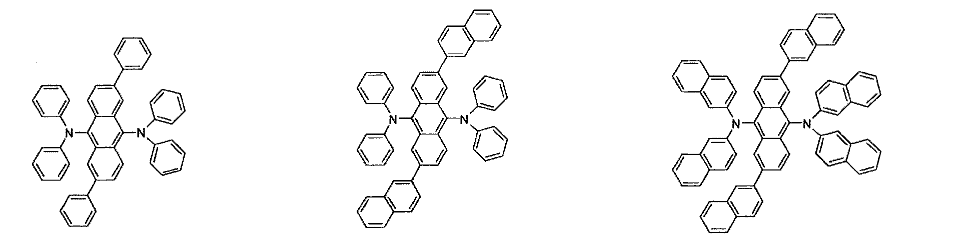

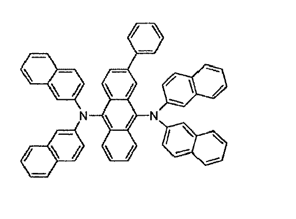

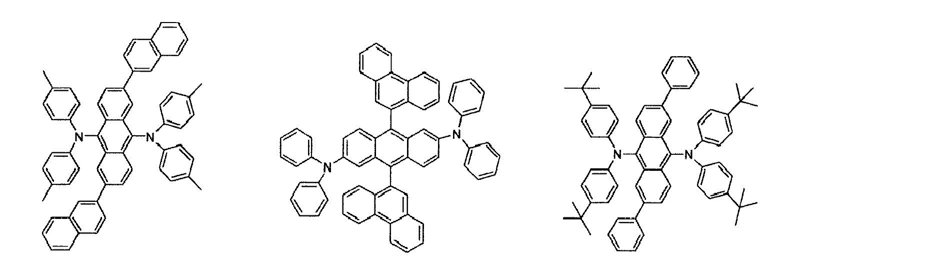

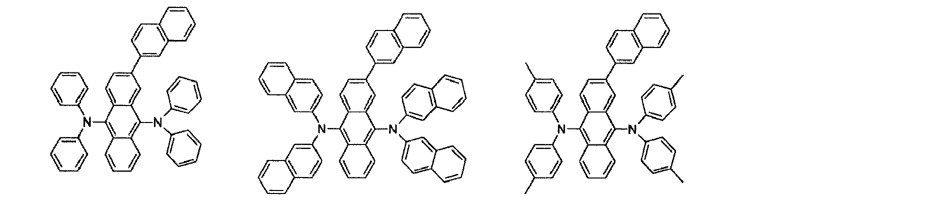

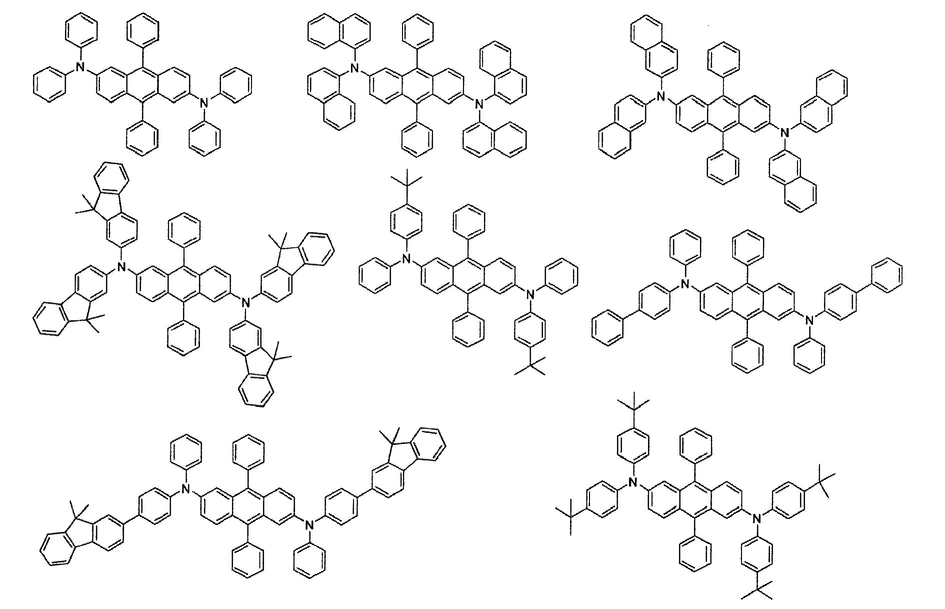

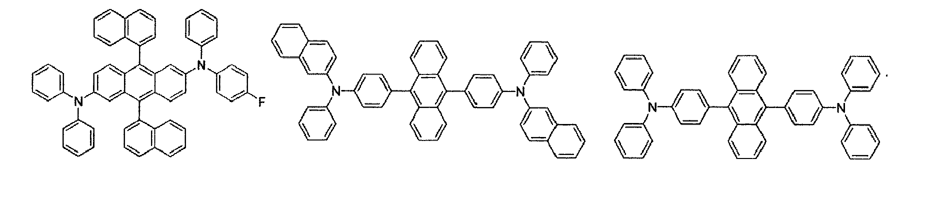

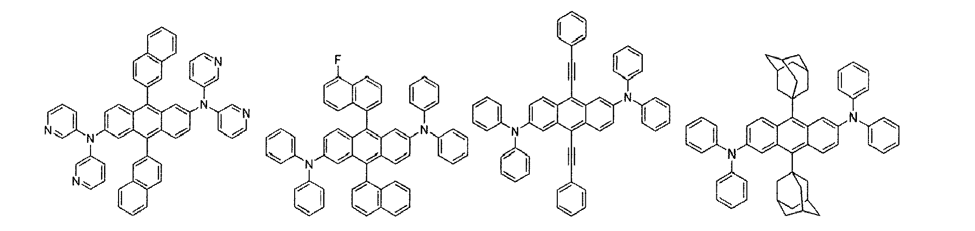

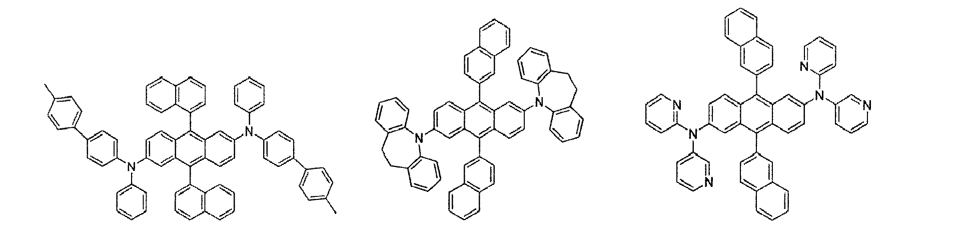

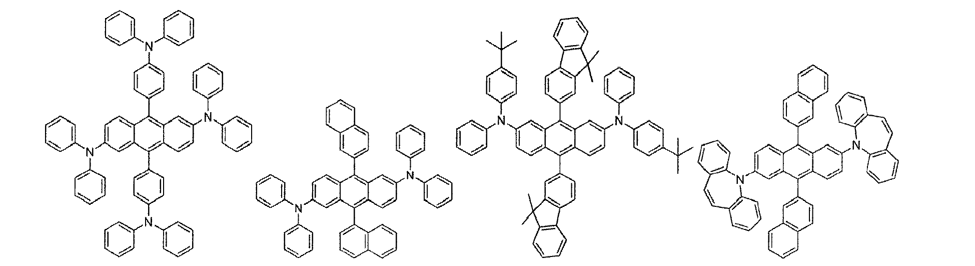

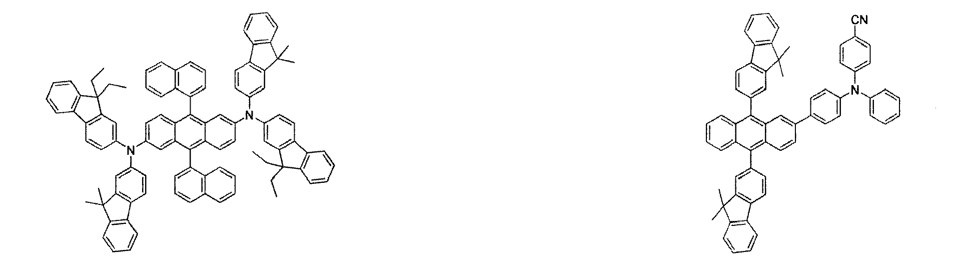

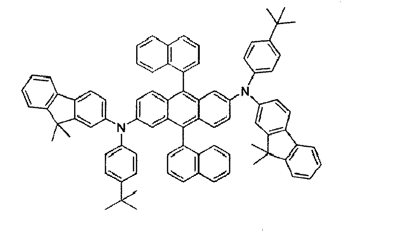

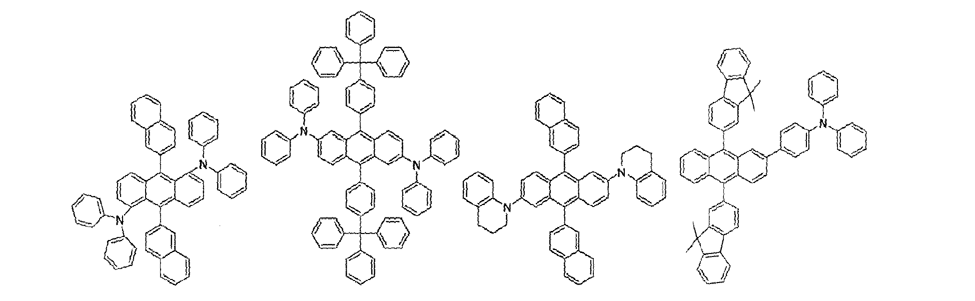

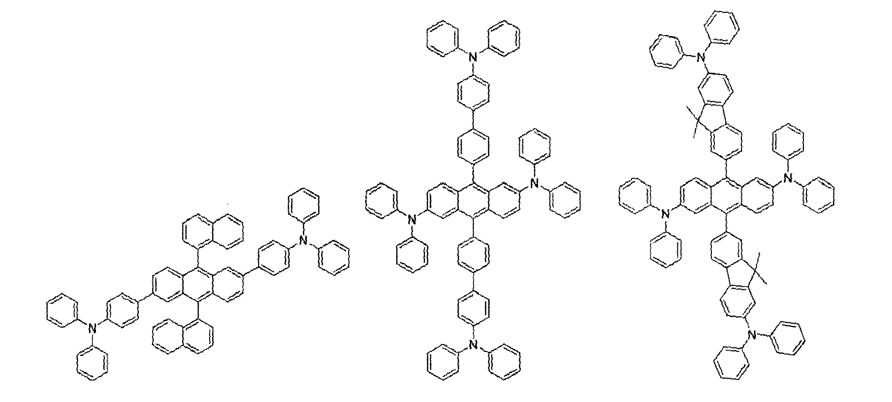

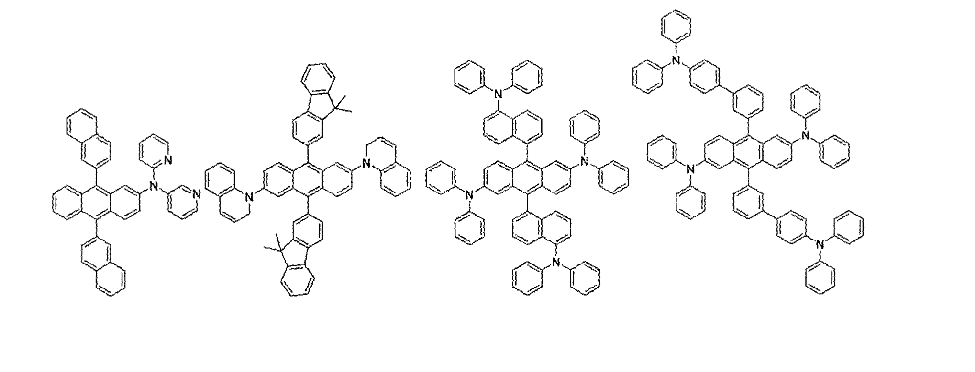

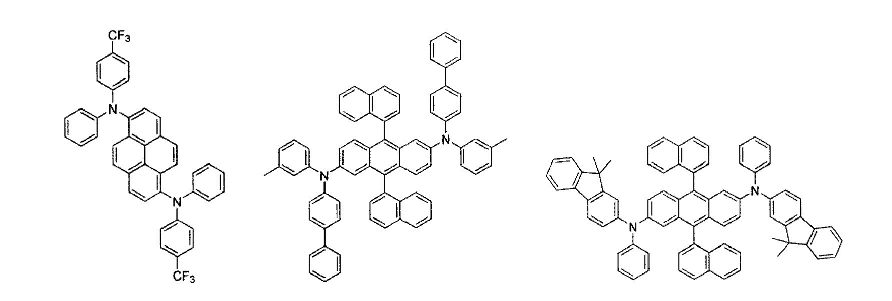

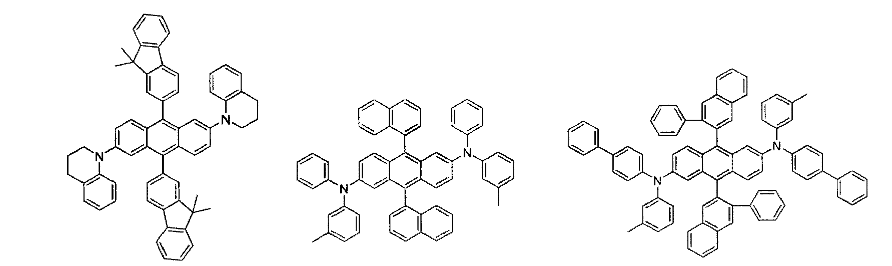

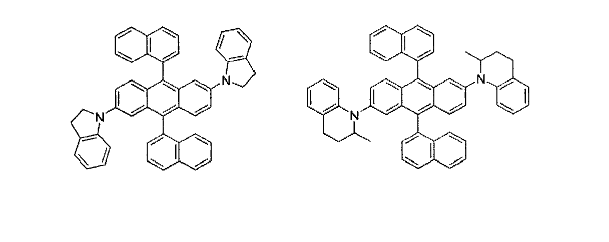

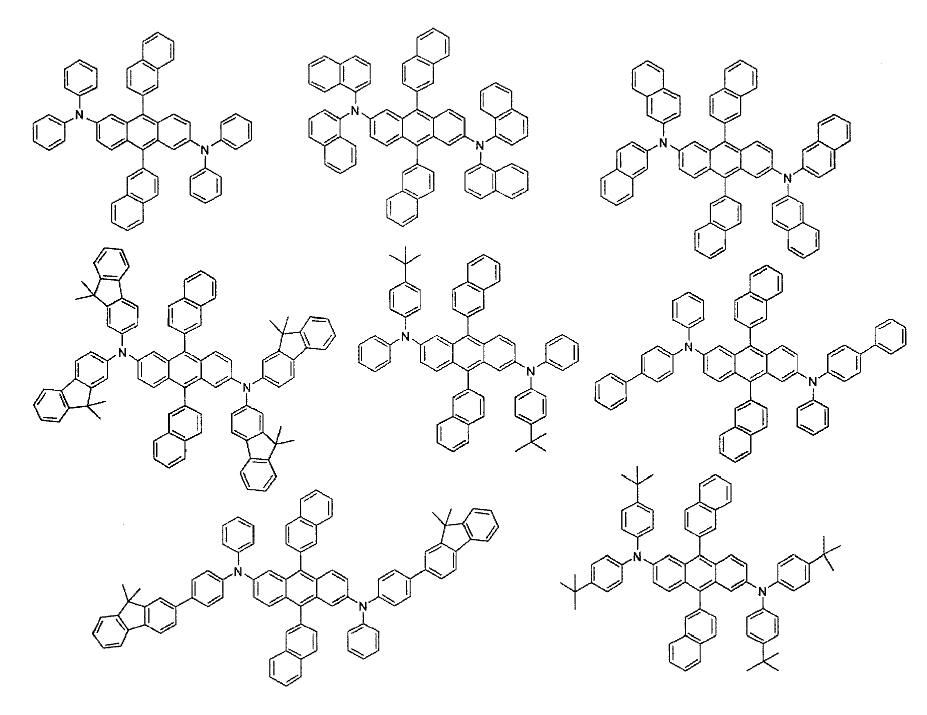

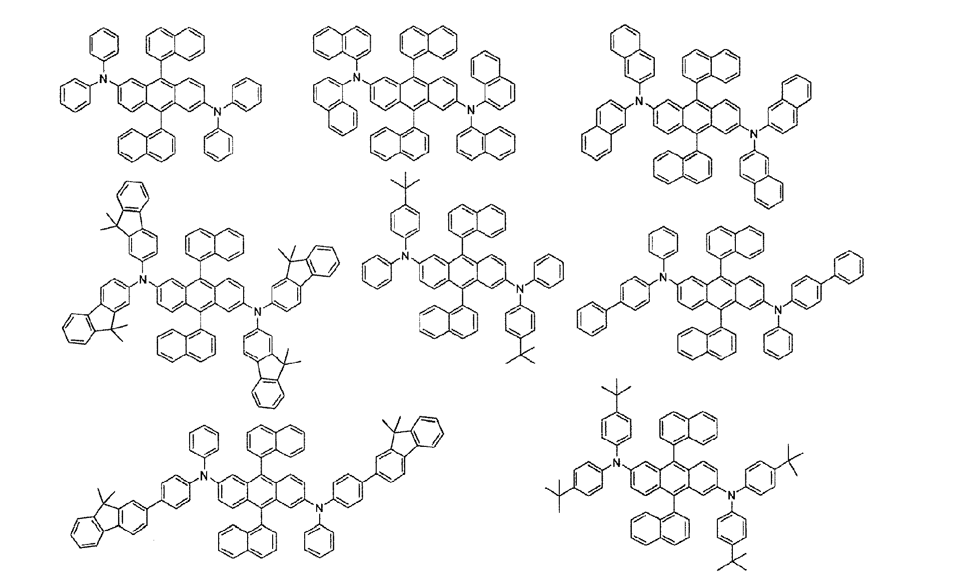

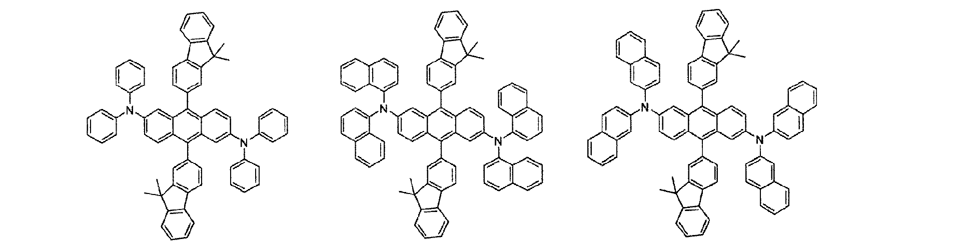

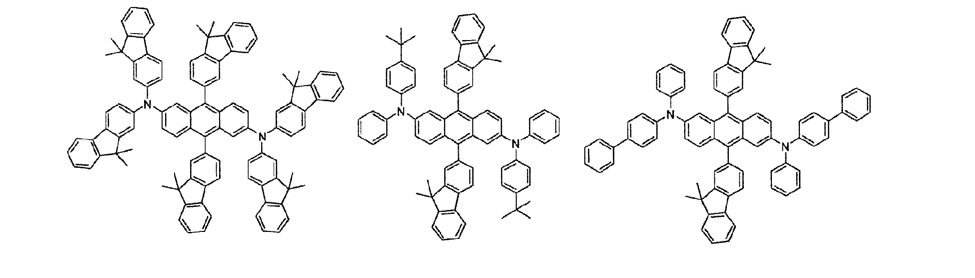

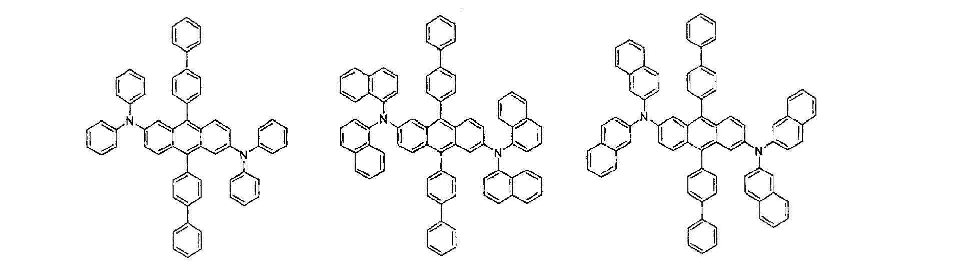

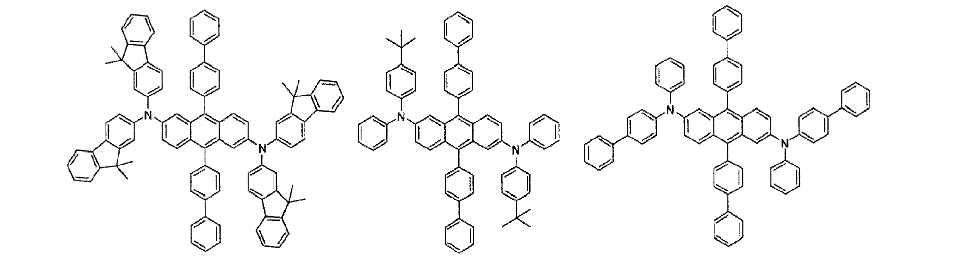

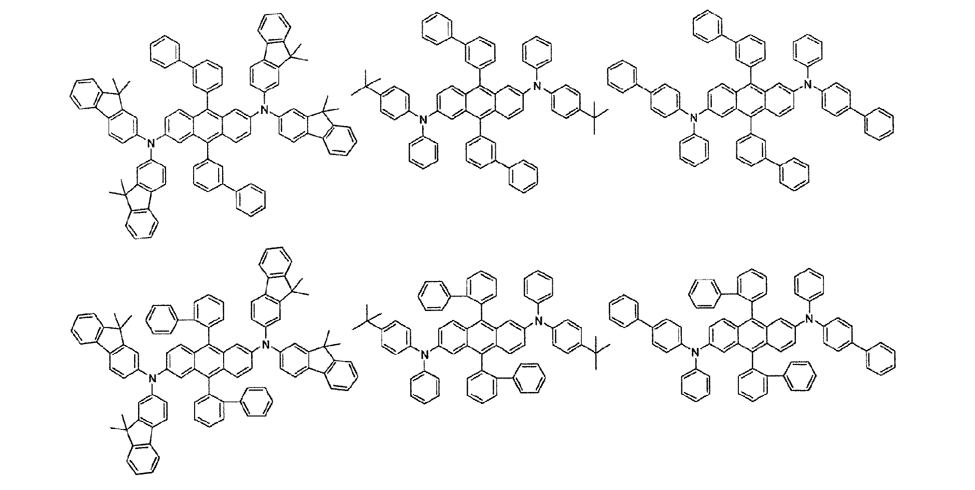

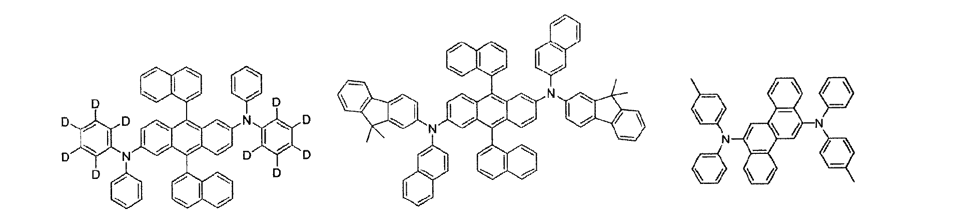

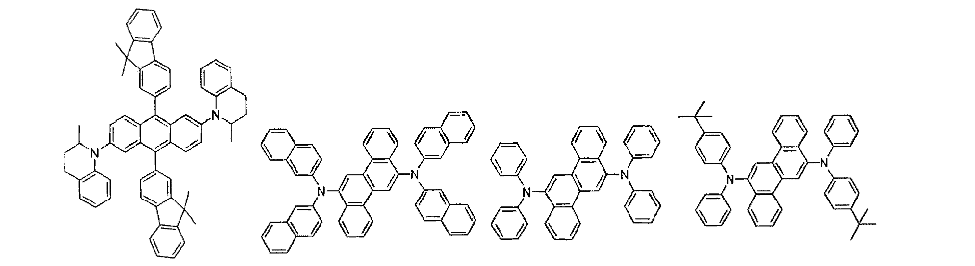

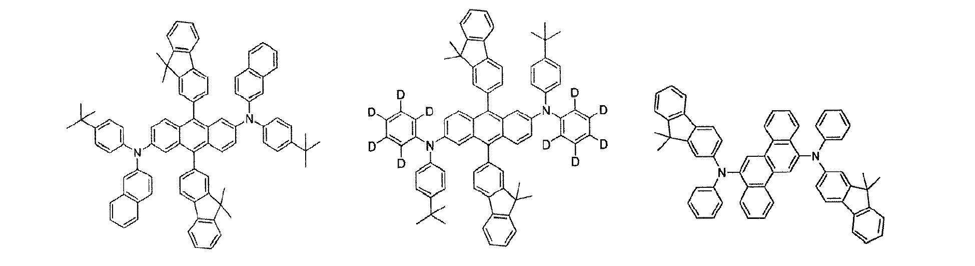

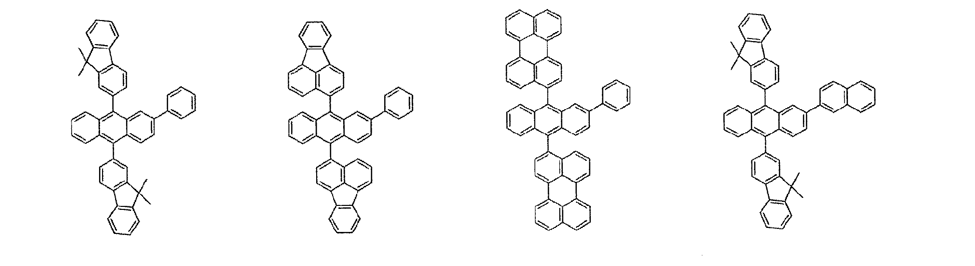

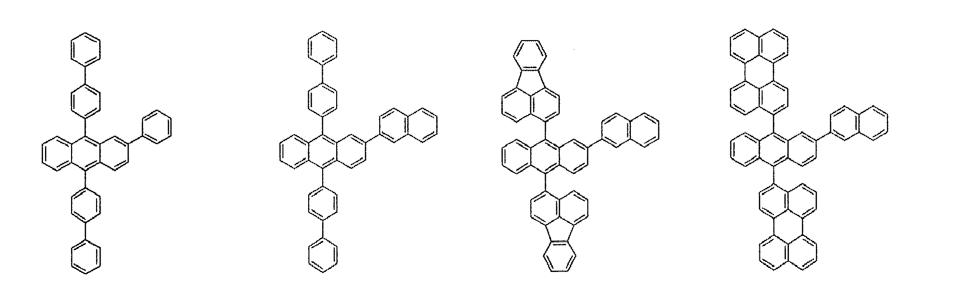

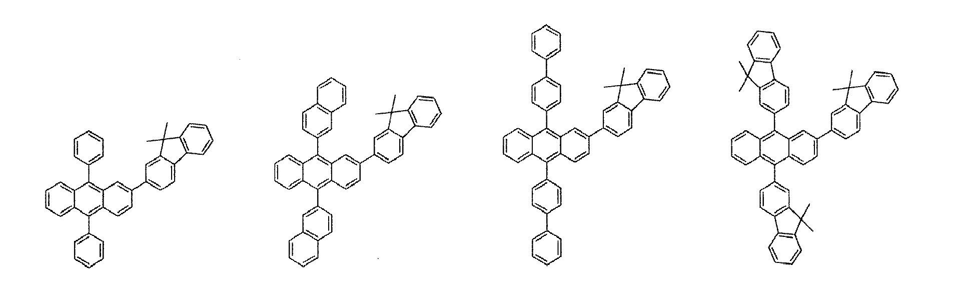

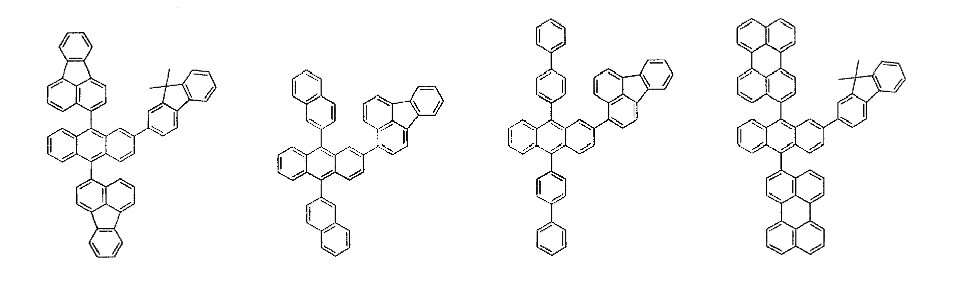

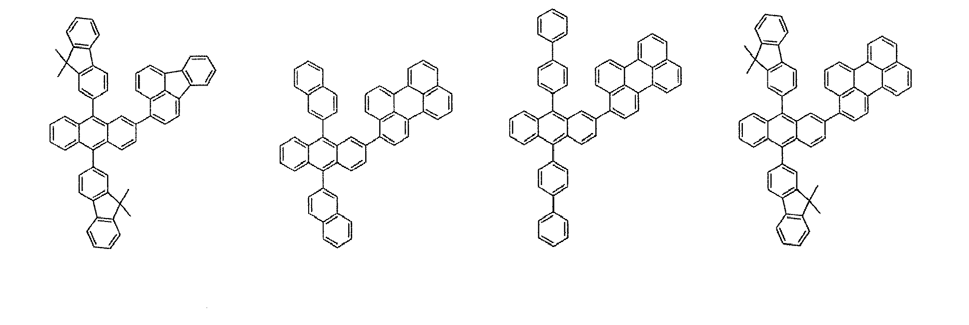

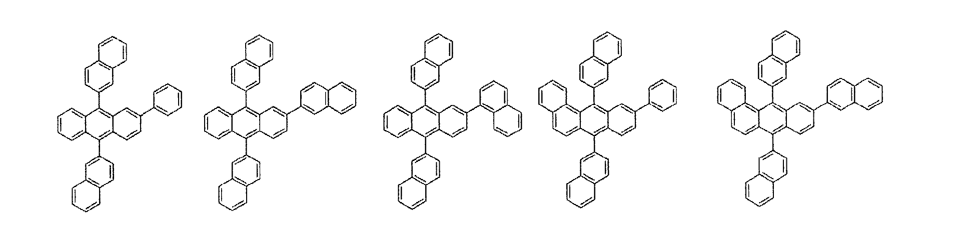

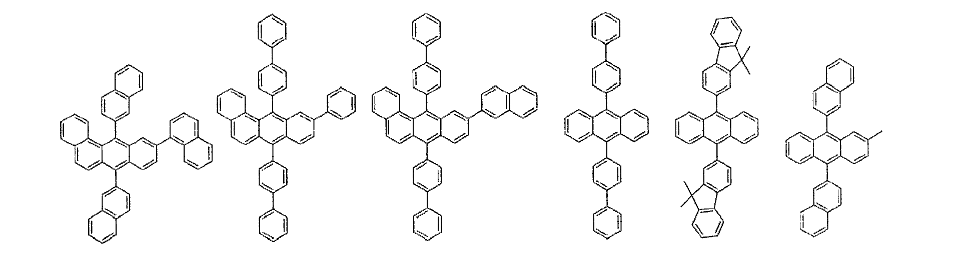

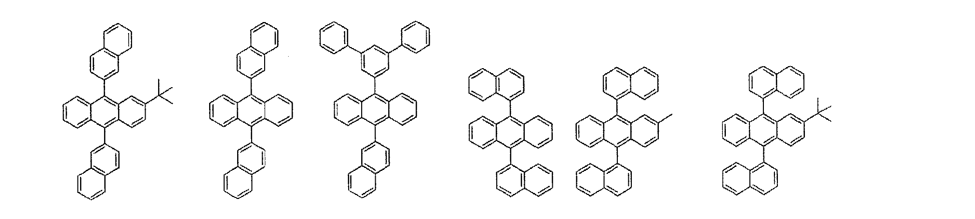

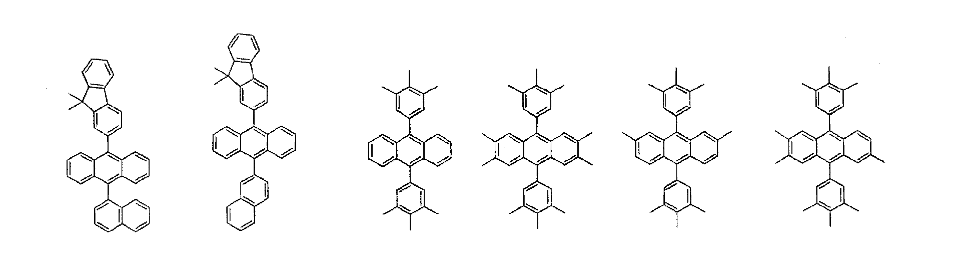

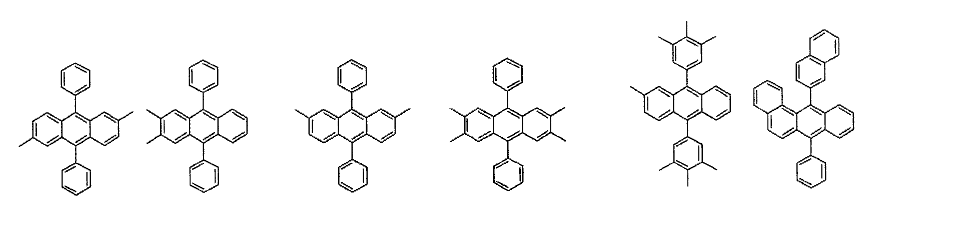

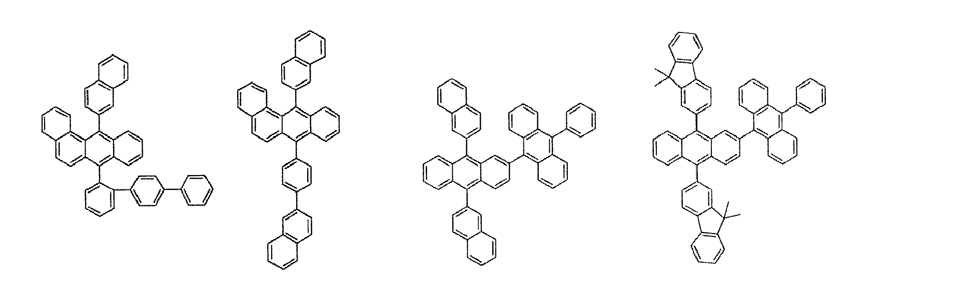

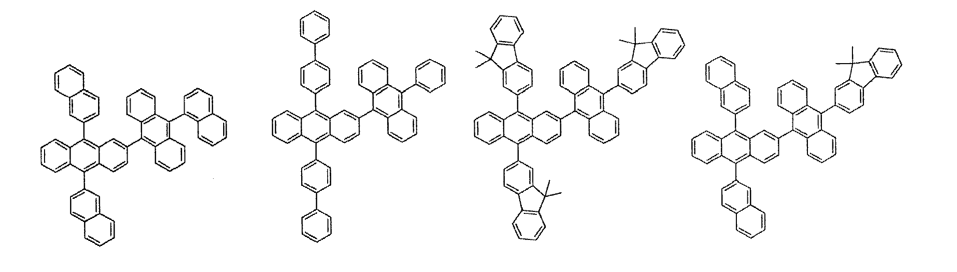

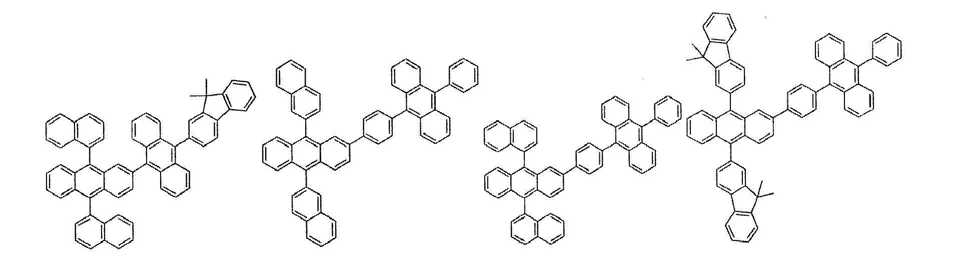

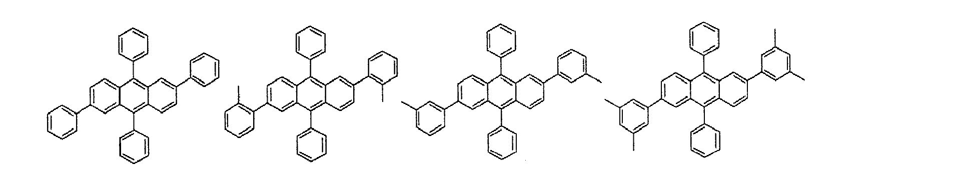

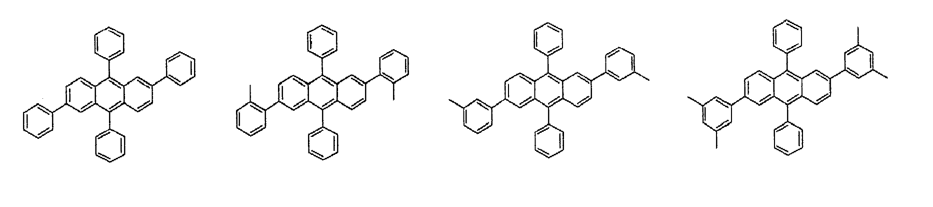

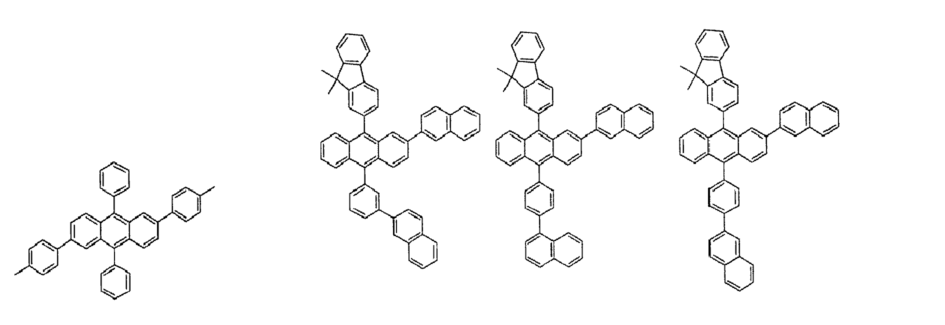

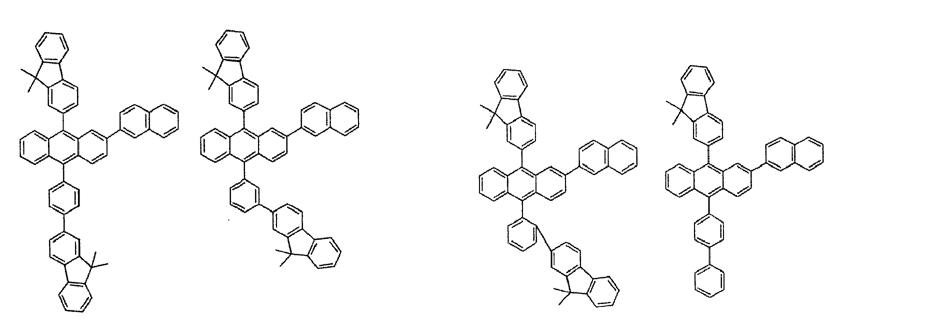

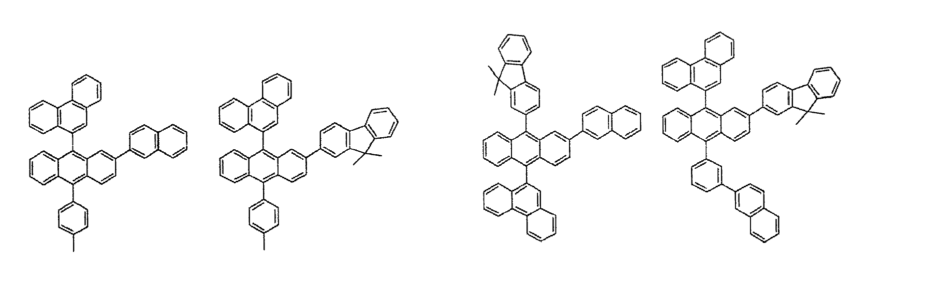

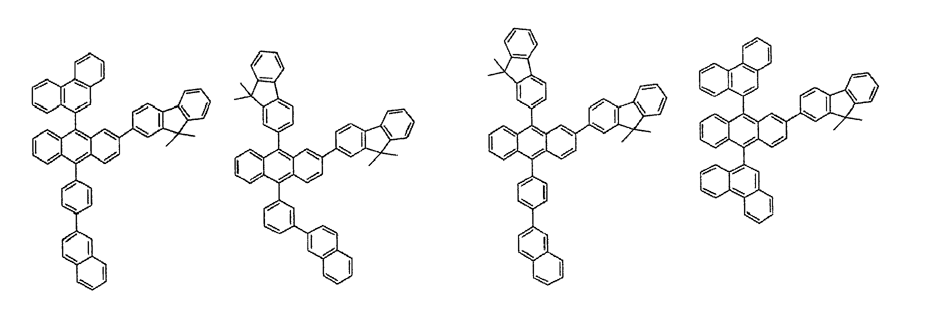

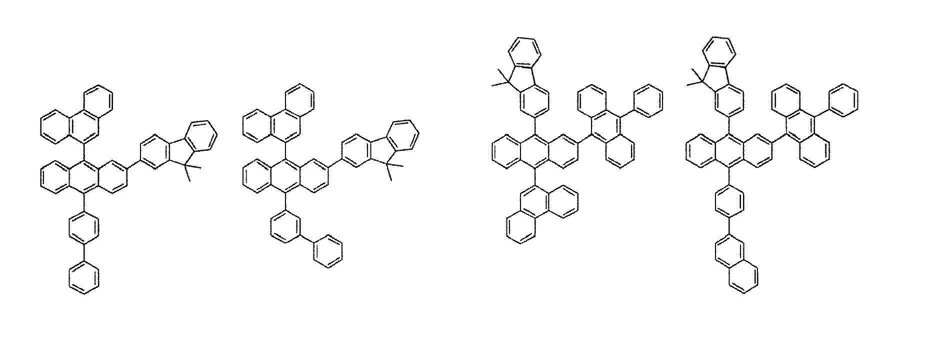

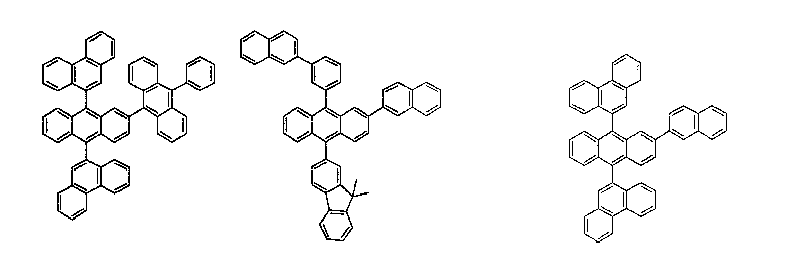

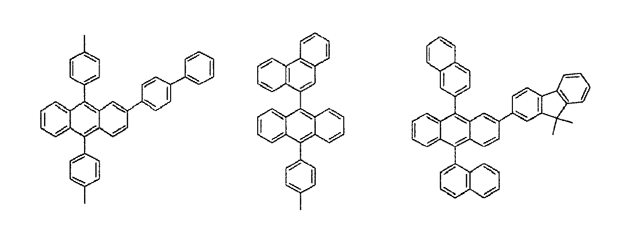

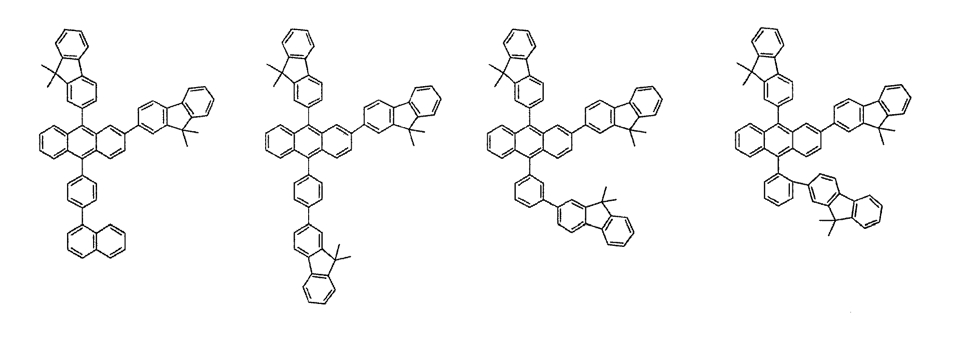

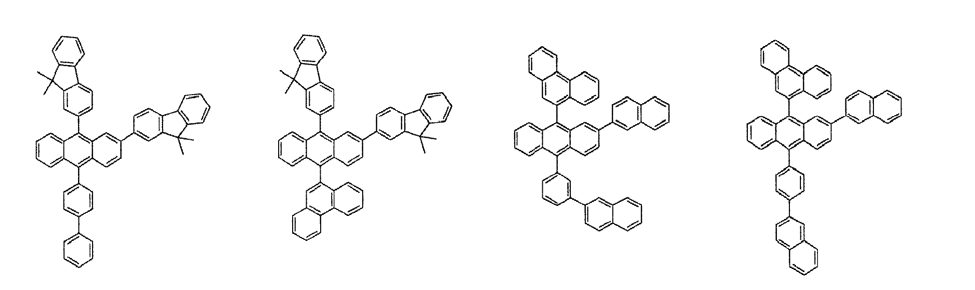

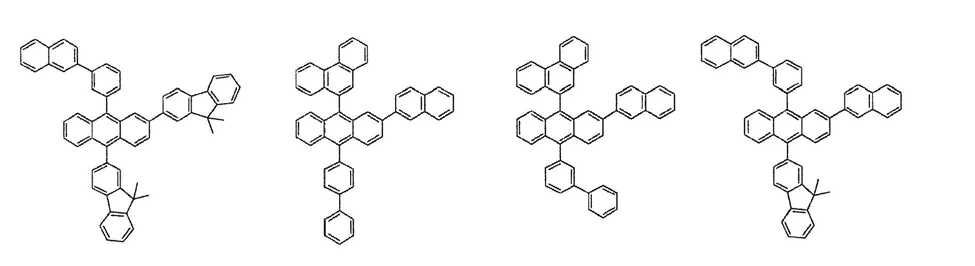

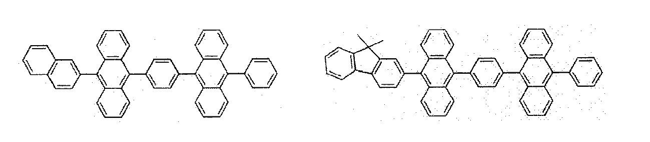

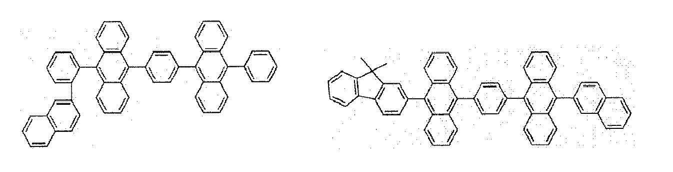

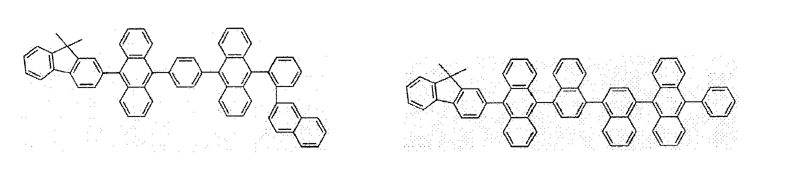

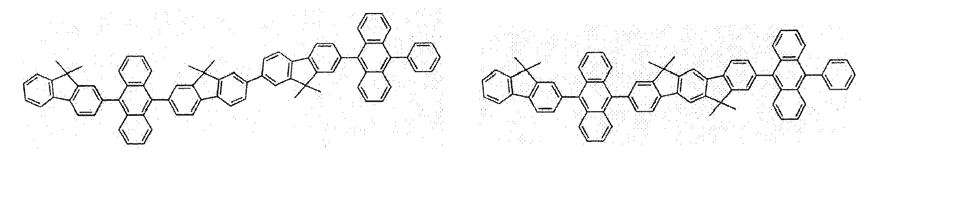

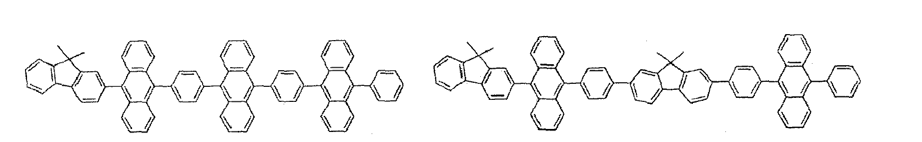

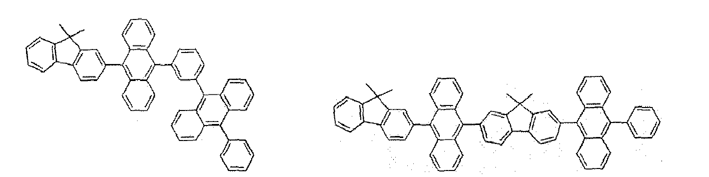

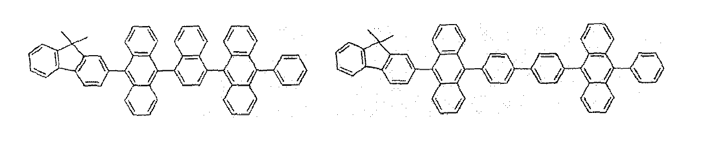

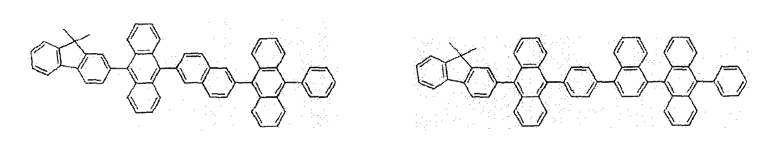

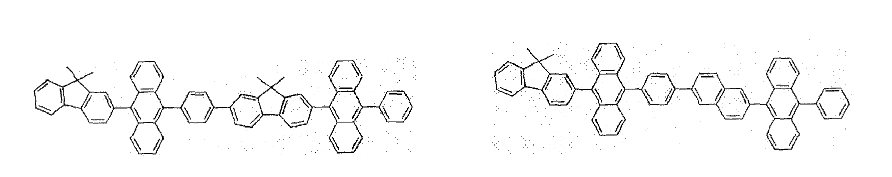

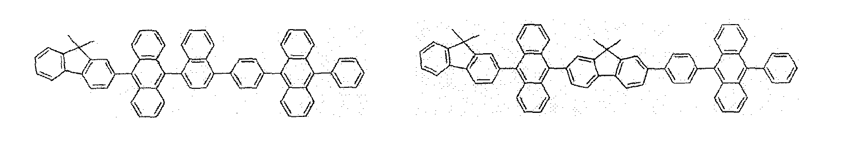

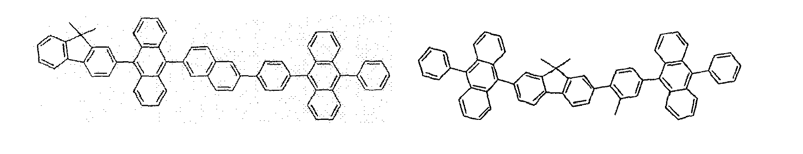

In an organic electroluminescent device according to the present invention, it is preferable to displace one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of lanthanides or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The organic electroluminescent compounds according to the invention, having a backbone of more excellent EL properties and thermal stability than conventional phosphorescent materials, provide higher quantum efficiency and lower operation voltage as compared to conventional materials. Thus, if an organic electroluminescent compound according to the present invention is applied to an OLED panel, further enhanced results are anticipated in development of OLED's having medium to large size. If the compound is applied to an organic solar cell as a material of high efficiency, more excellent properties are anticipated as compared to conventional materials.

### Best Mode

The present invention is further described with respect to the processes for preparing the novel organic electroluminescent compounds according to the present invention, which are provided for better understanding of the present invention only but are not intended to limit the scope of the invention by any means.

### Preparation Examples

### [Preparation Example 1] Preparation of Compound (994)

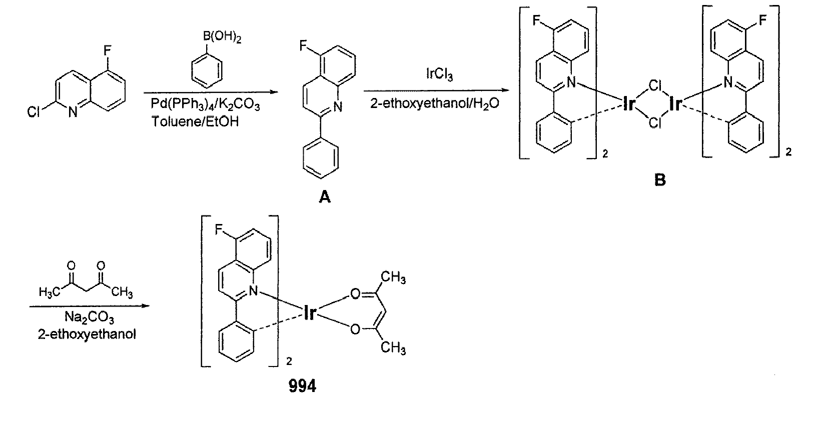

### Preparation of Compound (A)

2-Chloro-5-fluoroquinoline (0.7 g, 3.6 mmol), phenylboronic acid (0.5 g, 4.4 mmol) and tetrakis(triphenylphosphine)palladium(0) [Pd(PPh₃)₄] (0.2 g, 0.1 mmol) were dissolved in toluene (25 mL) and ethanol (10 mL). After adding aqueous 2 M sodium carbonate solution (10 mL), the resultant mixture was stirred at 120°C under reflux for 4 hours. Then, the mixture was cooled to 25°C, and distilled water (200 mL) was added to terminate the reaction. The resultant mixture was extracted with ethyl acetate (300 mL), and the extract was dried under reduced pressure. Purification via silica gel column chromatography gave Compound (A) (0.7 g, 3.2 mmol).

### Preparation of Compound (B)

Compound (A) (0.7 g, 3.2 mmol) and iridium chloride (IrCl₃) (1.0 g, 1.6 mmol) were added to 2-ethoxyethanol (20 mL) and distilled water (7 mL), and the solution was heated under reflux in the presence of argon gas atmosphere for 24 hours. When the reaction was completed, the reaction mixture was cooled to room temperature. The precipitate was filtered and completely dried to obtain Compound (B) (0.7 g, 0.5 mmol).

### Preparation of Compound (994)

Compound (B) (0.7 g, 0.5 mmol), 2,4-pentanedione (0.1 mL, 1.1 mmol) and sodium carbonate (0.6 g, 5.4 mmol) were dissolved in 2-ethoxyethanol (40 mL), and the resultant mixture was heated for 4 hours. When the reaction was completed, the reaction mixture was cooled to room temperature. The solid precipitate was filtered. Purification via silica gel column chromatography and recrystallization gave Compound (994) (0.4 g, 0.5 mmol, overall yield: 34.2%) as red crystal.

According to the same procedure as Preparation Example 1, organic electroluminescent compounds (Compound 1 through Compound 1198) in Table 1 were prepared, of which the ¹H NMR and MS/FAB data are listed in Table 2.

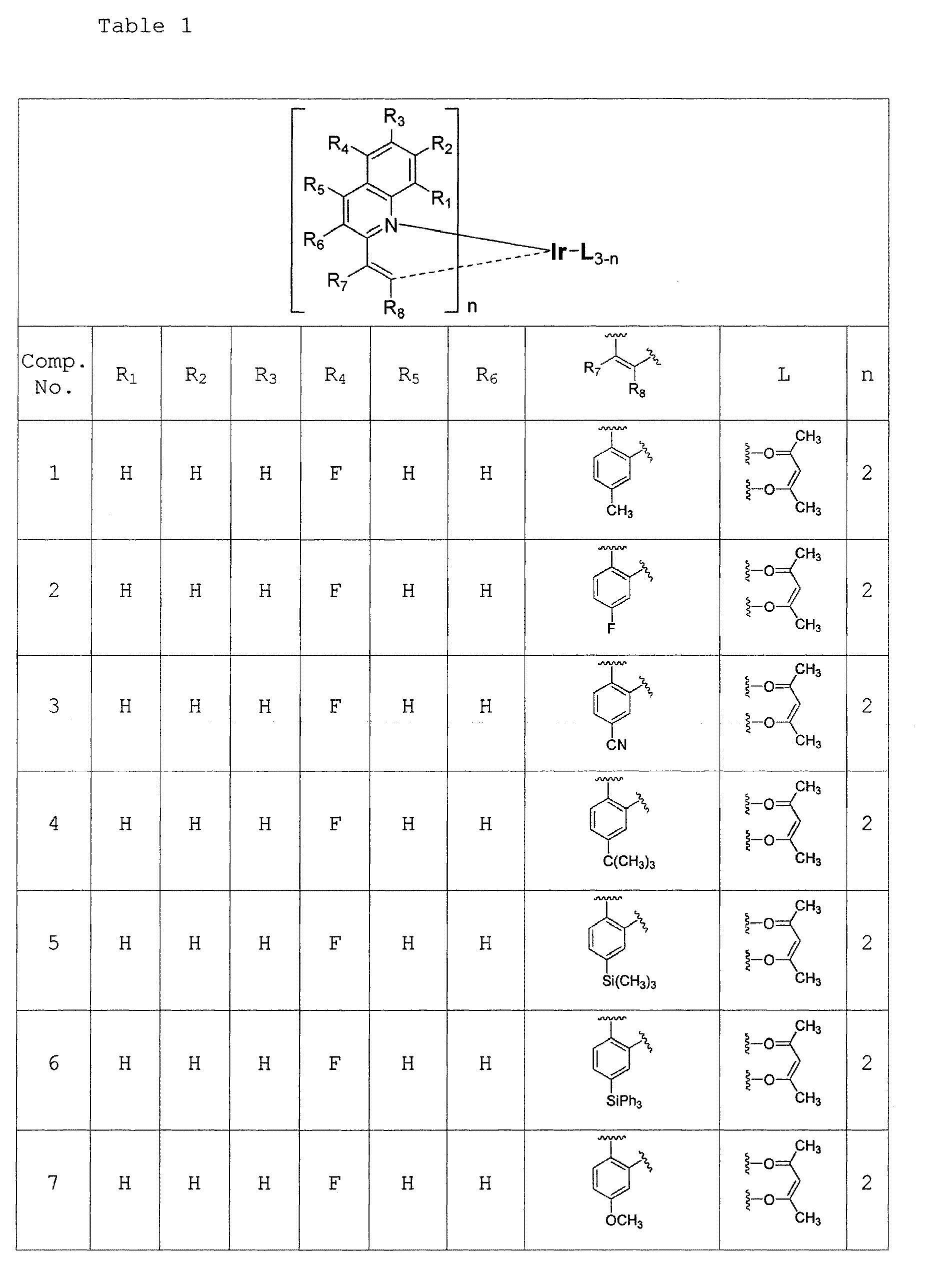

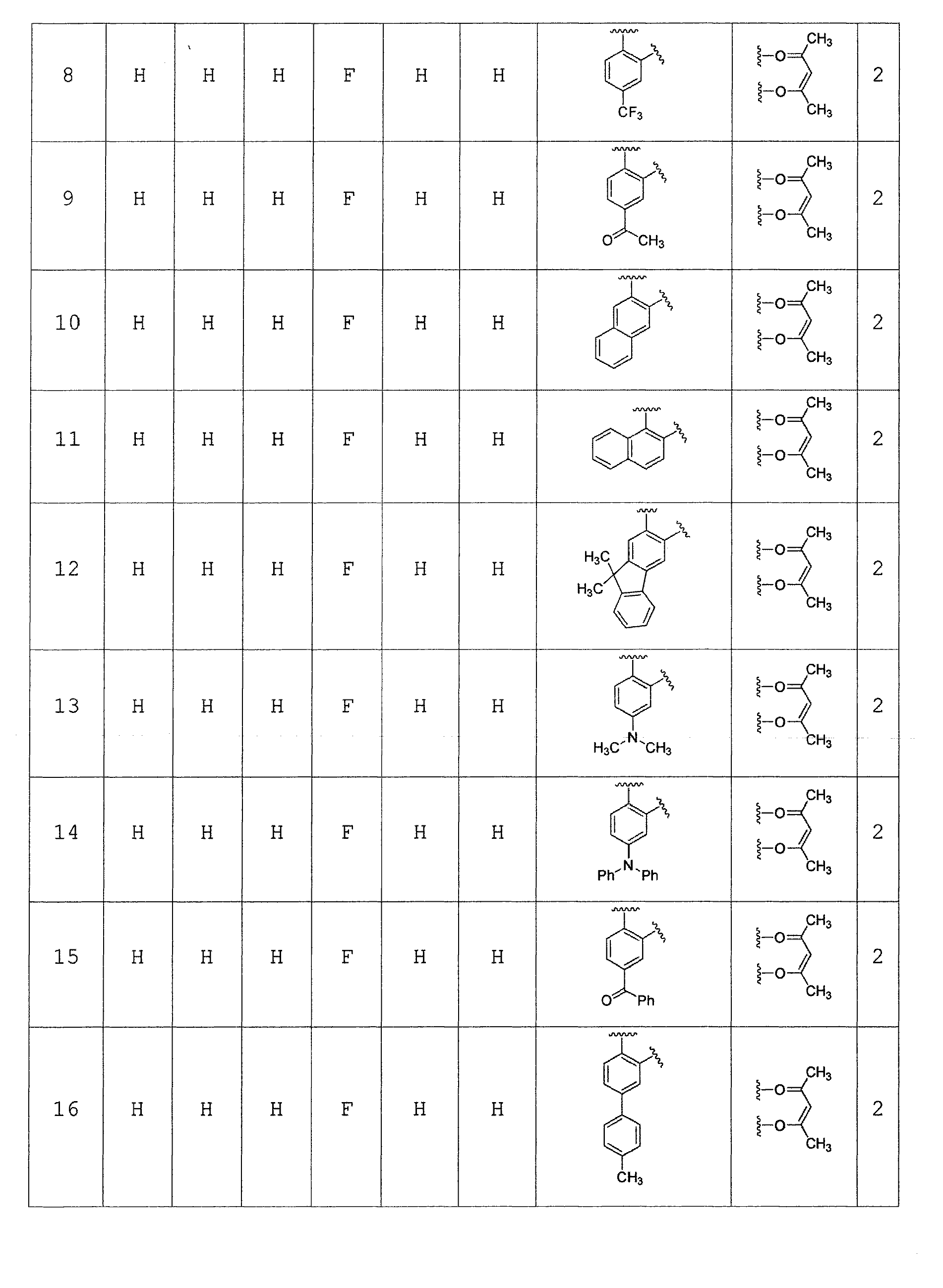

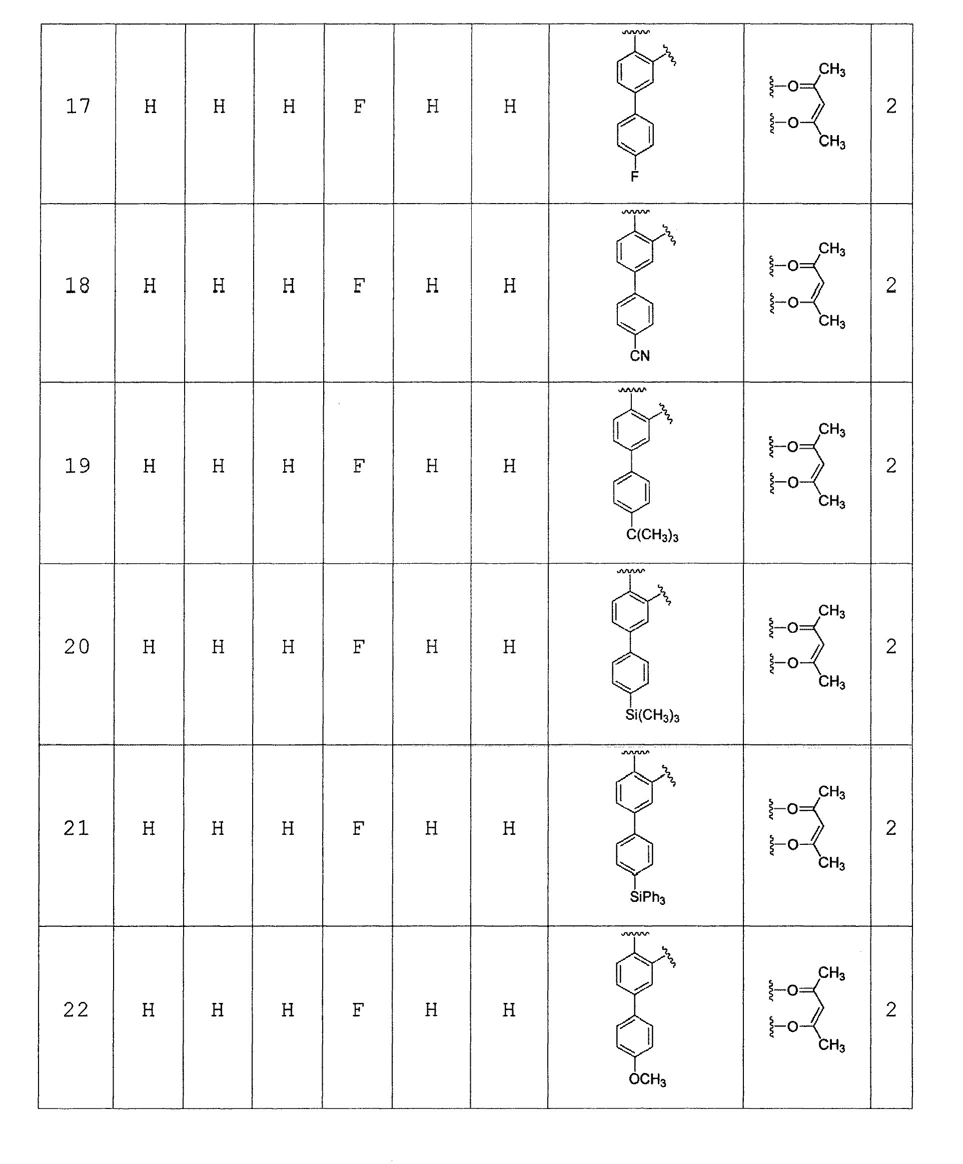

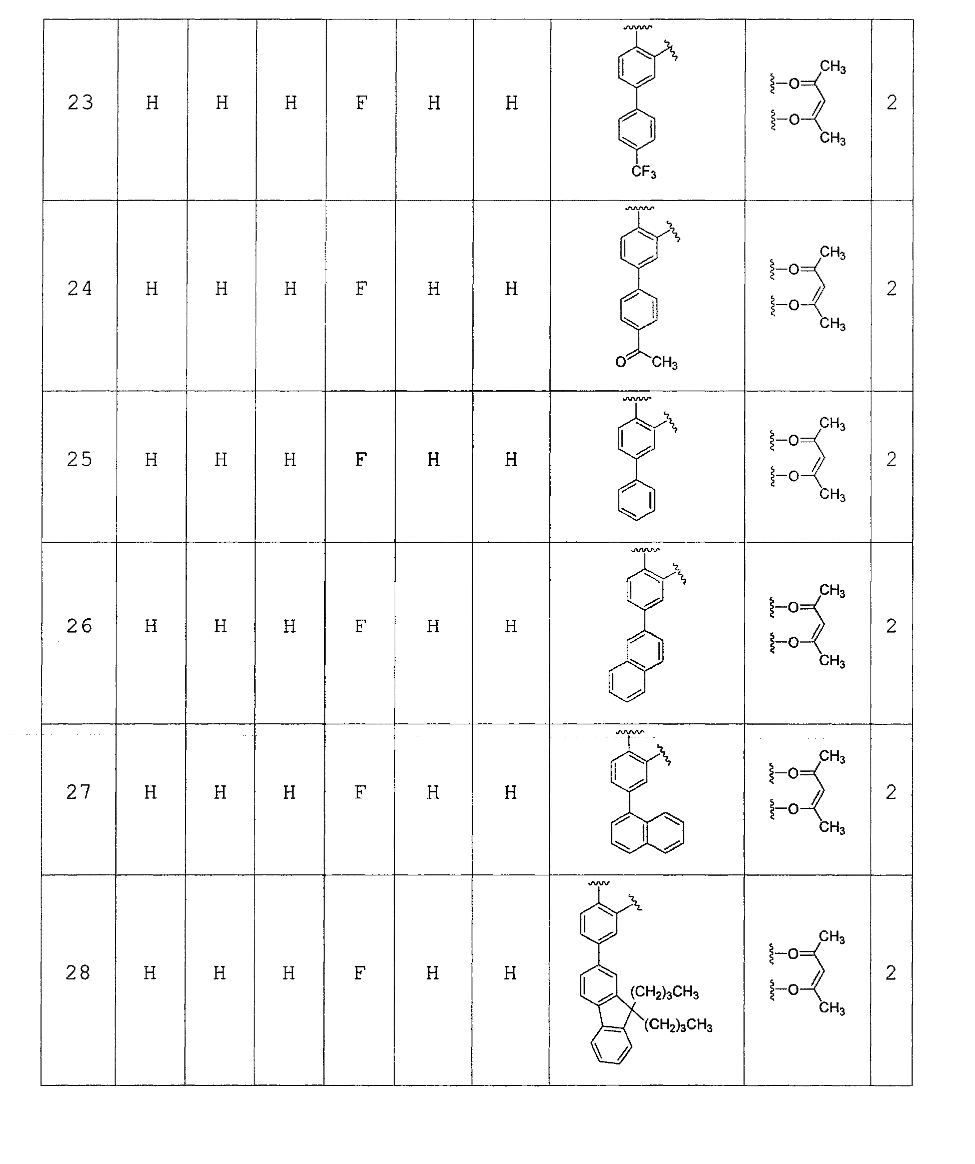

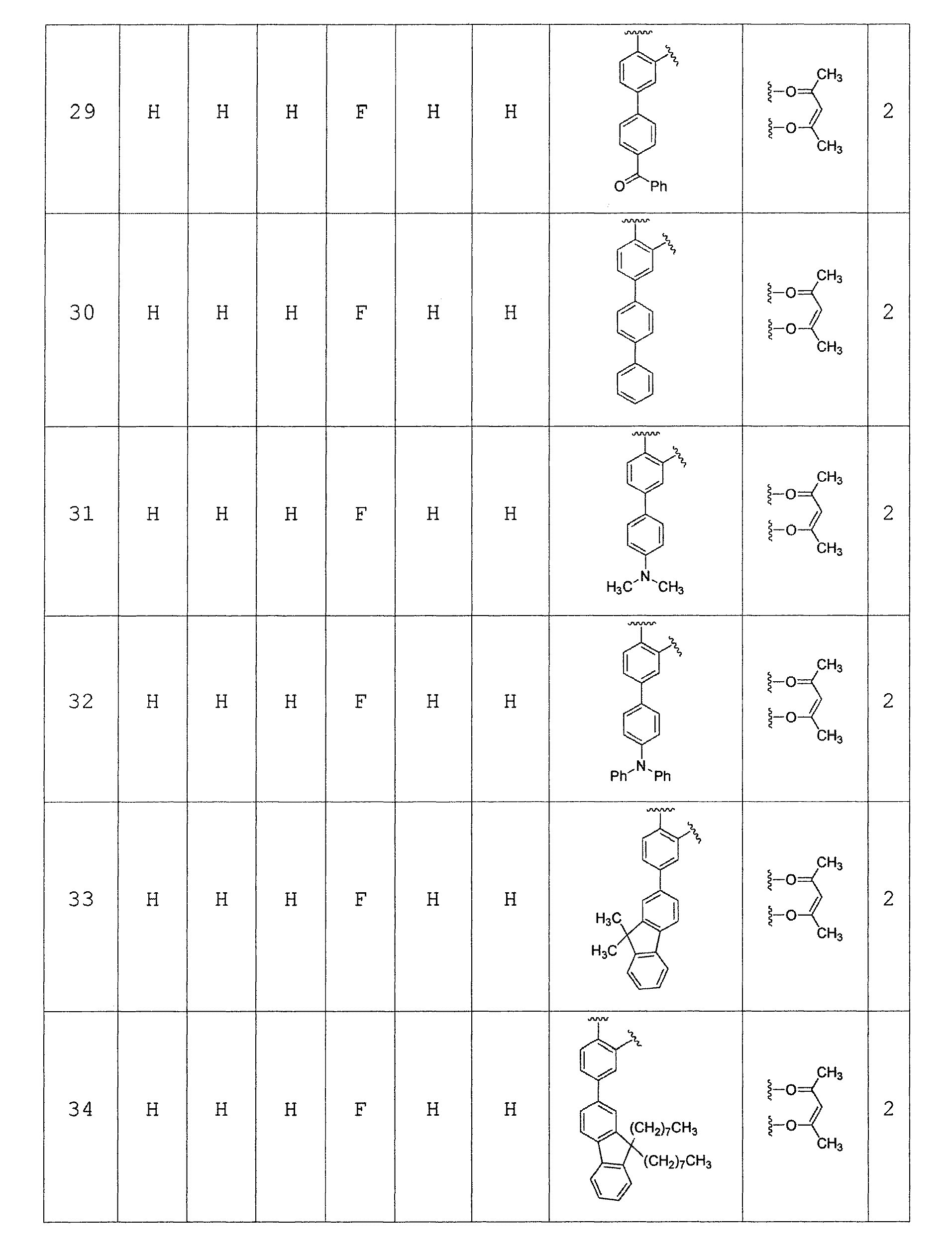

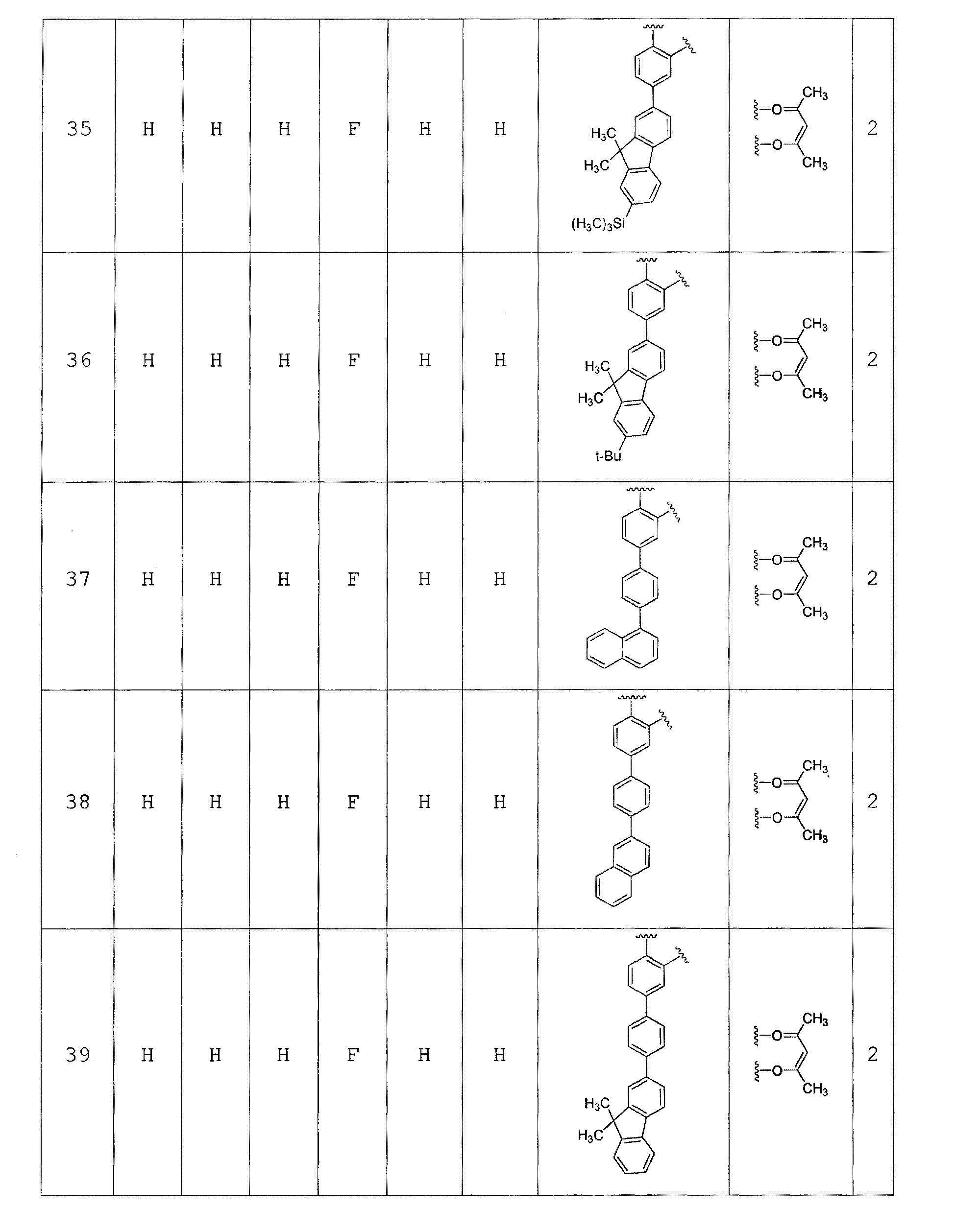

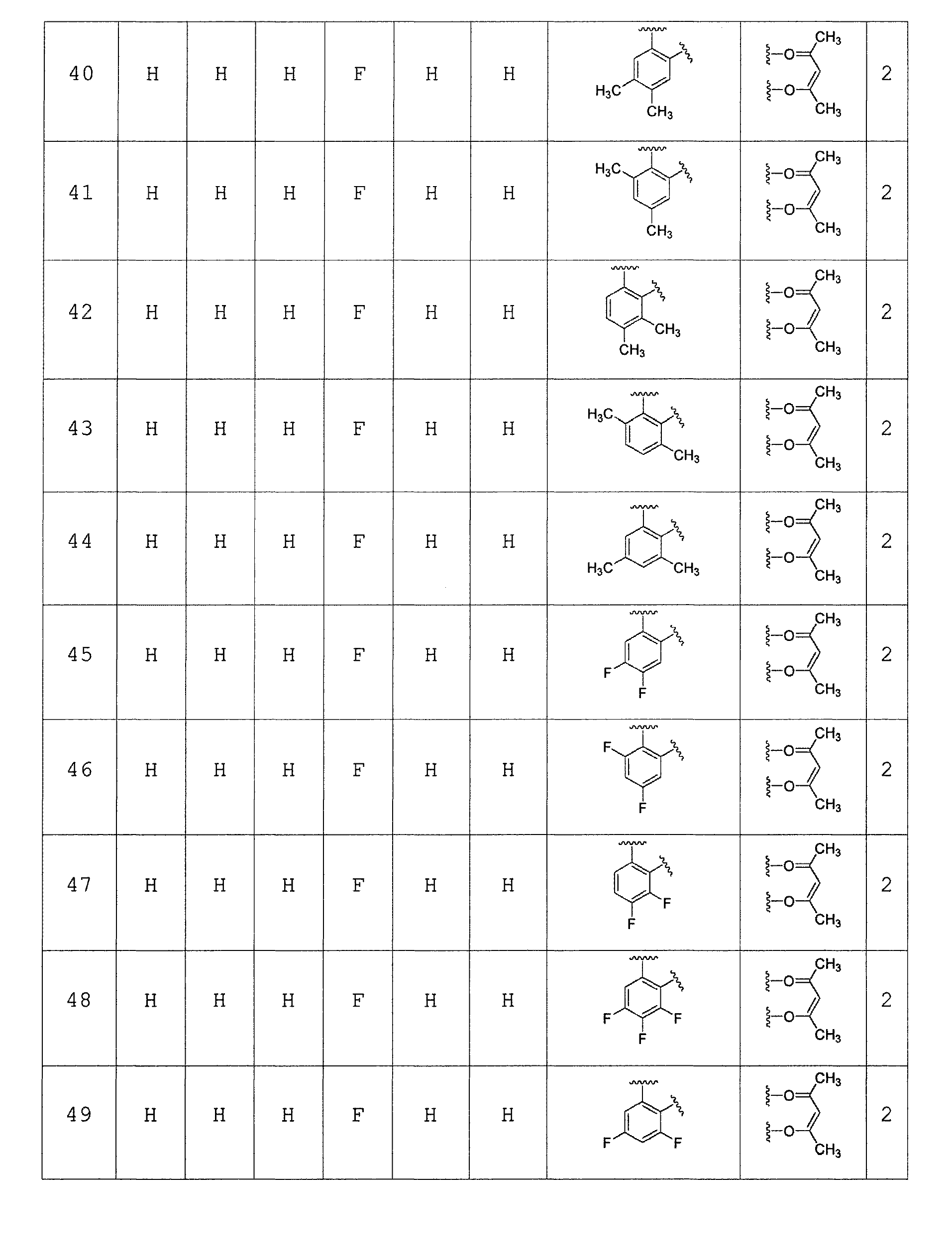

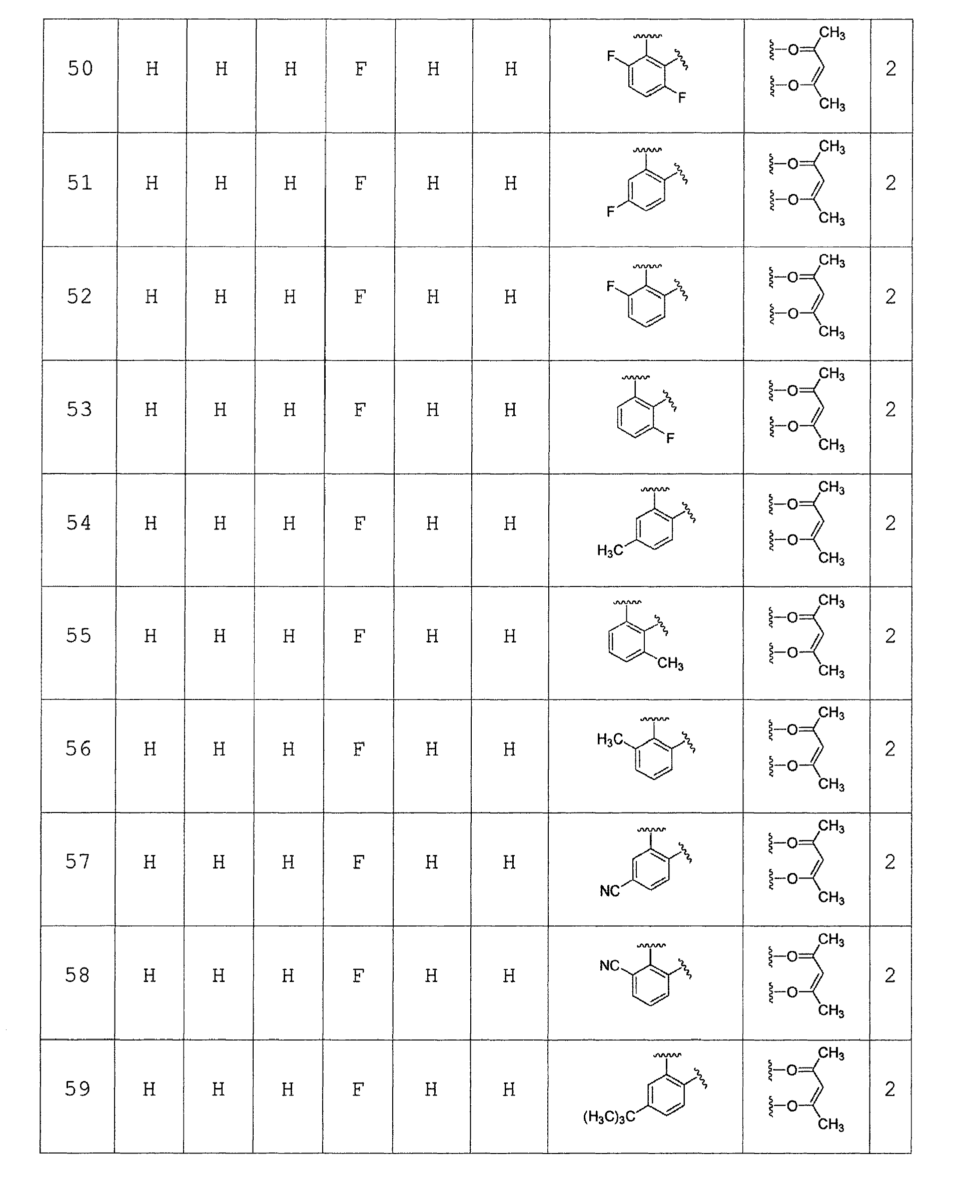

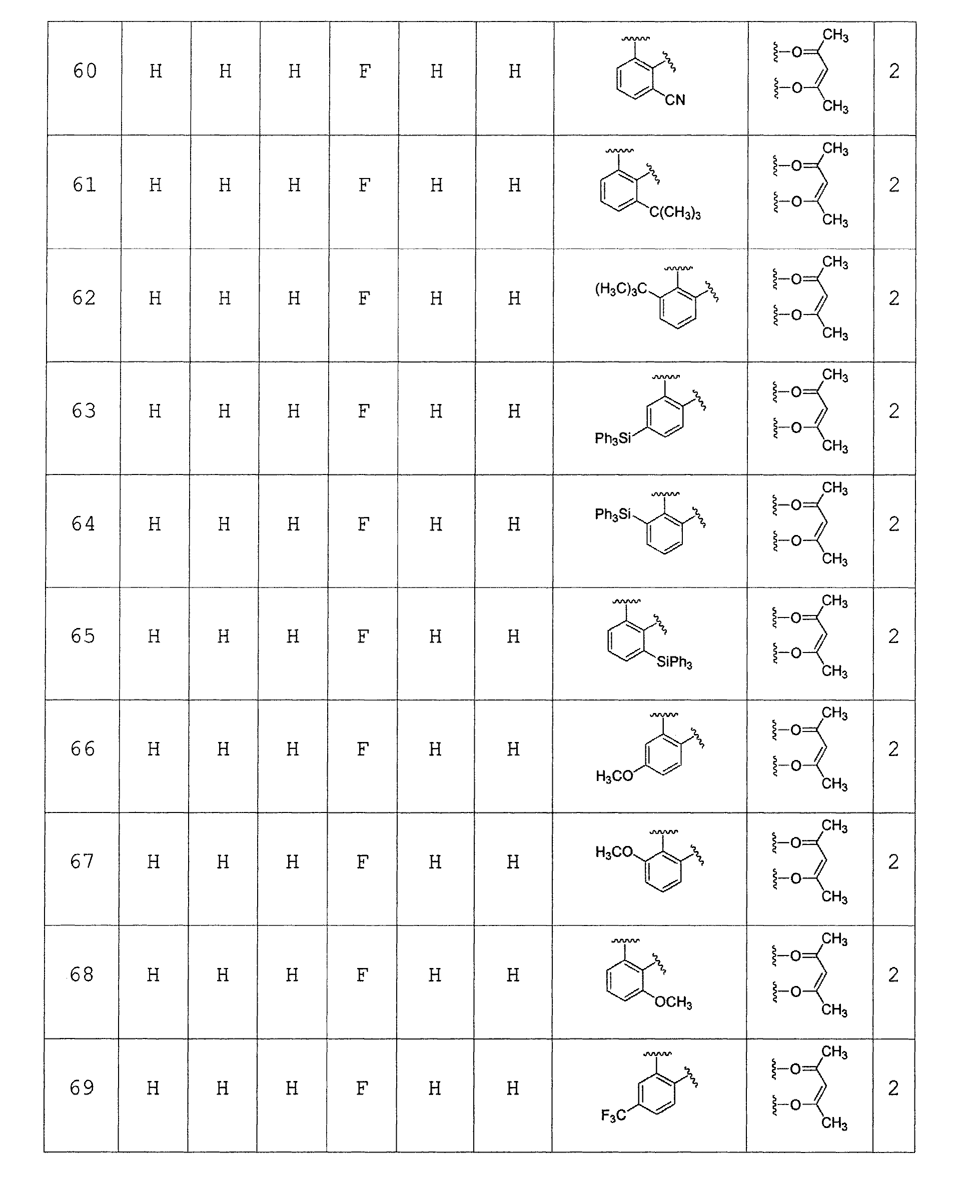

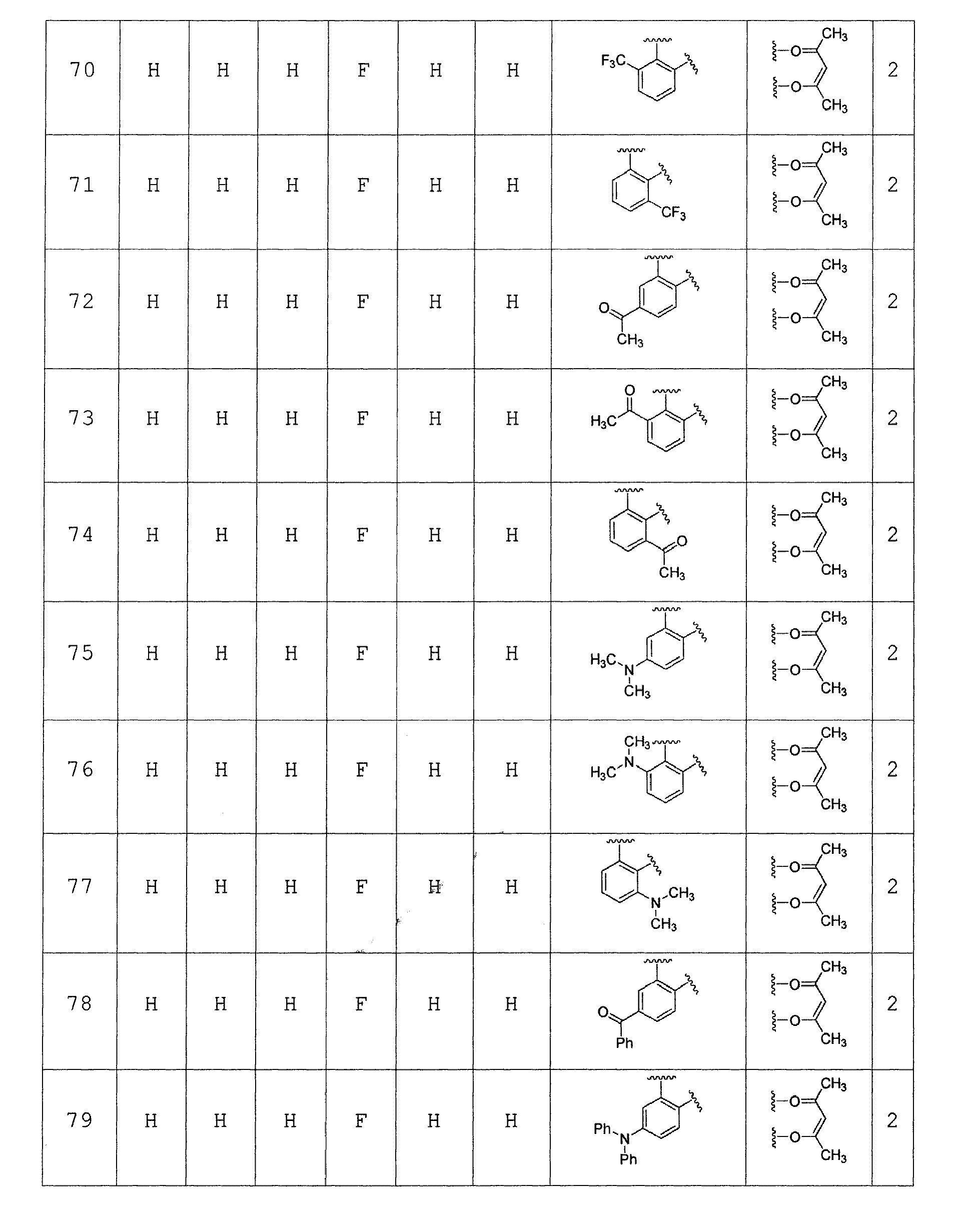

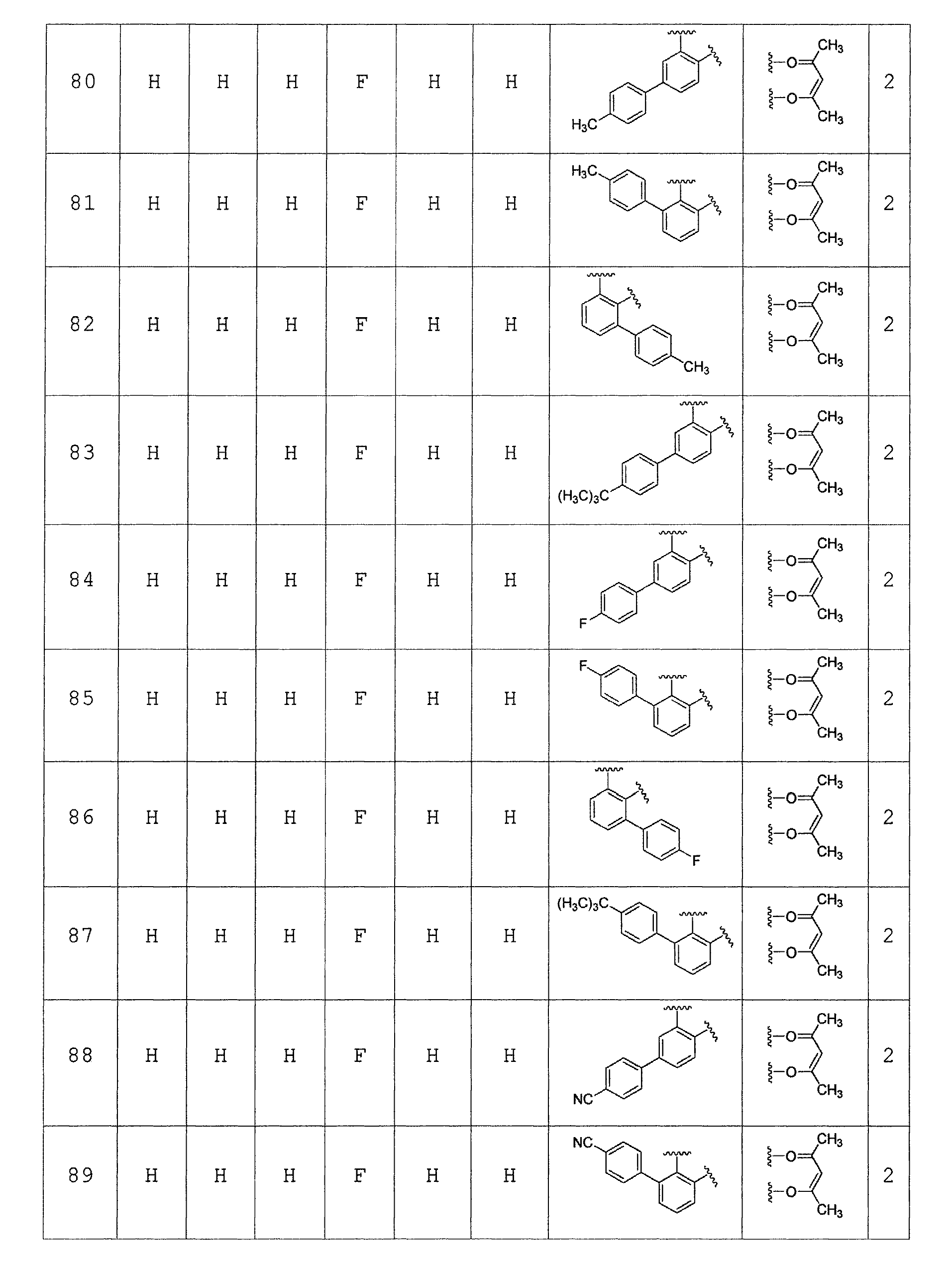

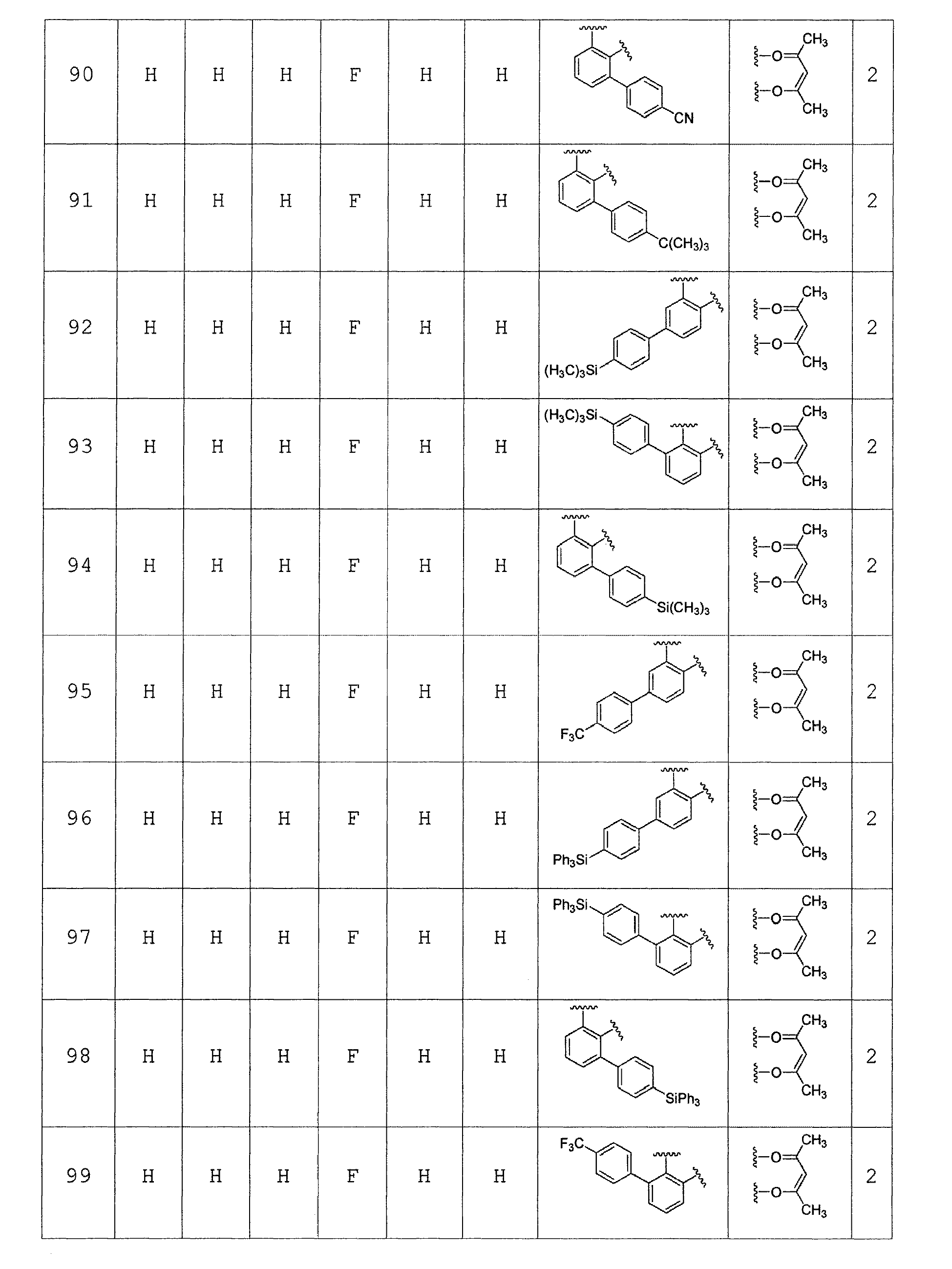

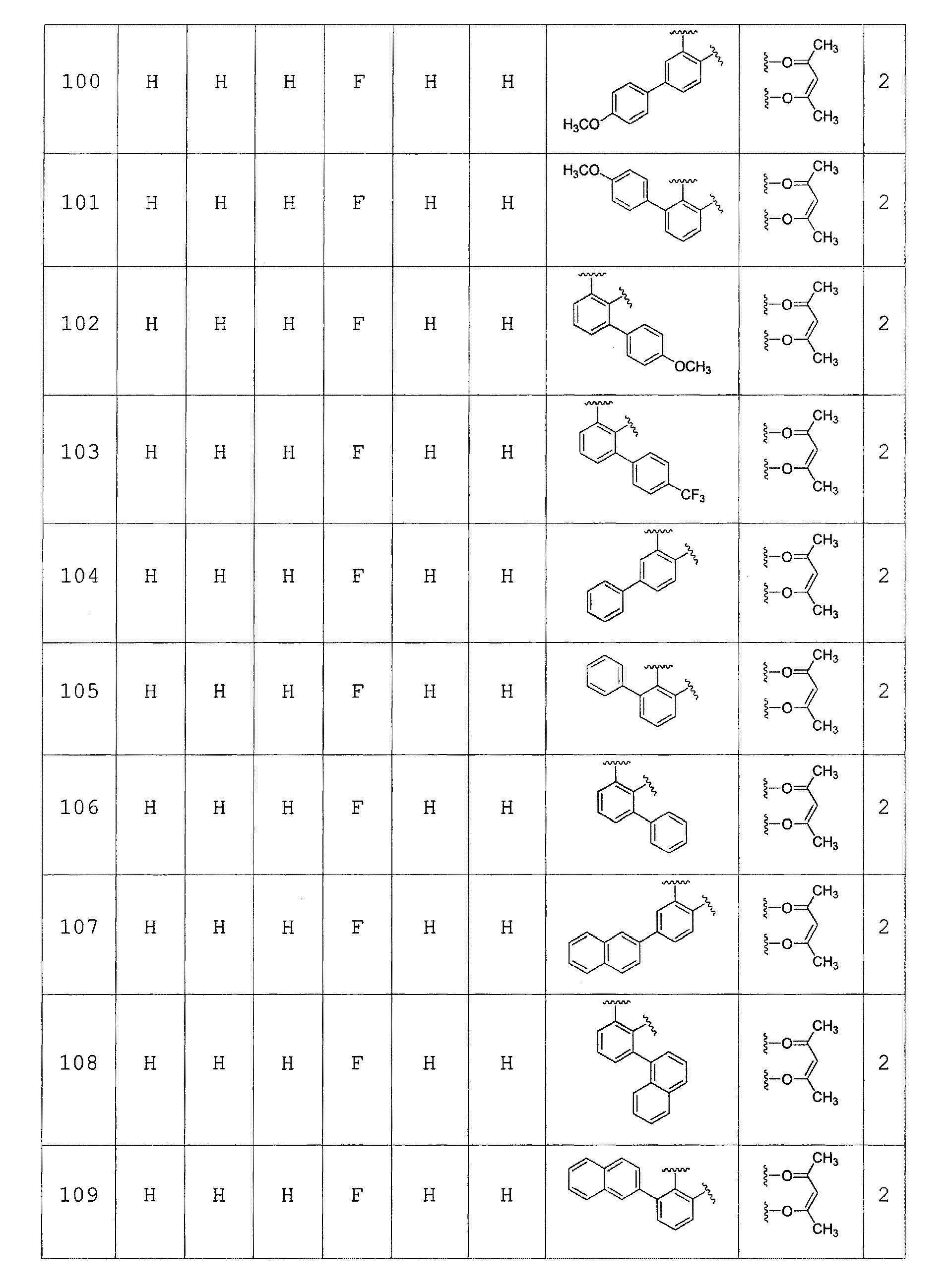

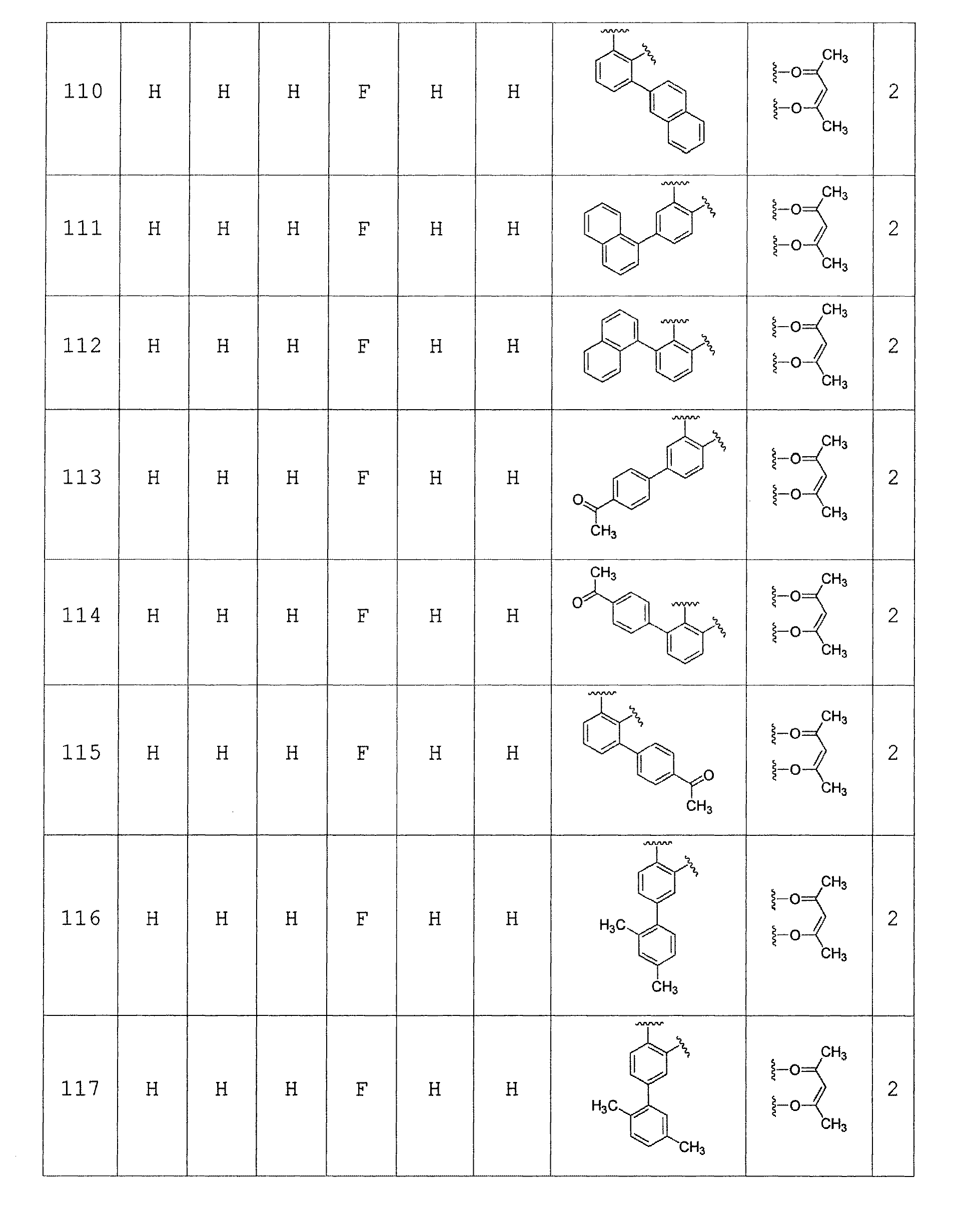

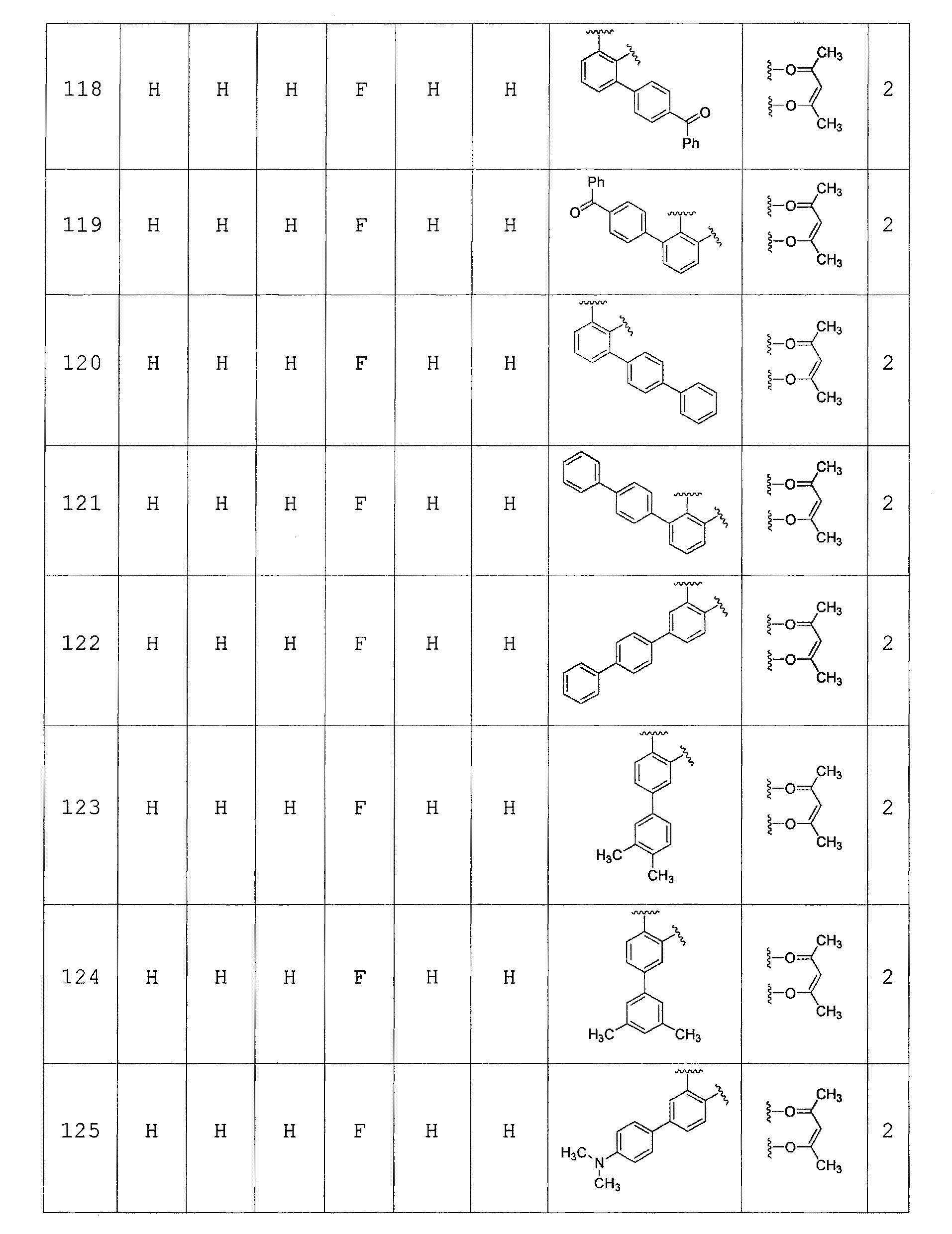

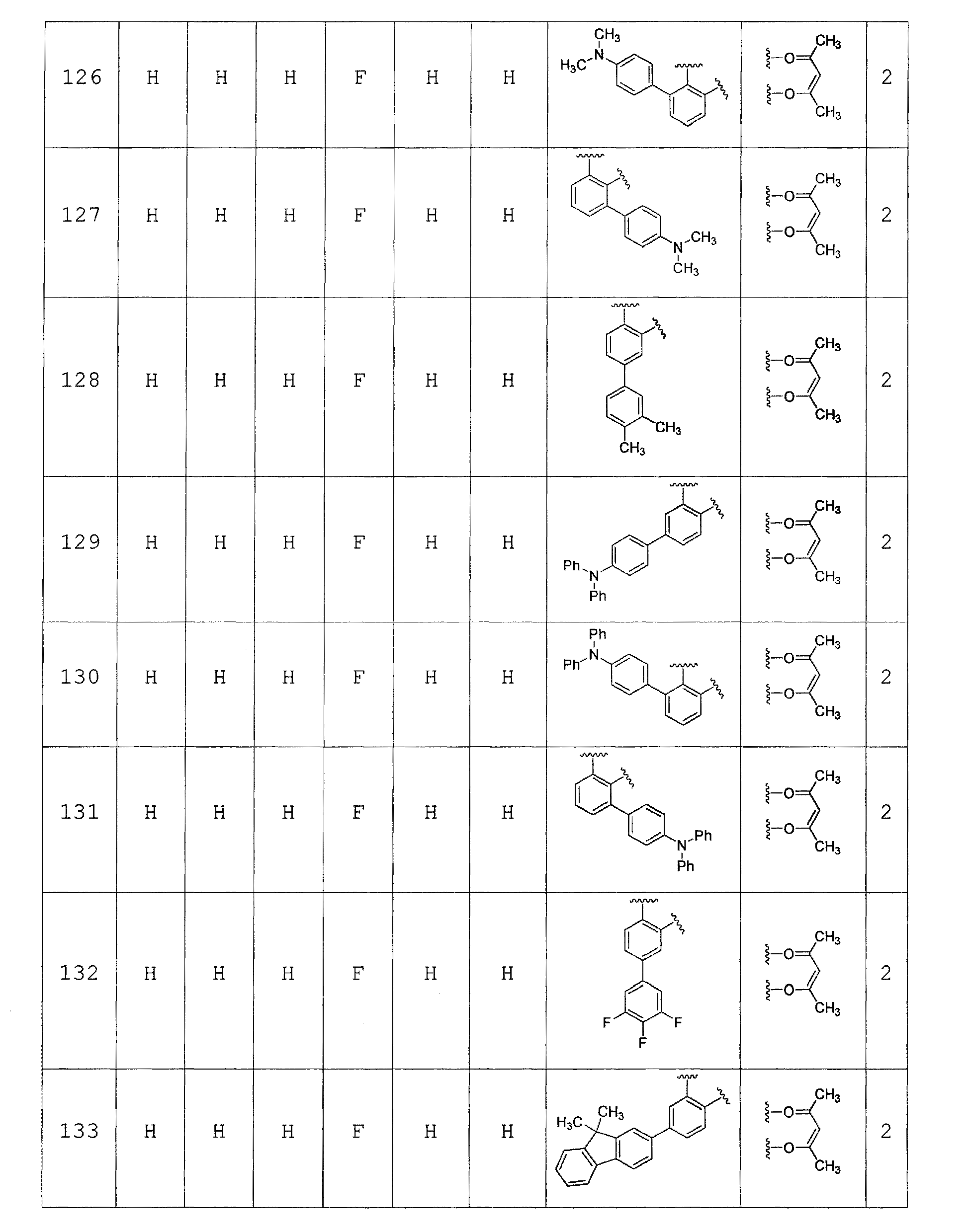

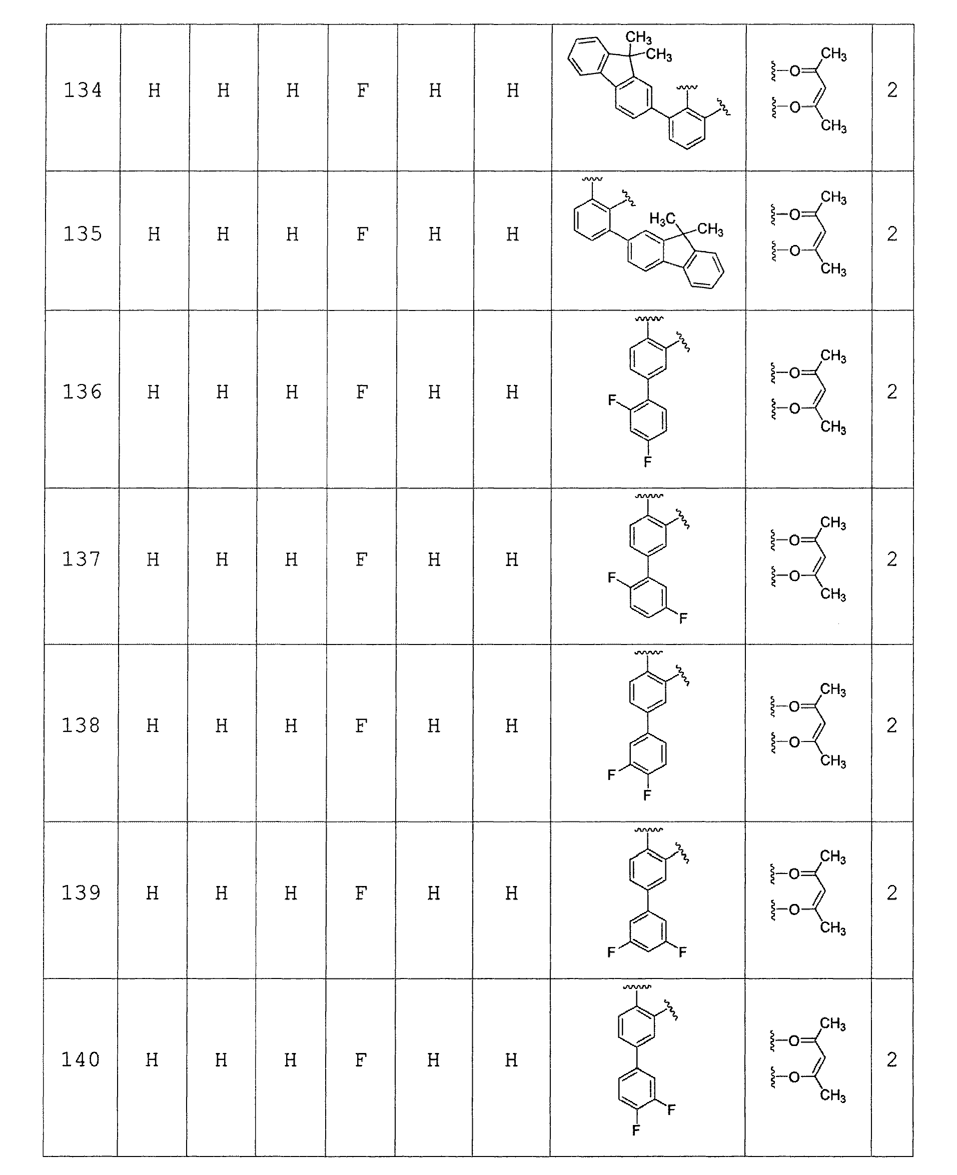

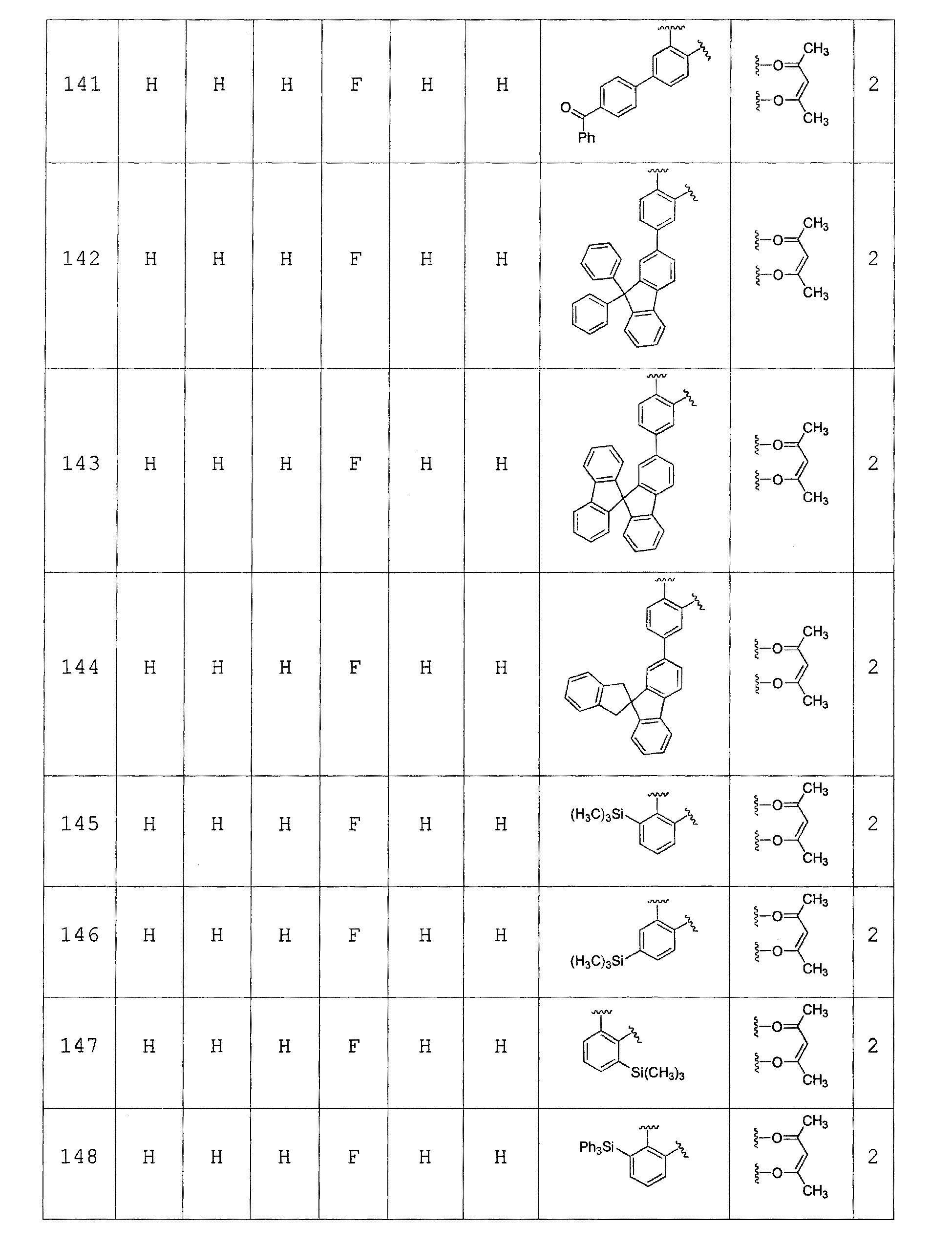

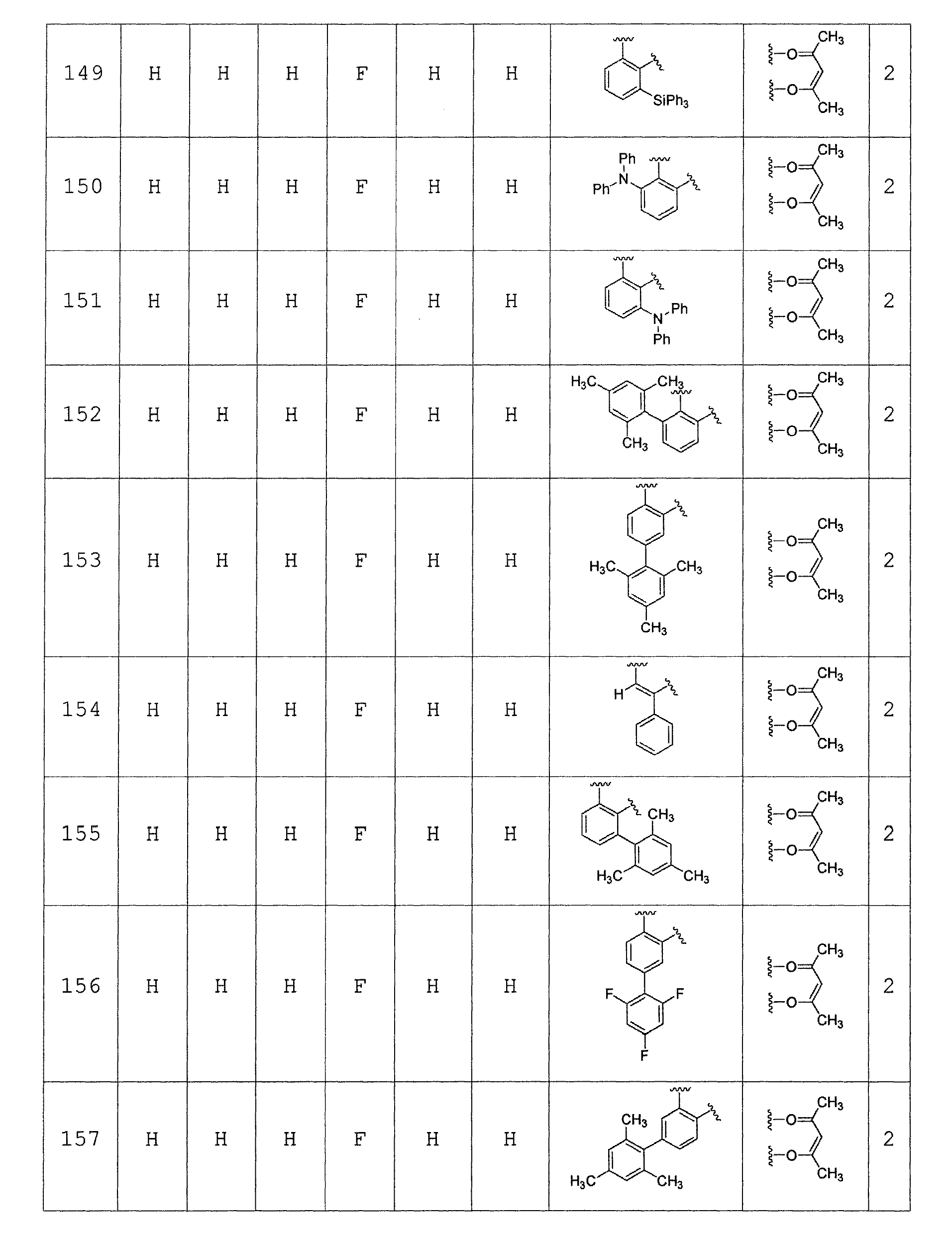

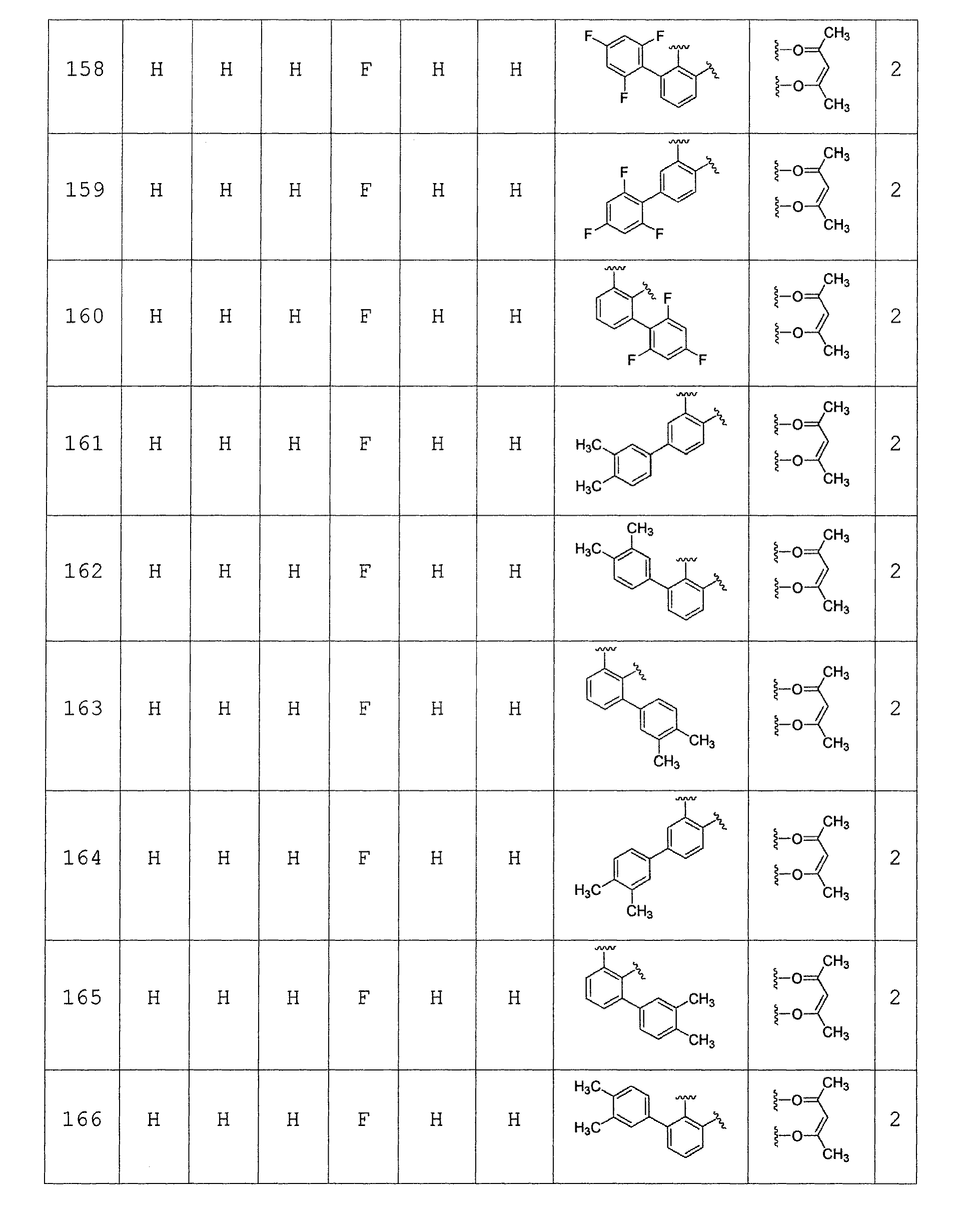

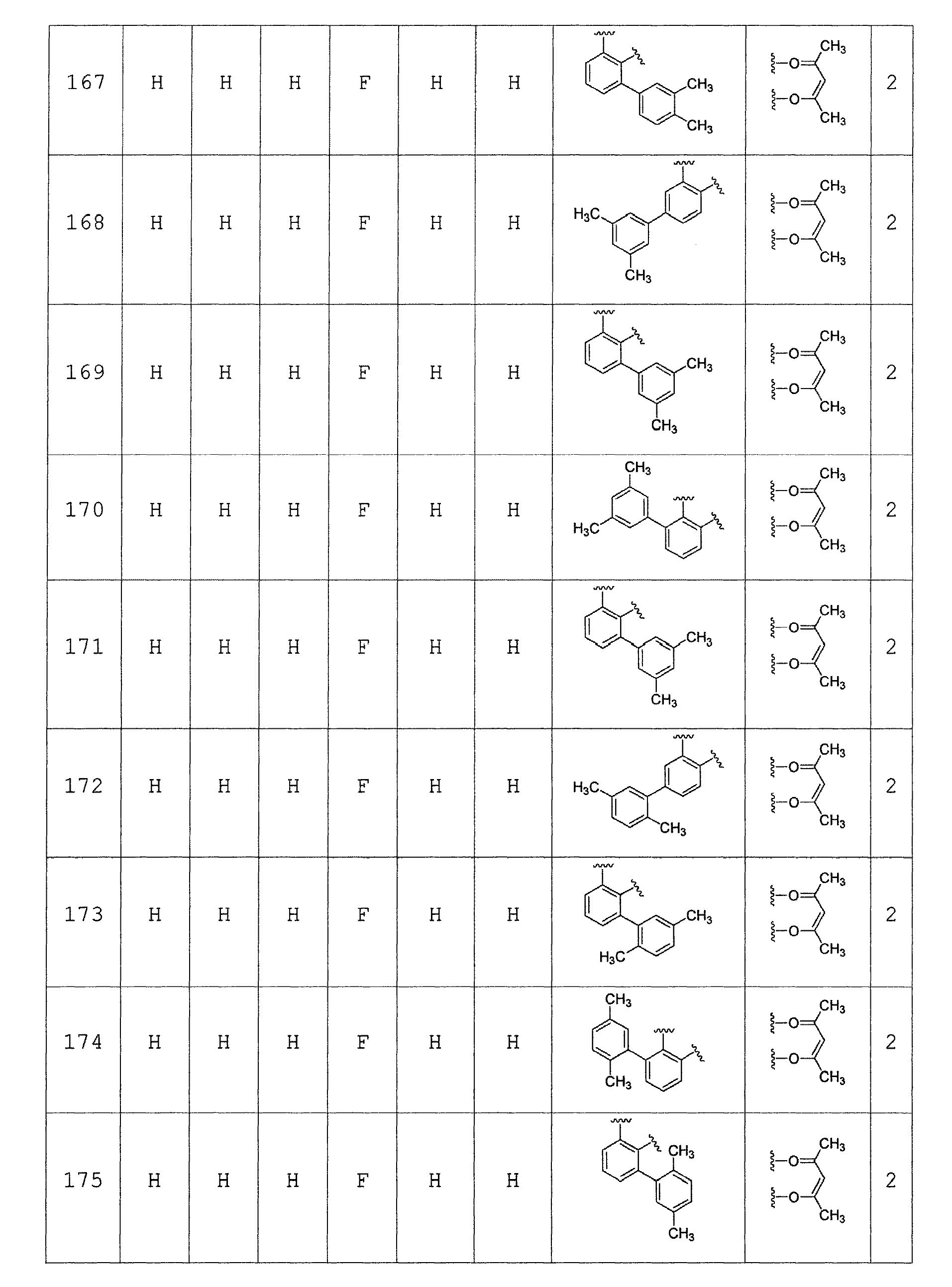

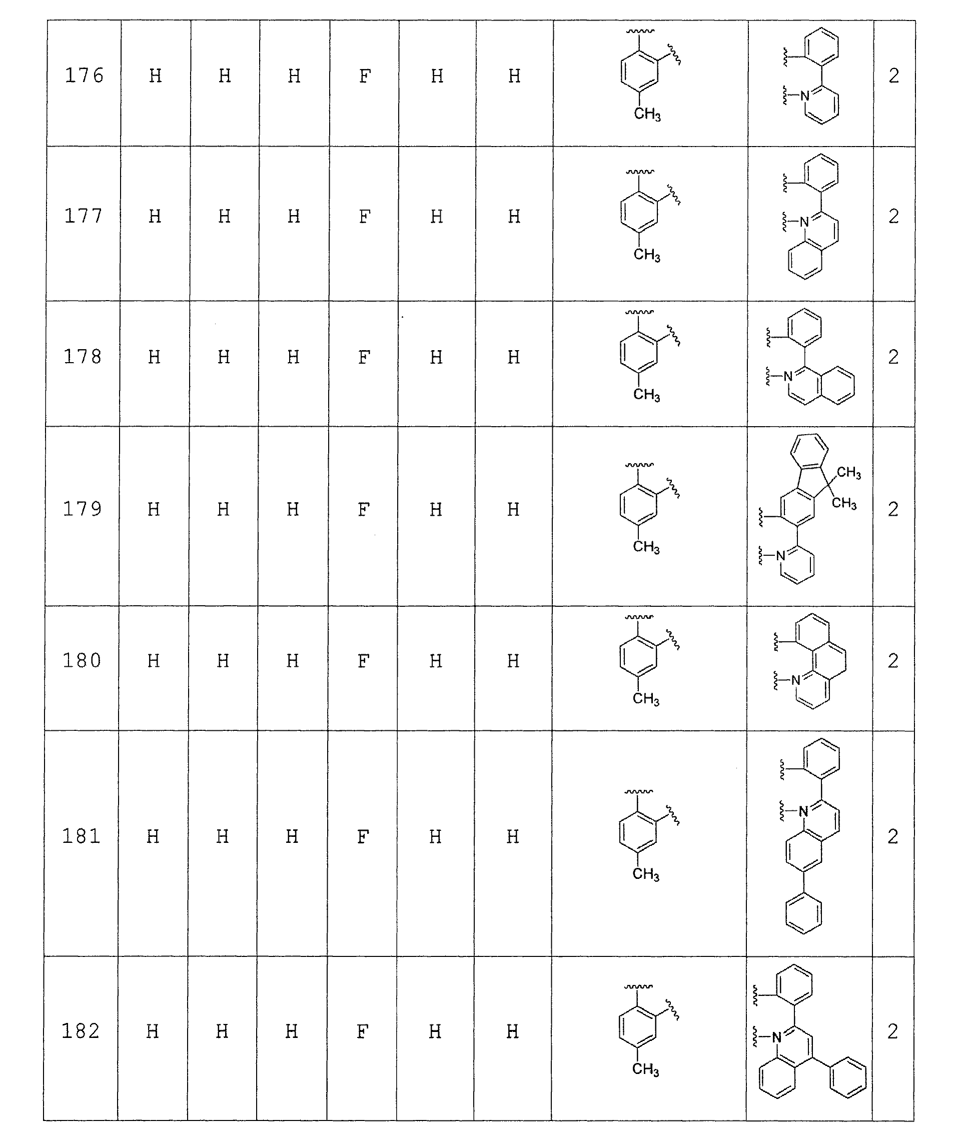

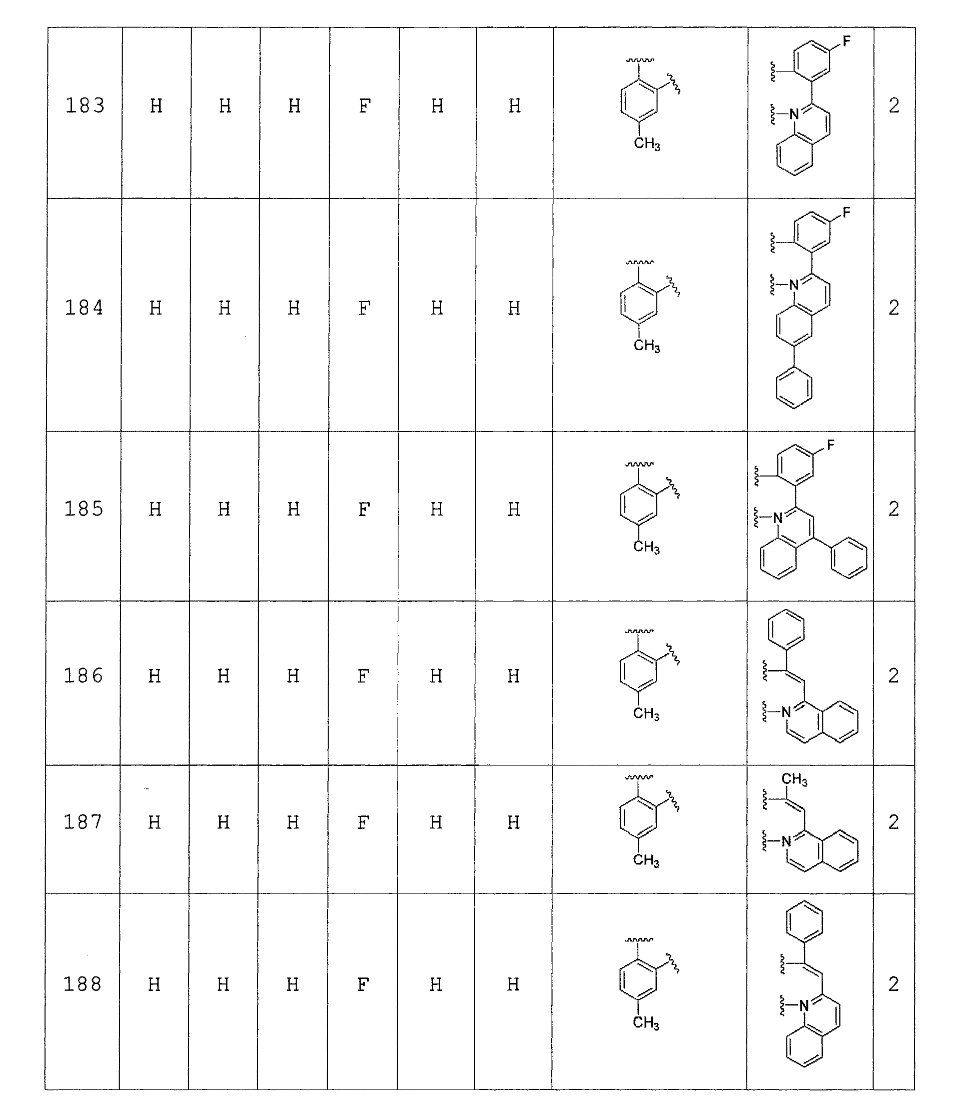

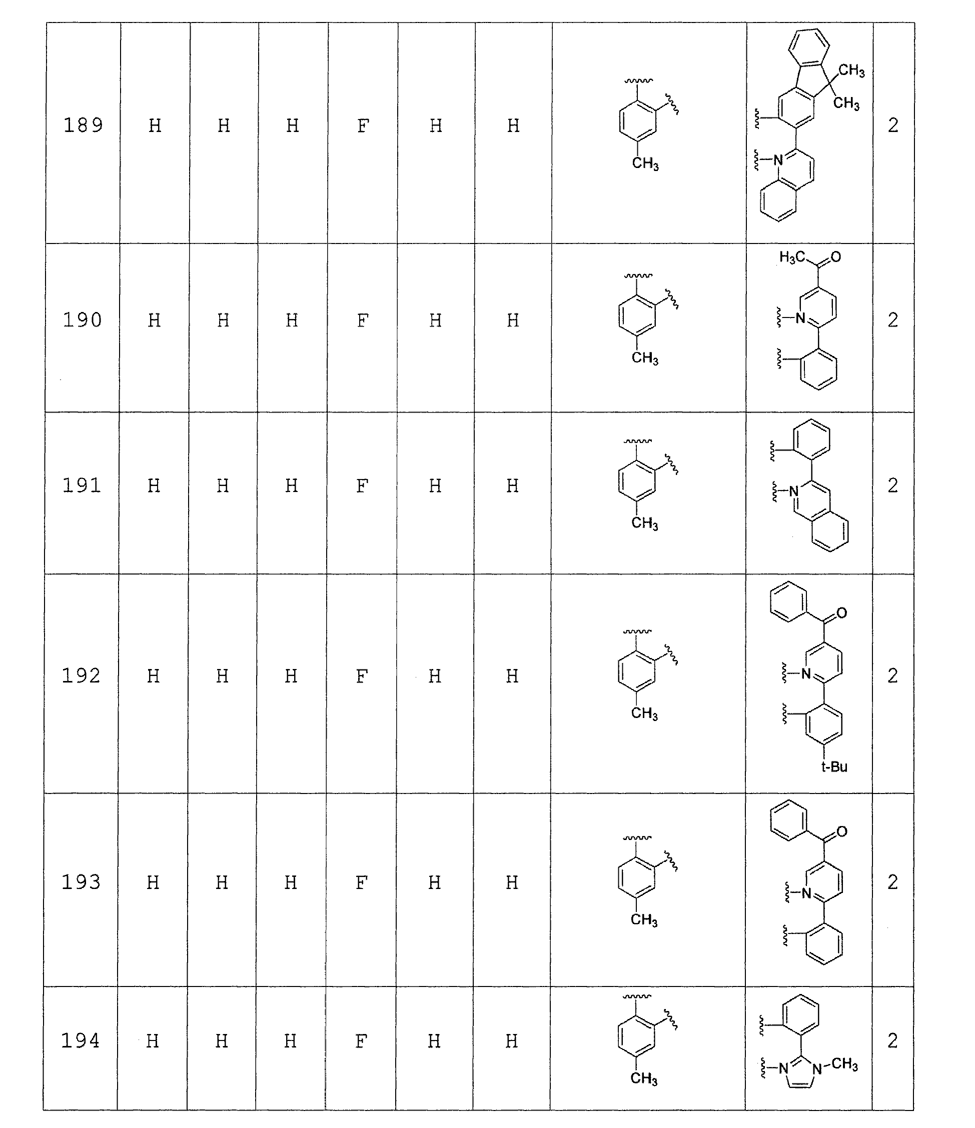

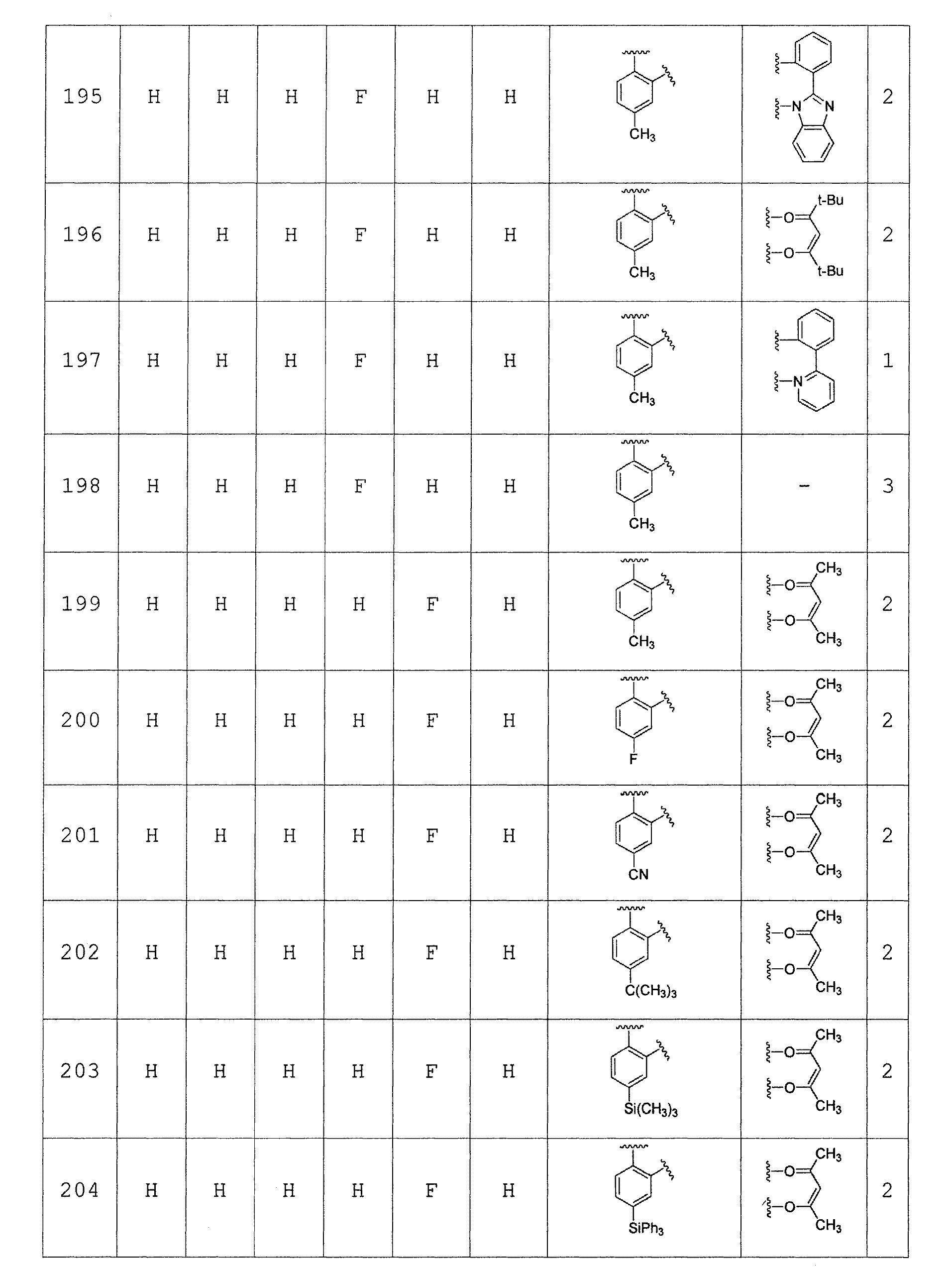

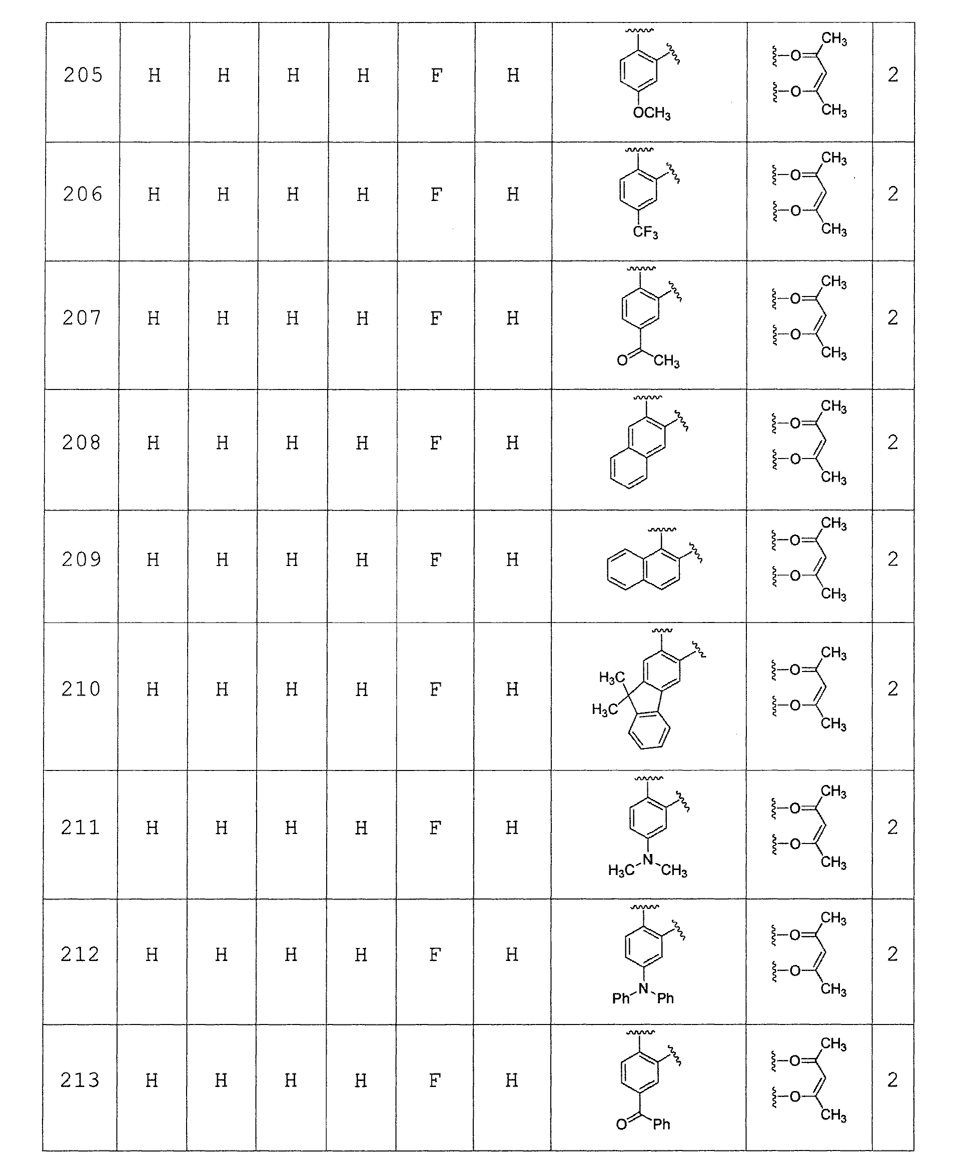

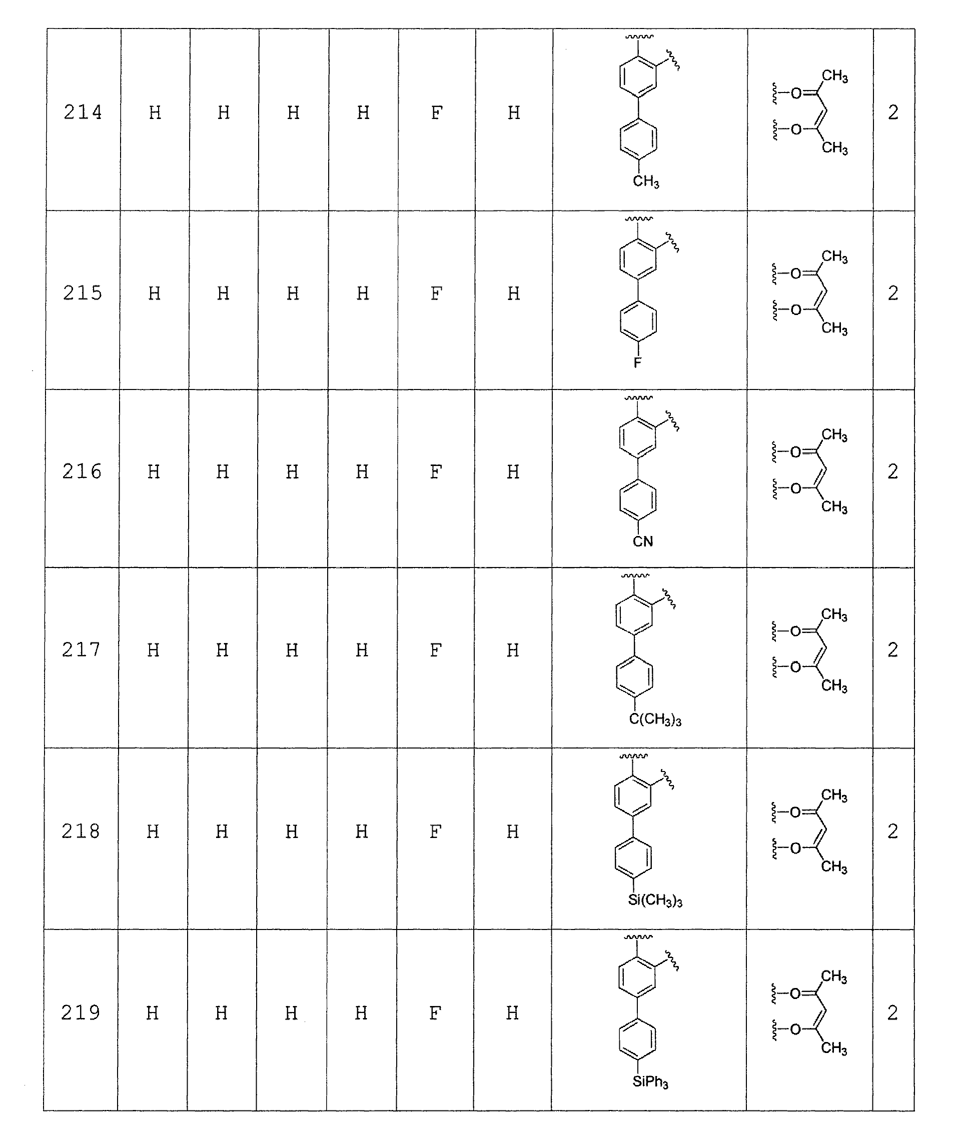

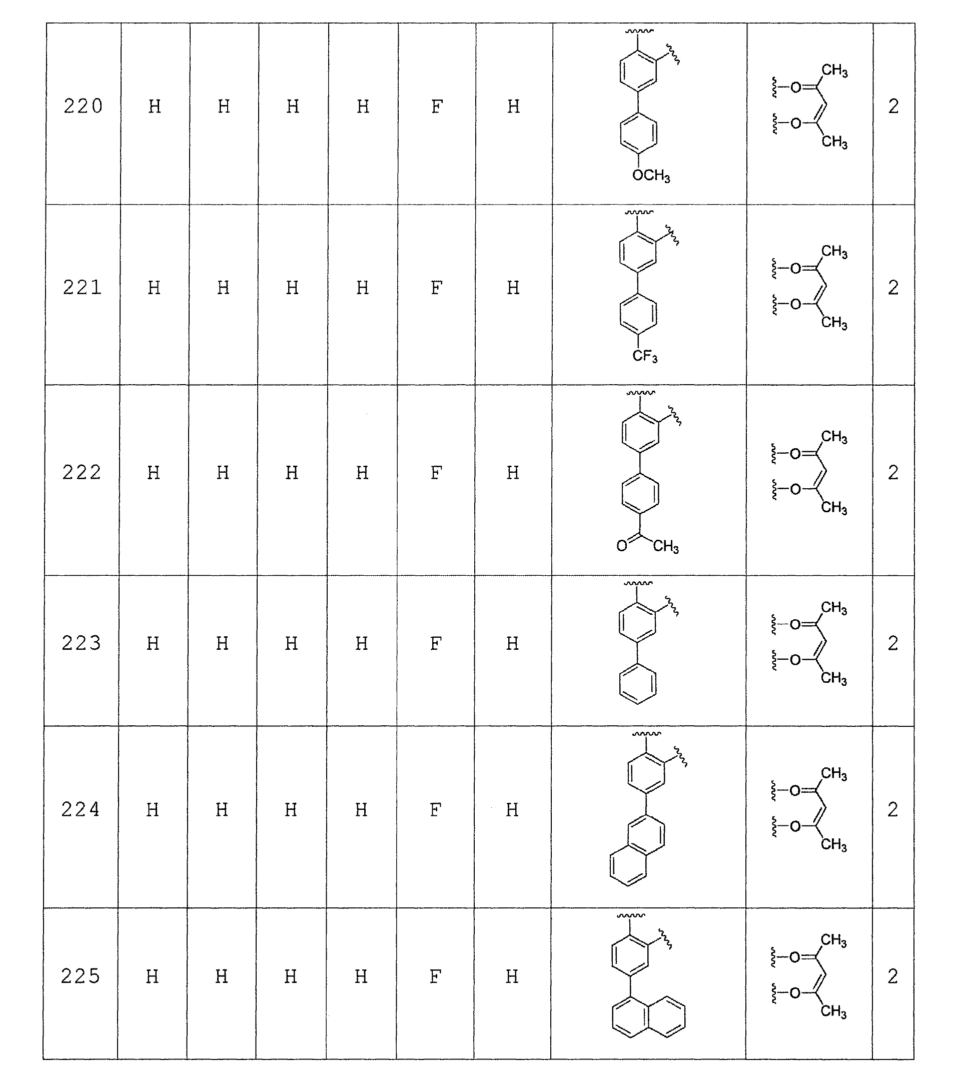

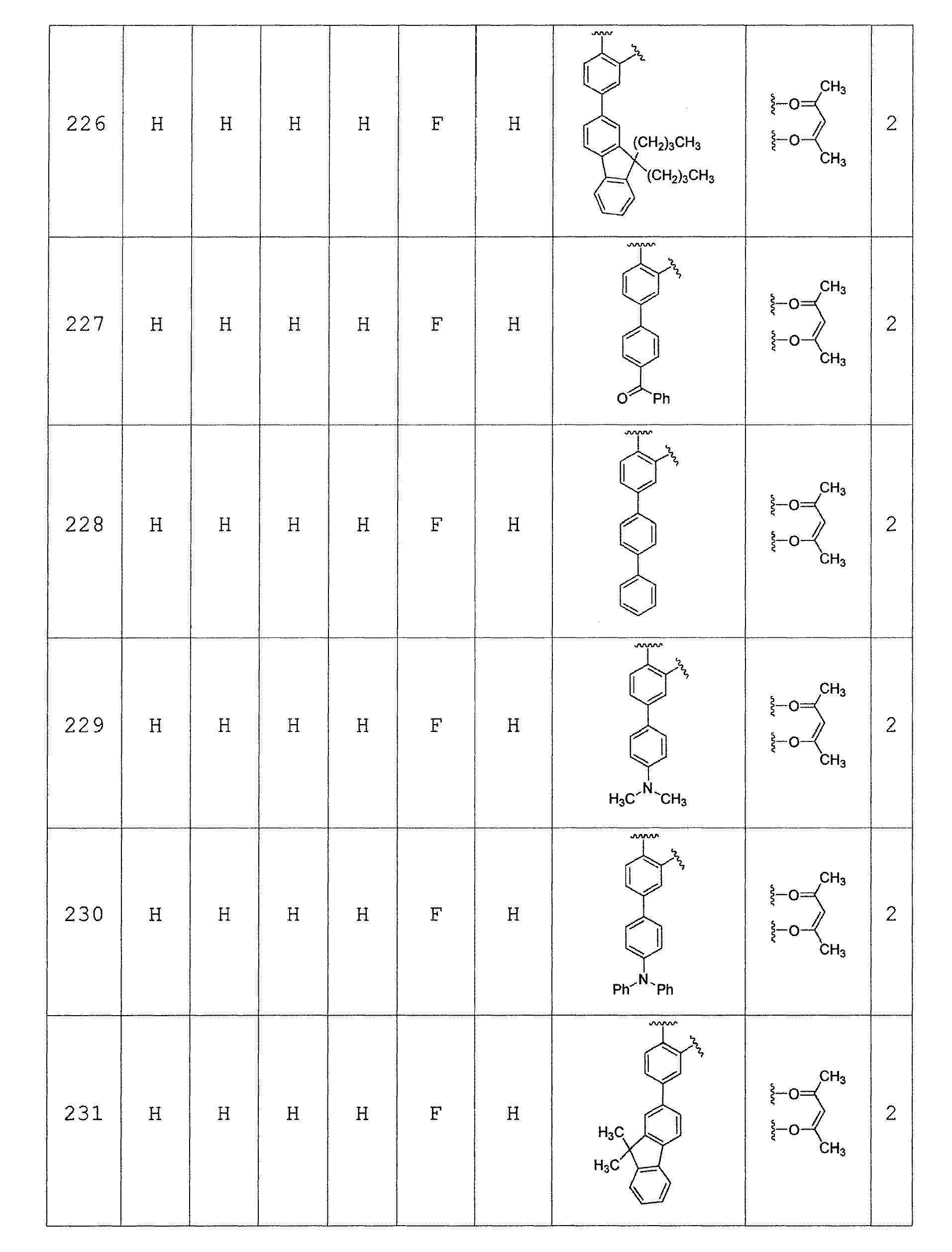

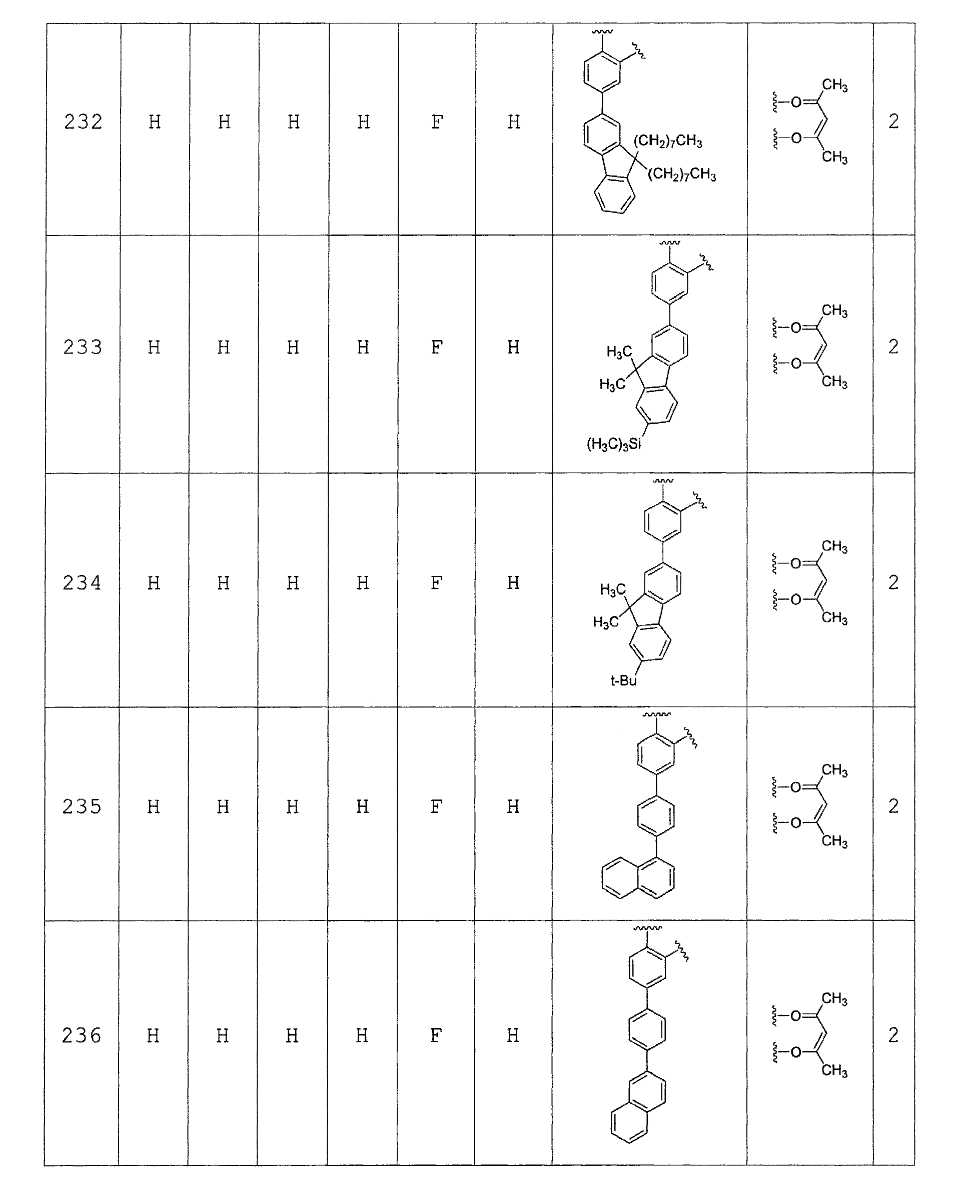

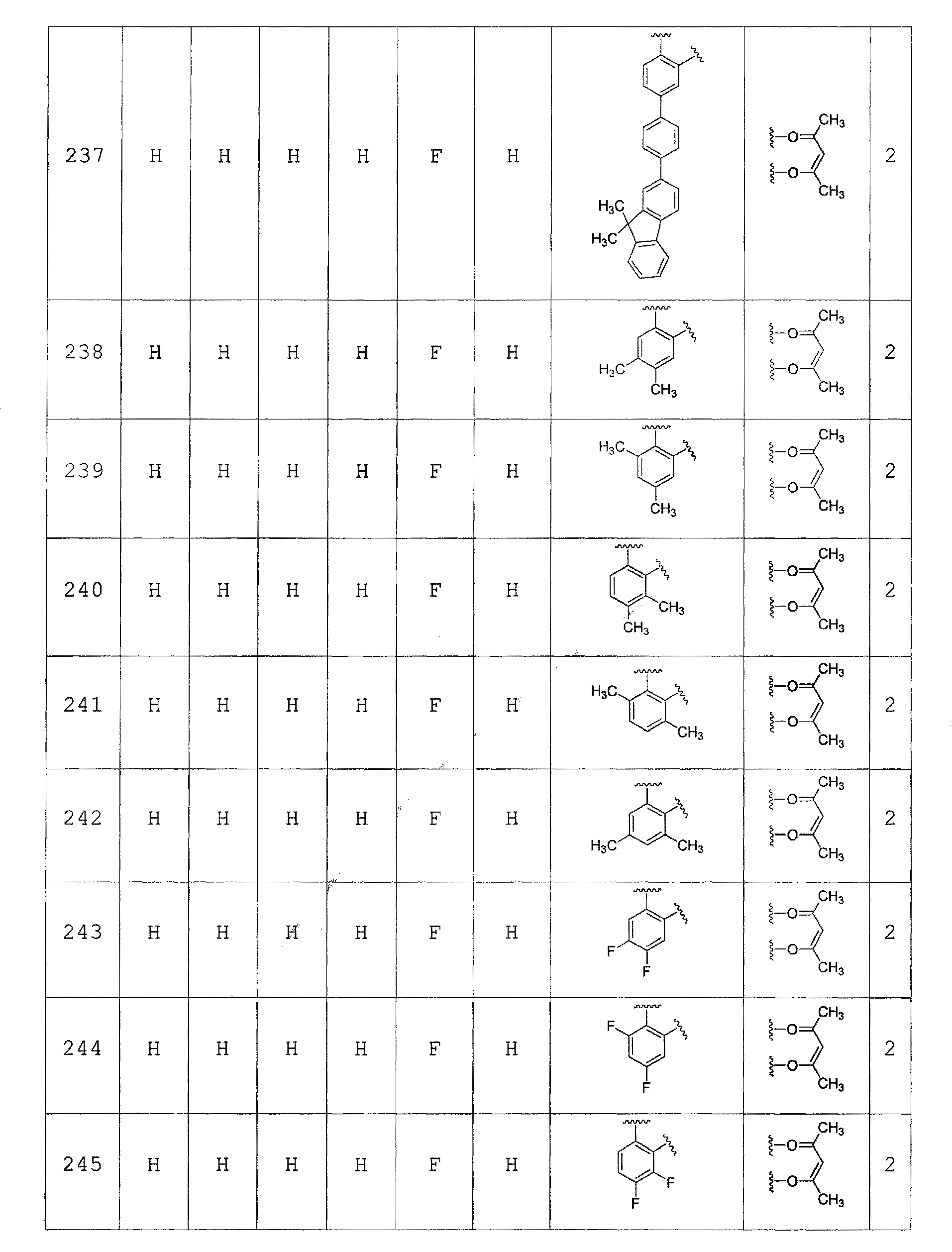

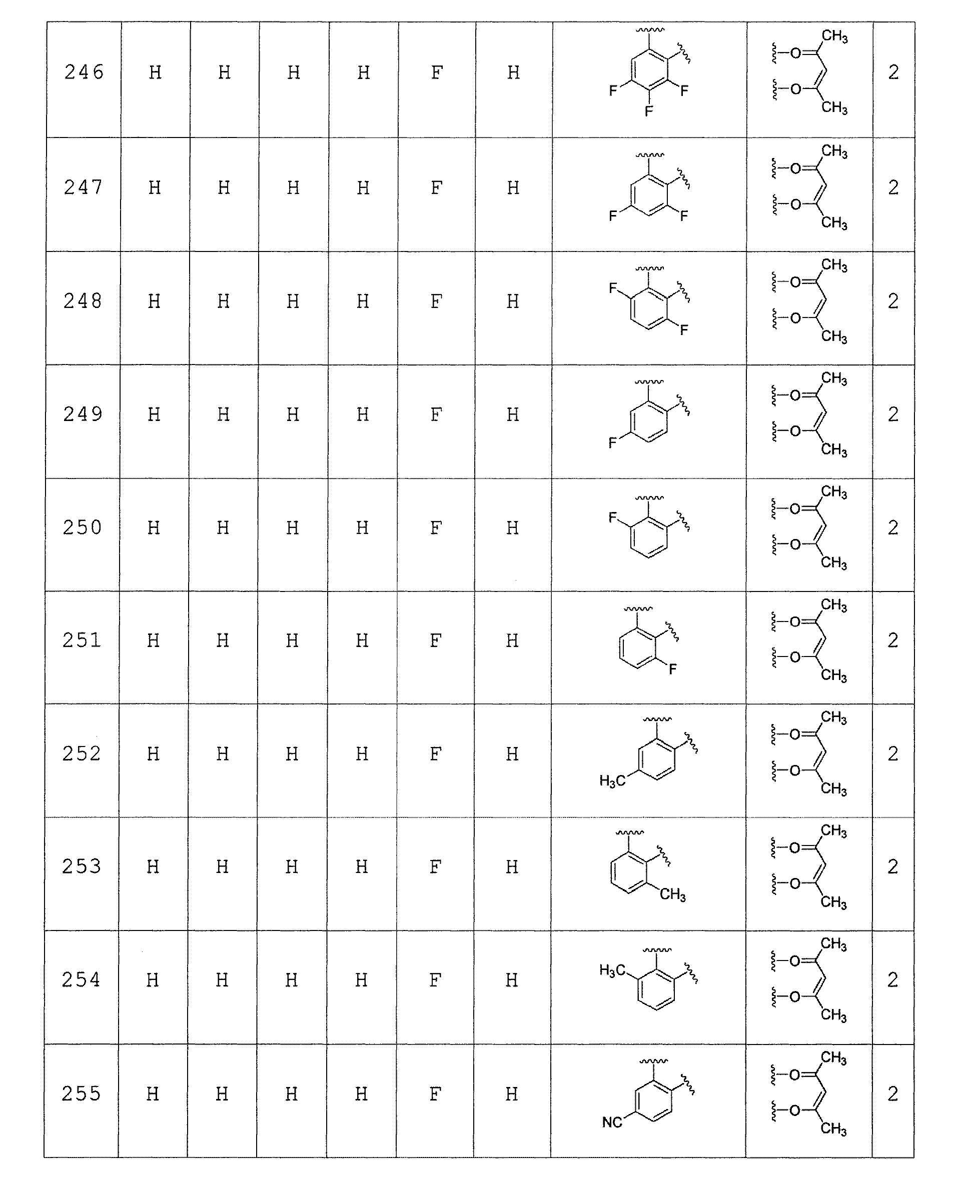

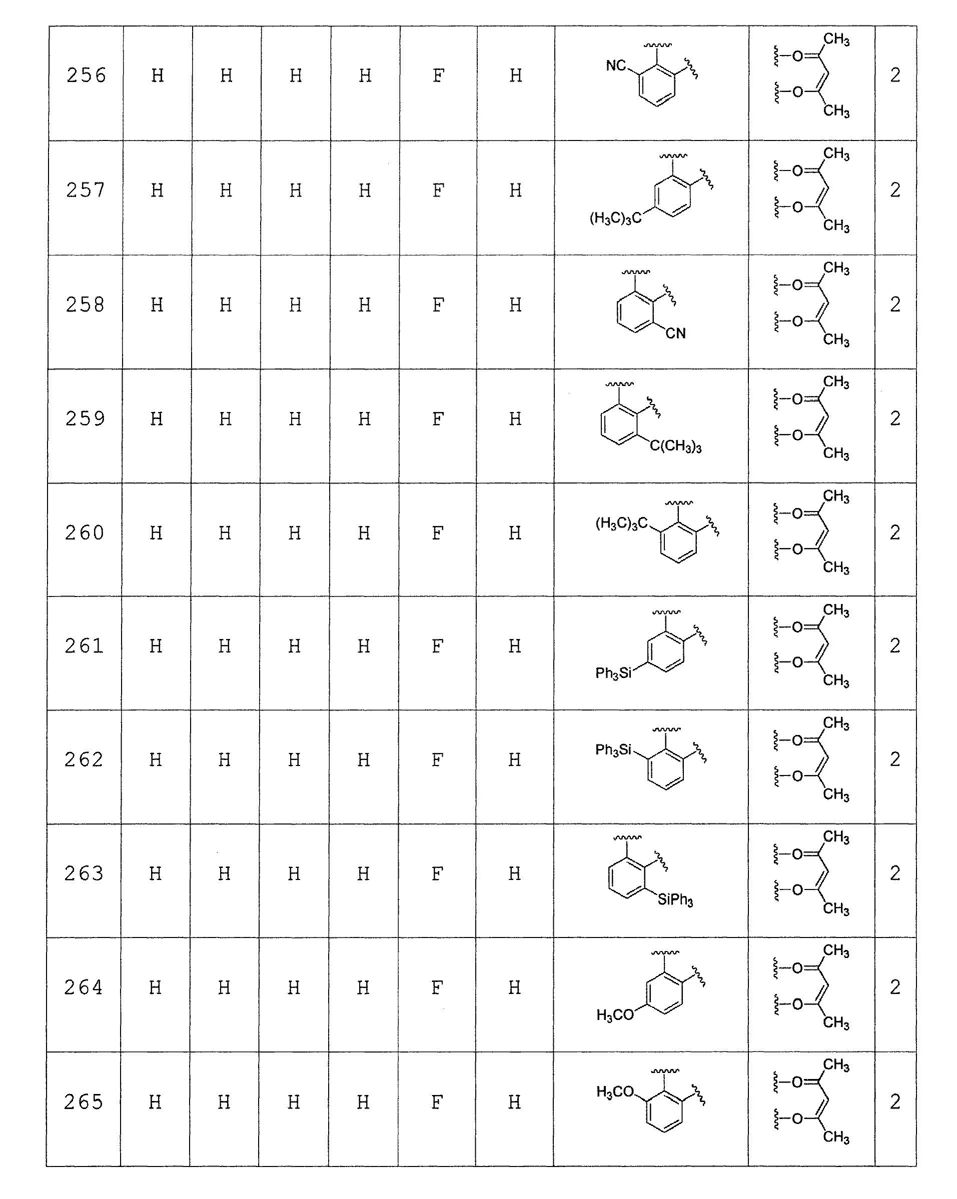

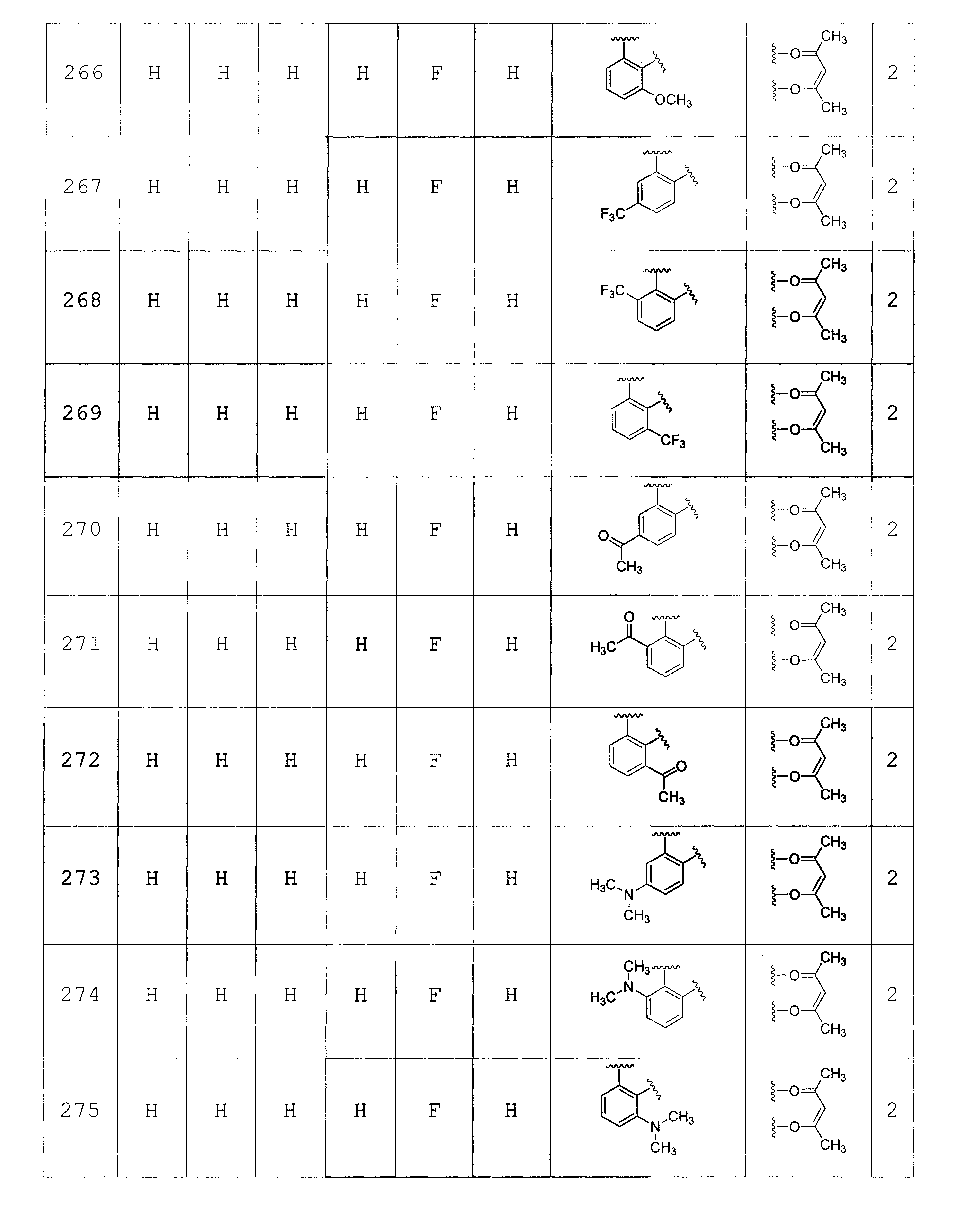

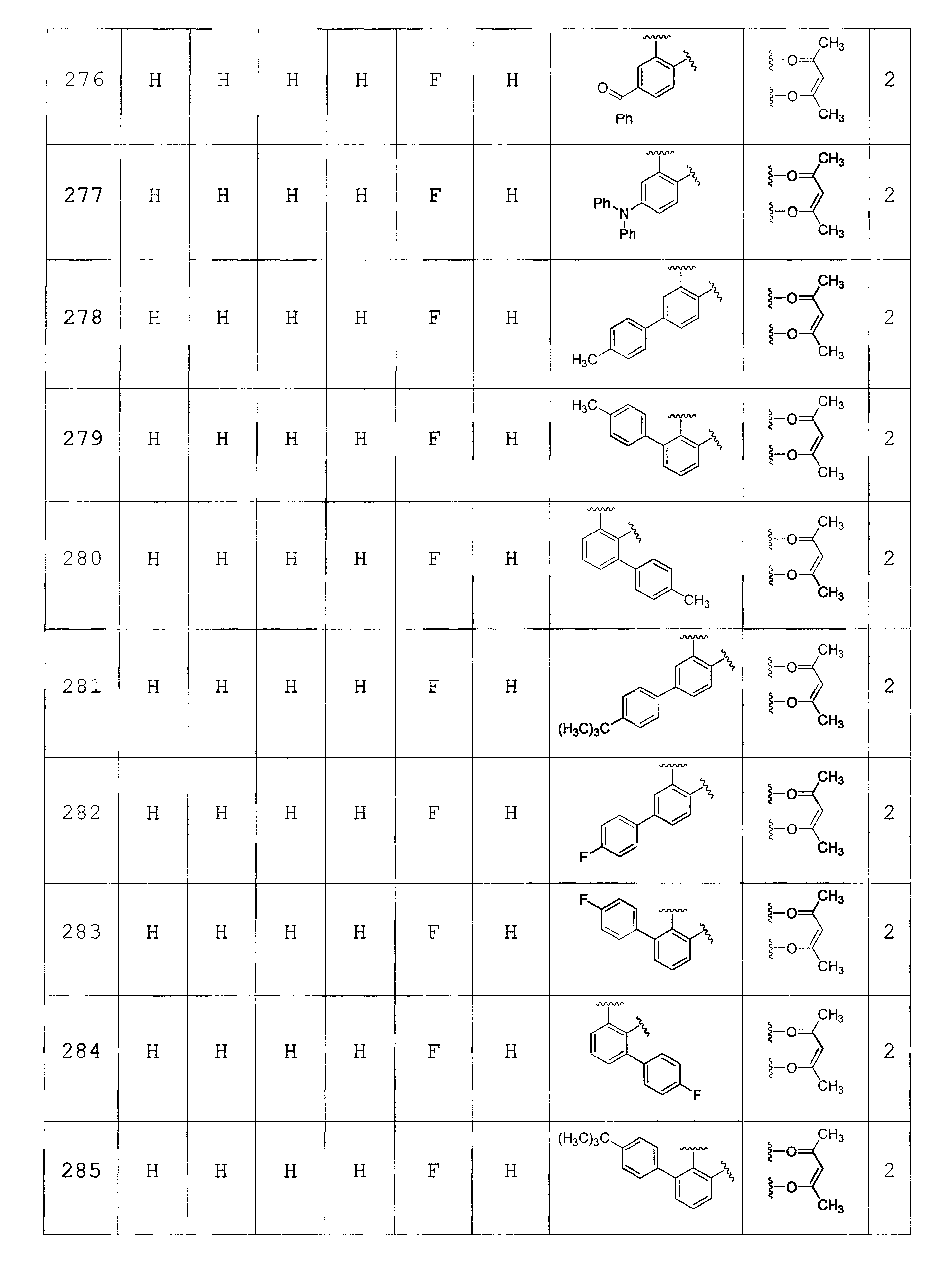

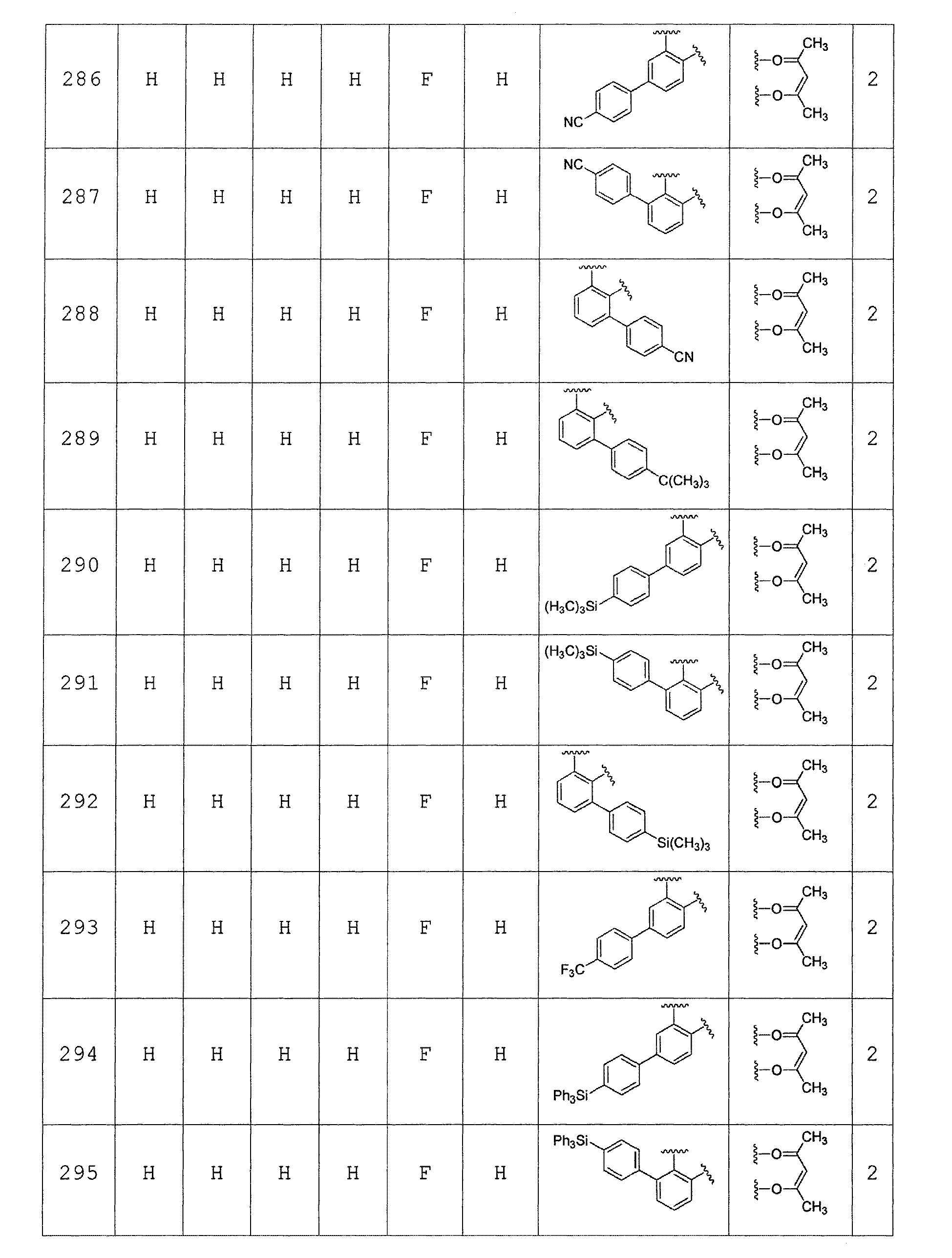

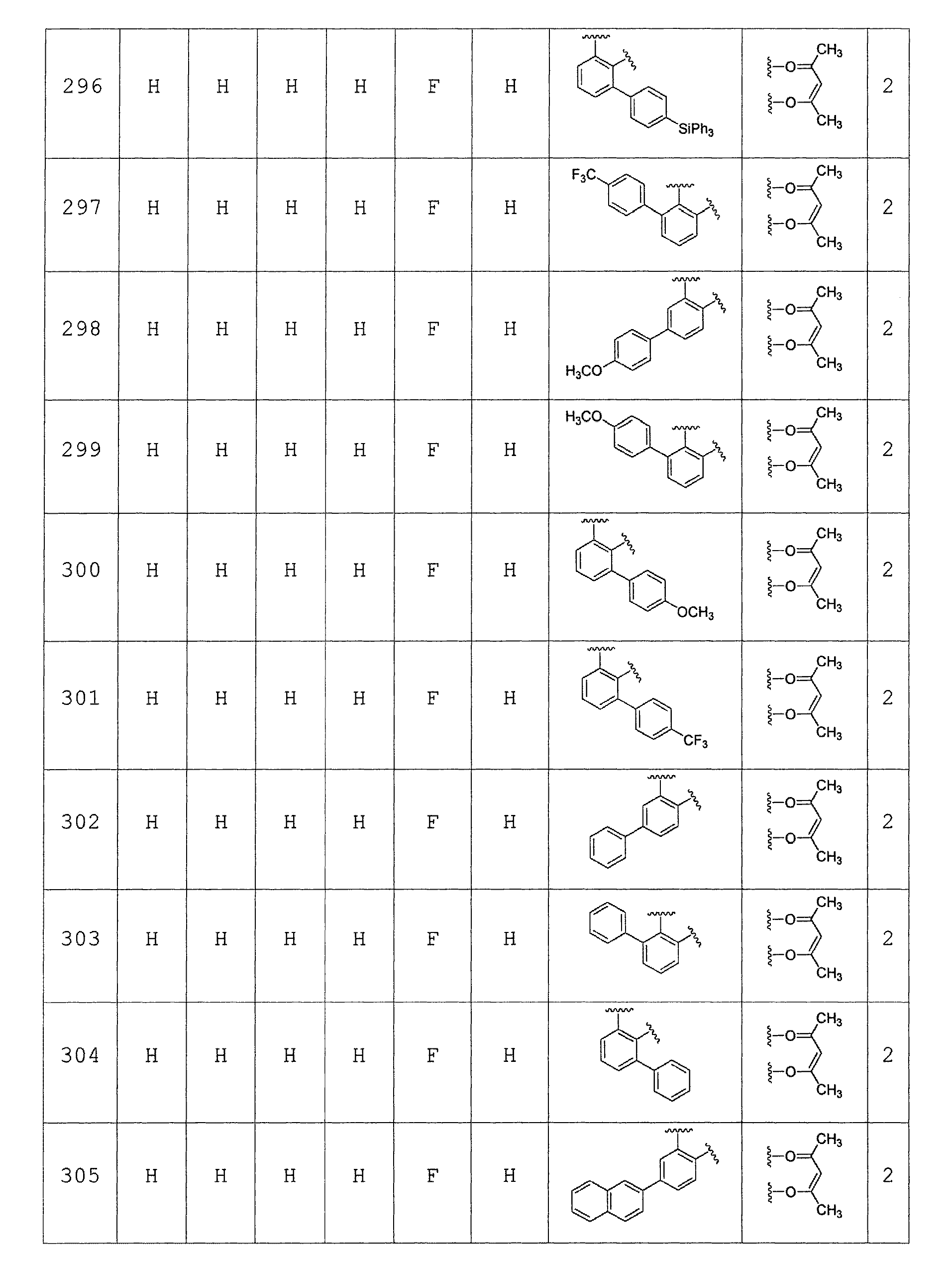

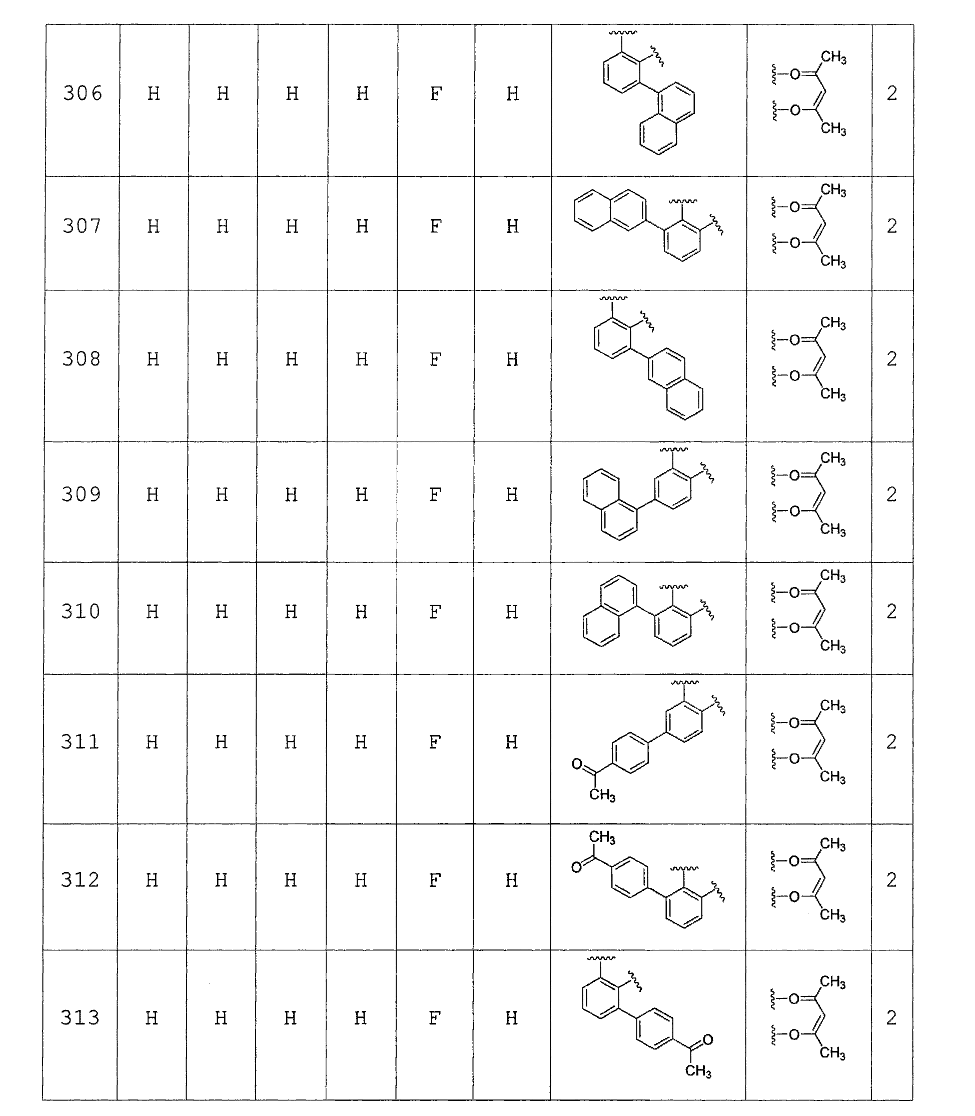

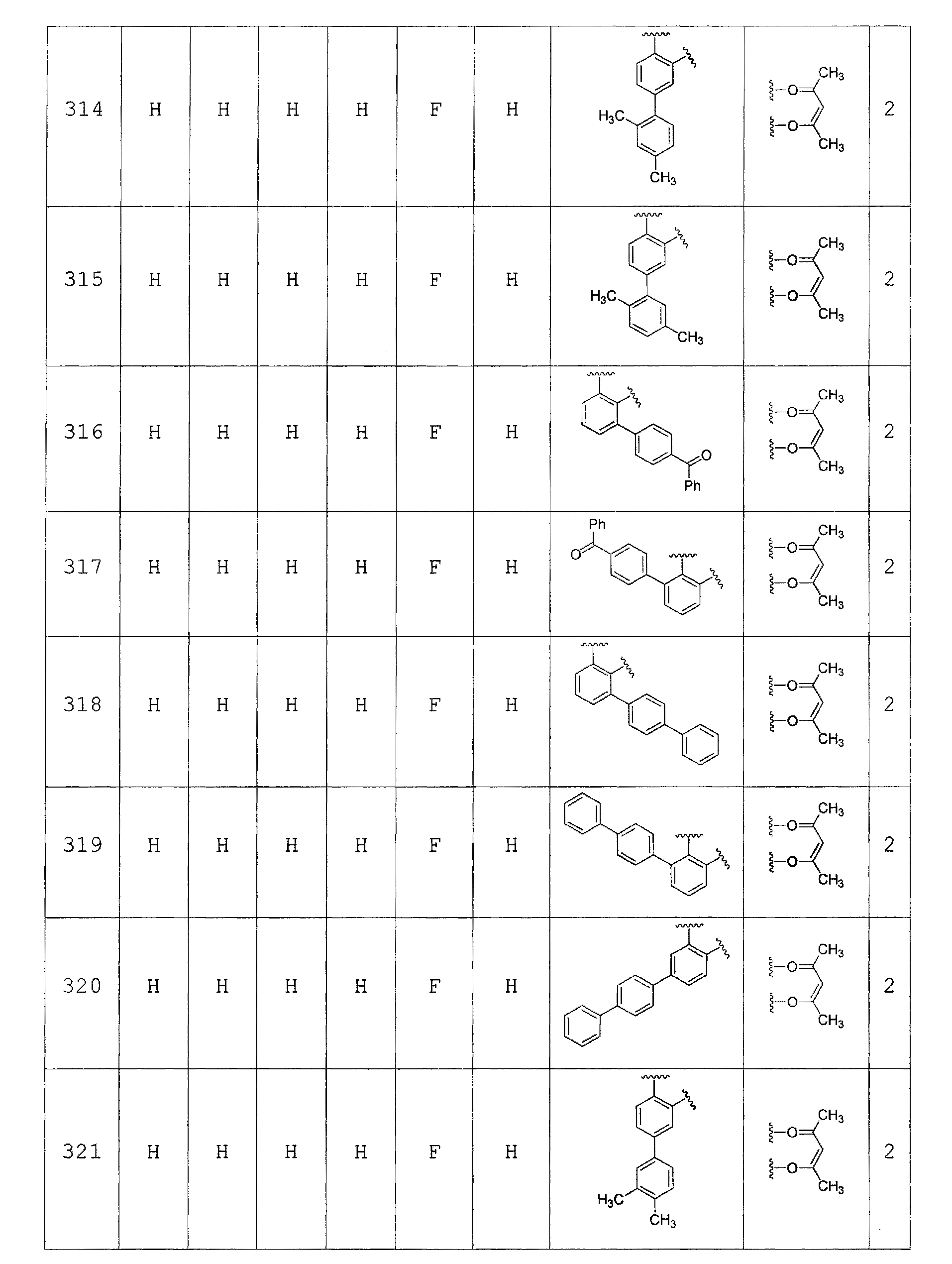

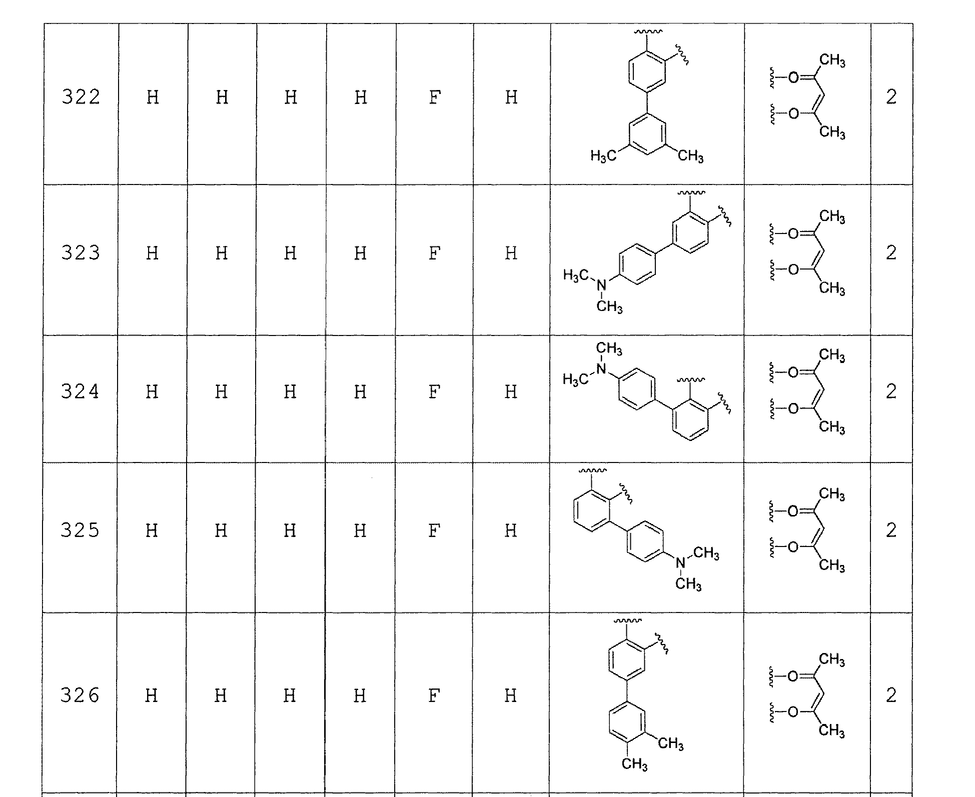

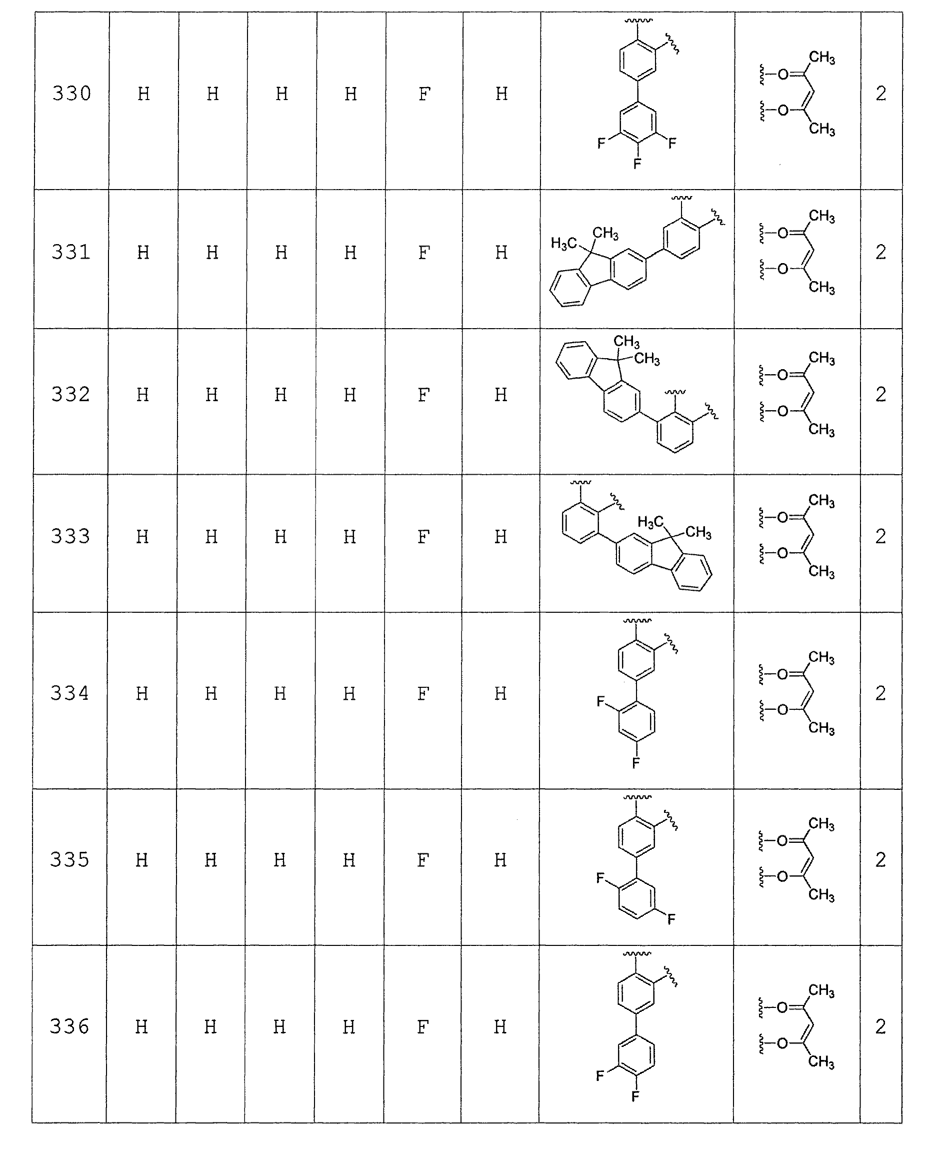

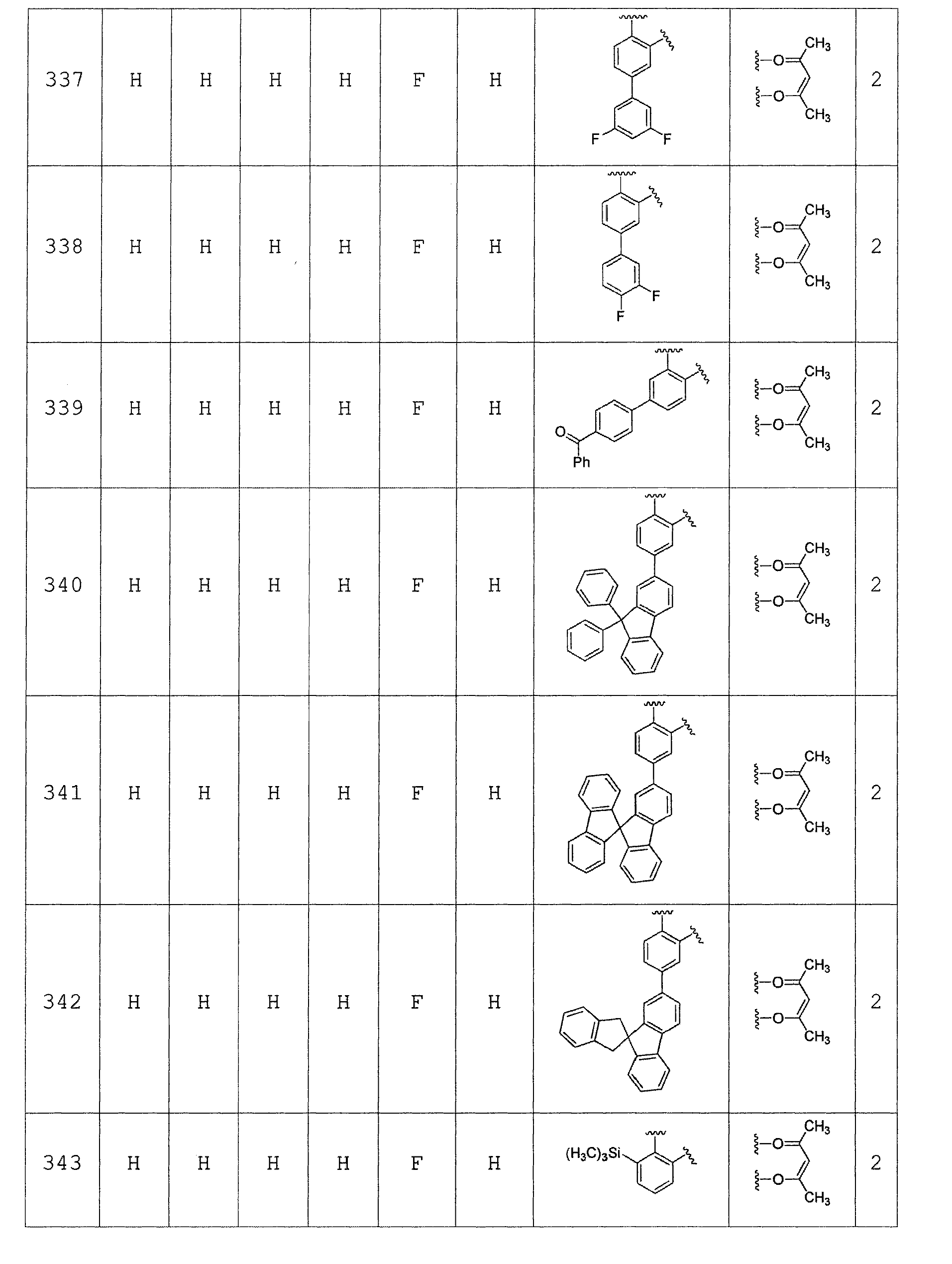

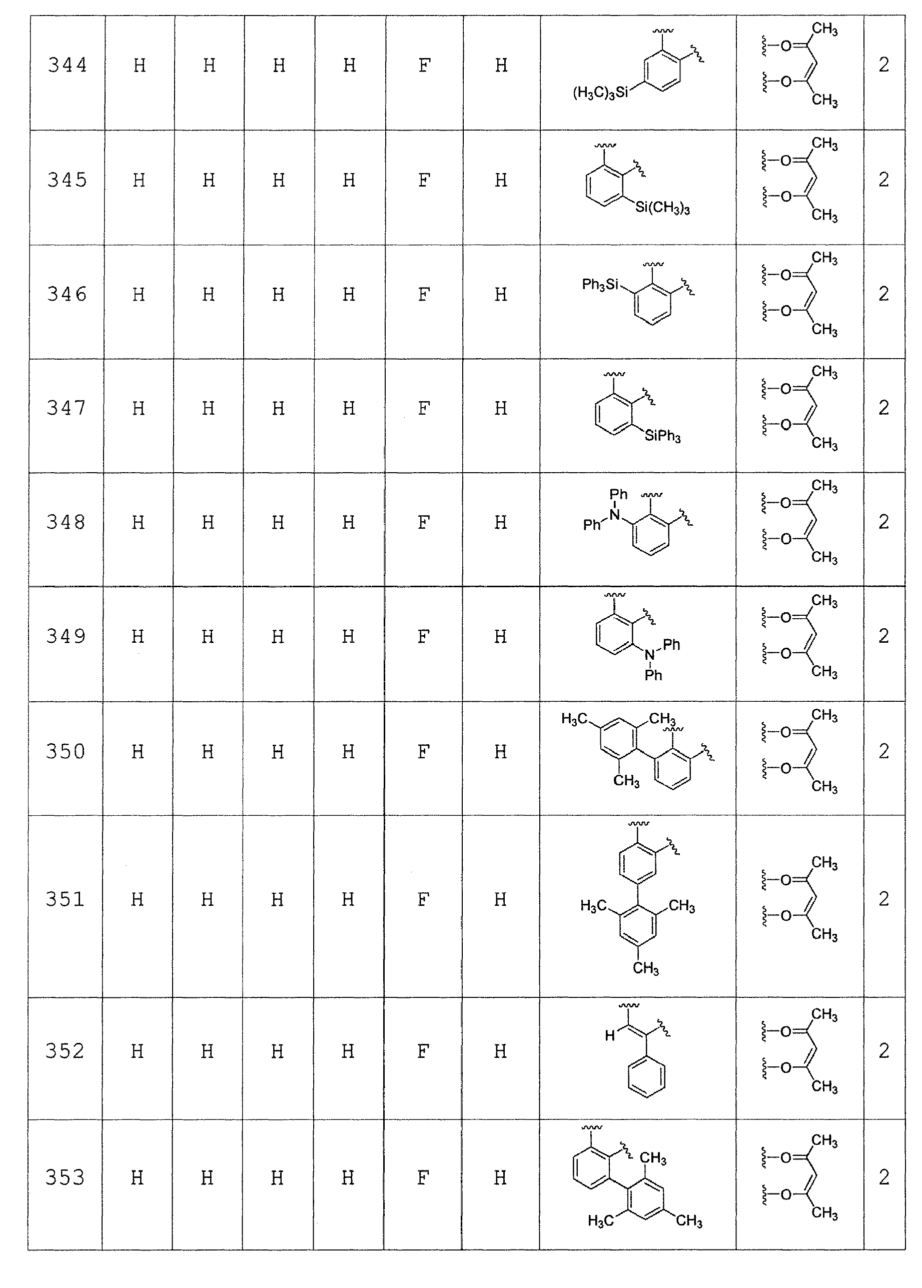

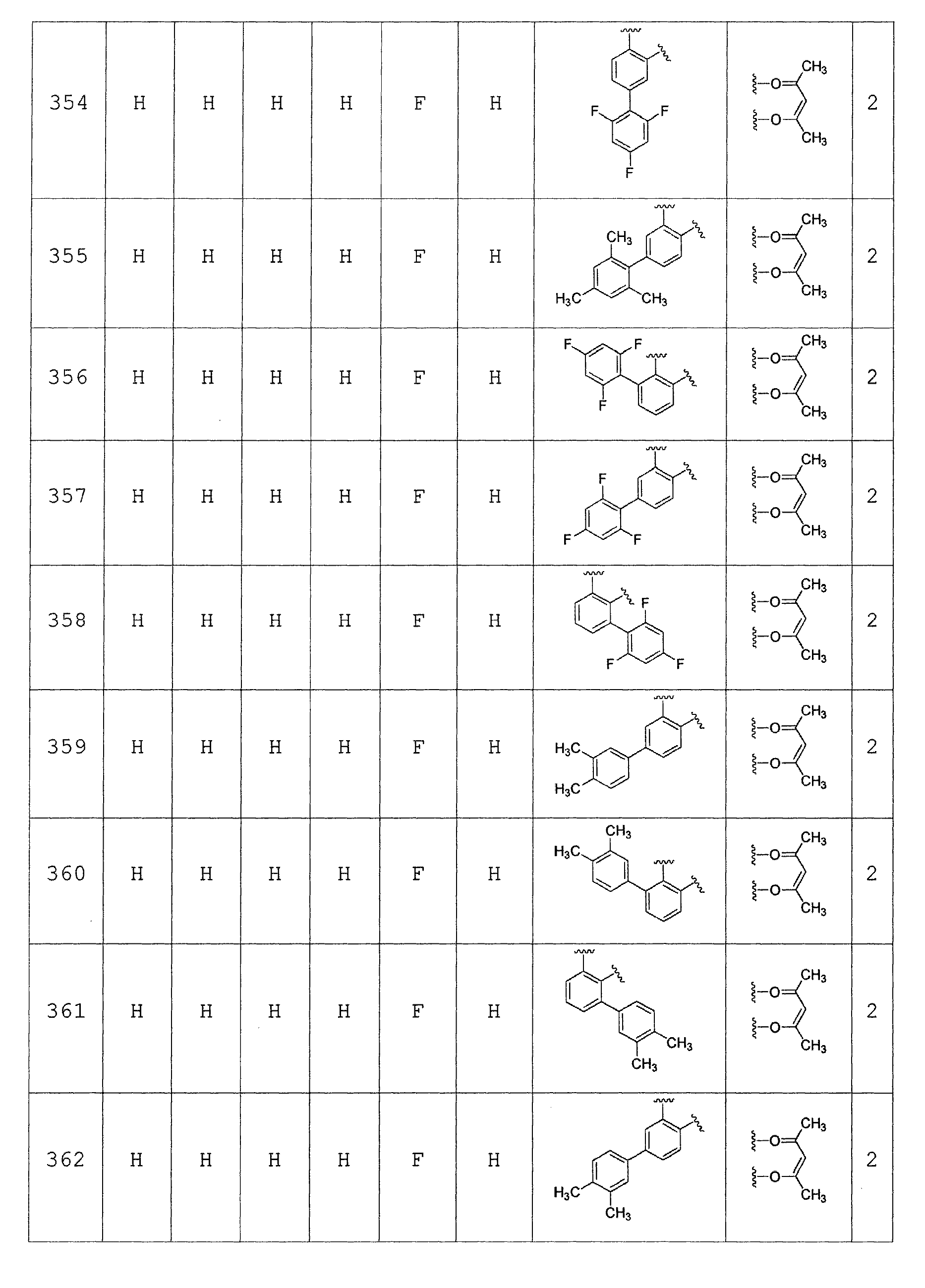

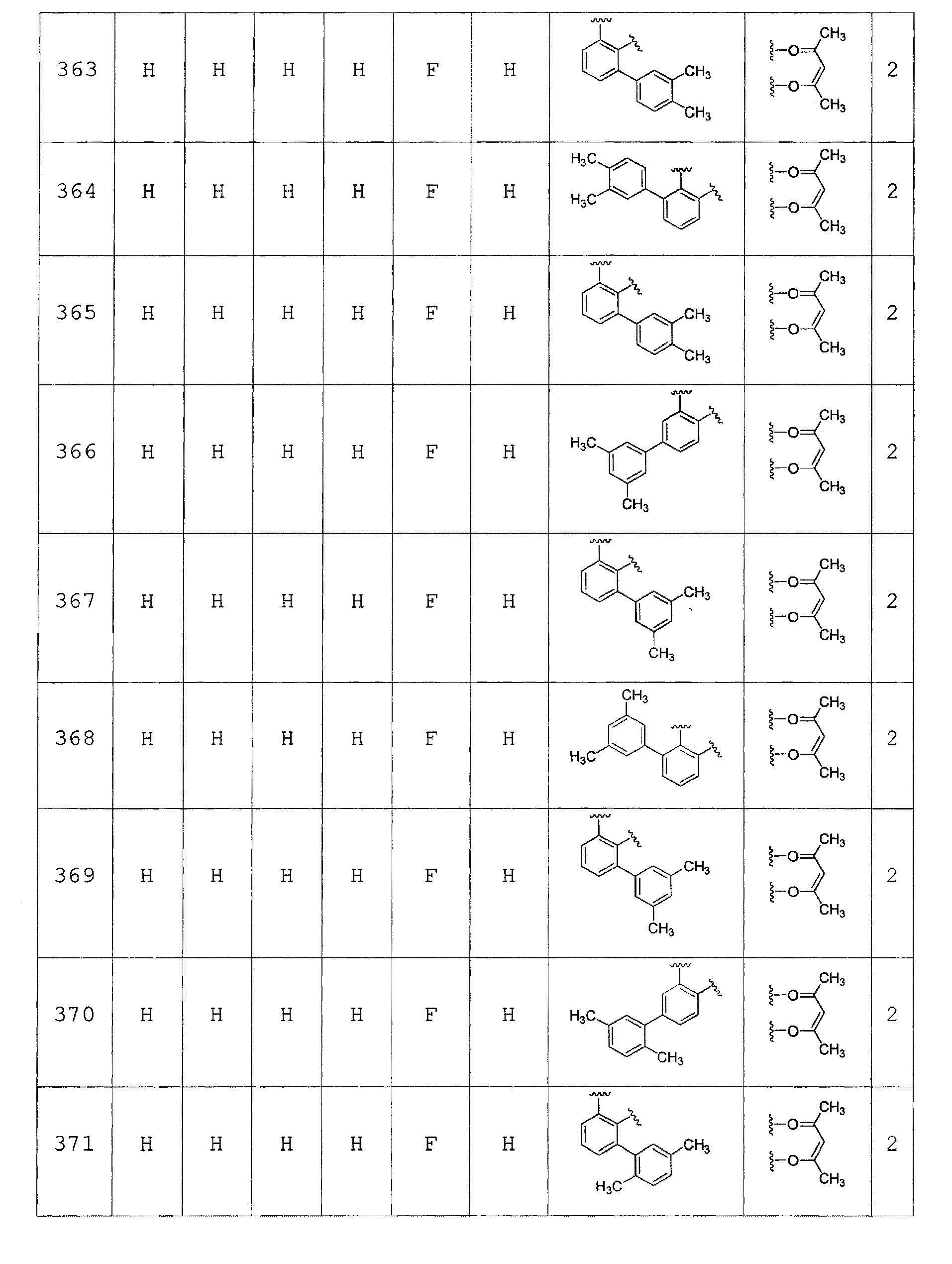

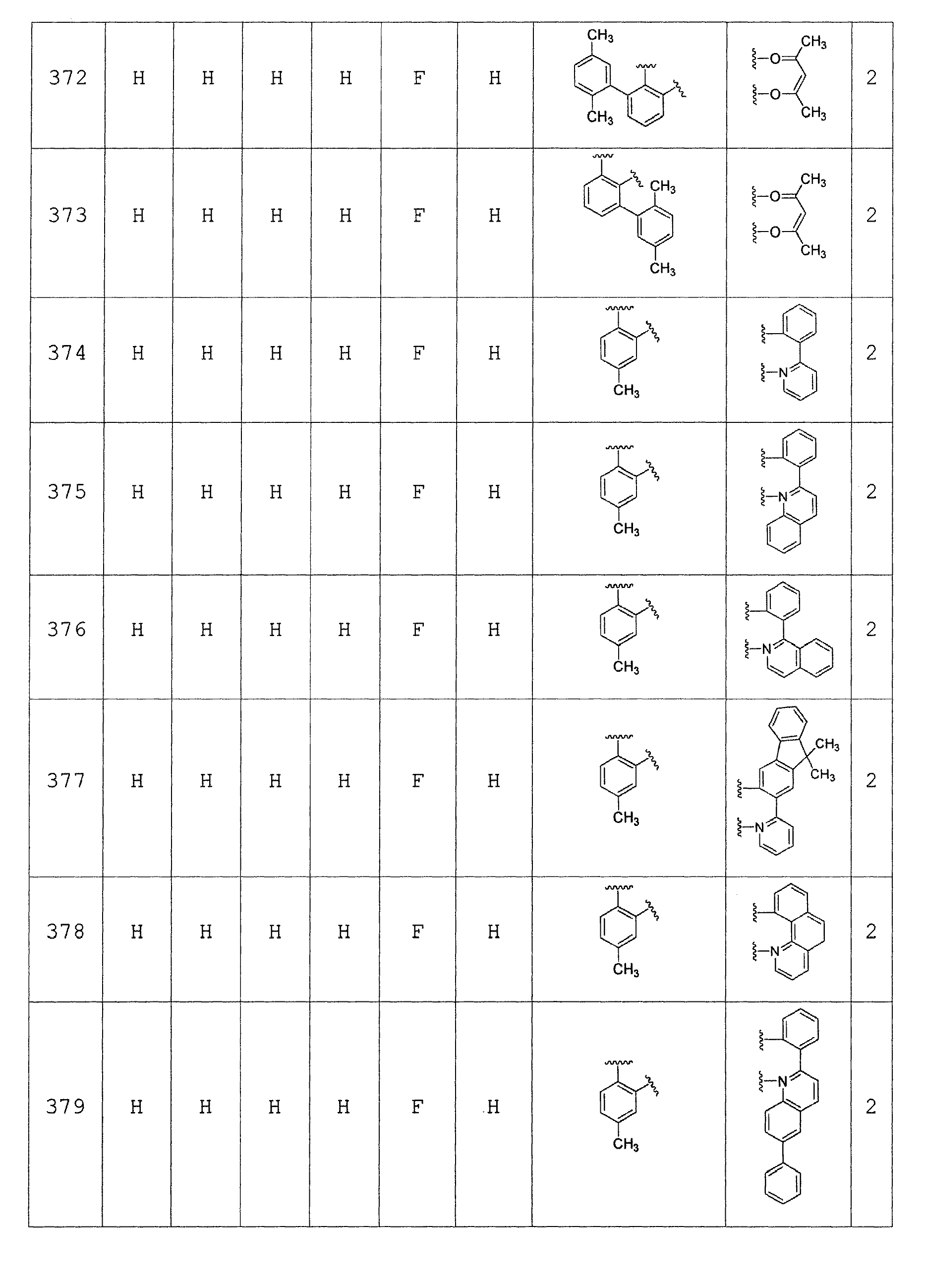

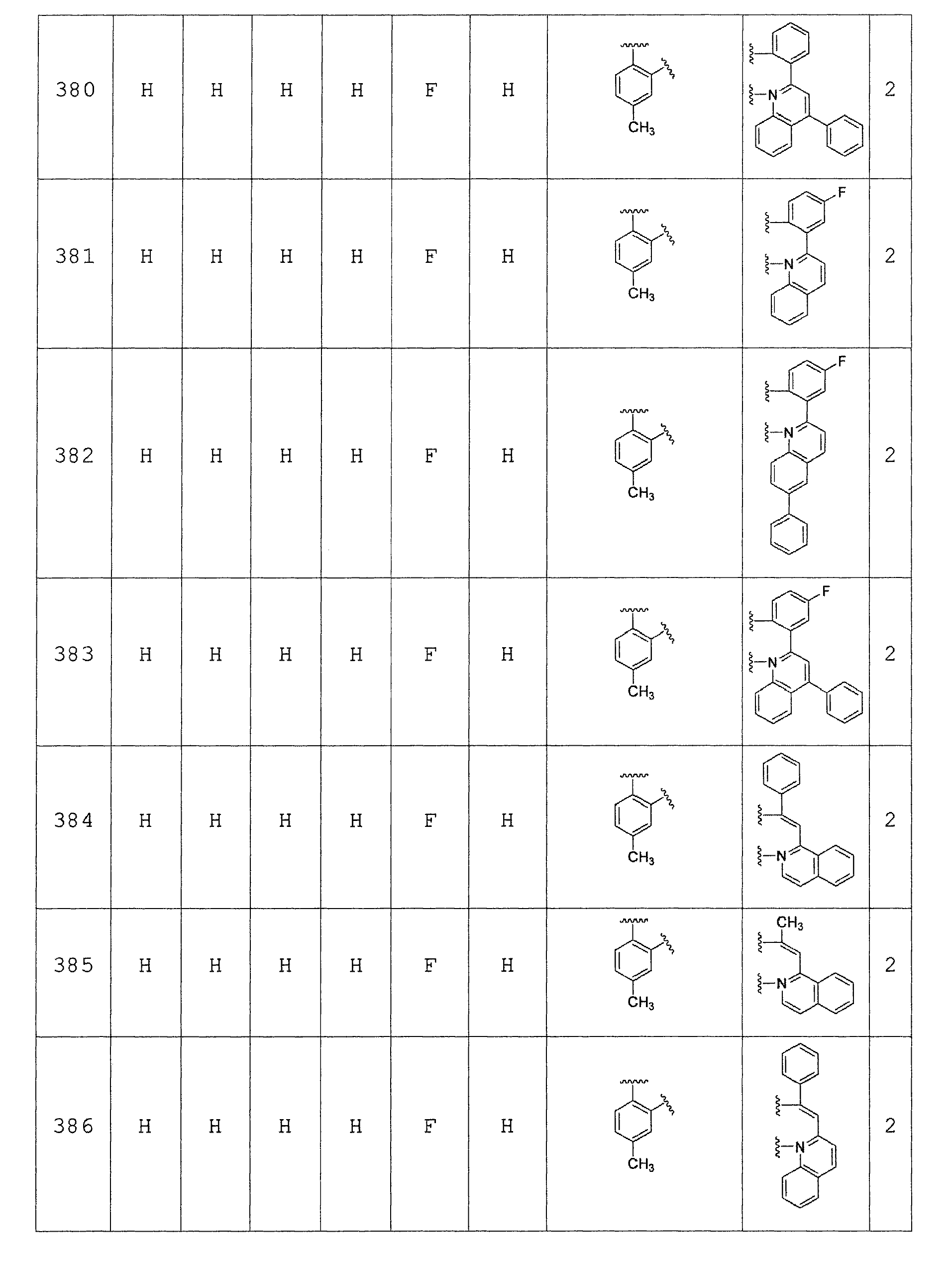

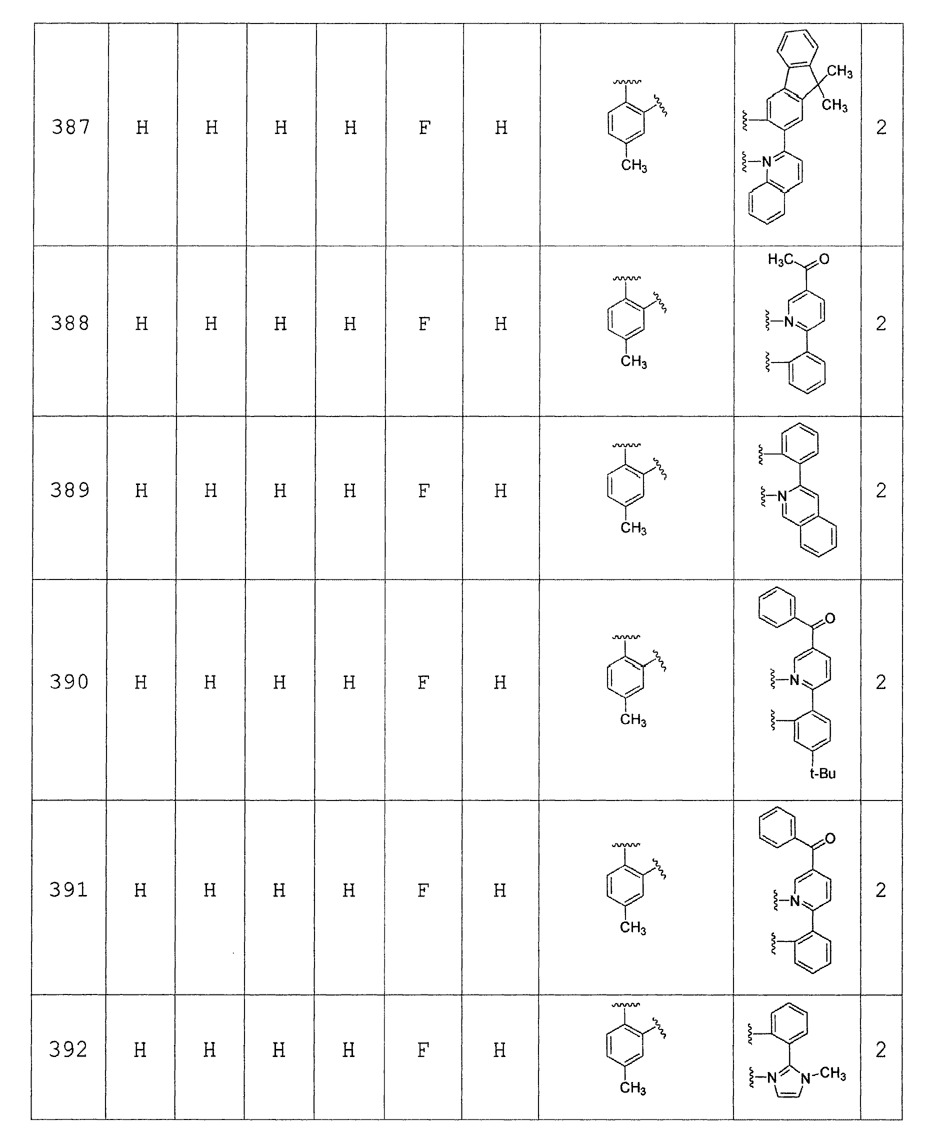

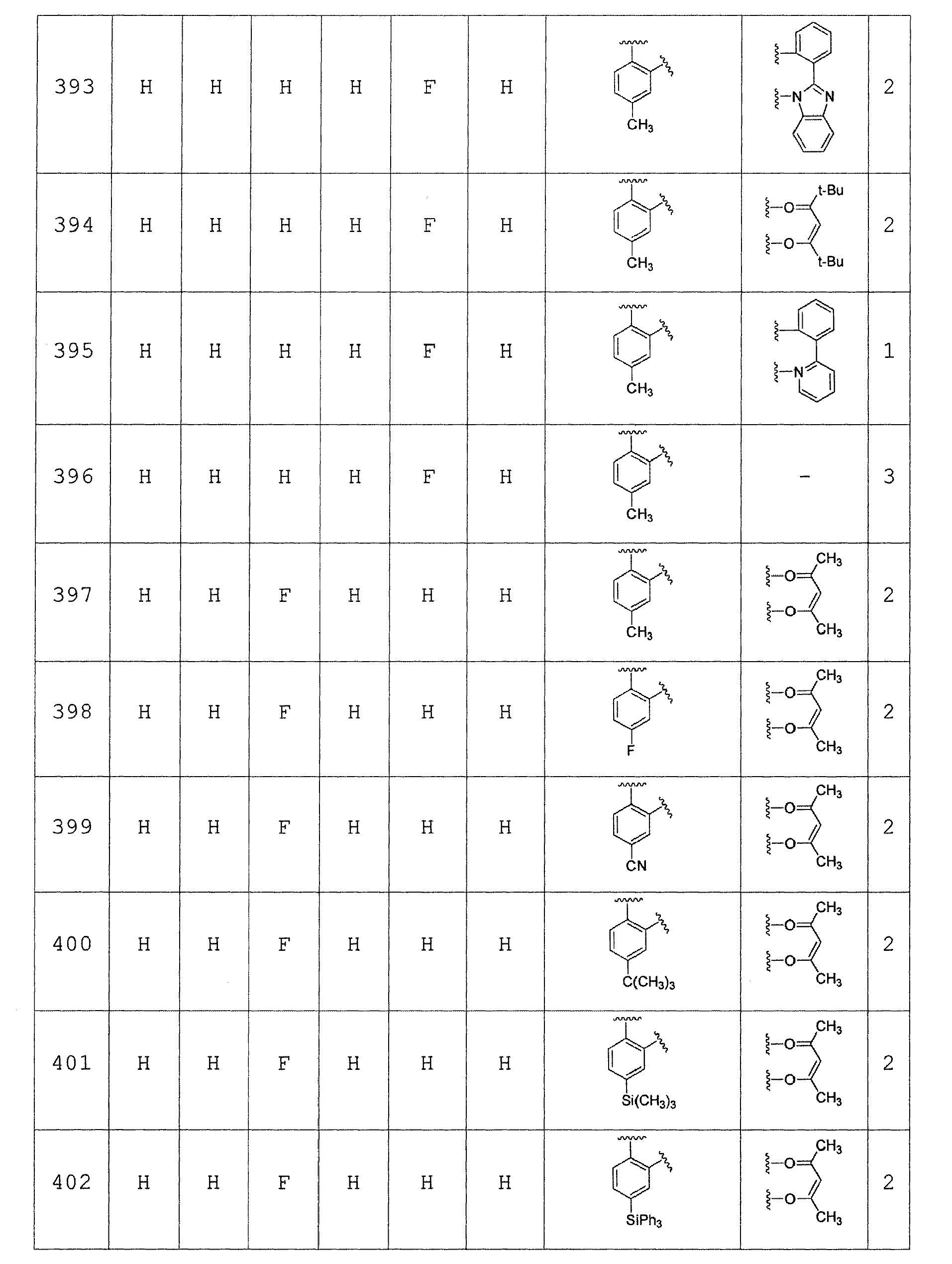

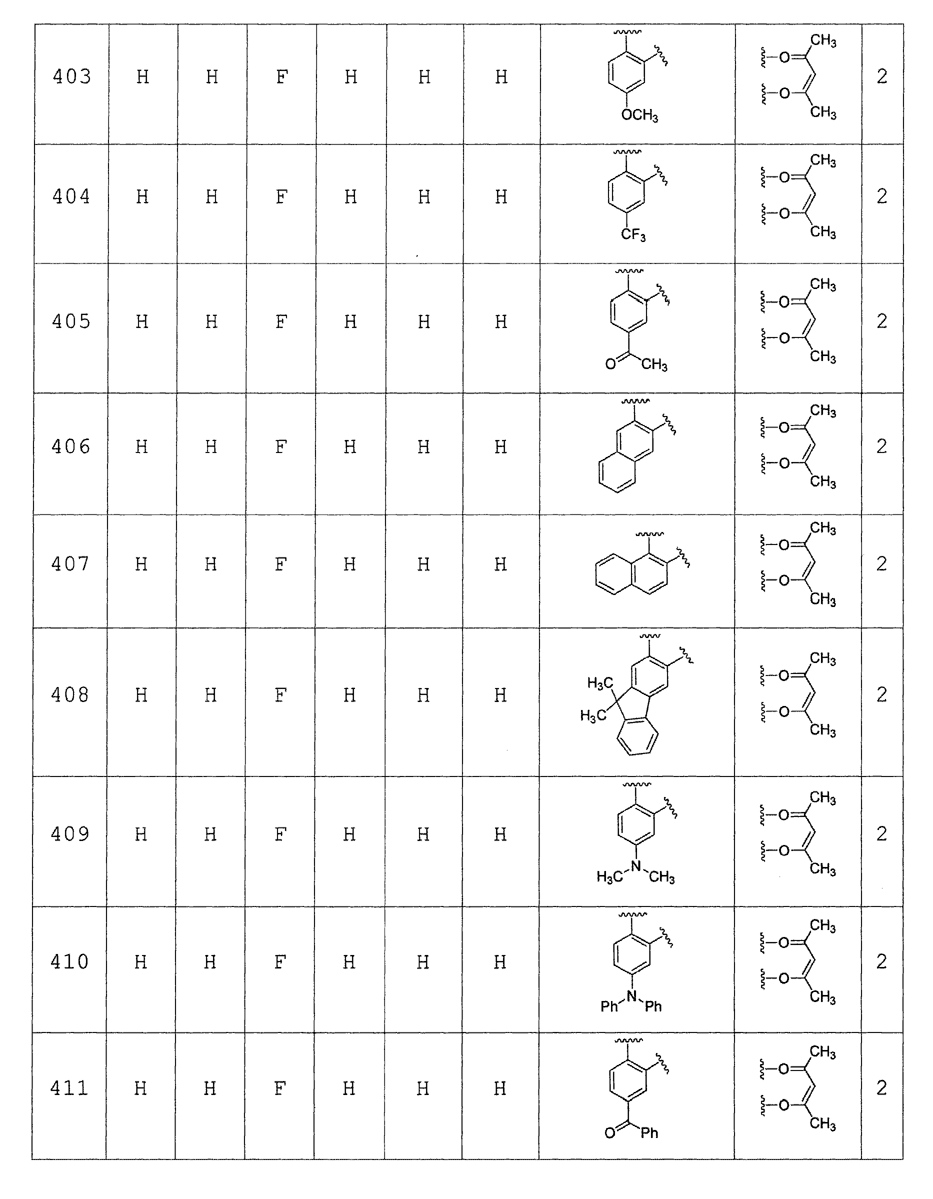

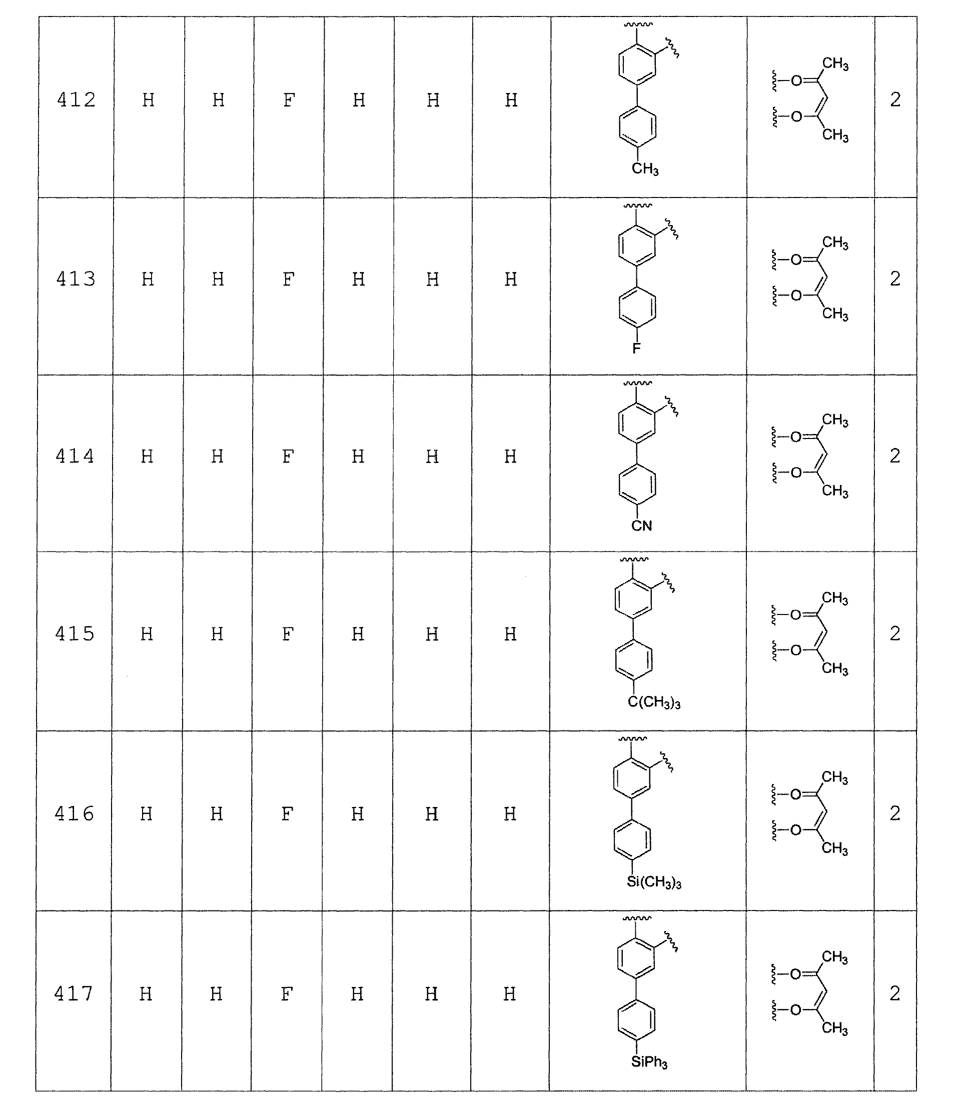

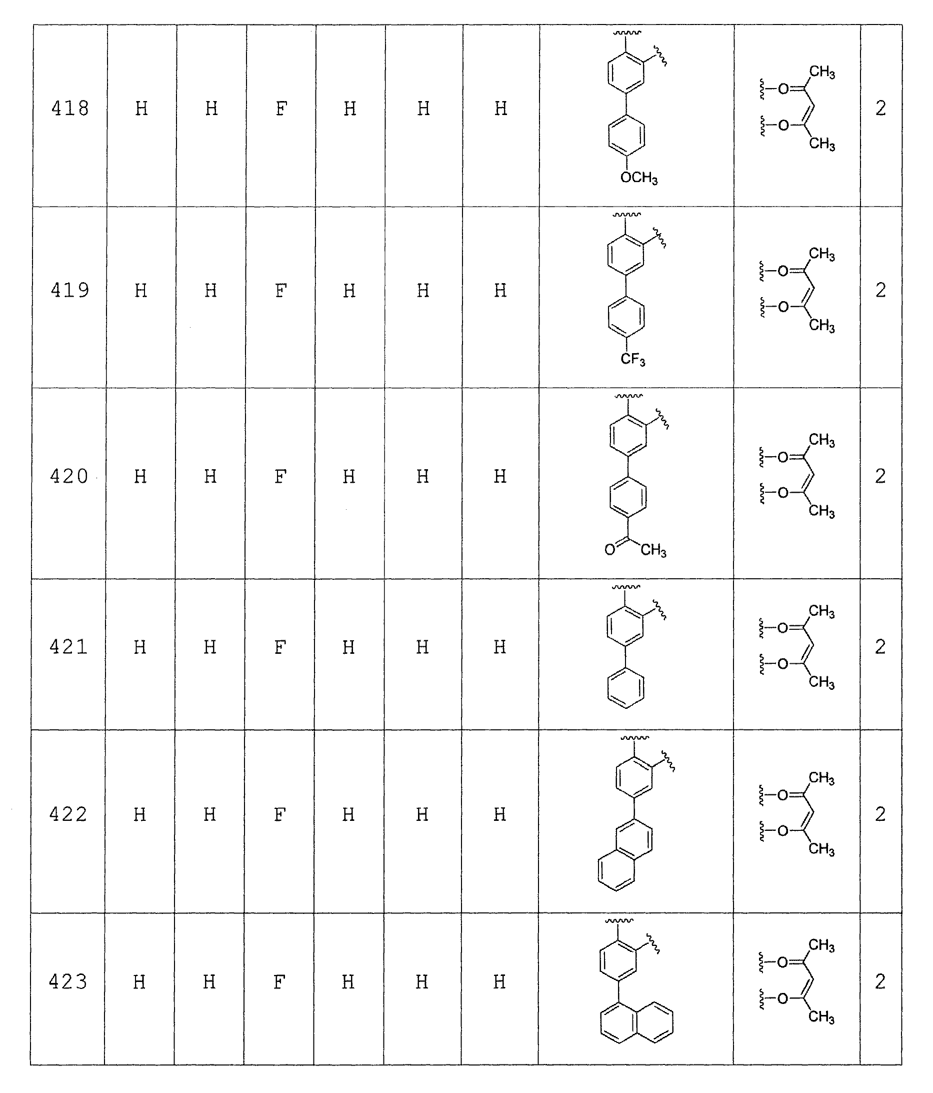

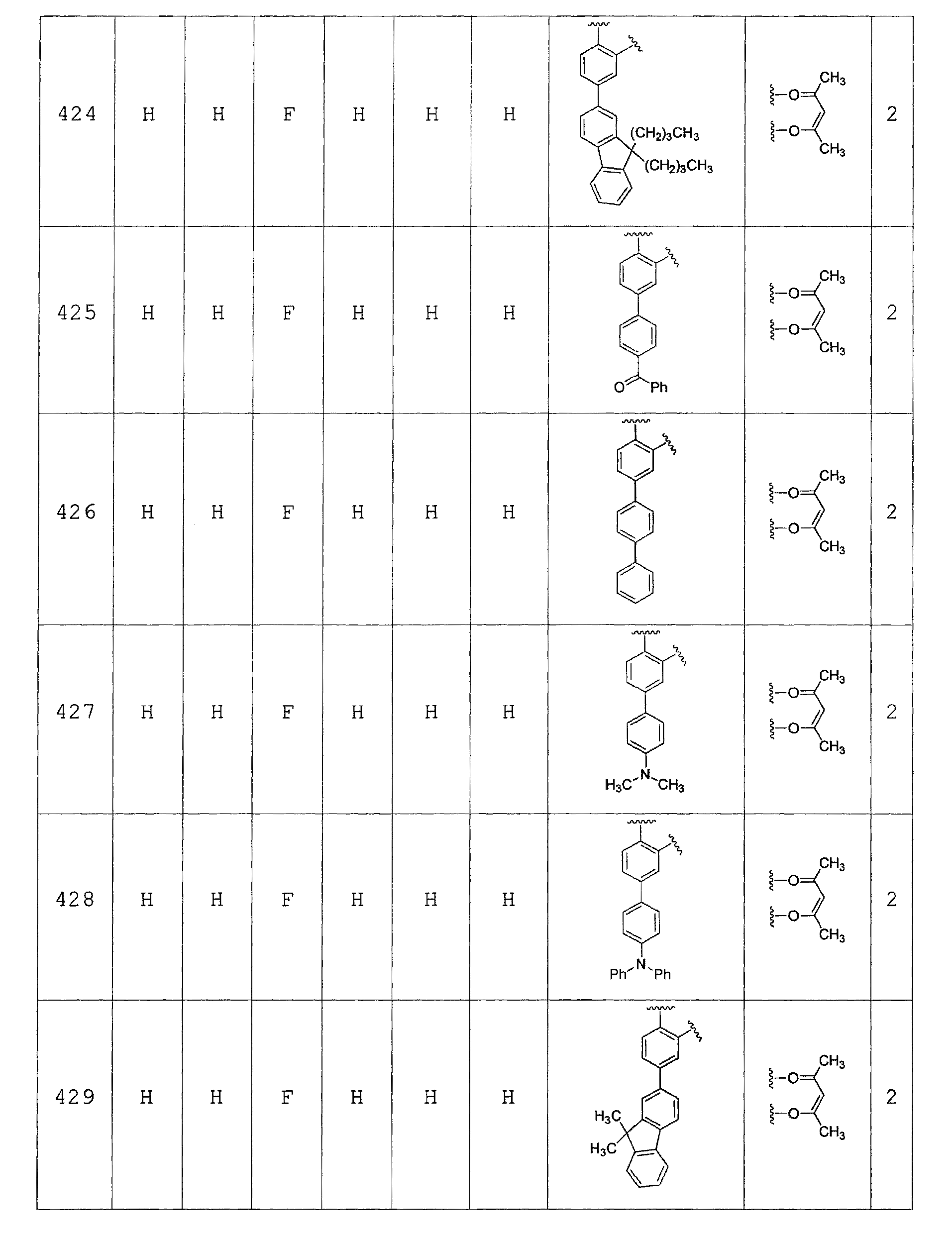

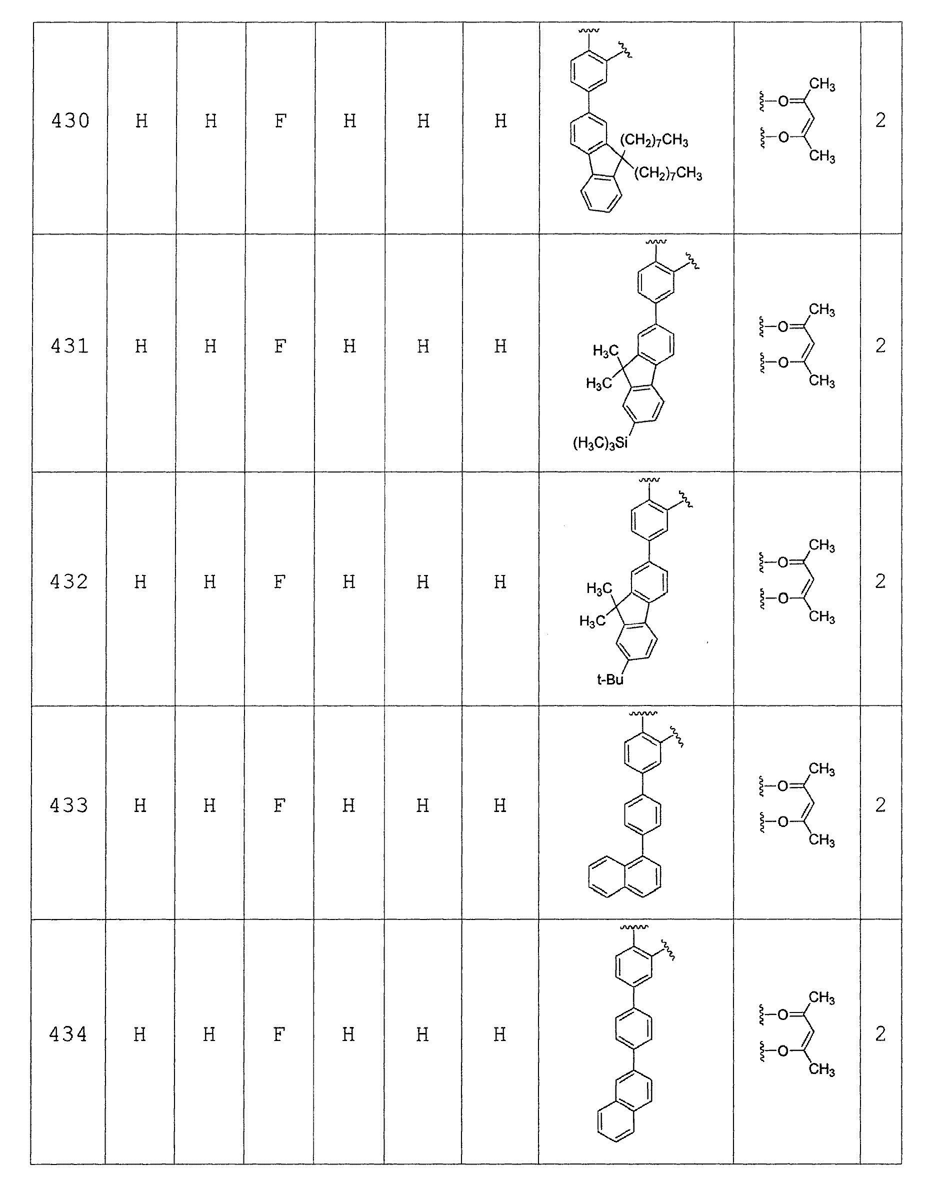

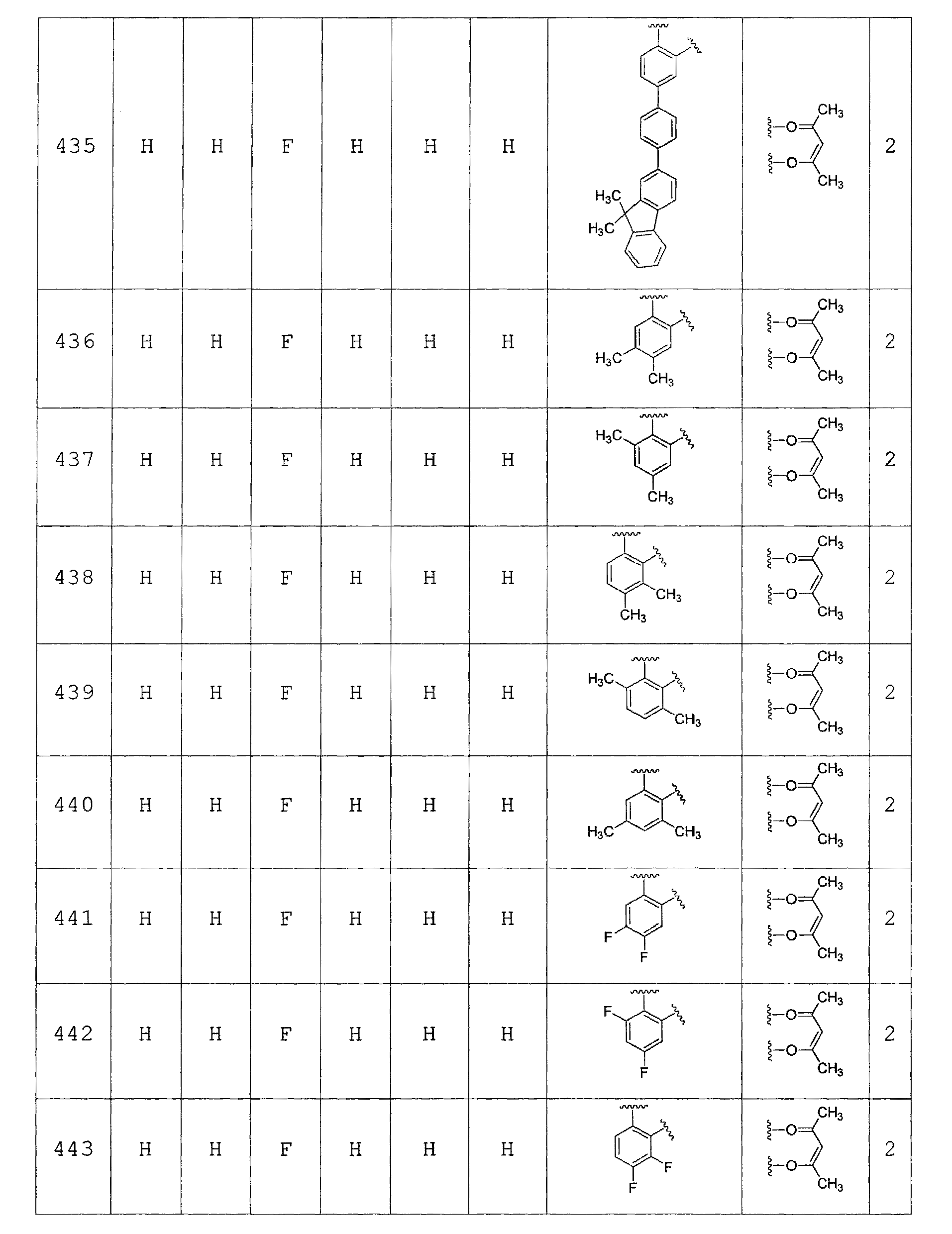

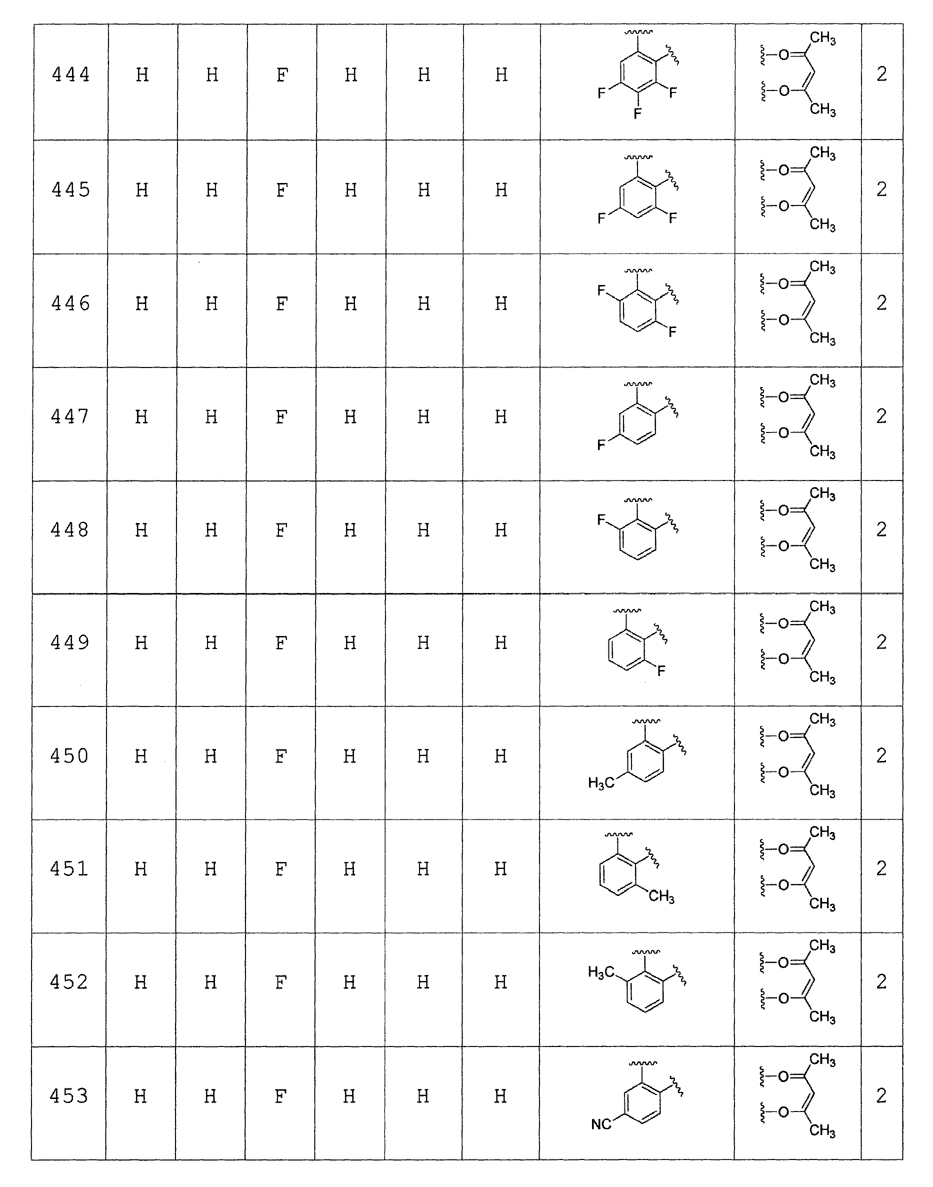

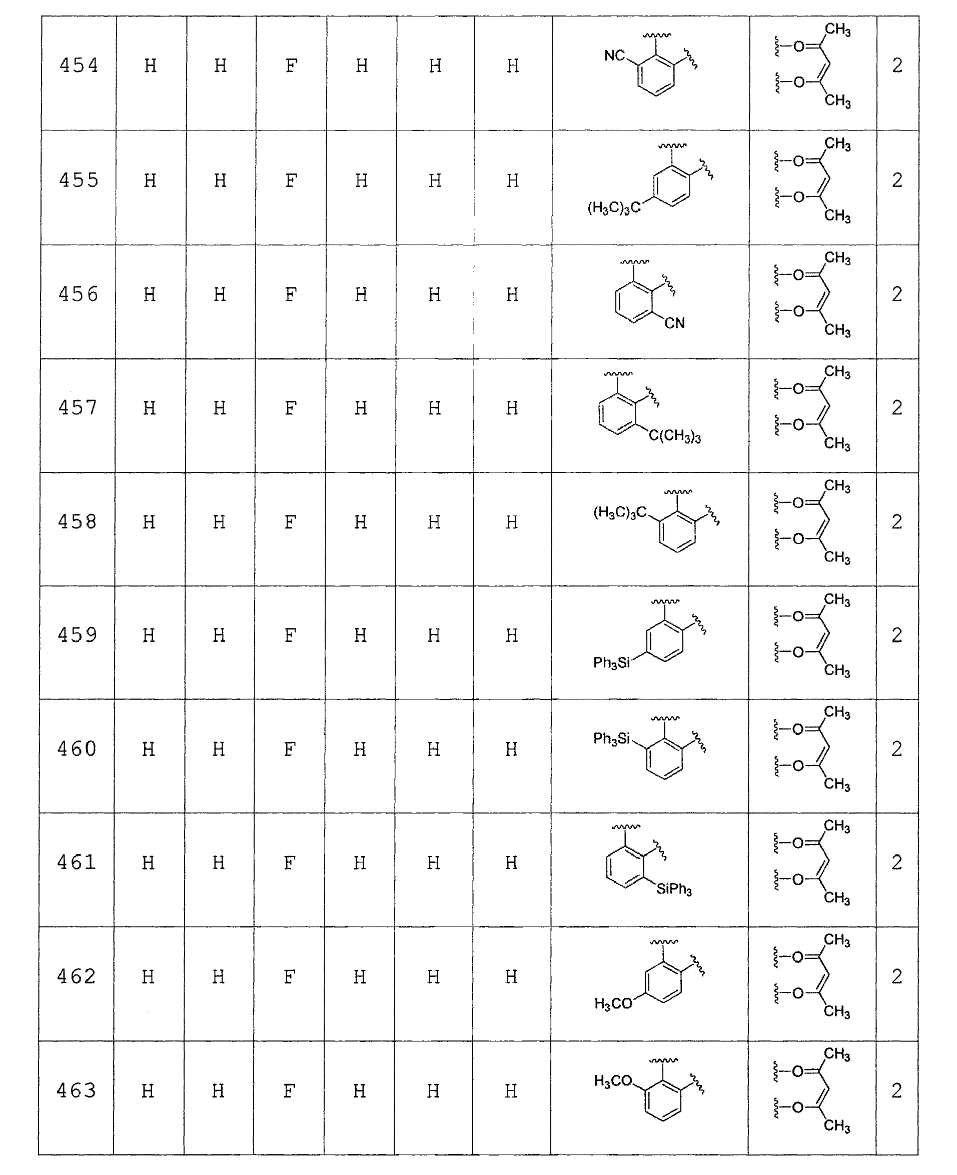

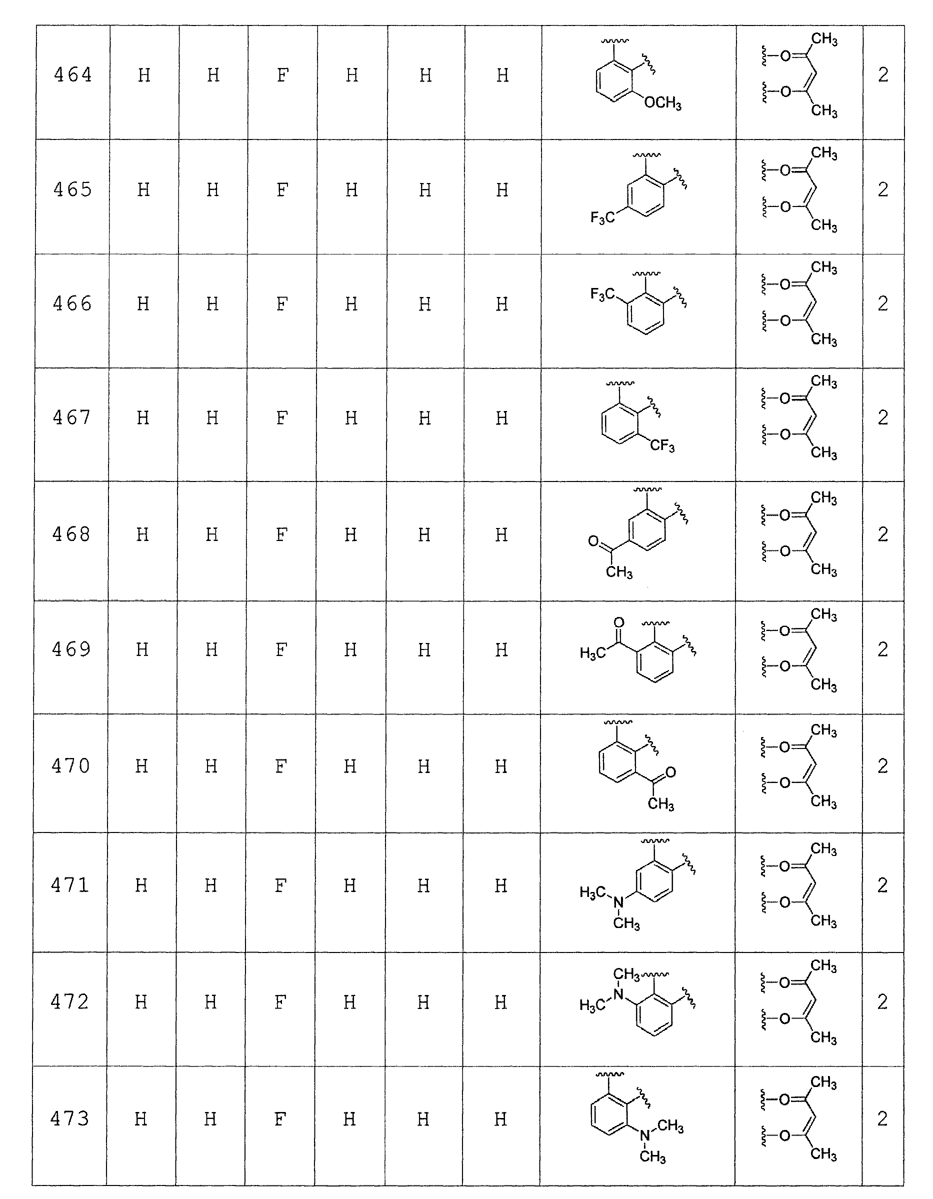

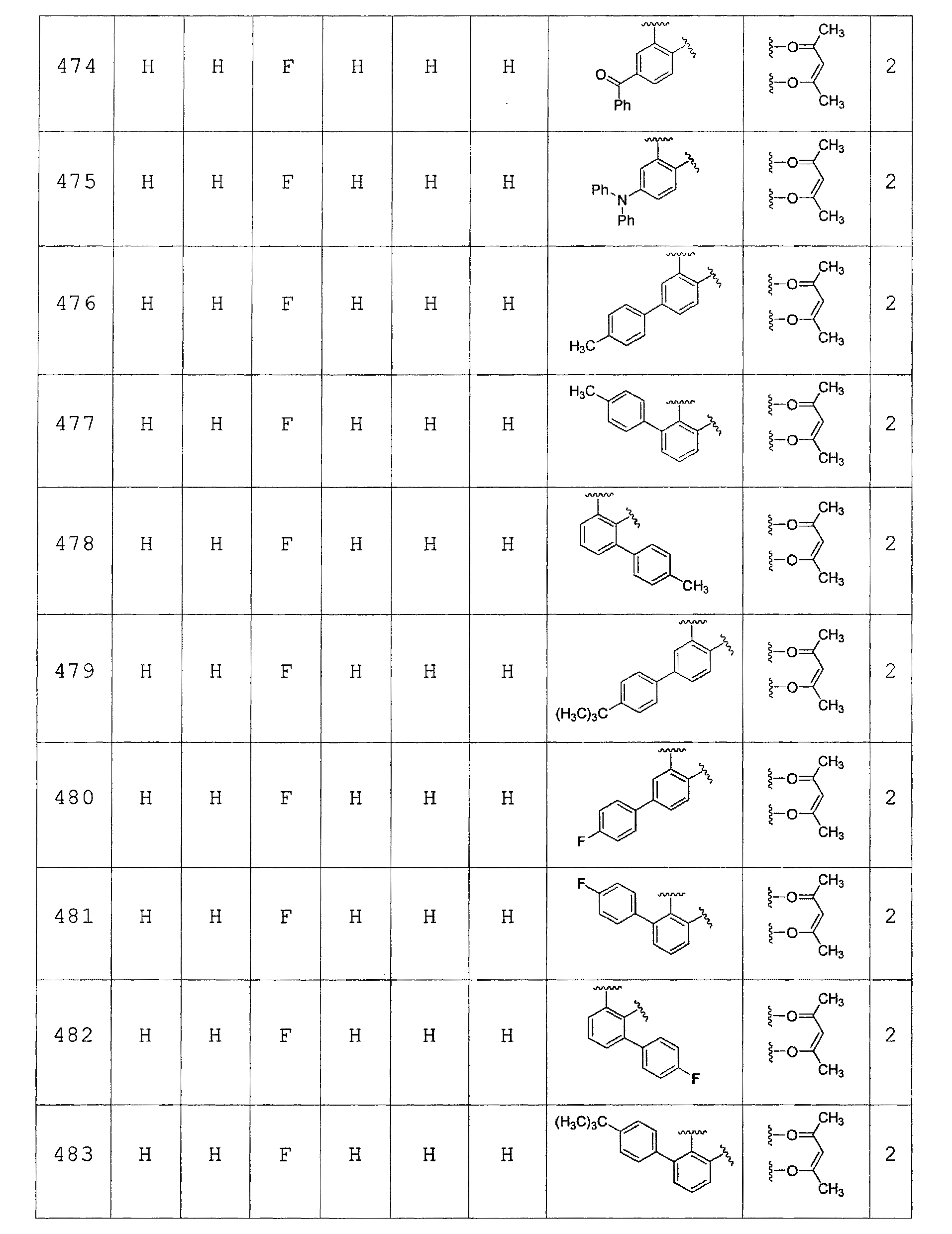

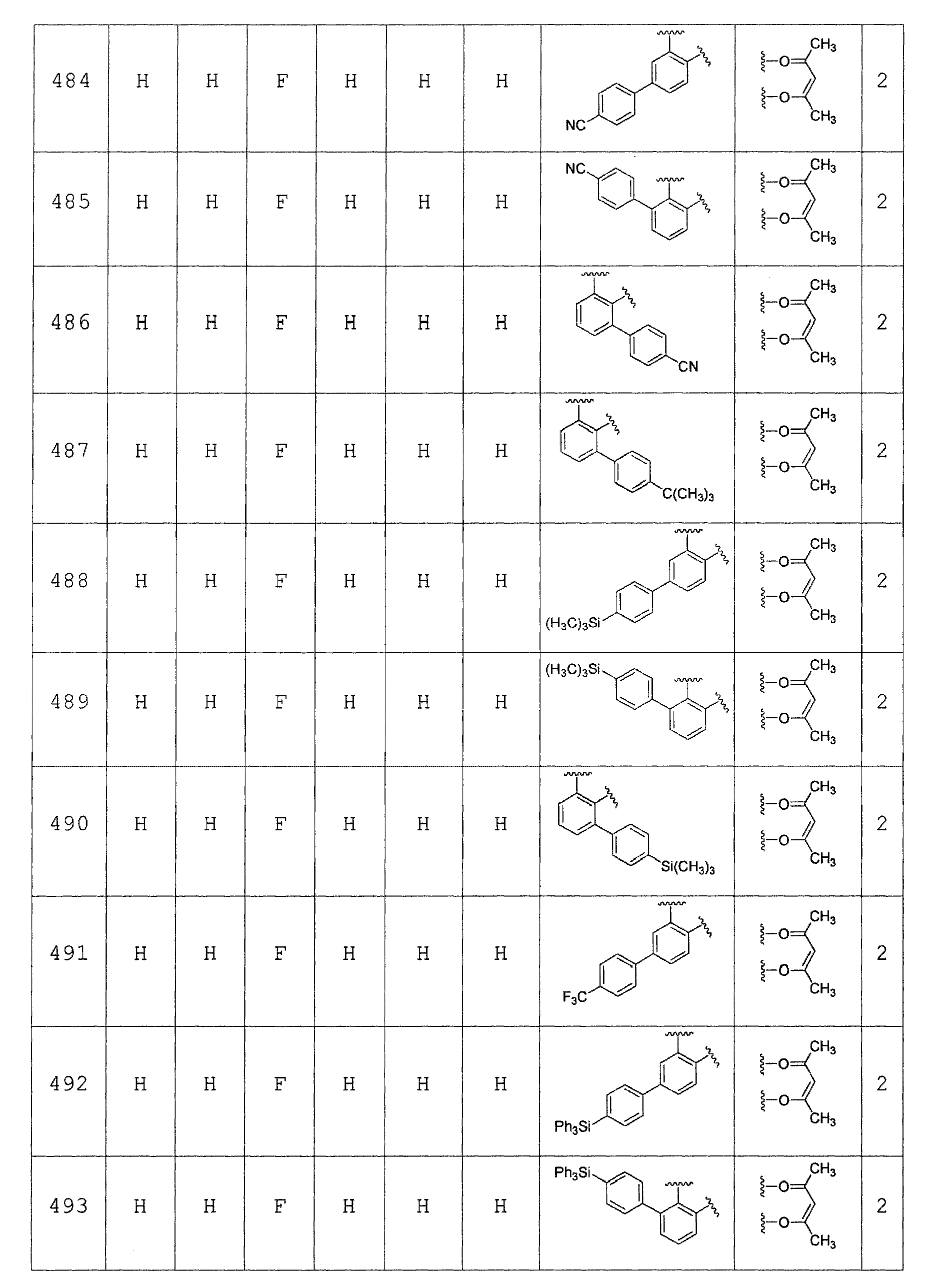

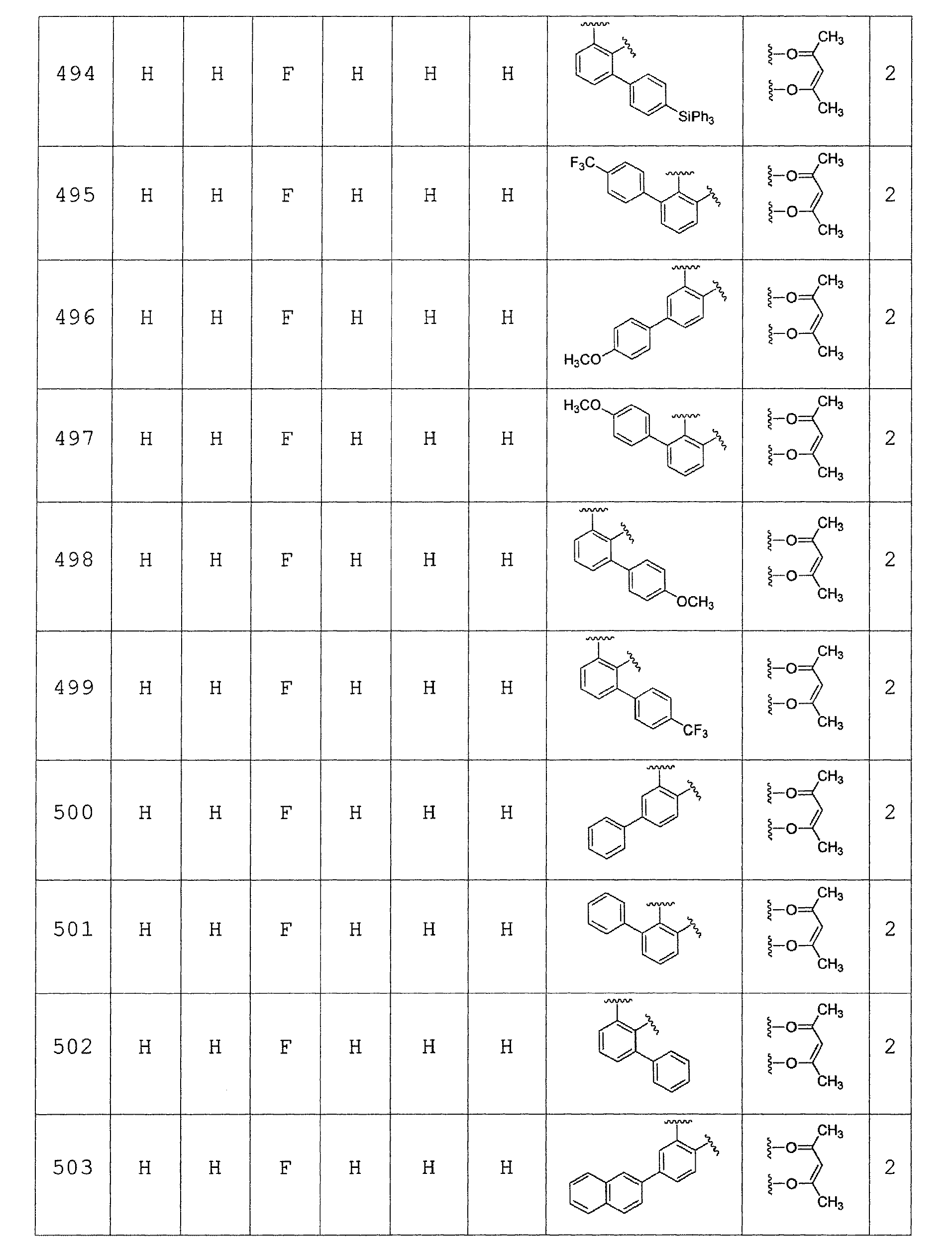

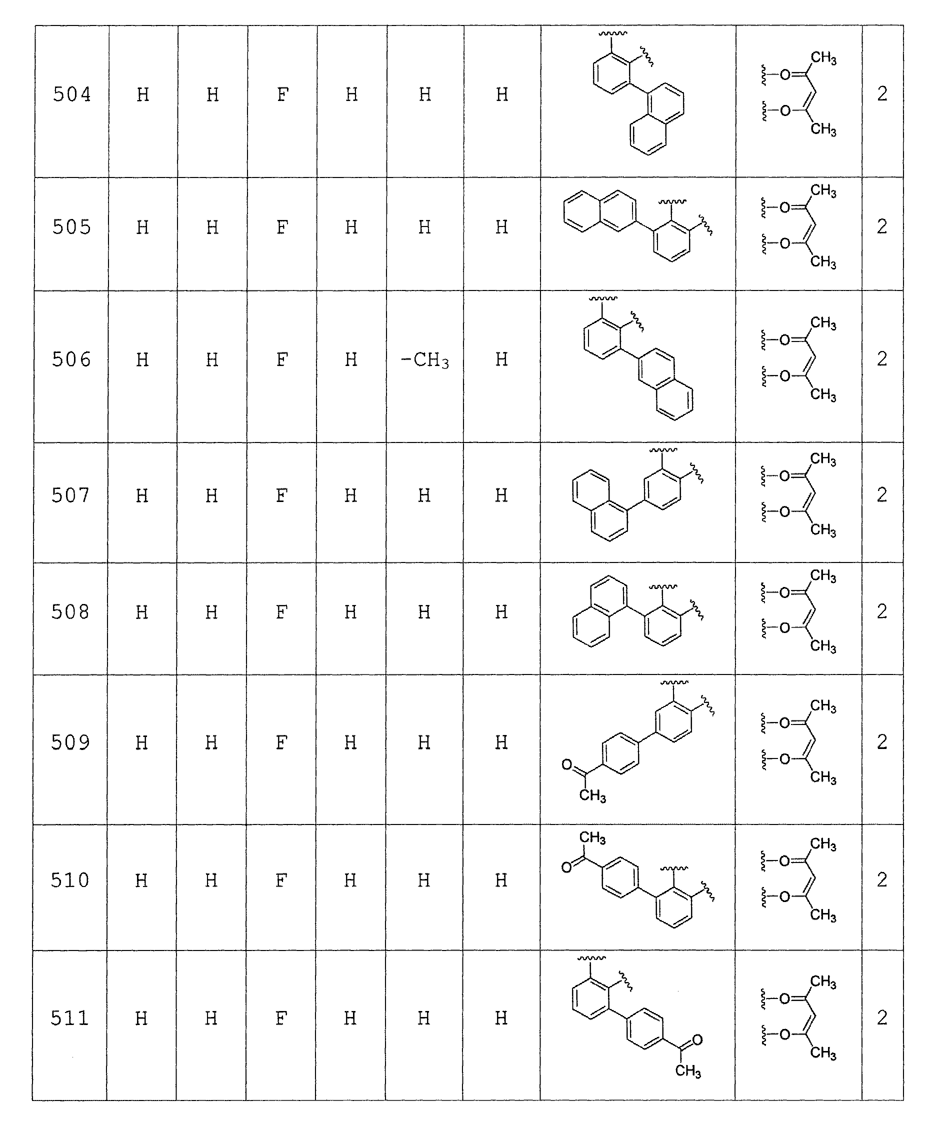

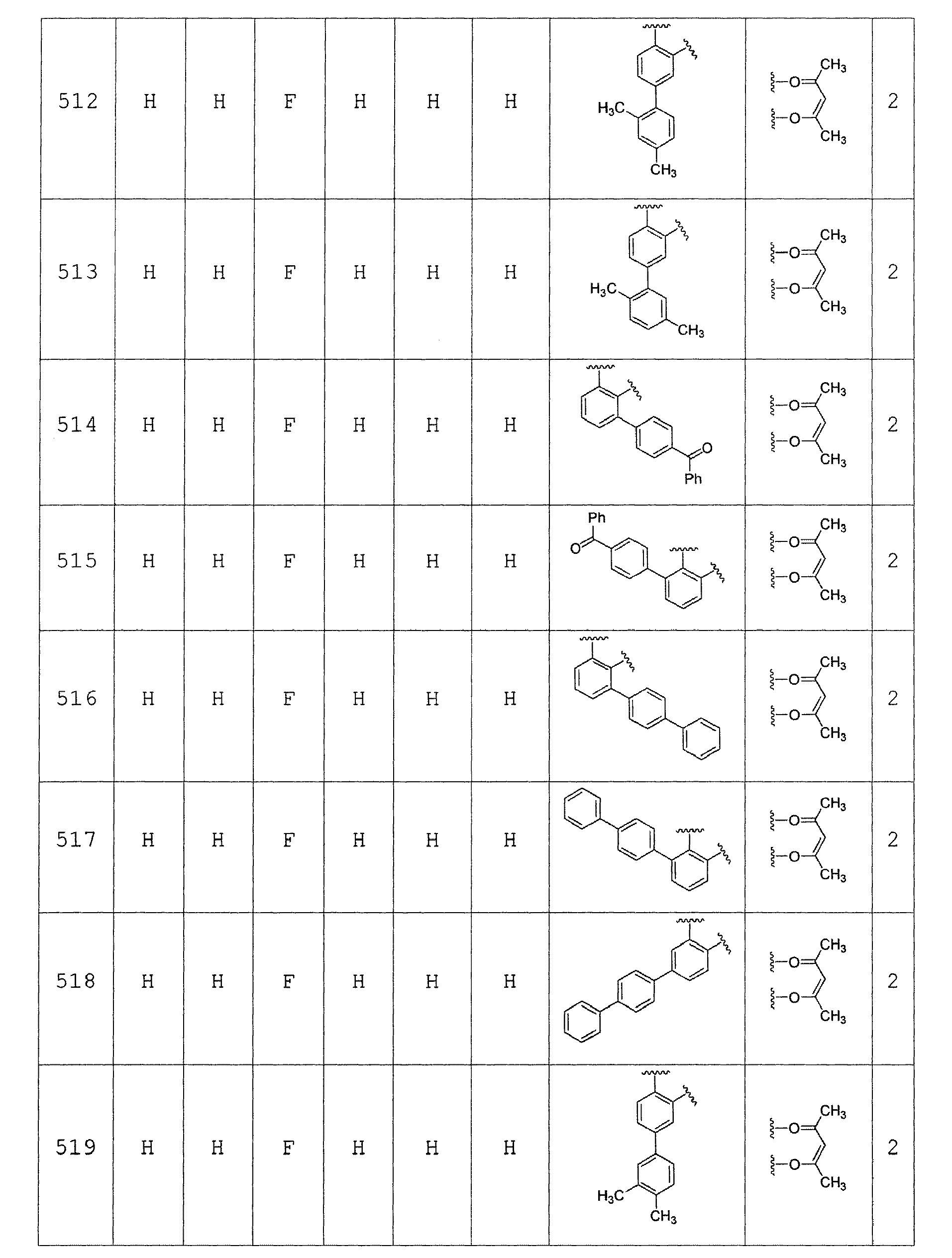

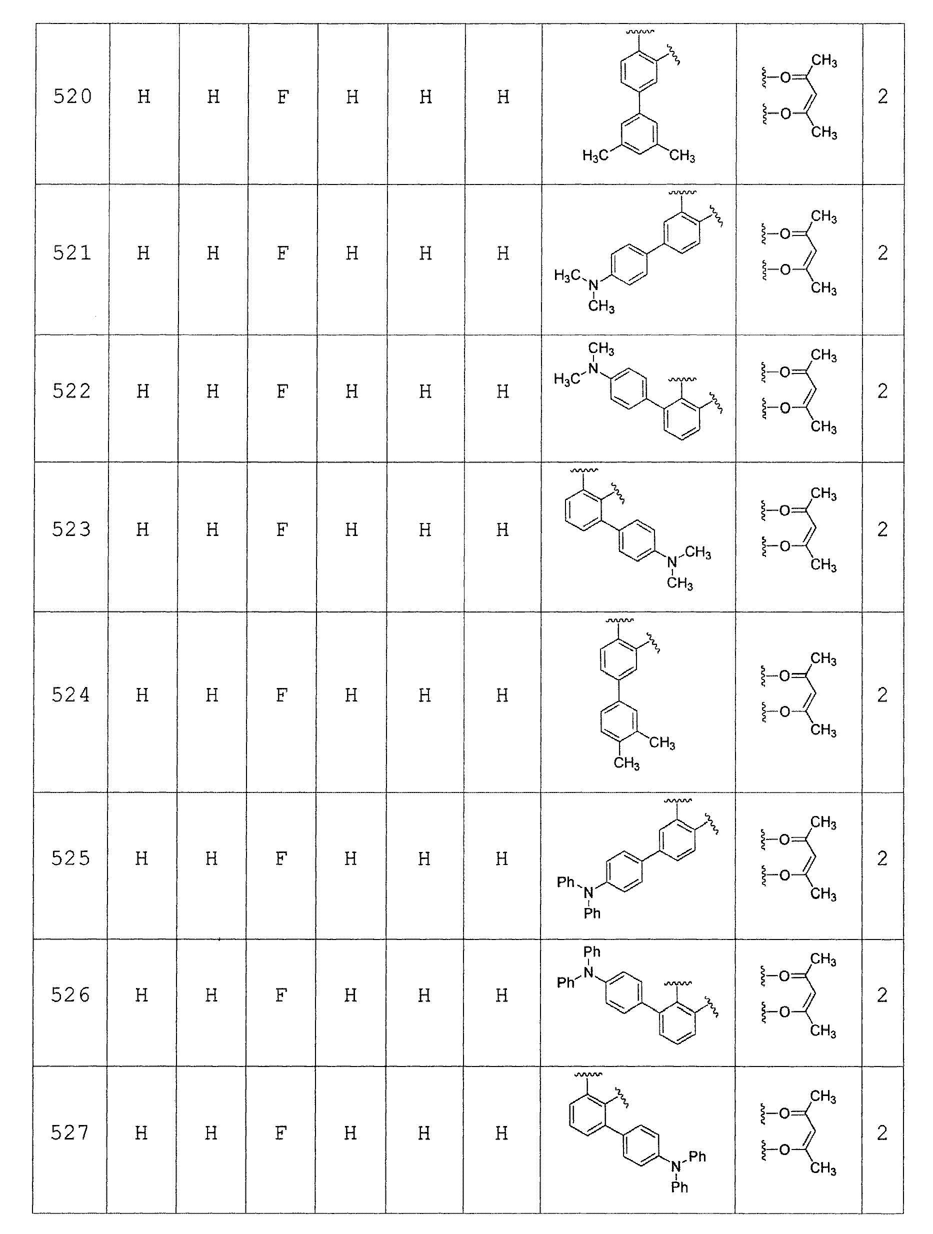

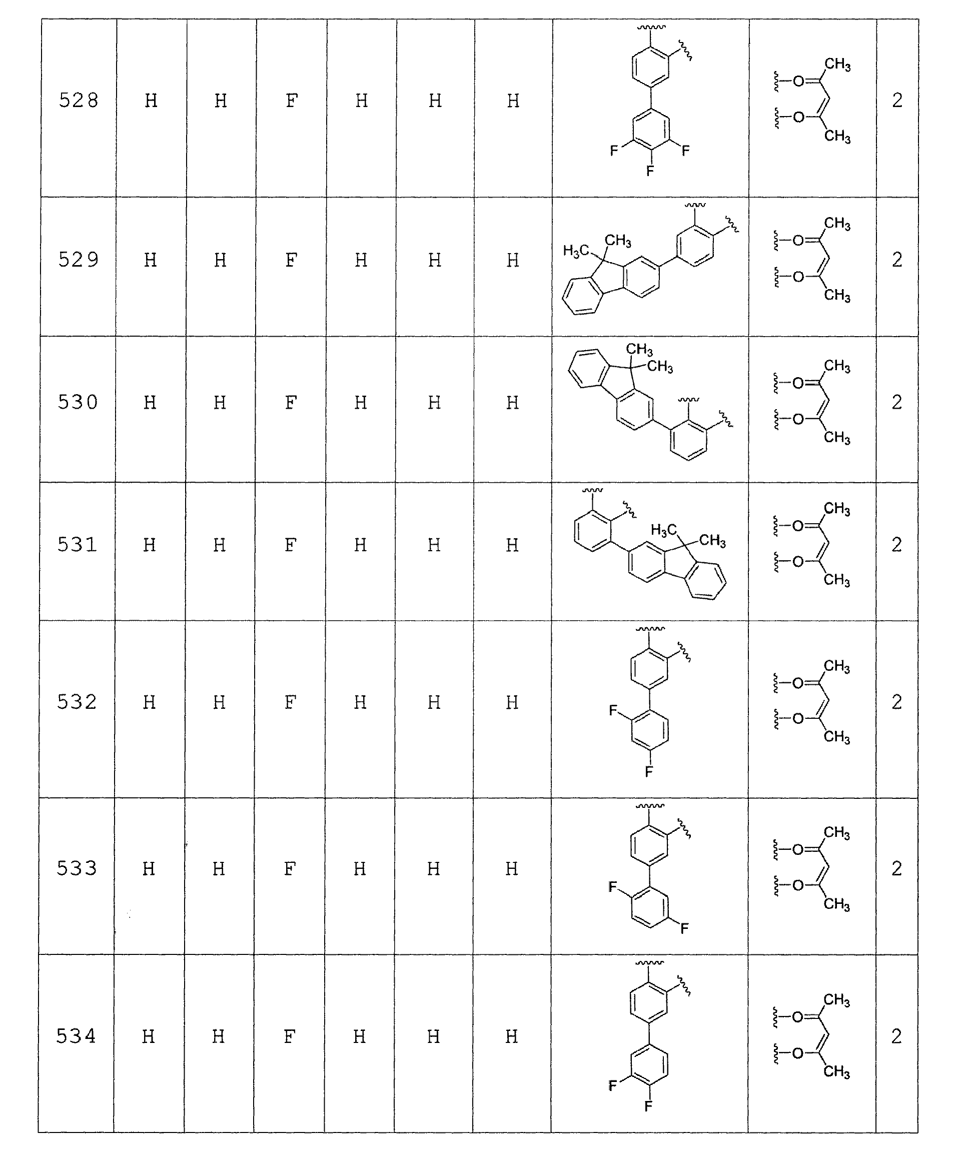

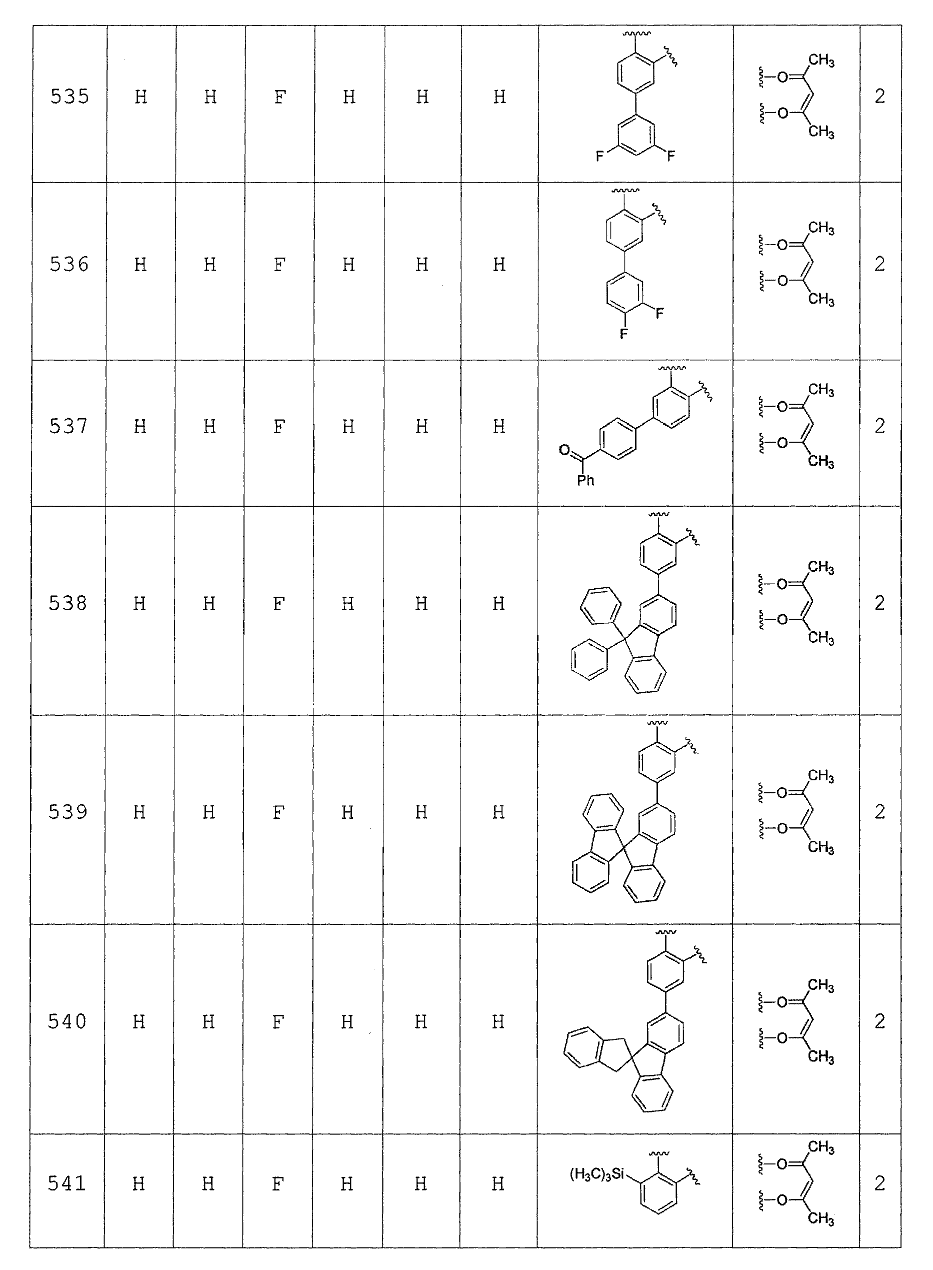

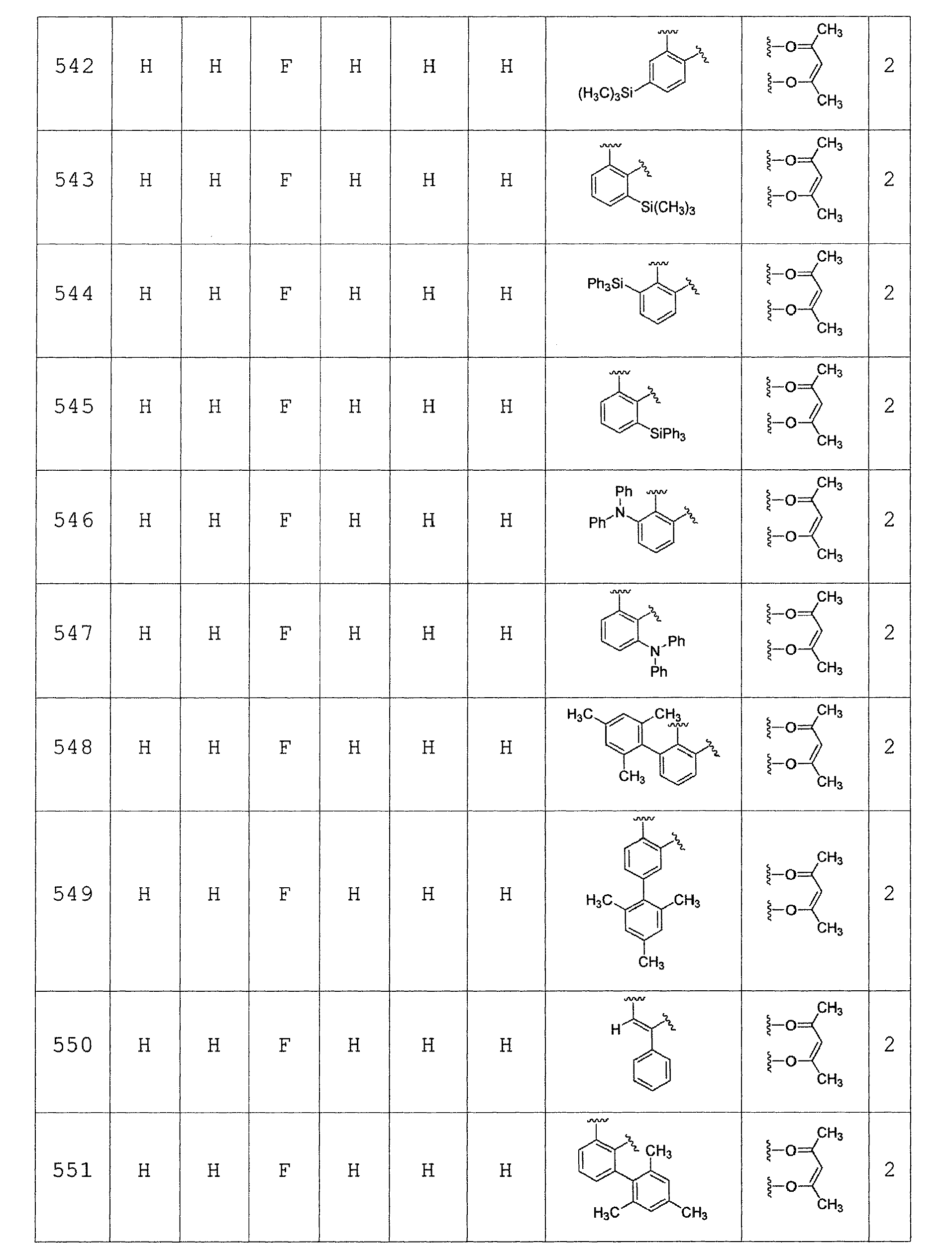

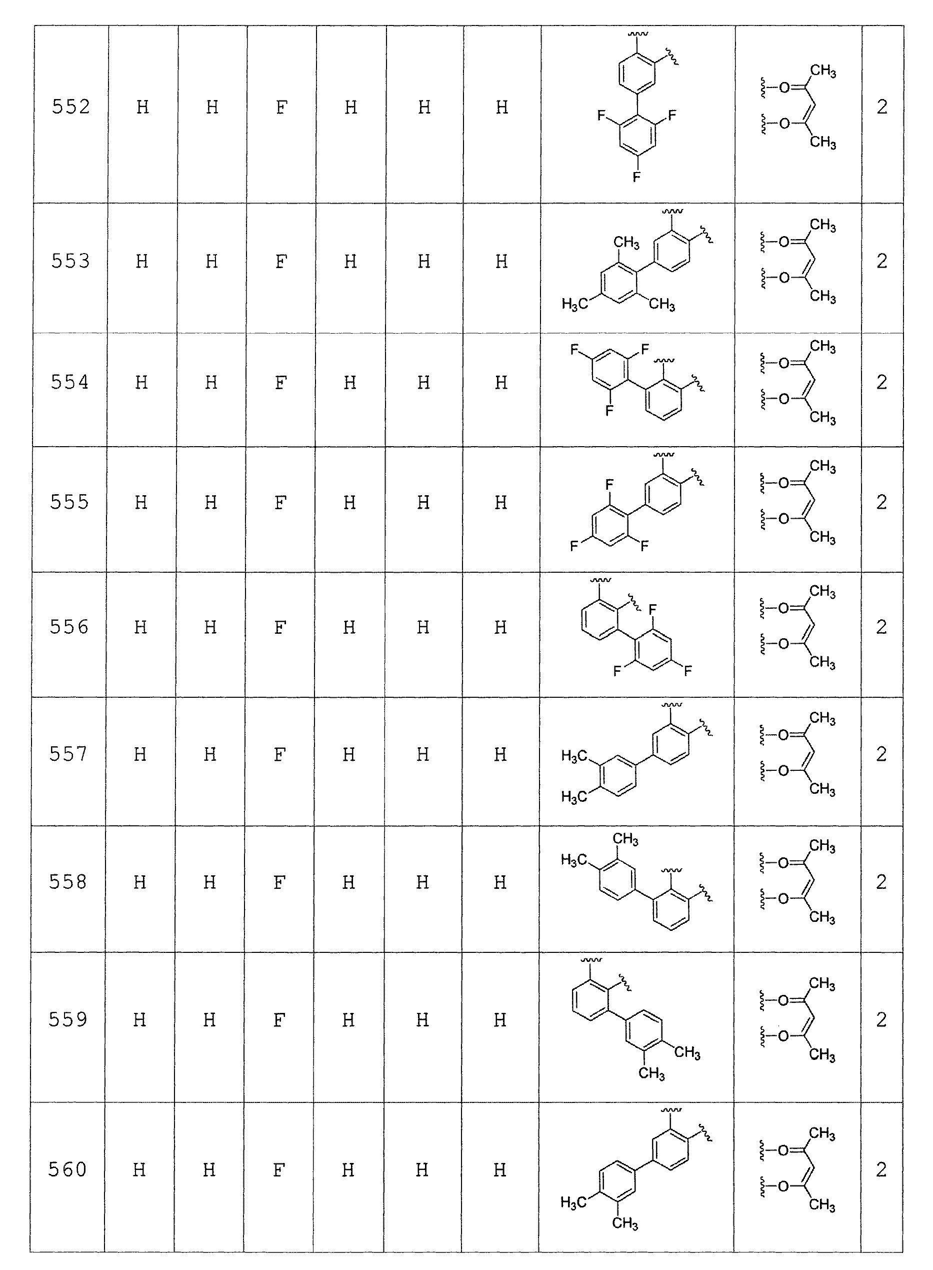

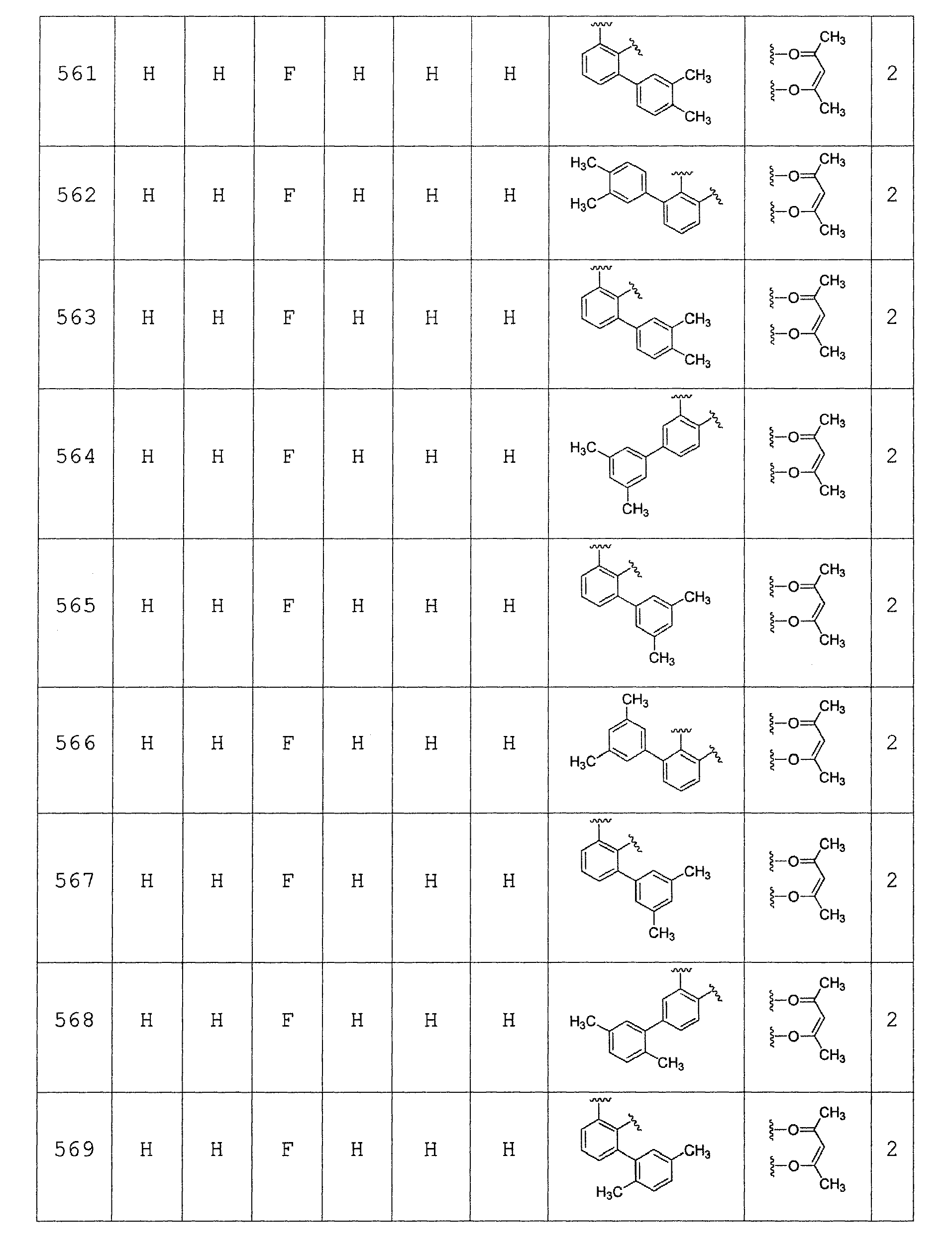

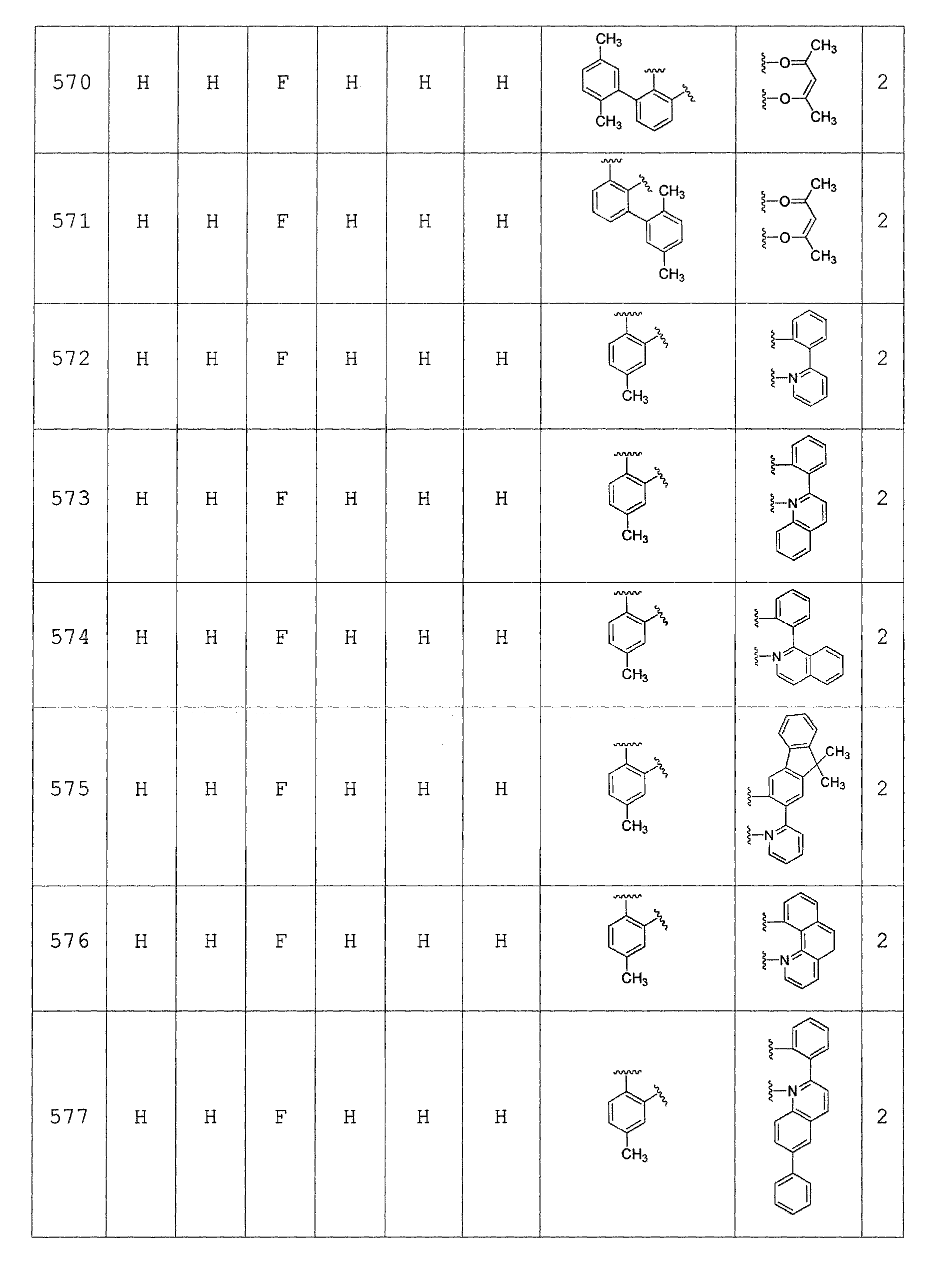

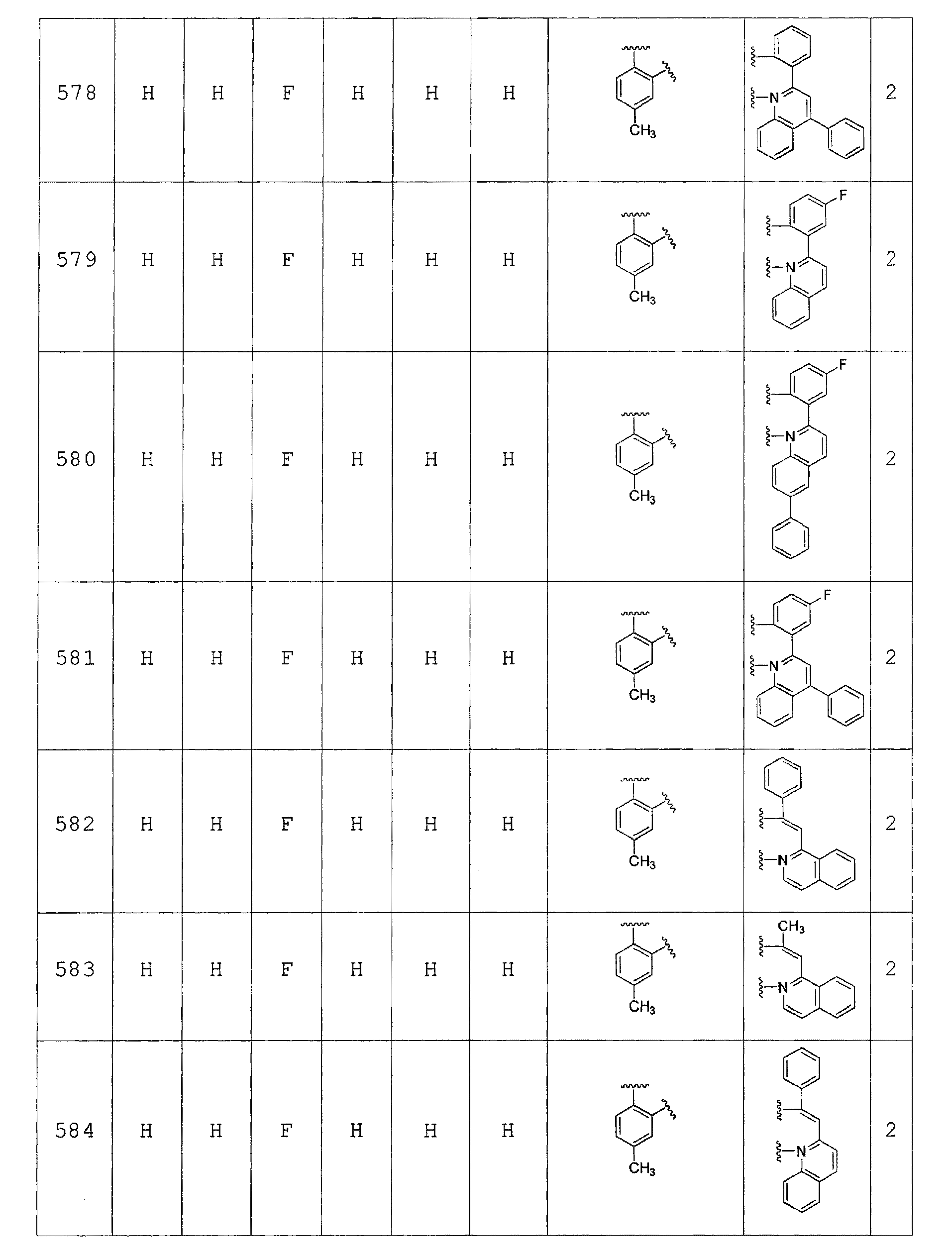

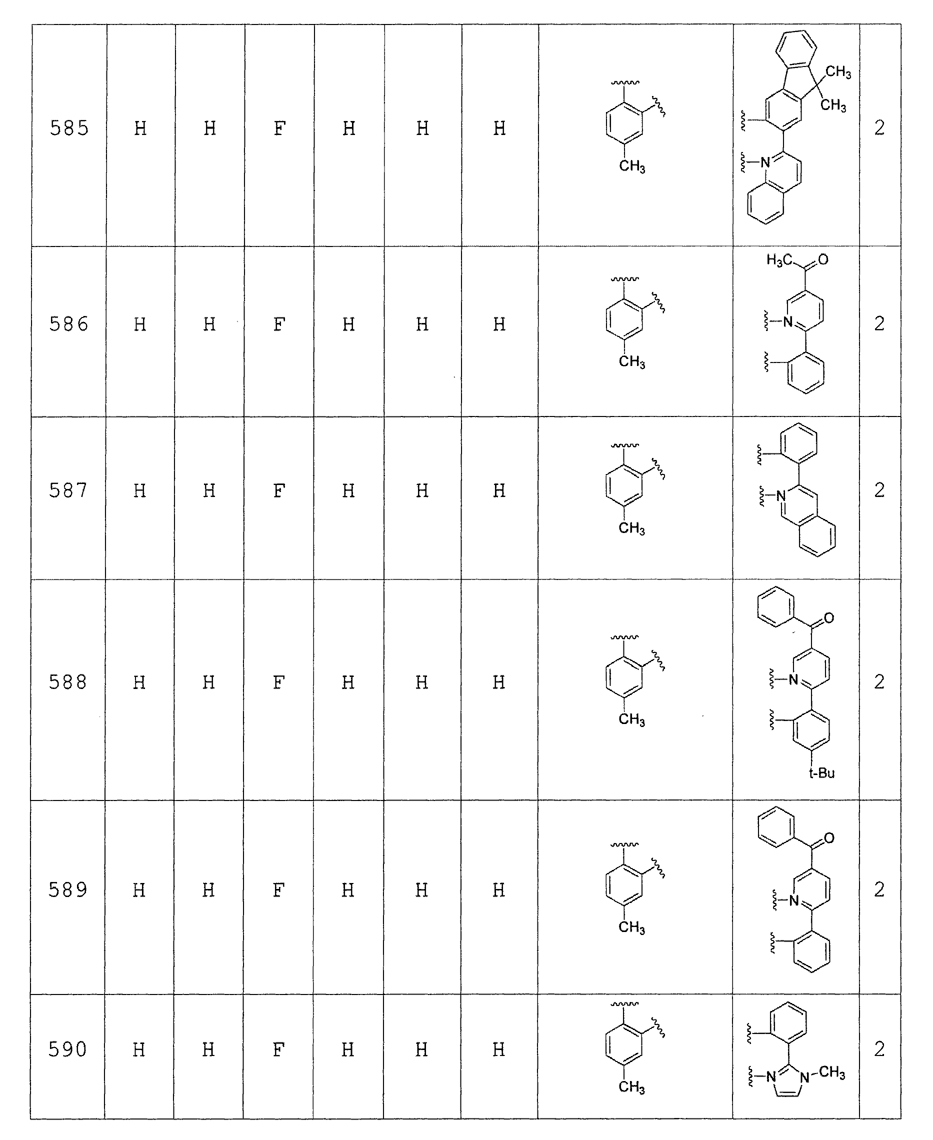

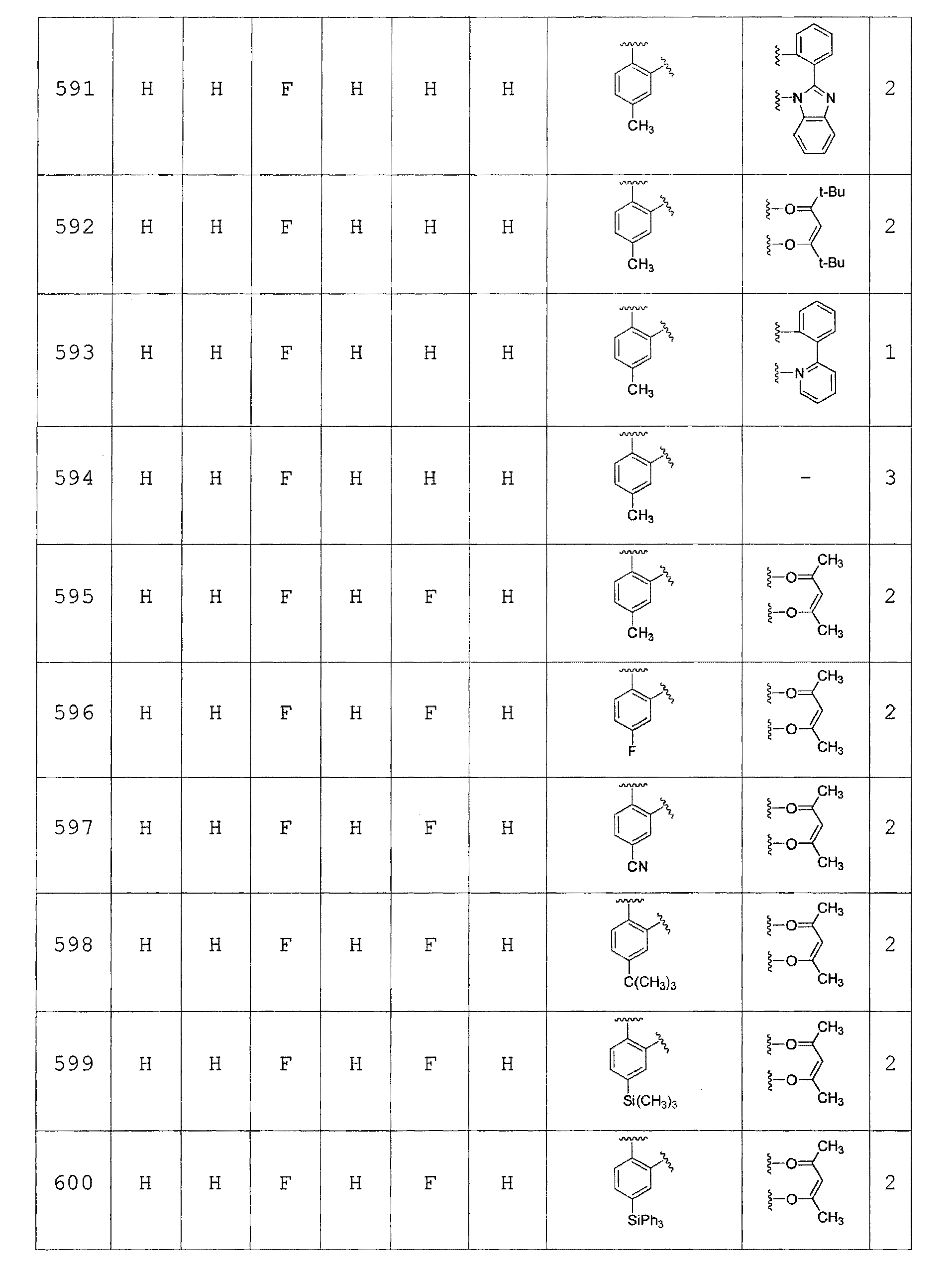

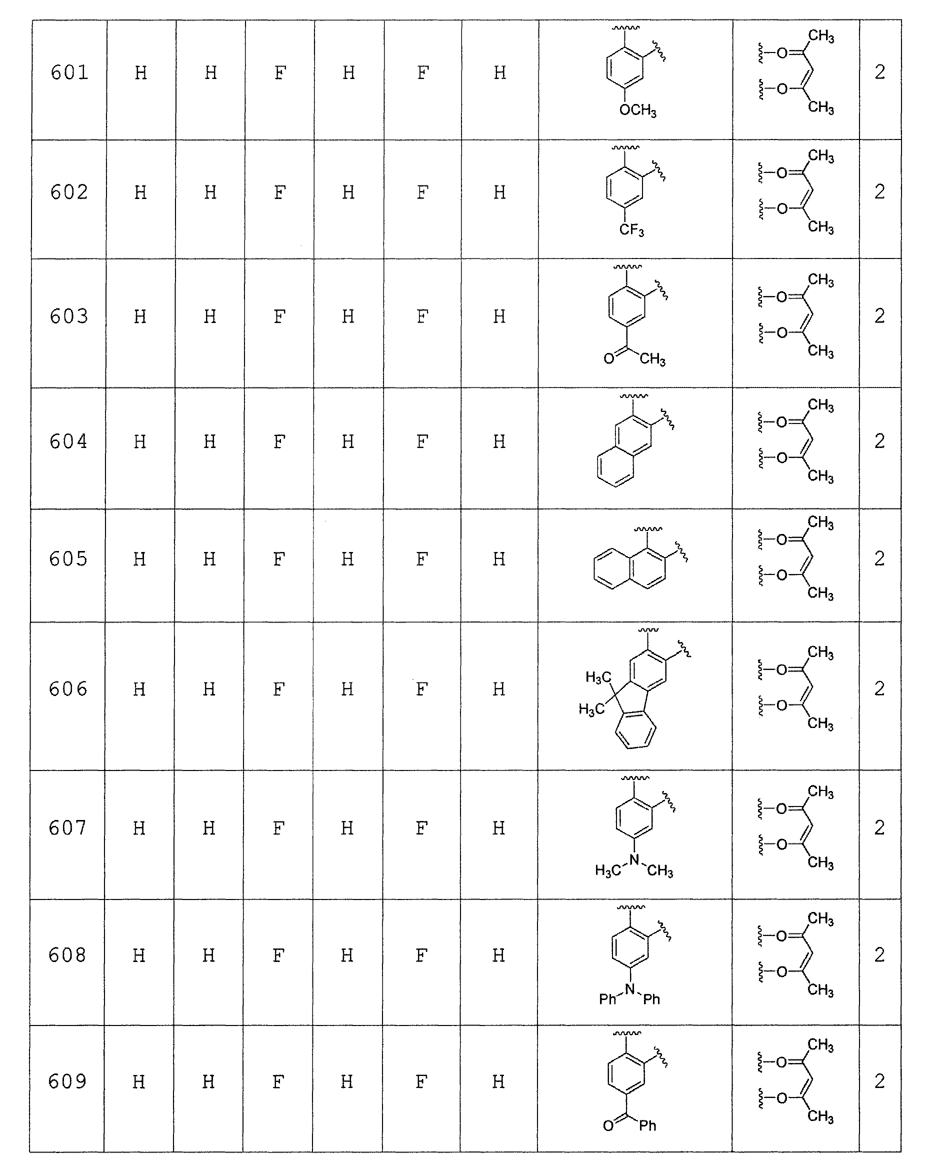

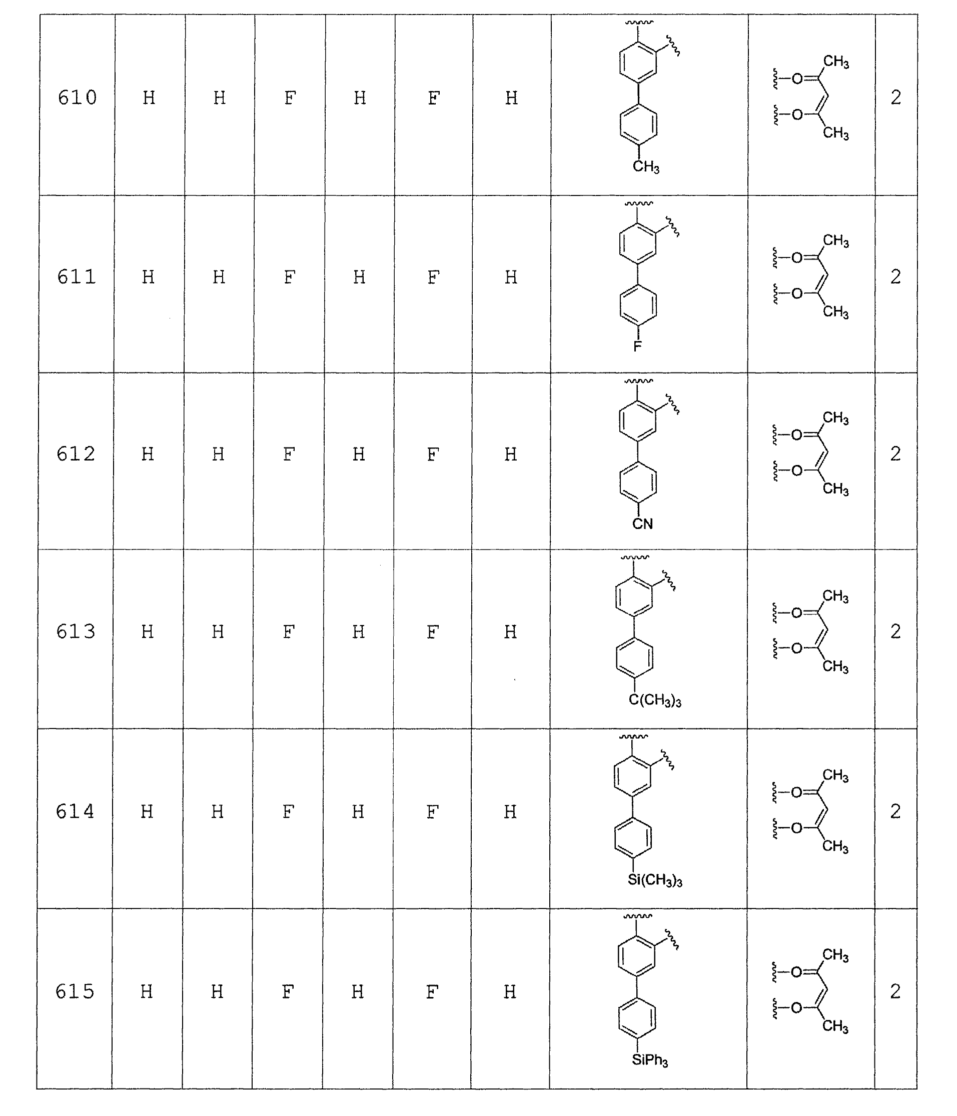

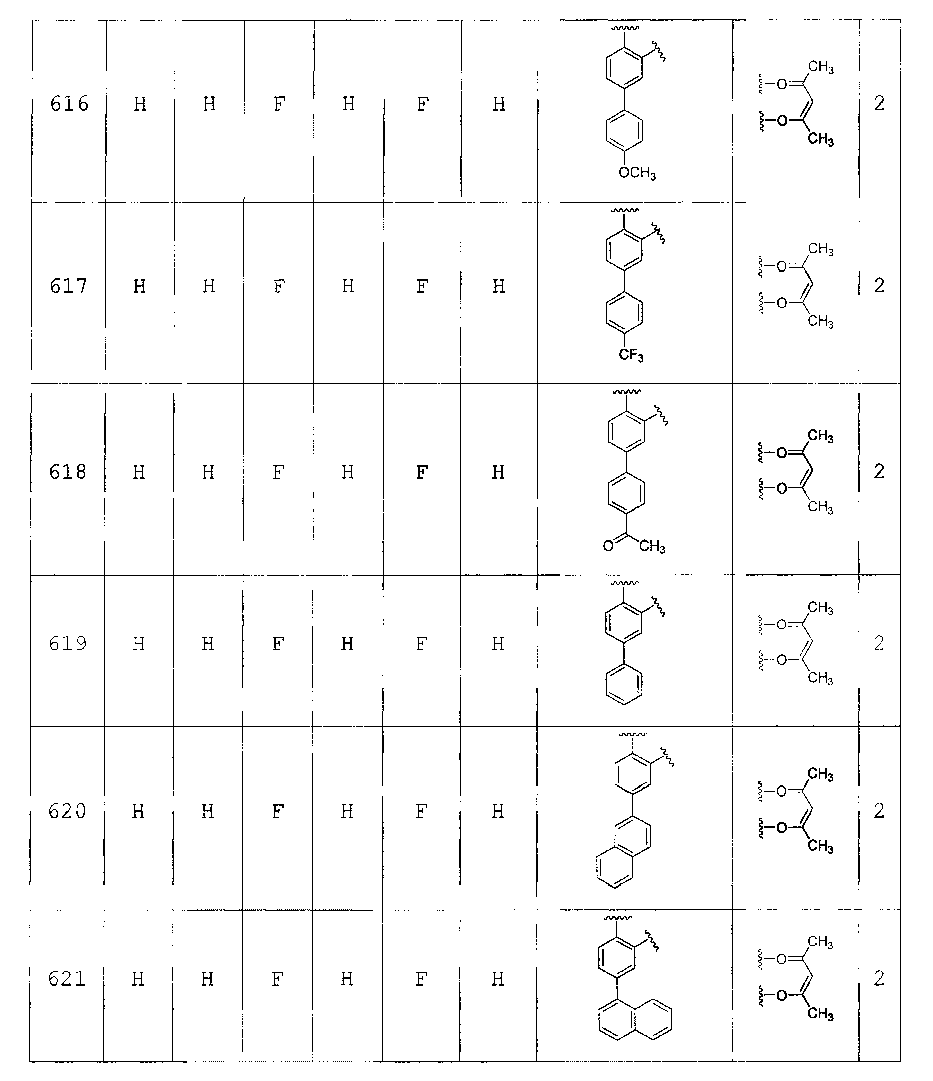

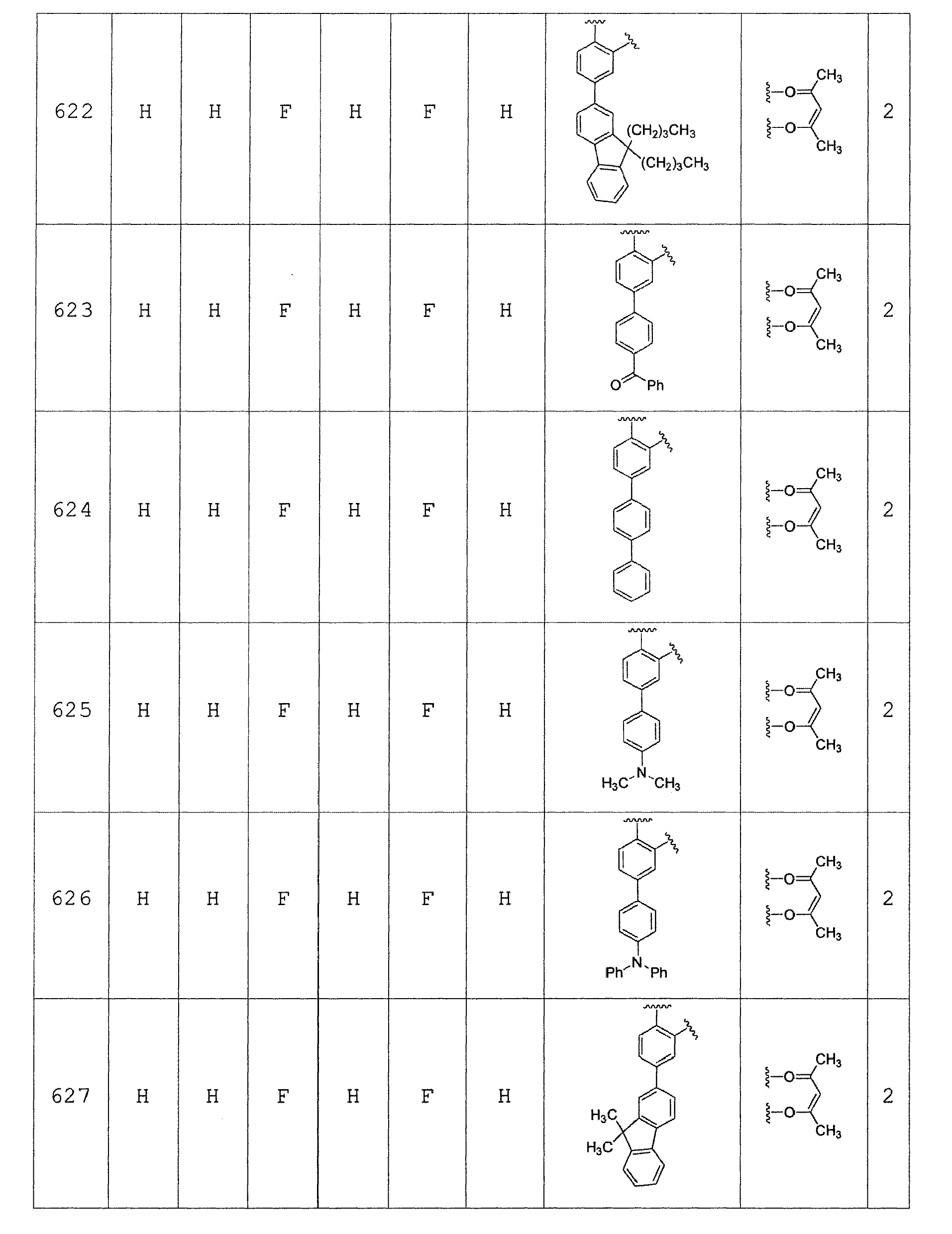

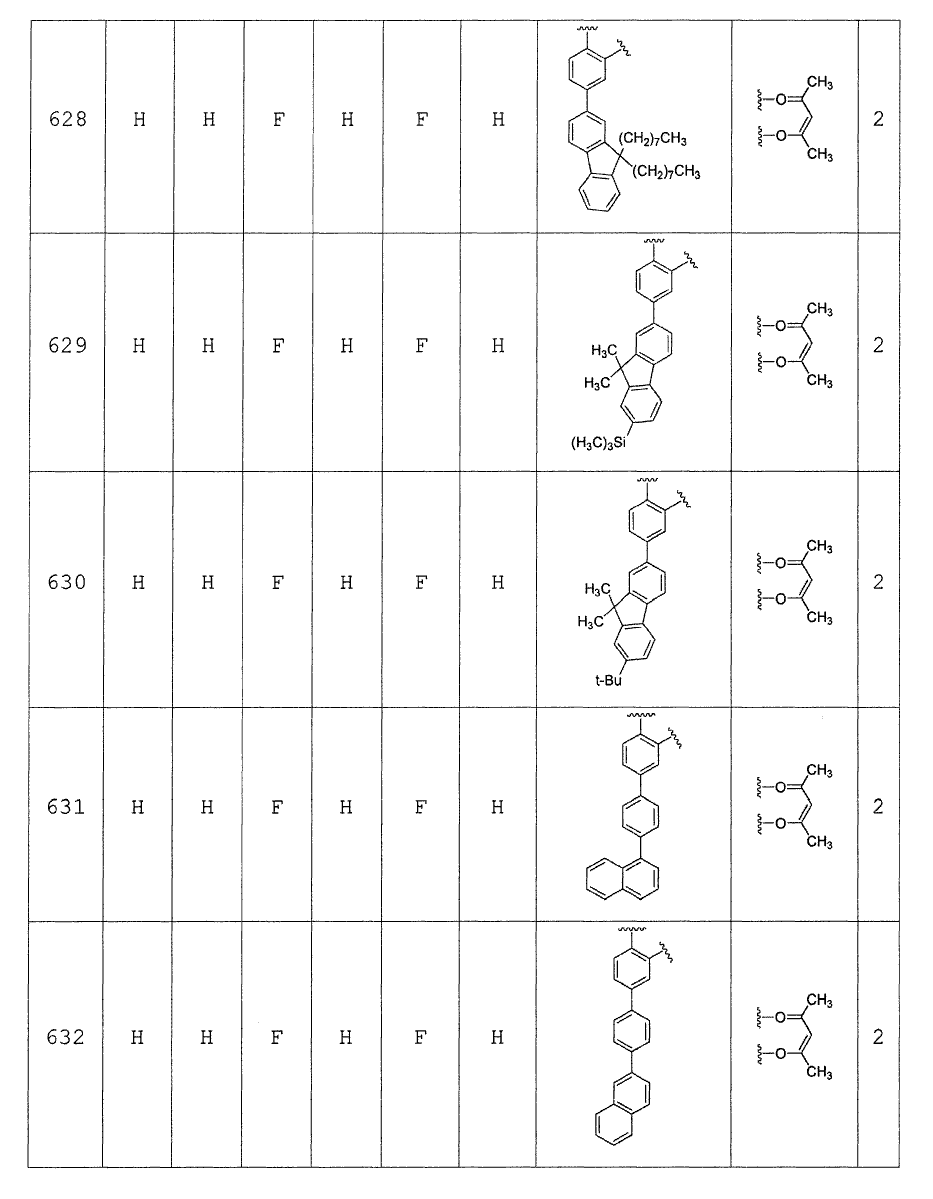

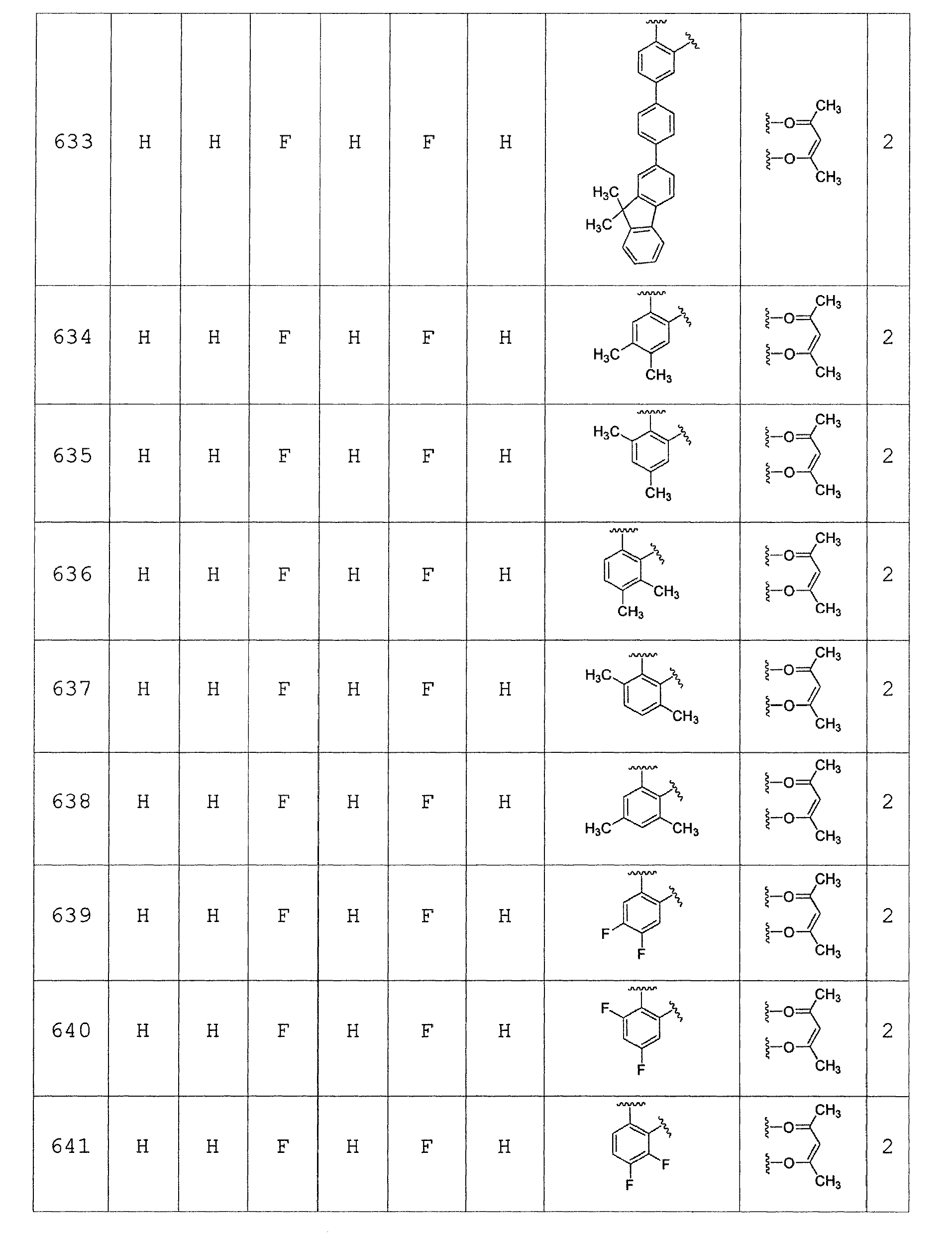

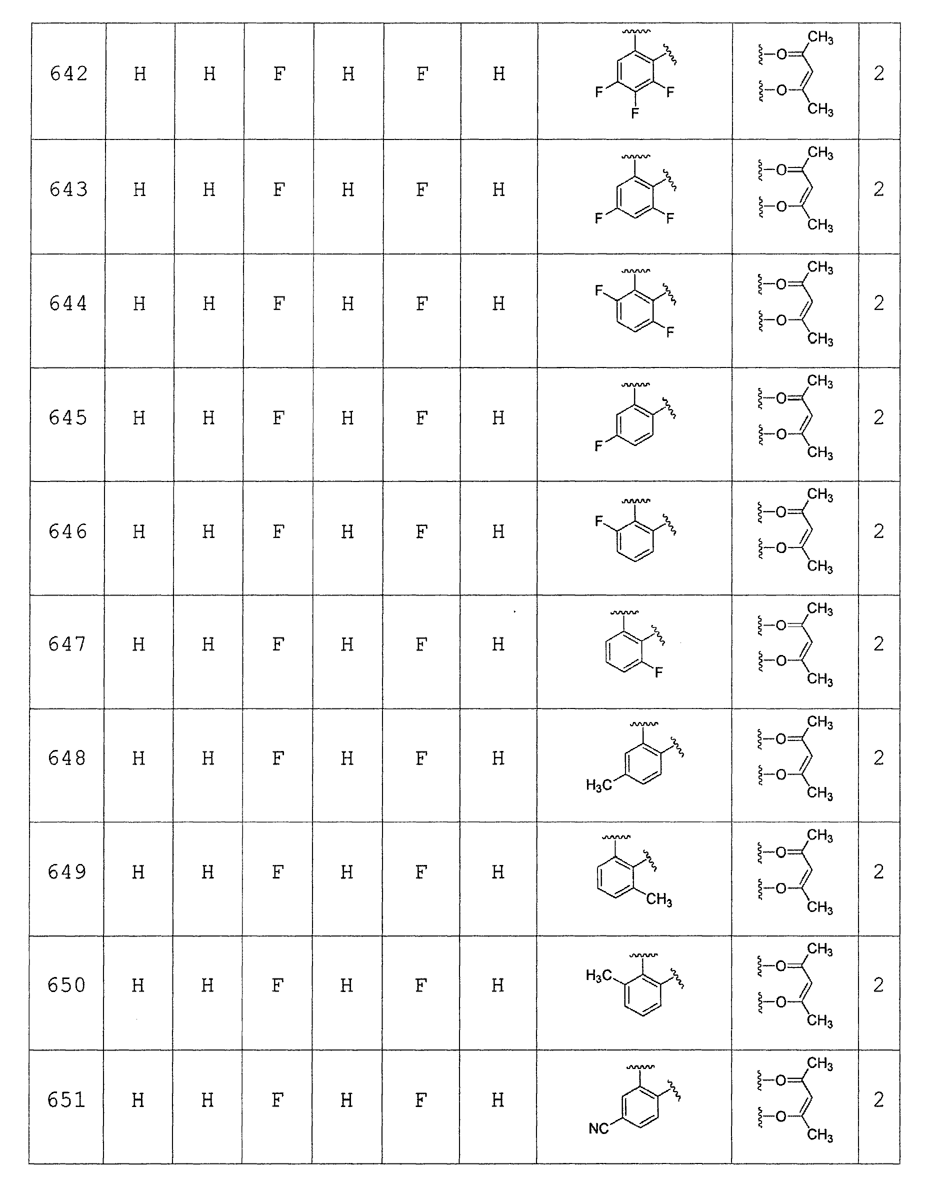

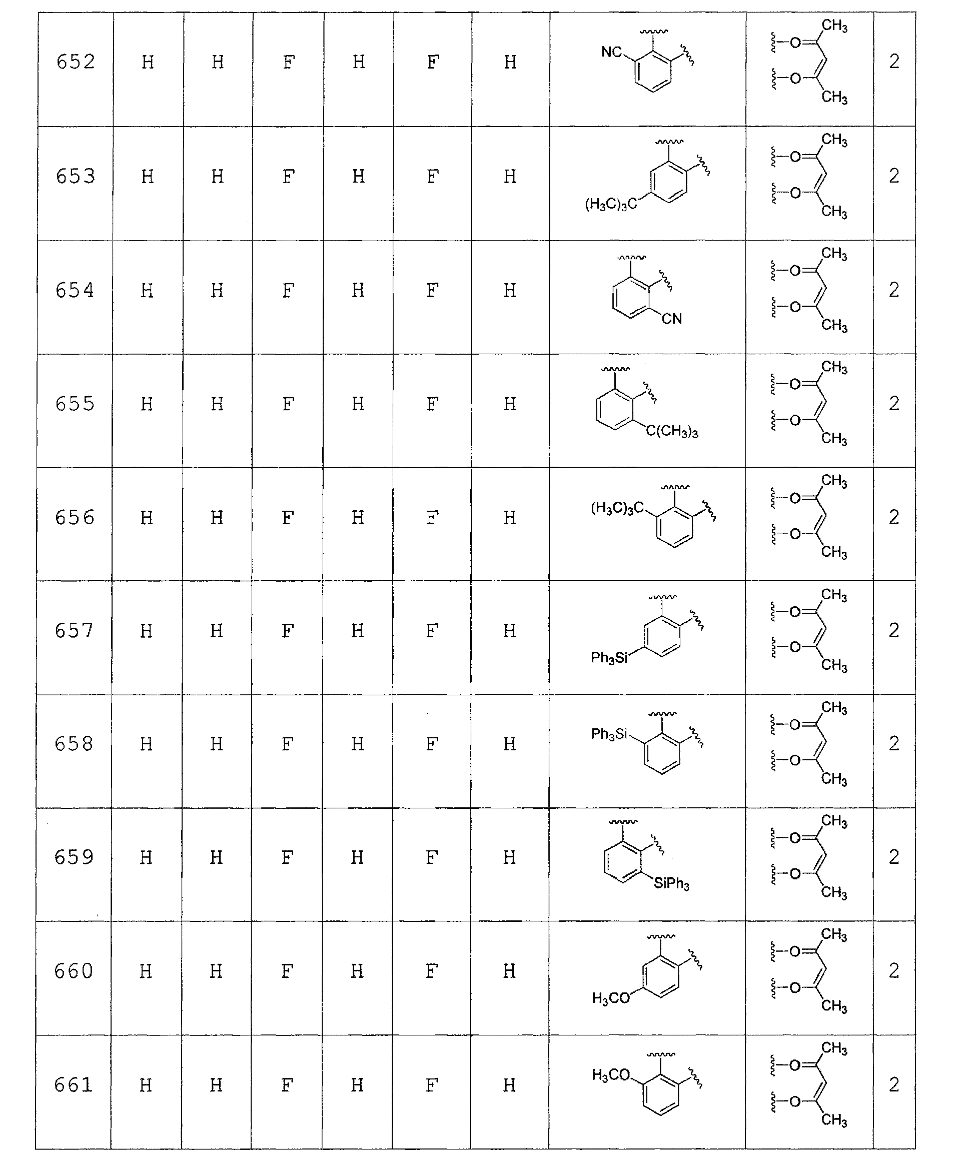

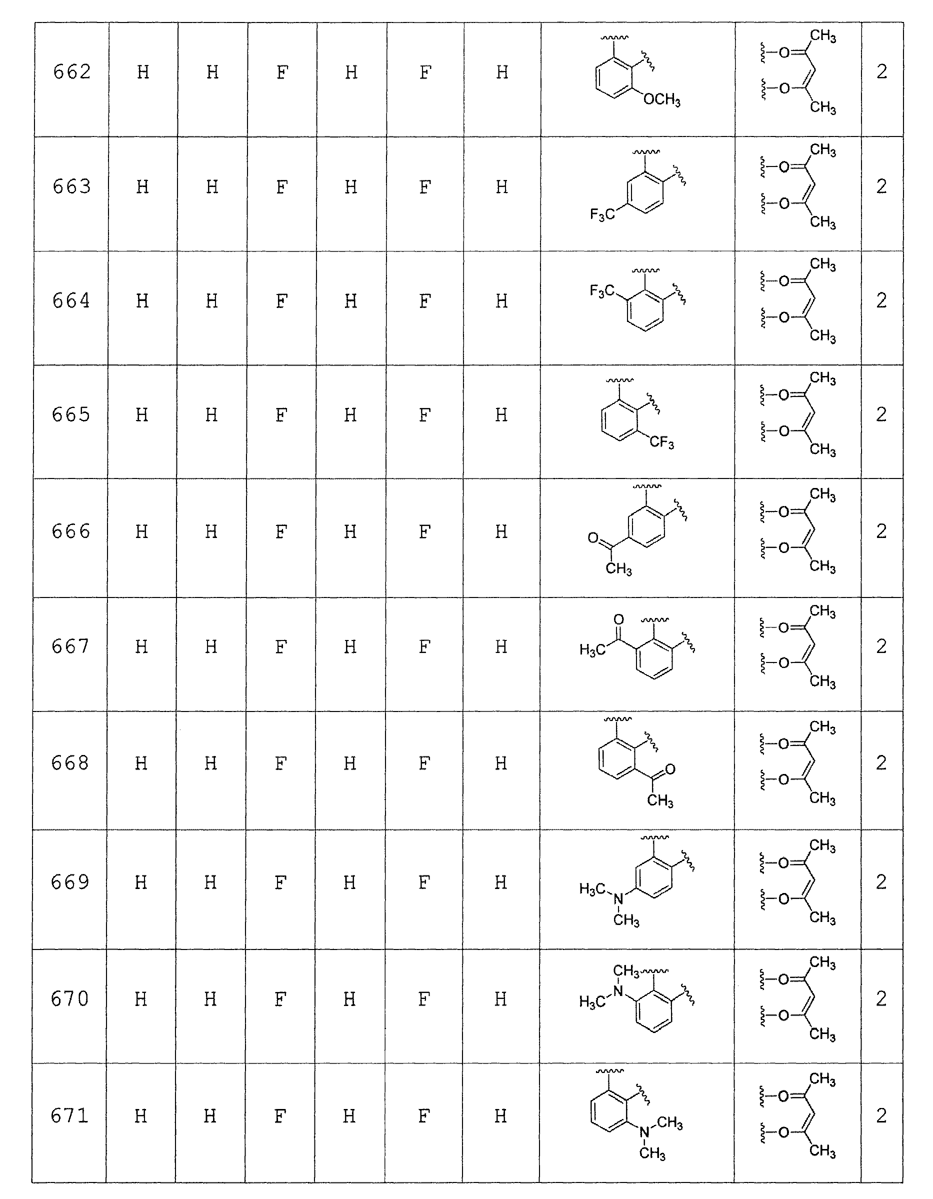

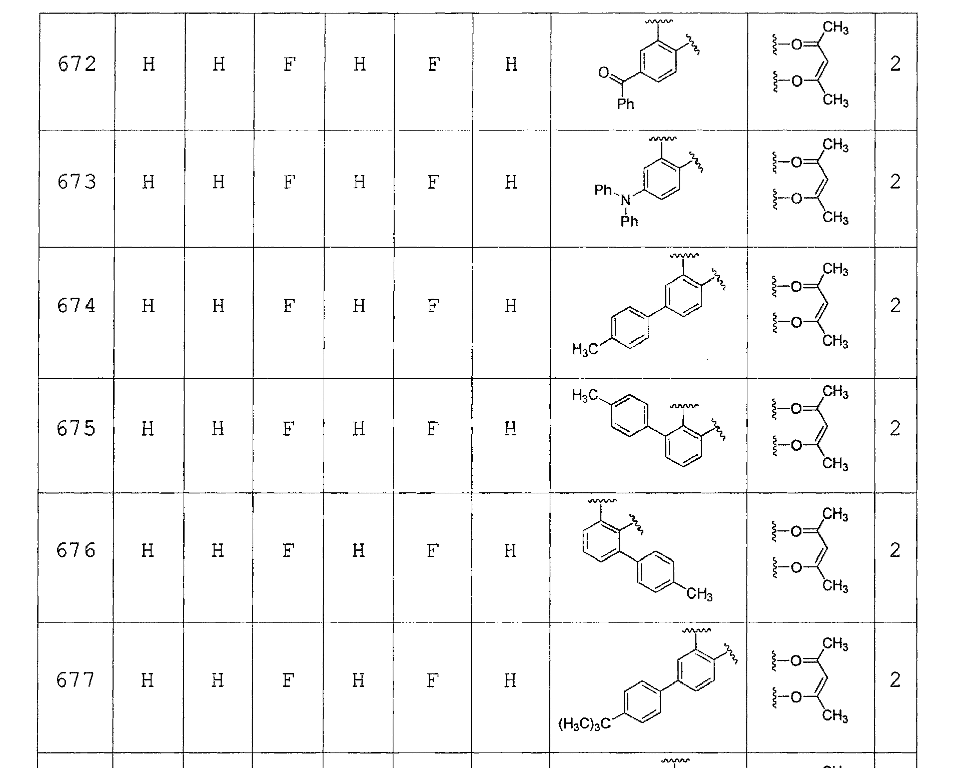

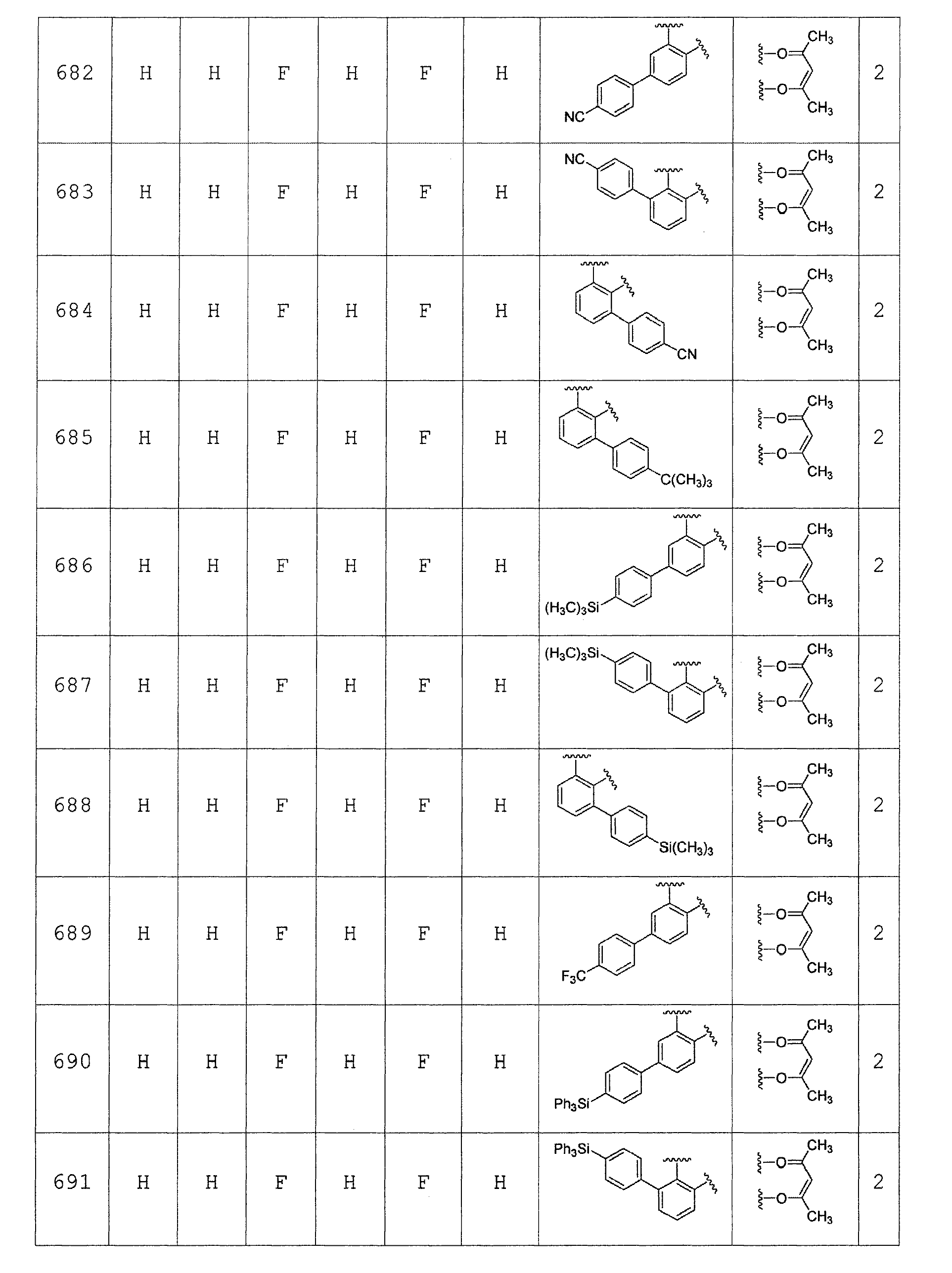

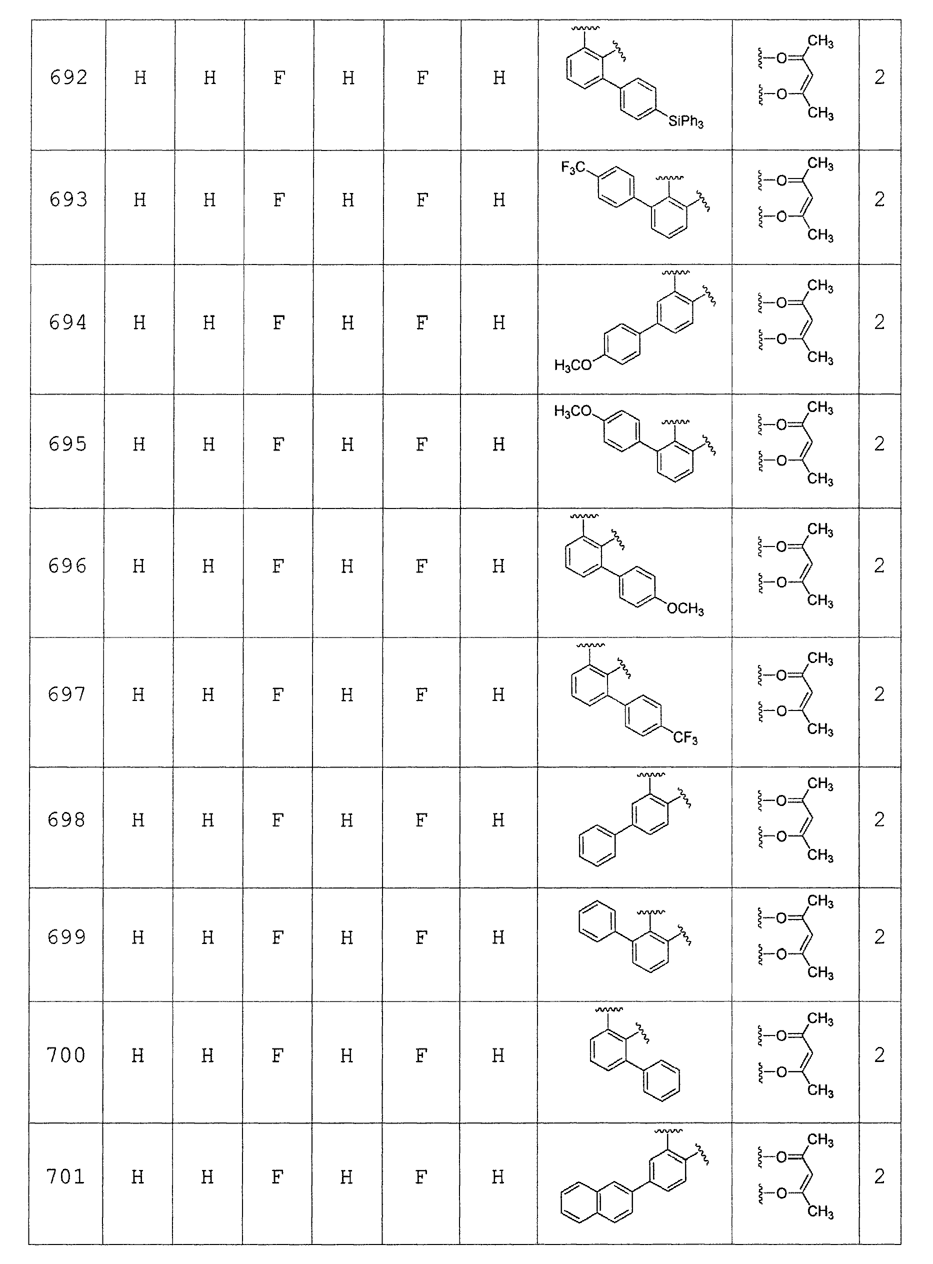

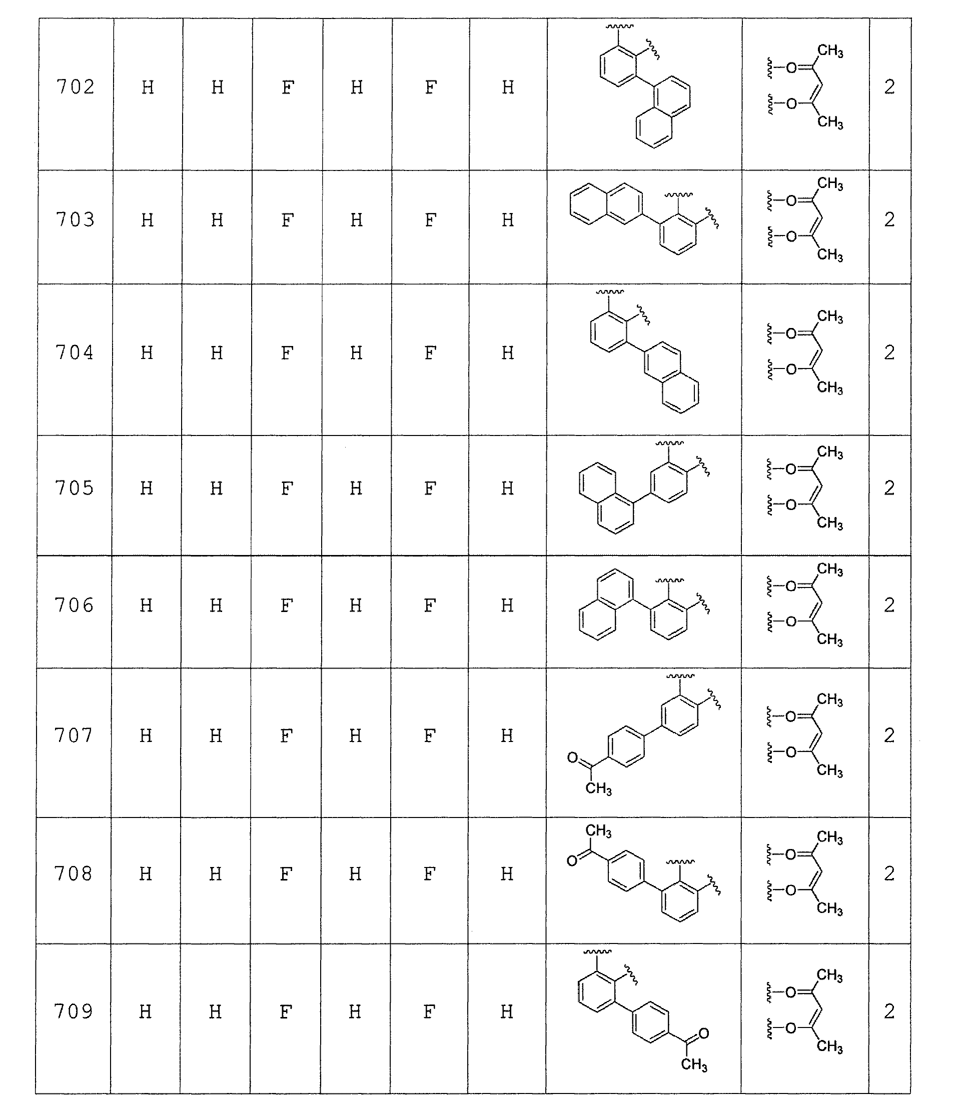

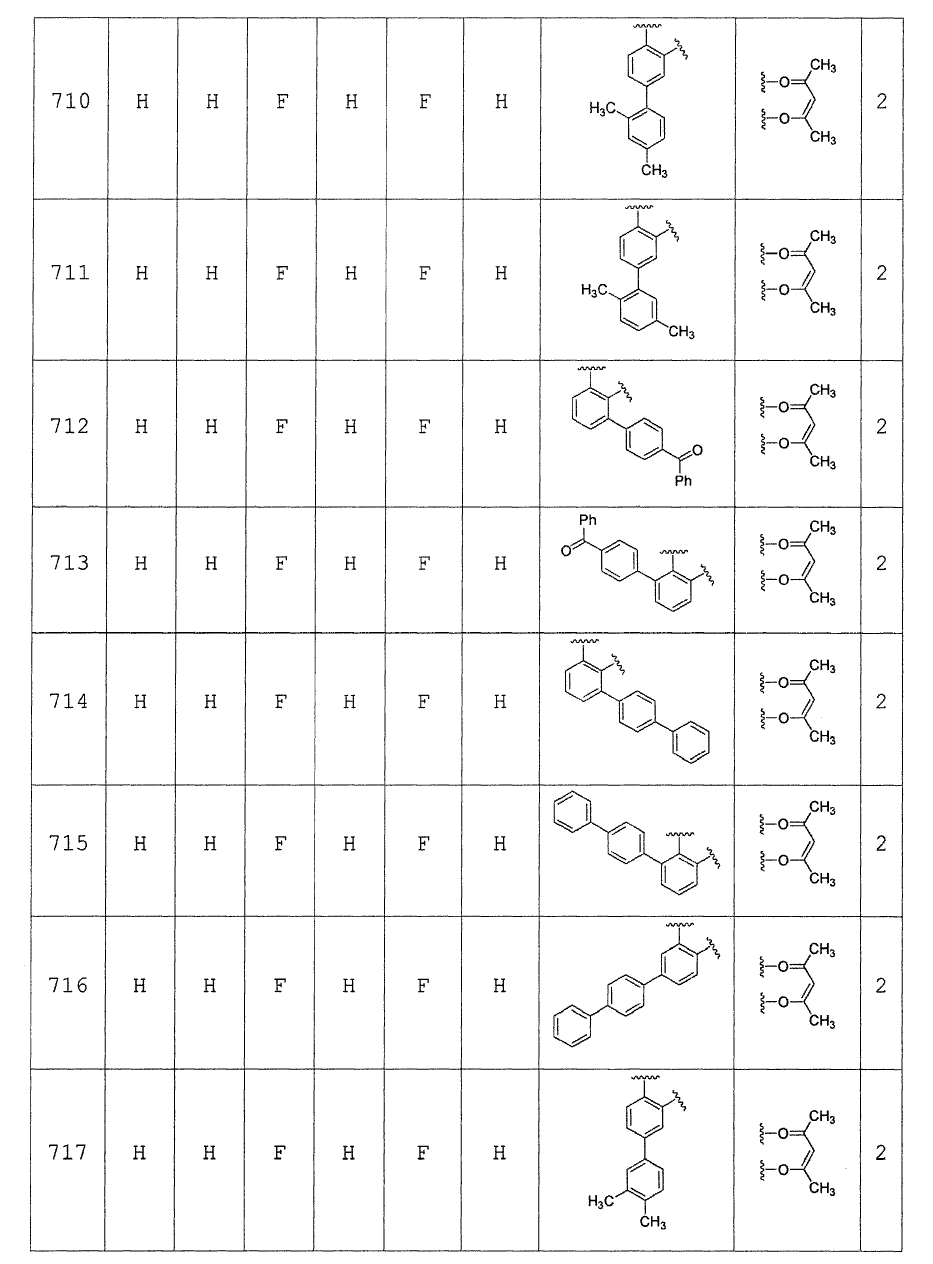

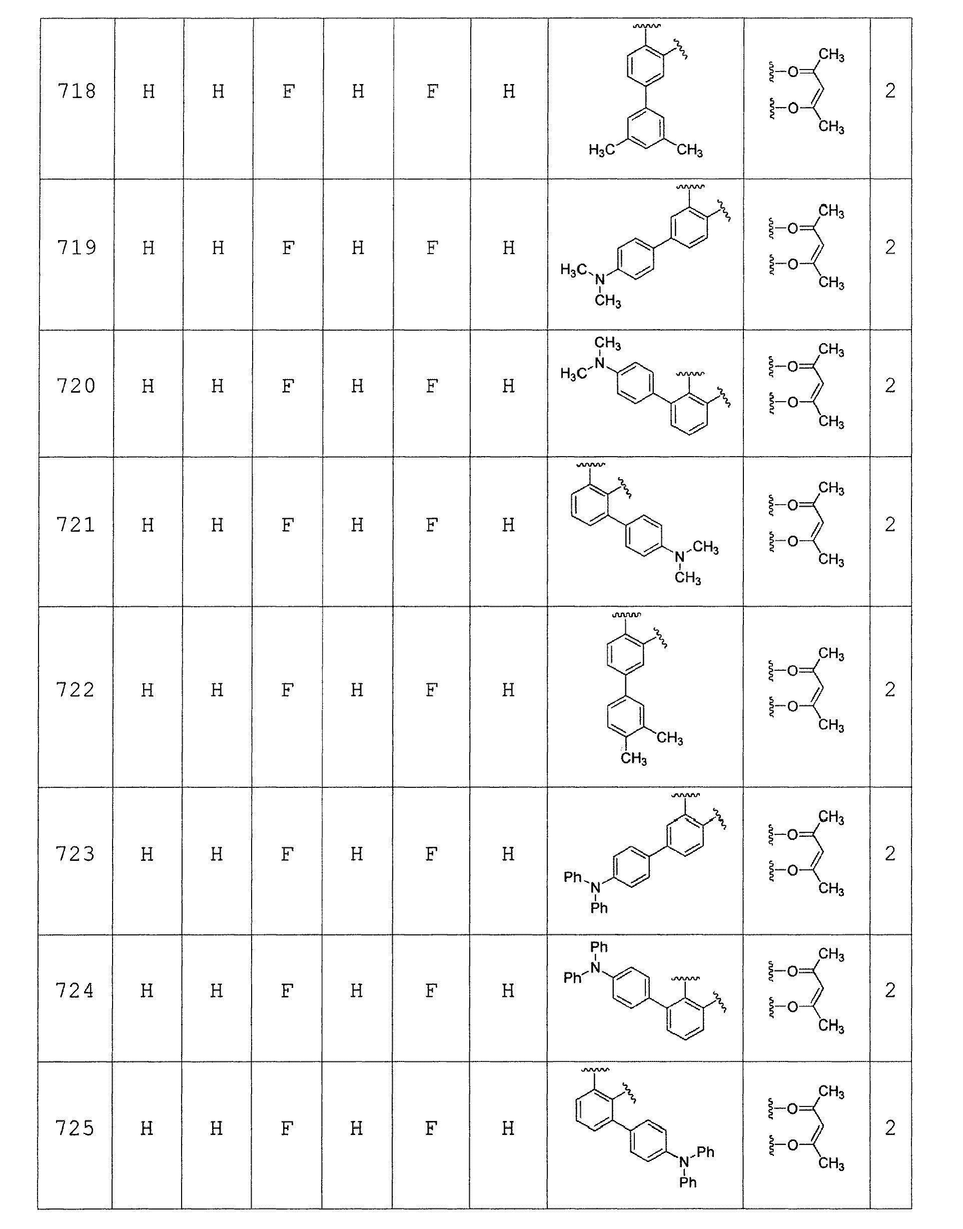

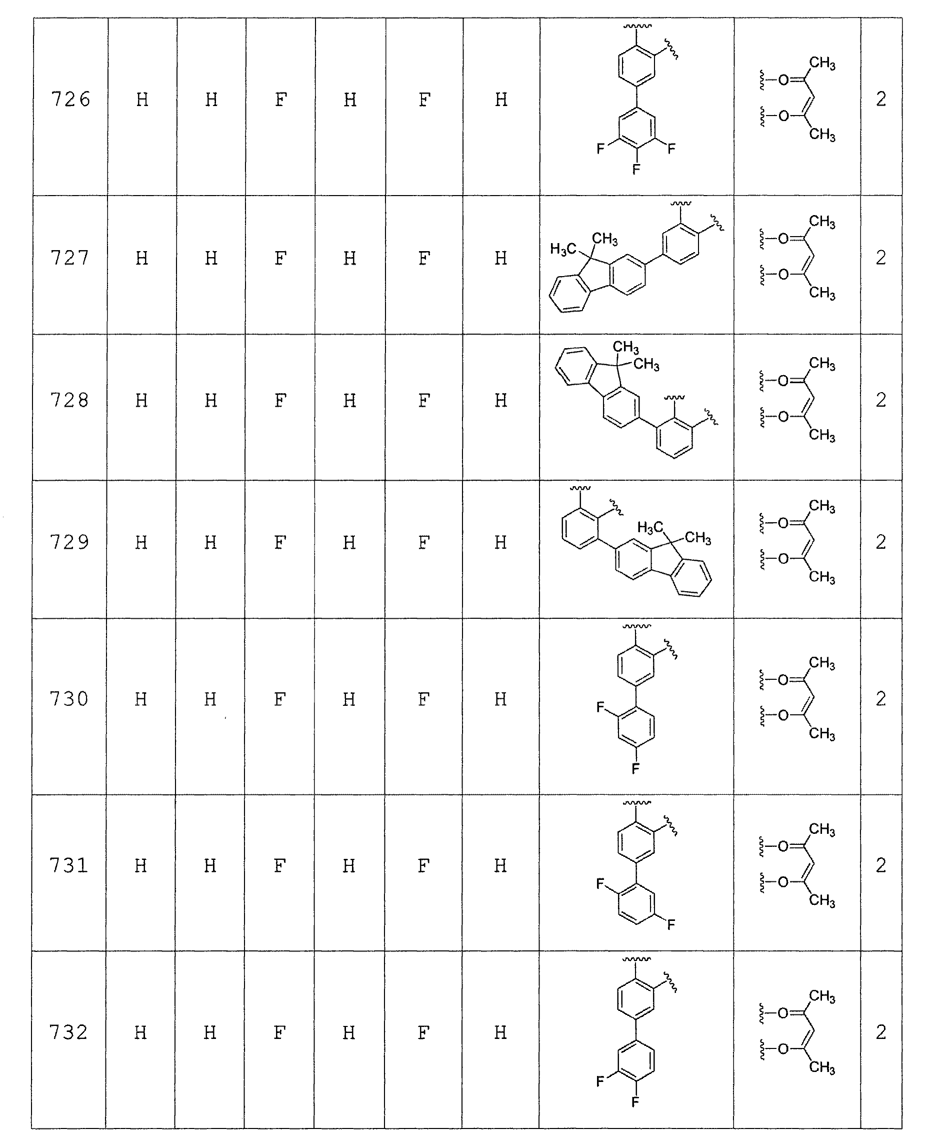

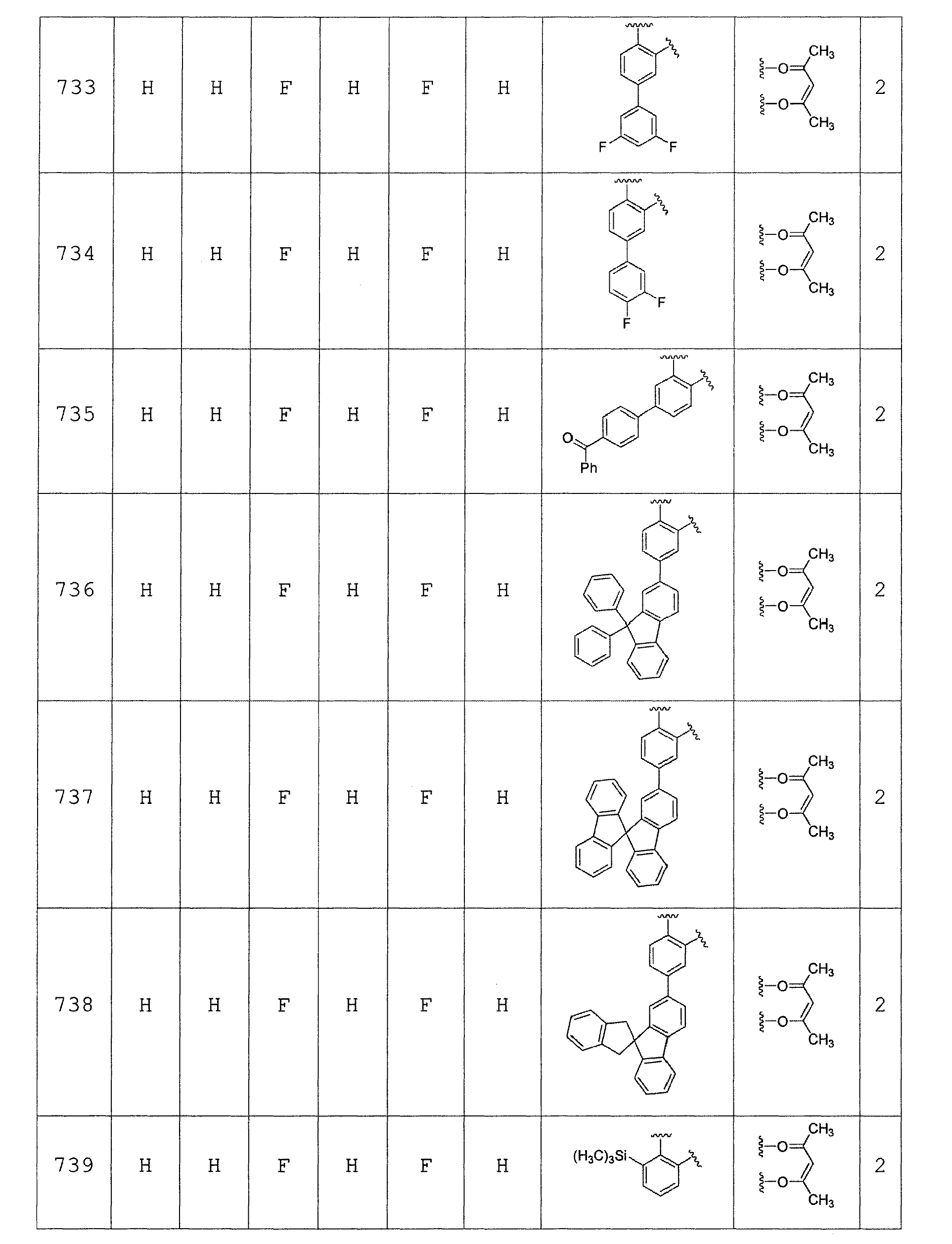

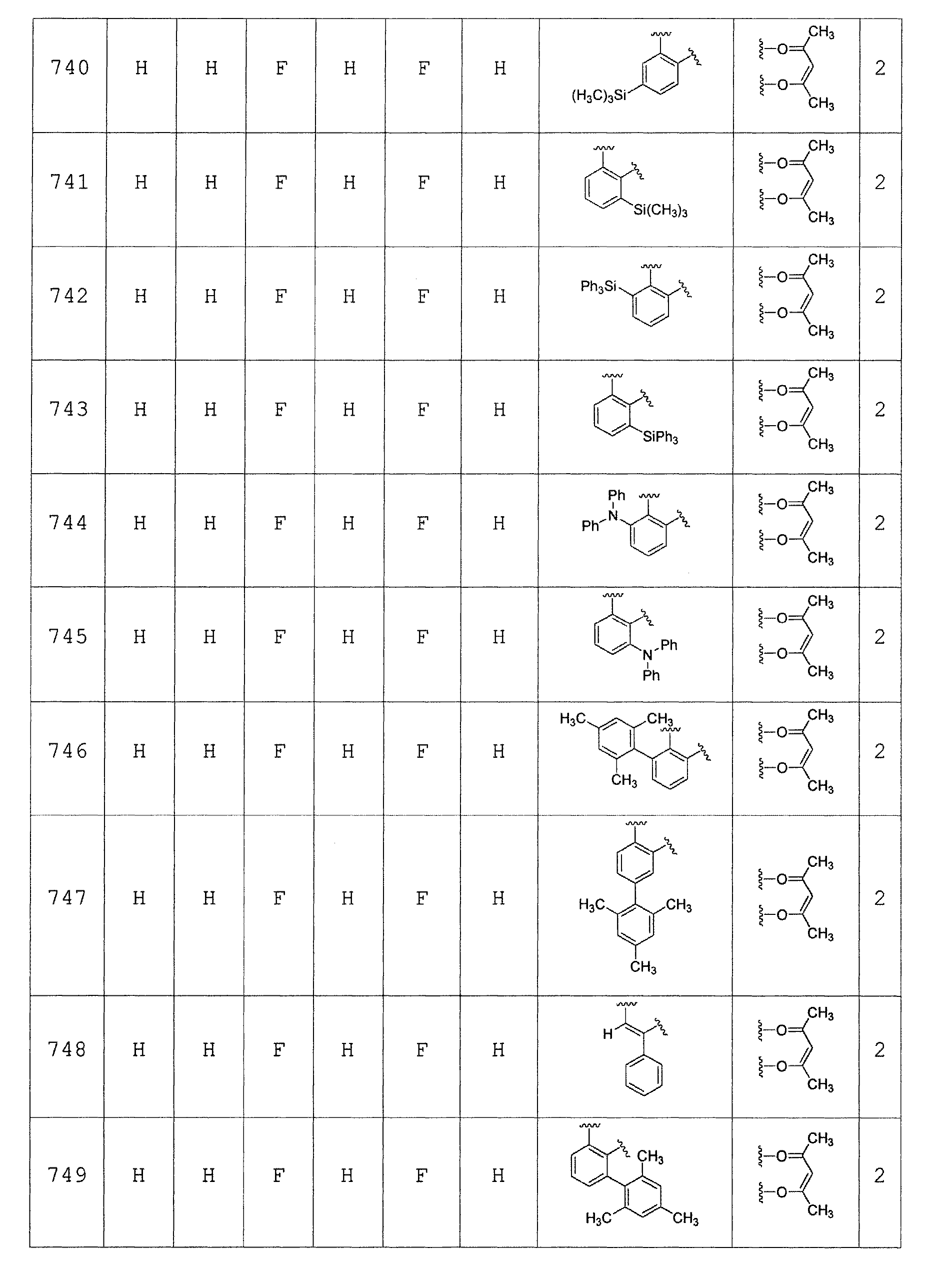

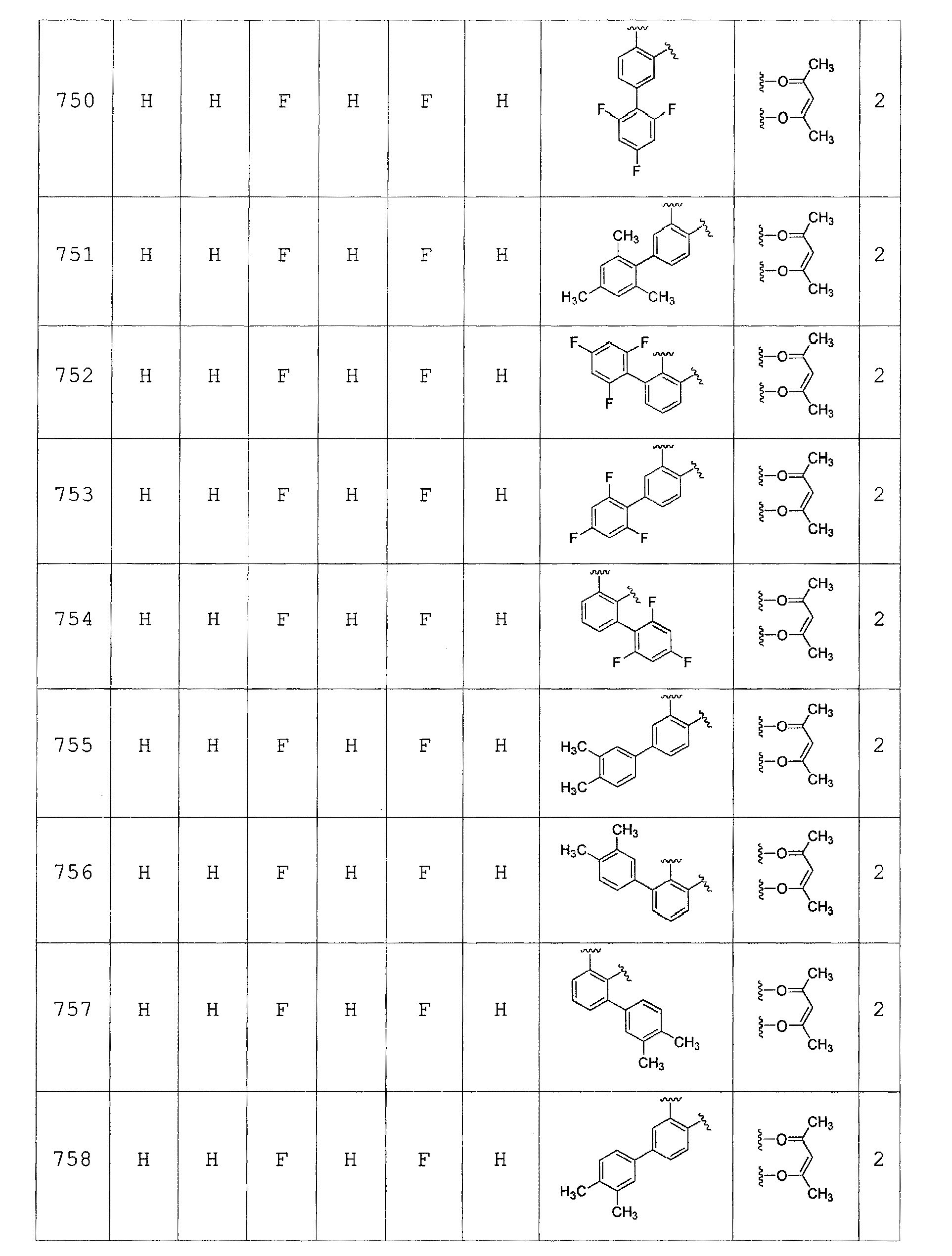

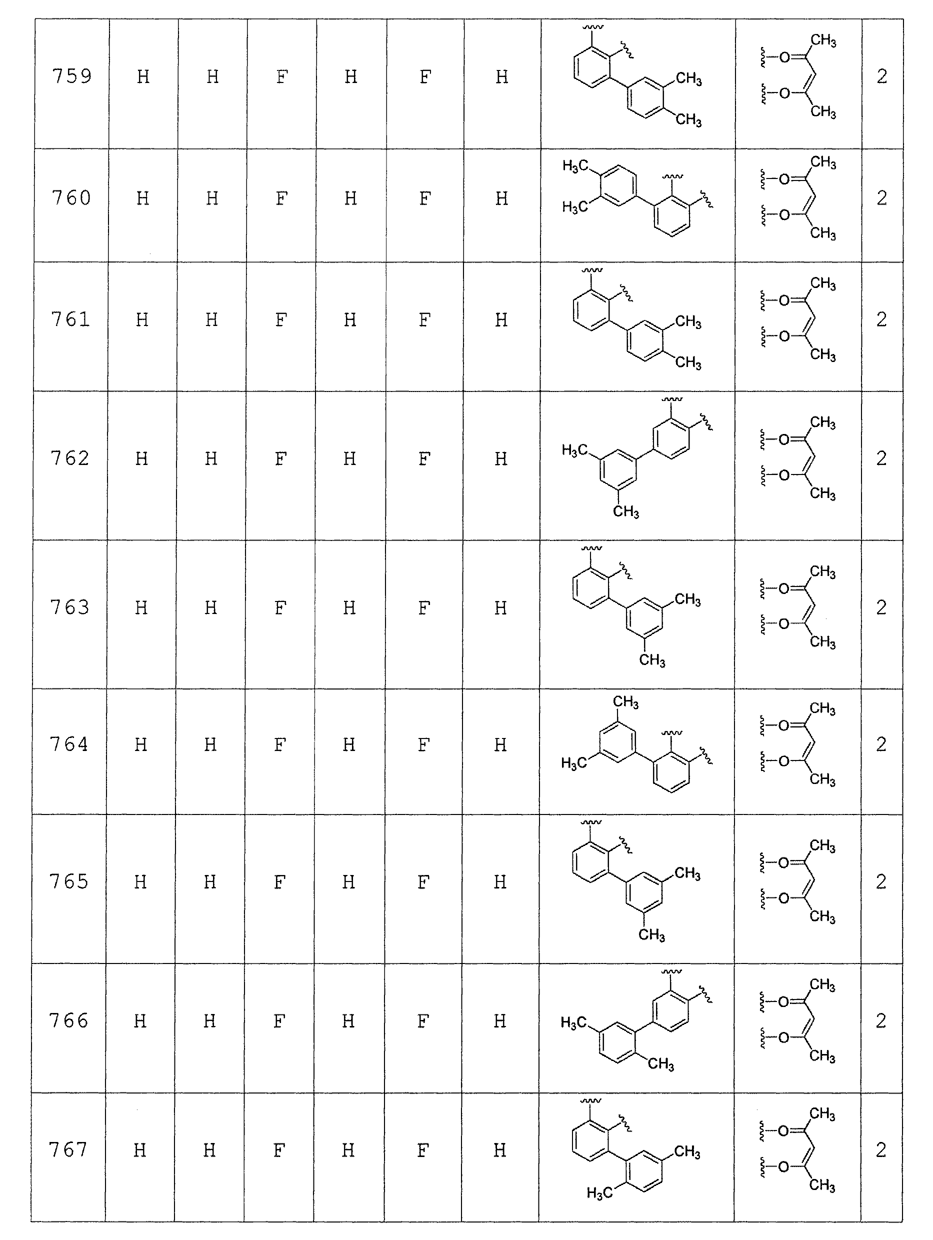

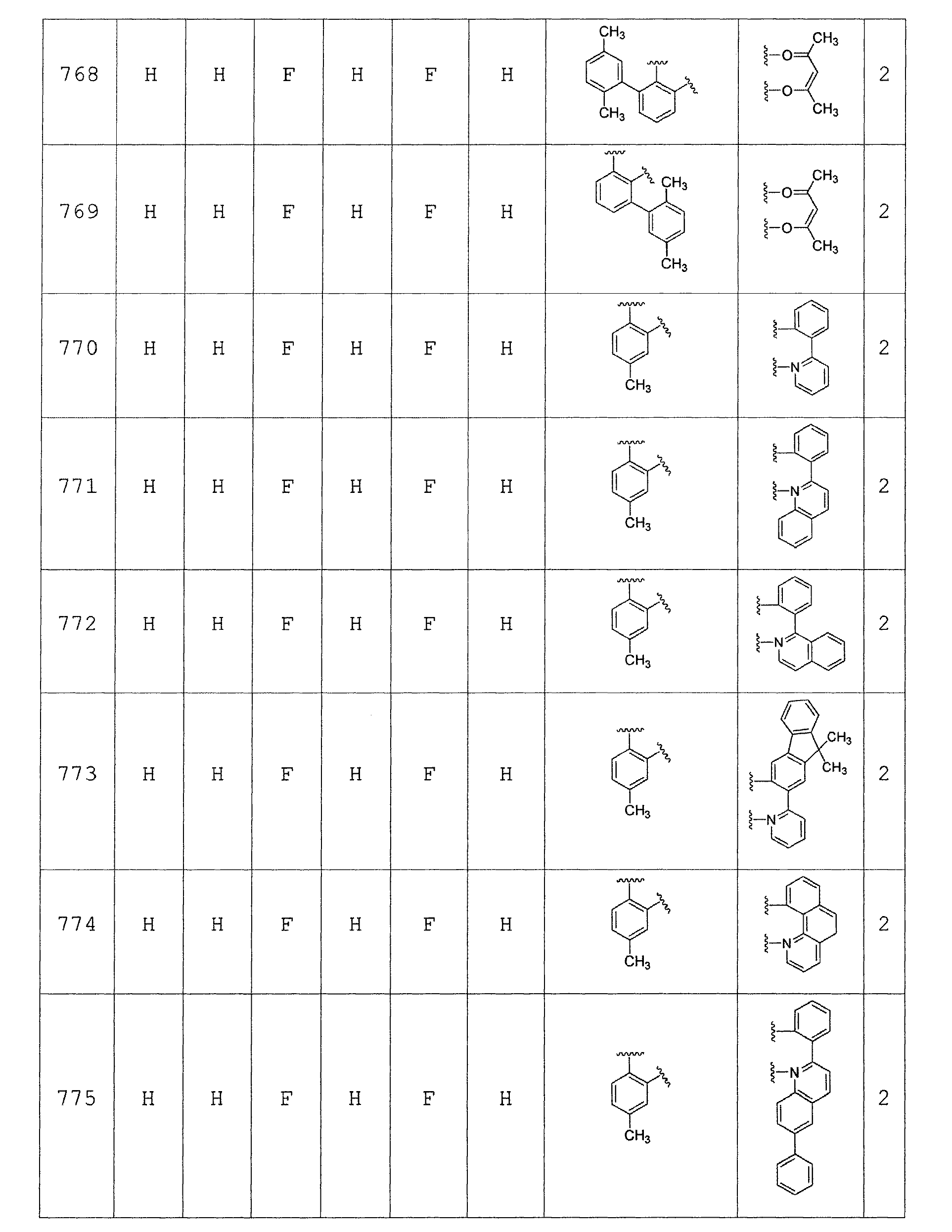

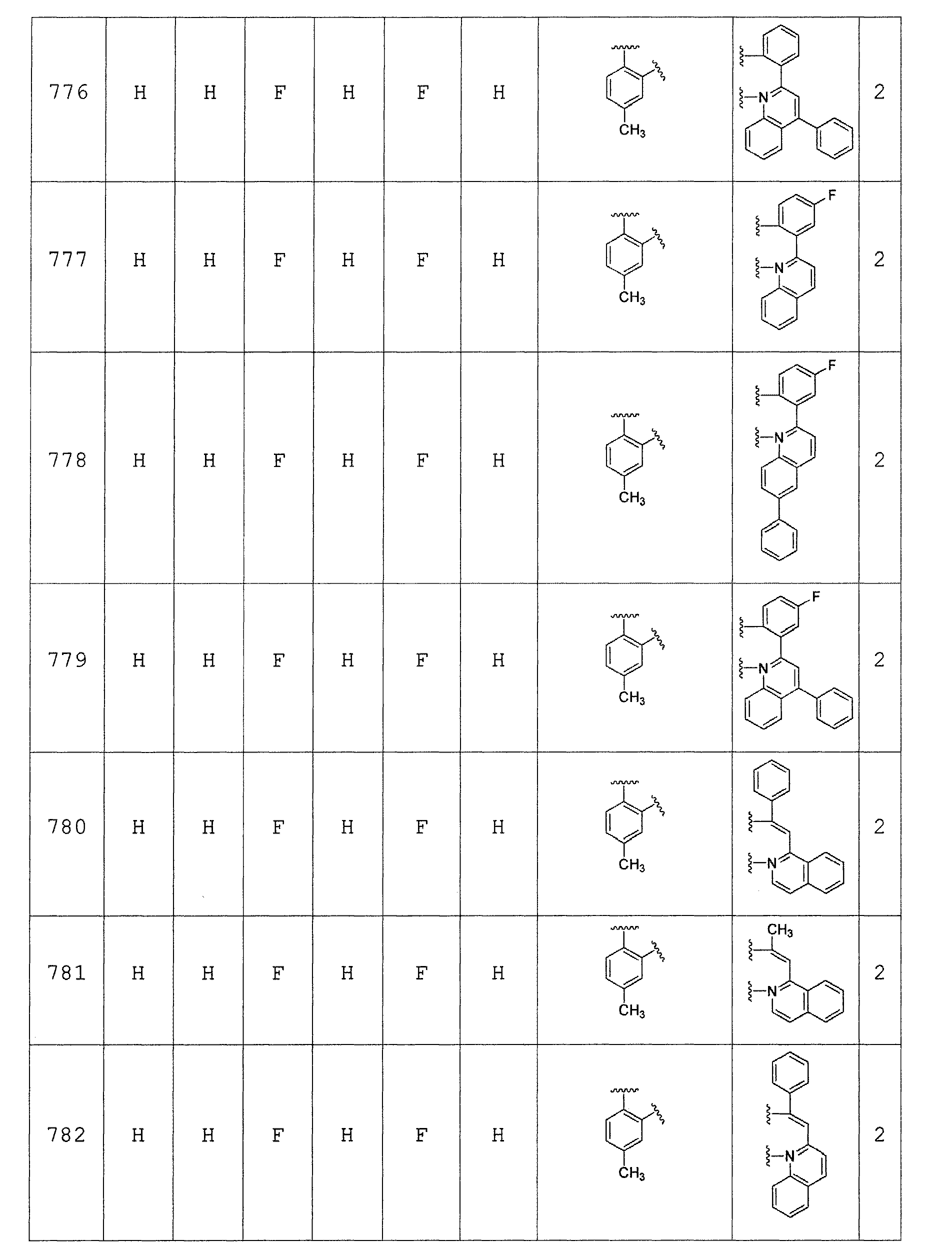

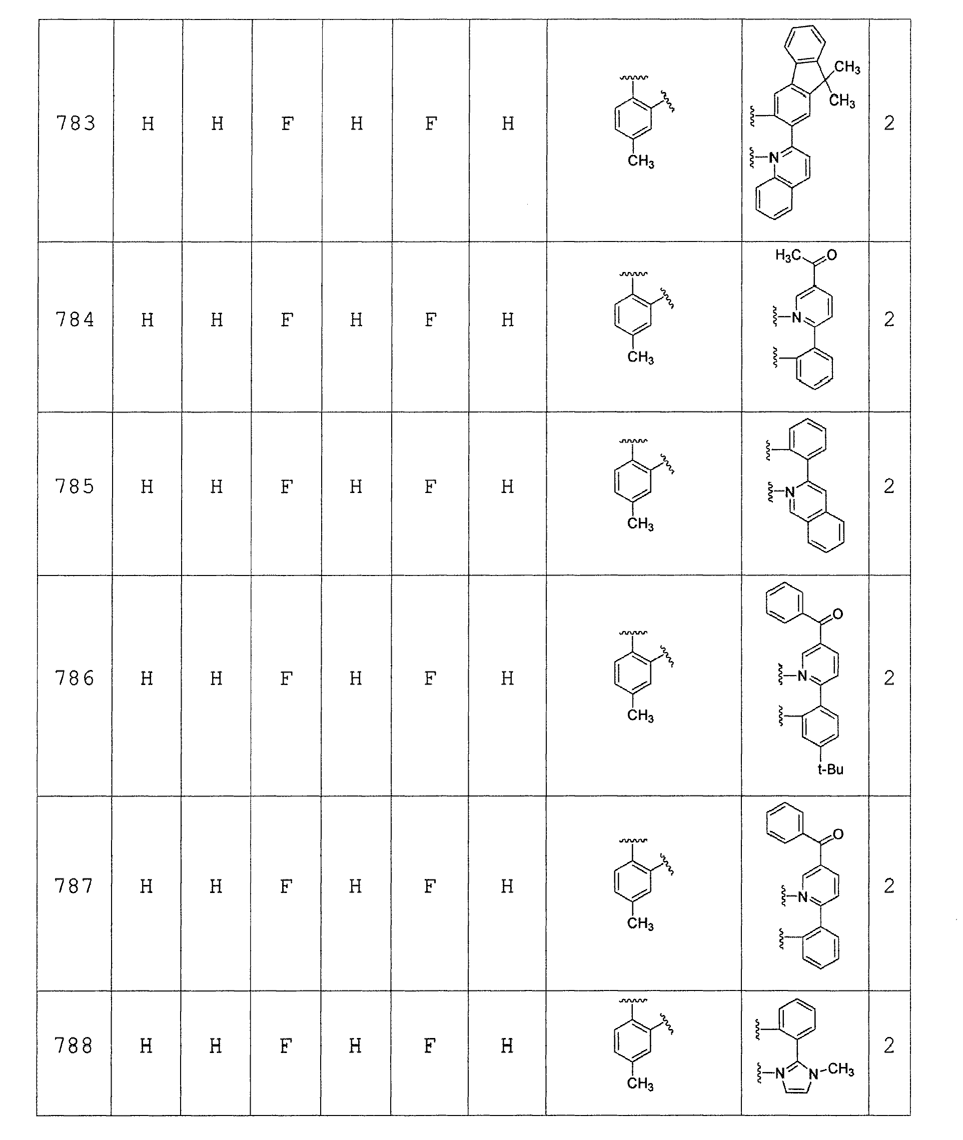

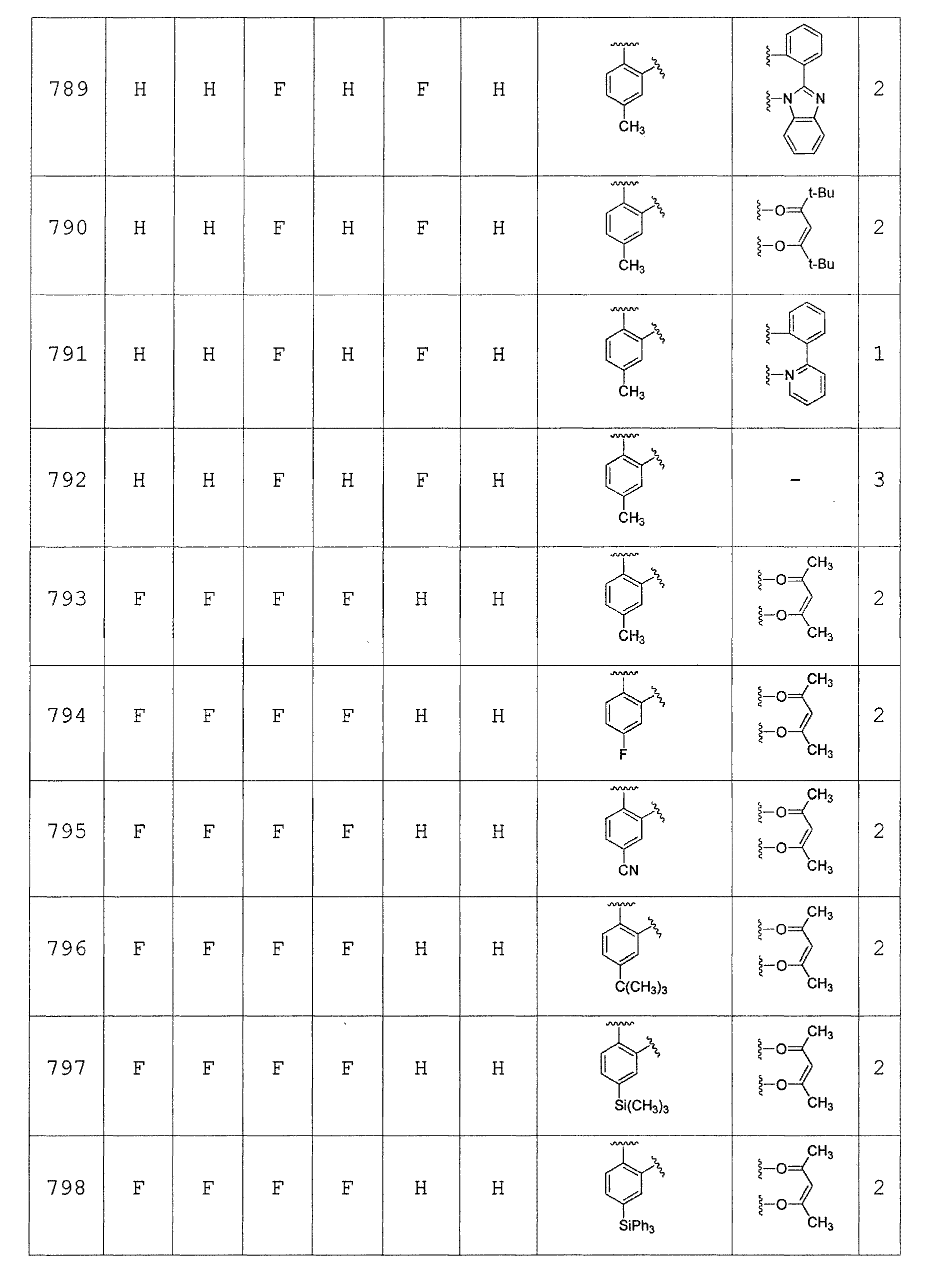

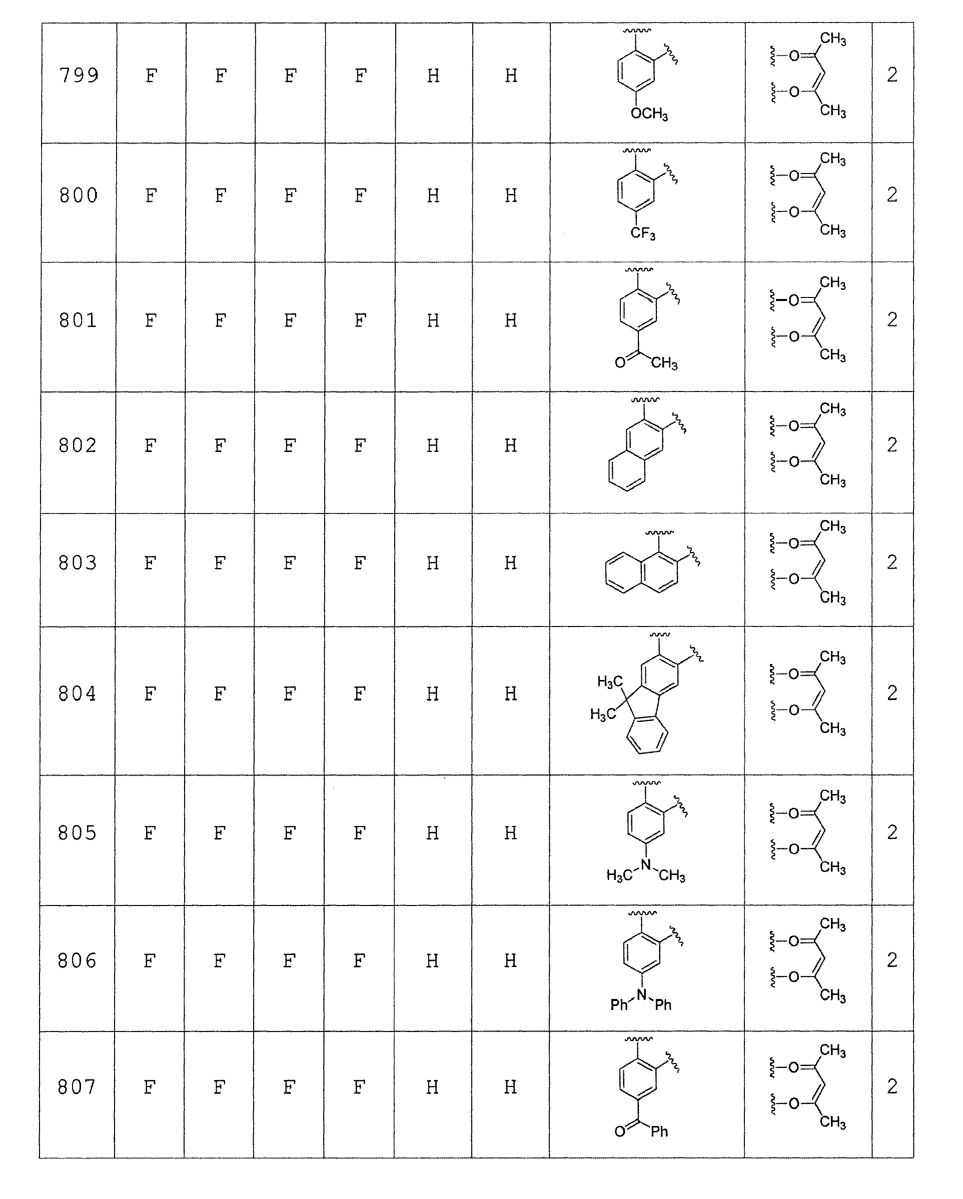

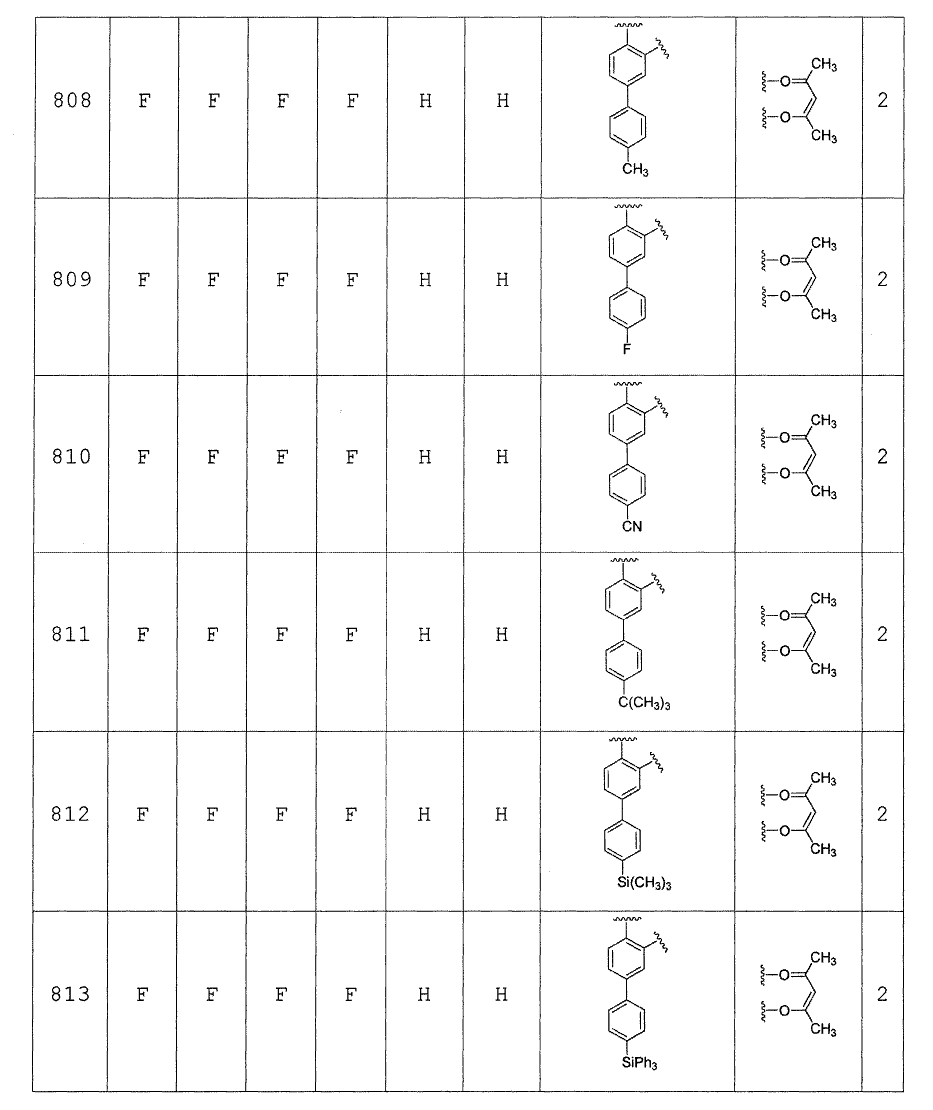

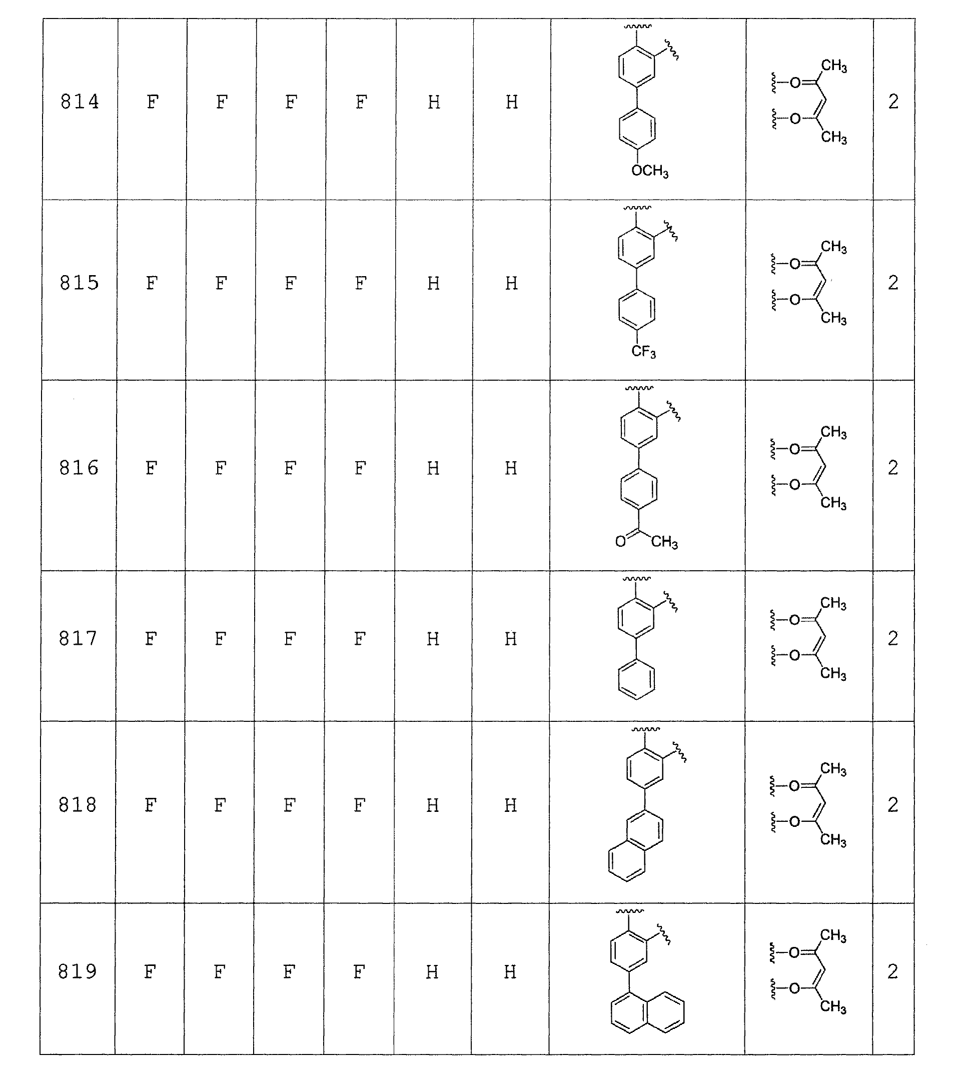

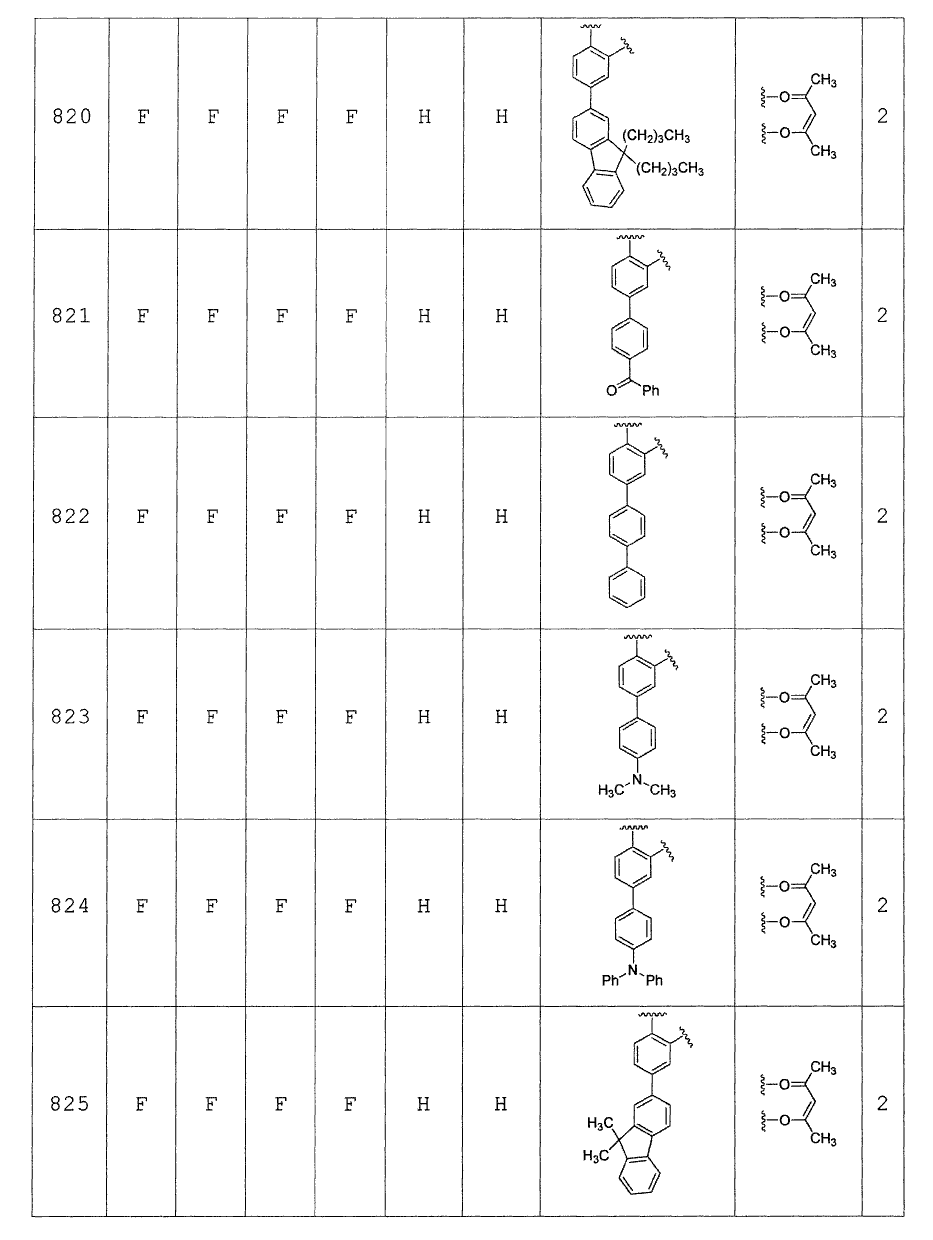

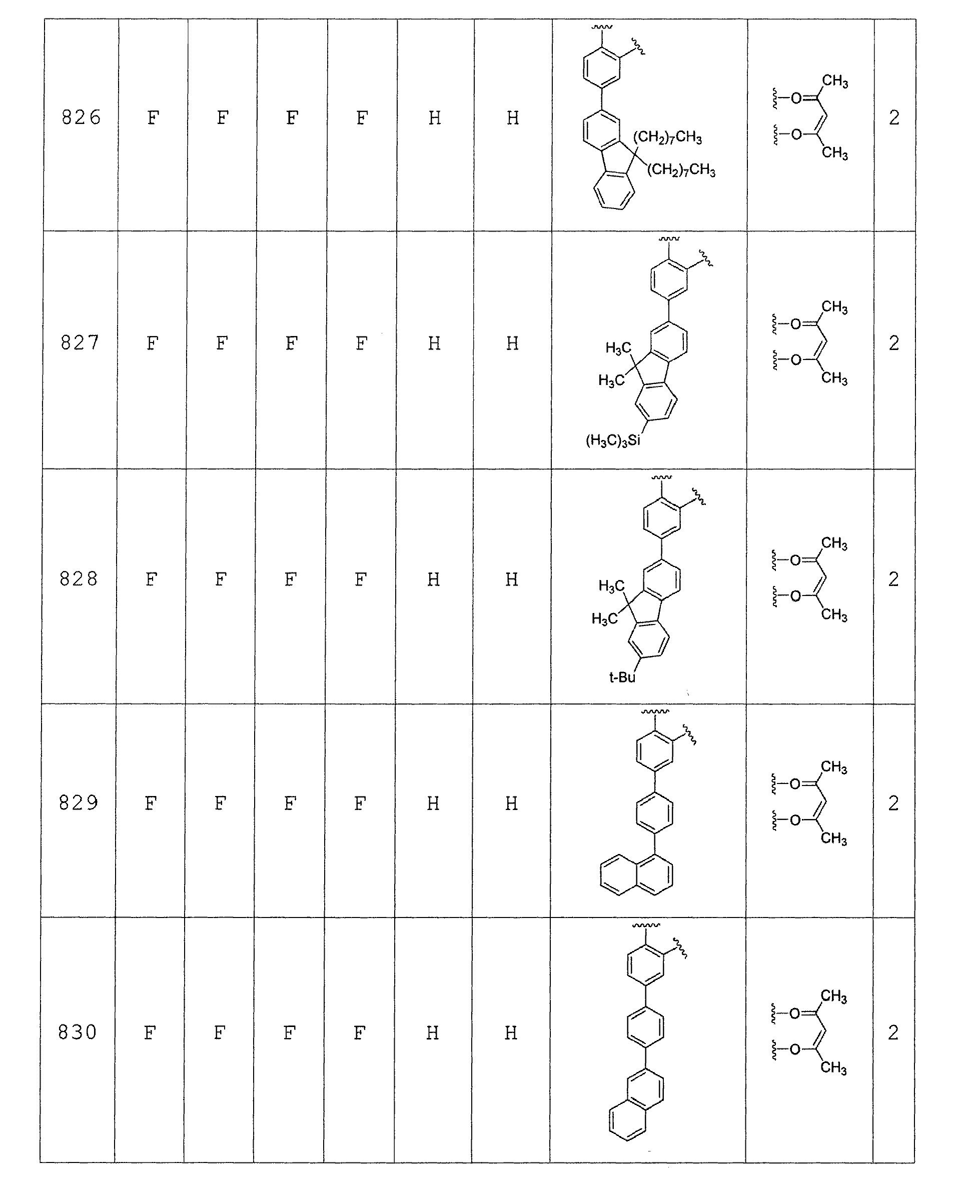

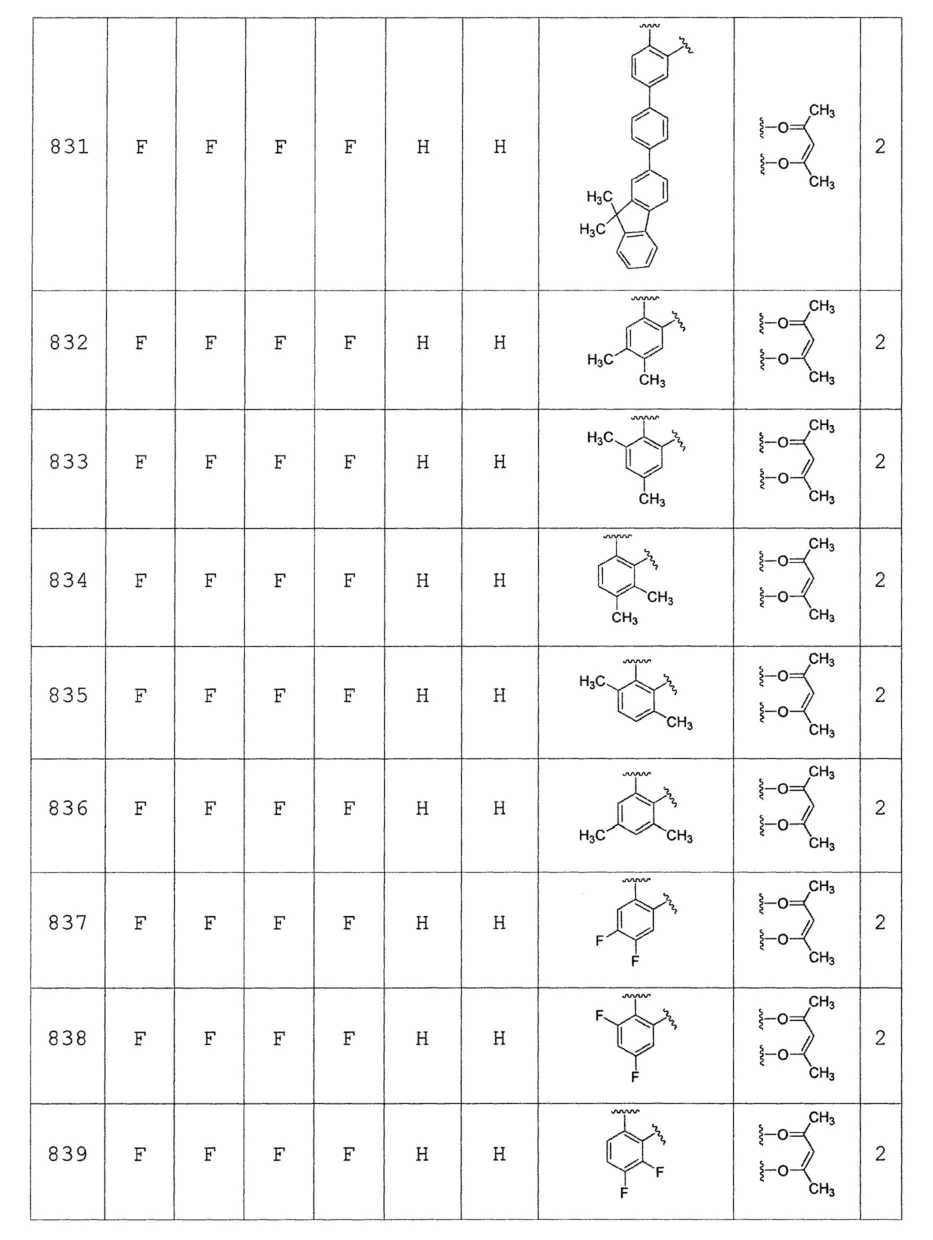

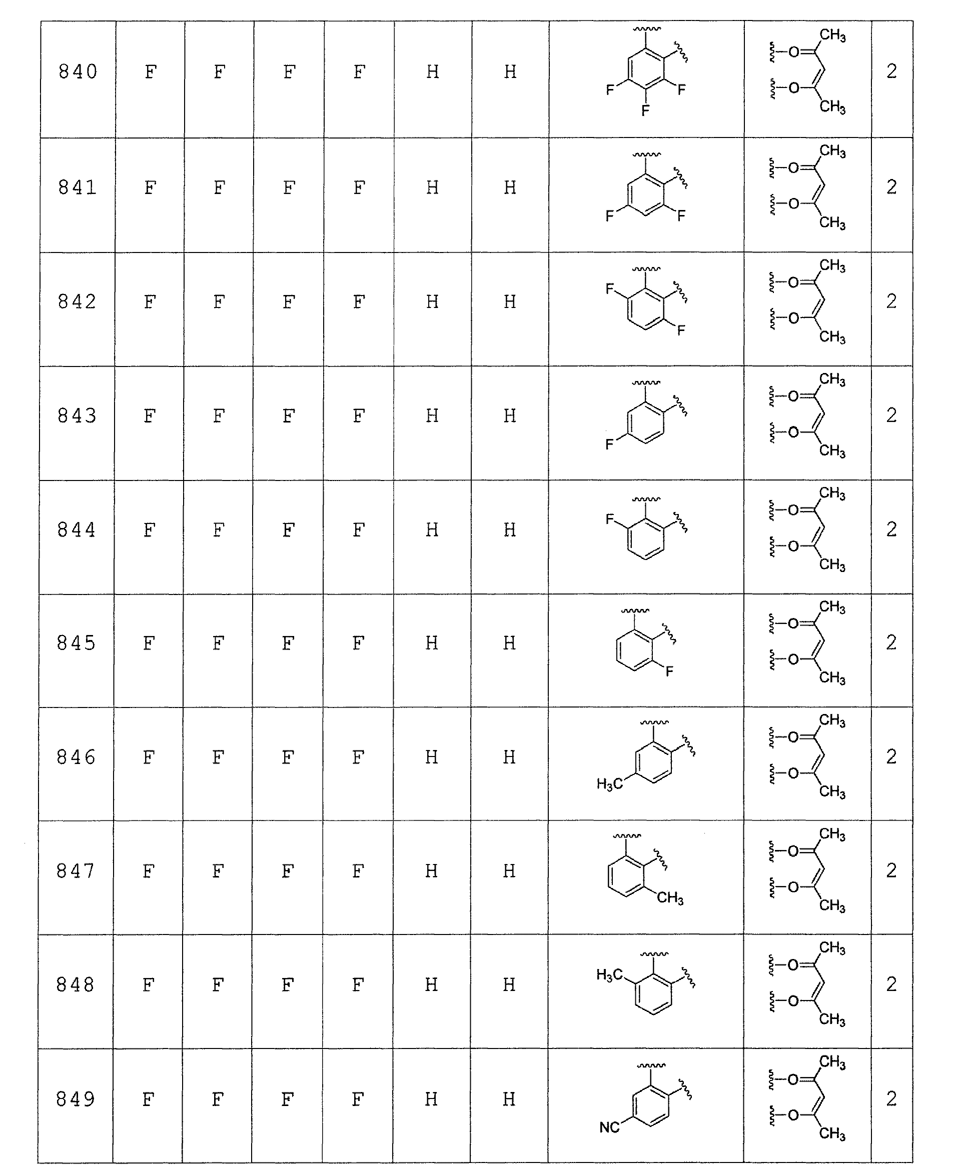

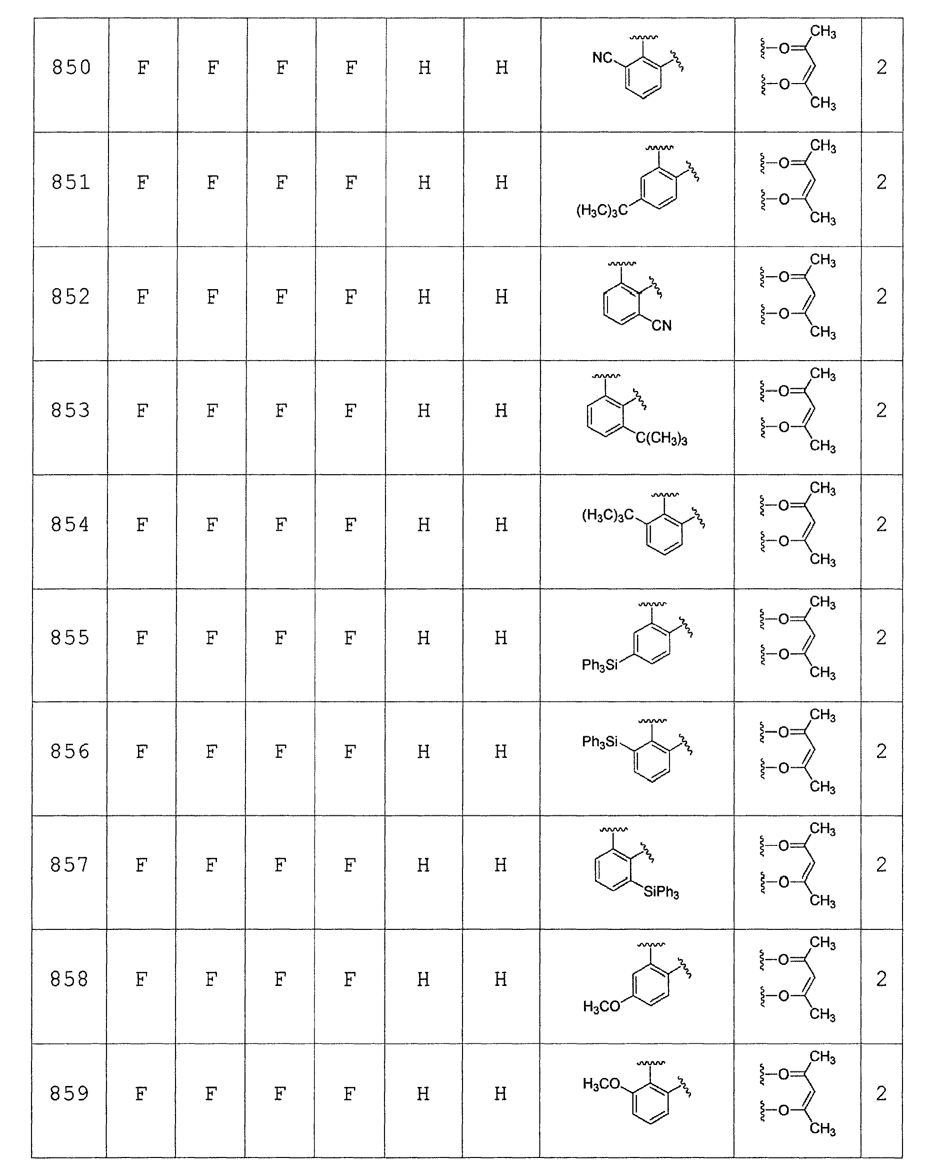

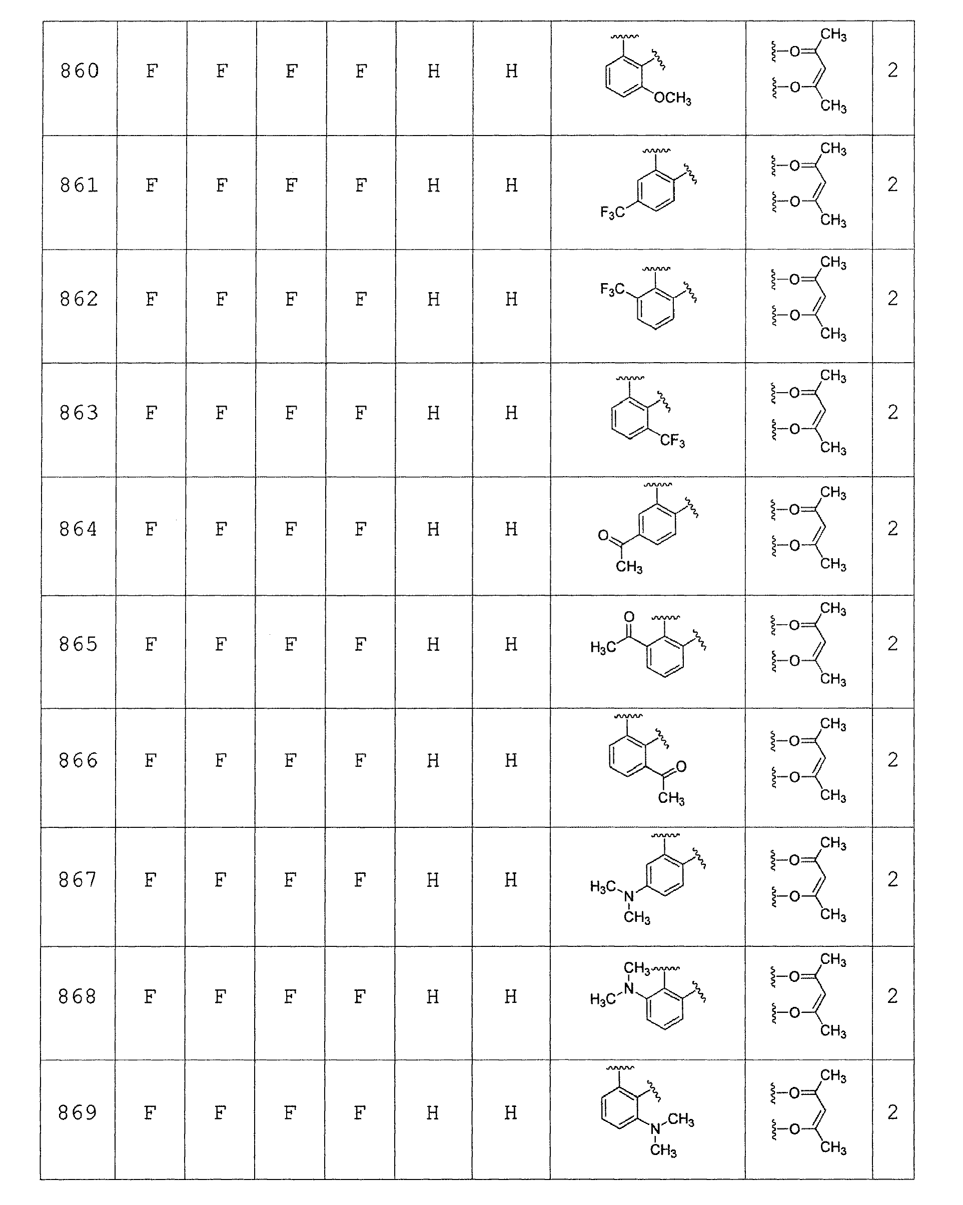

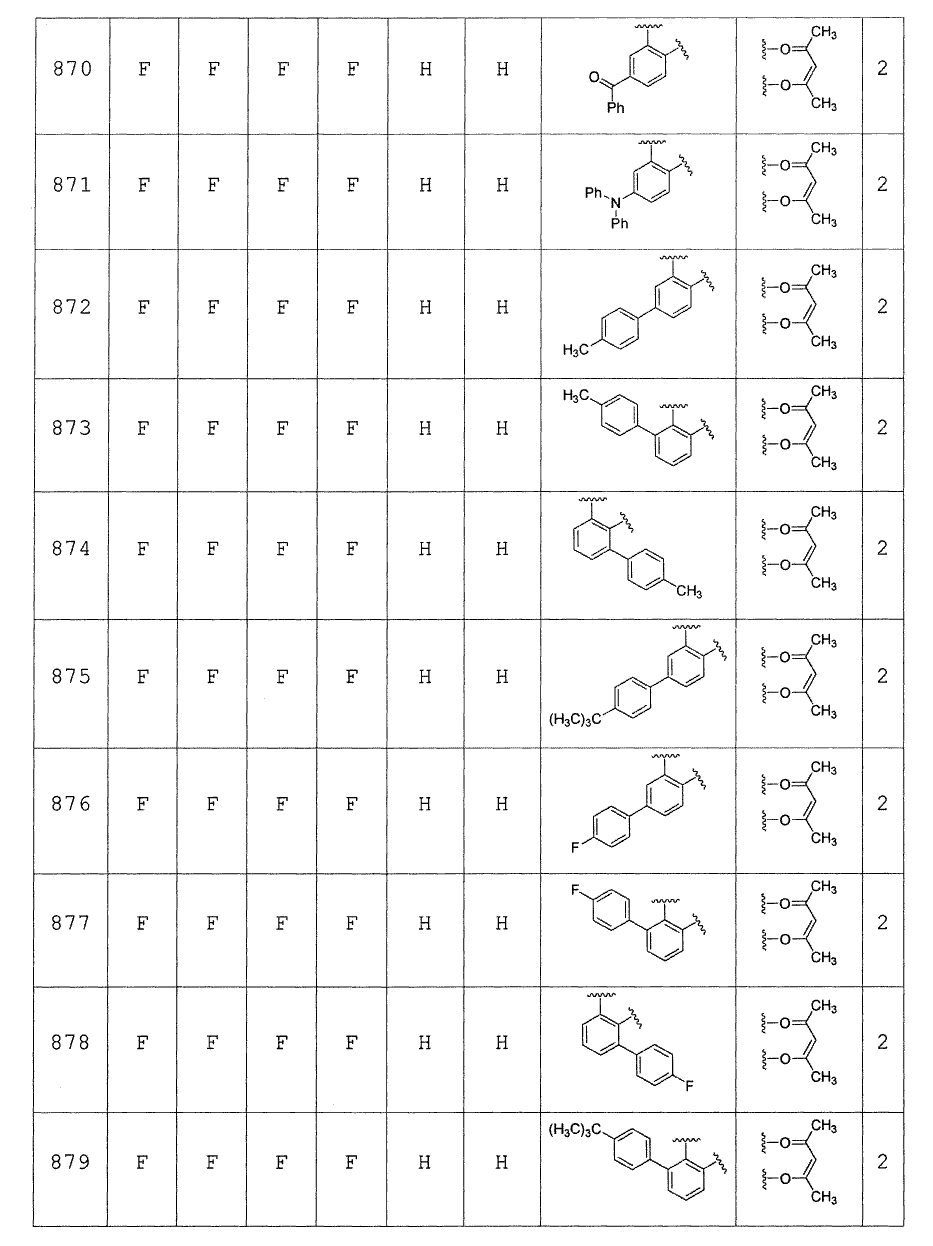

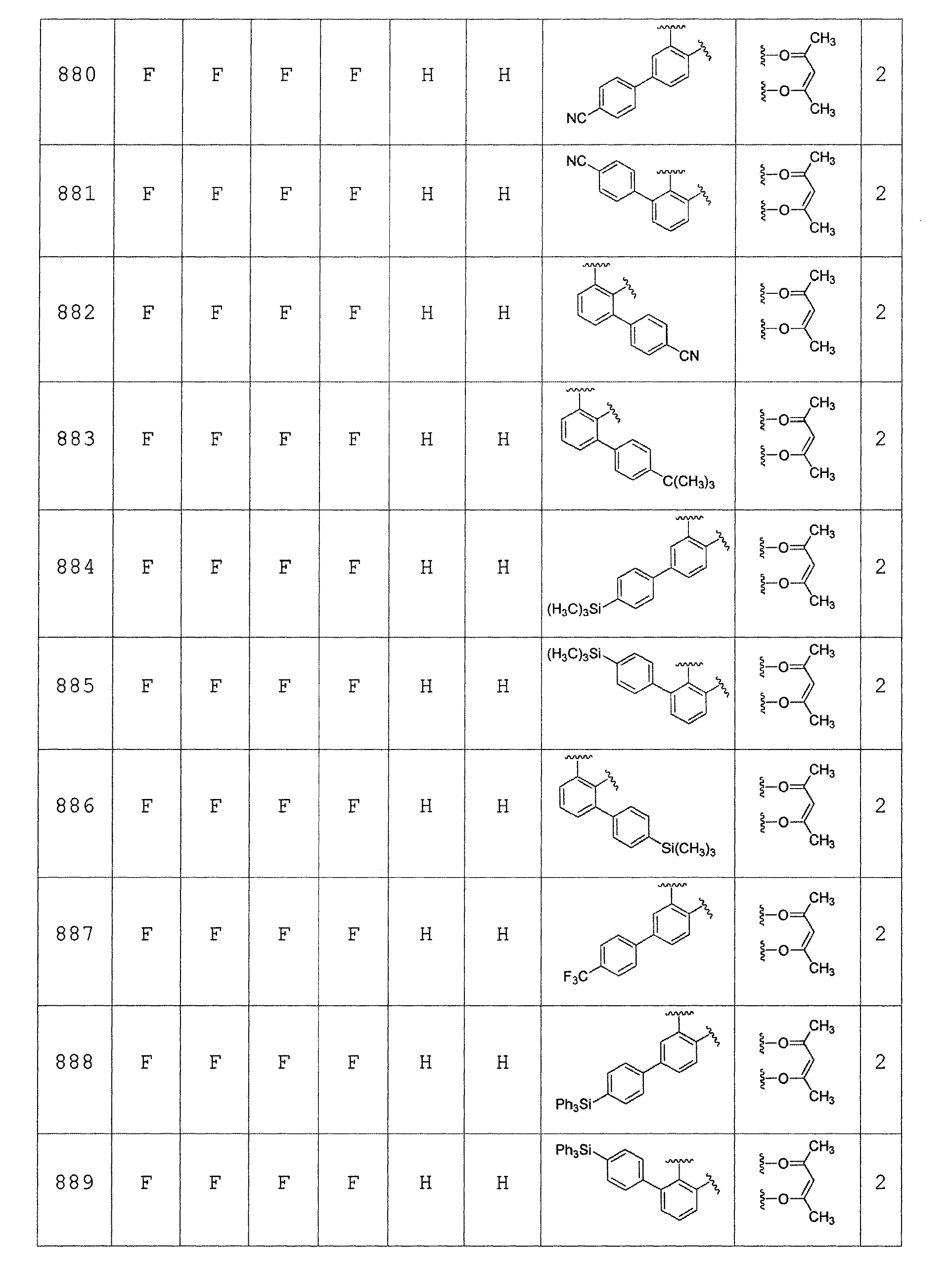

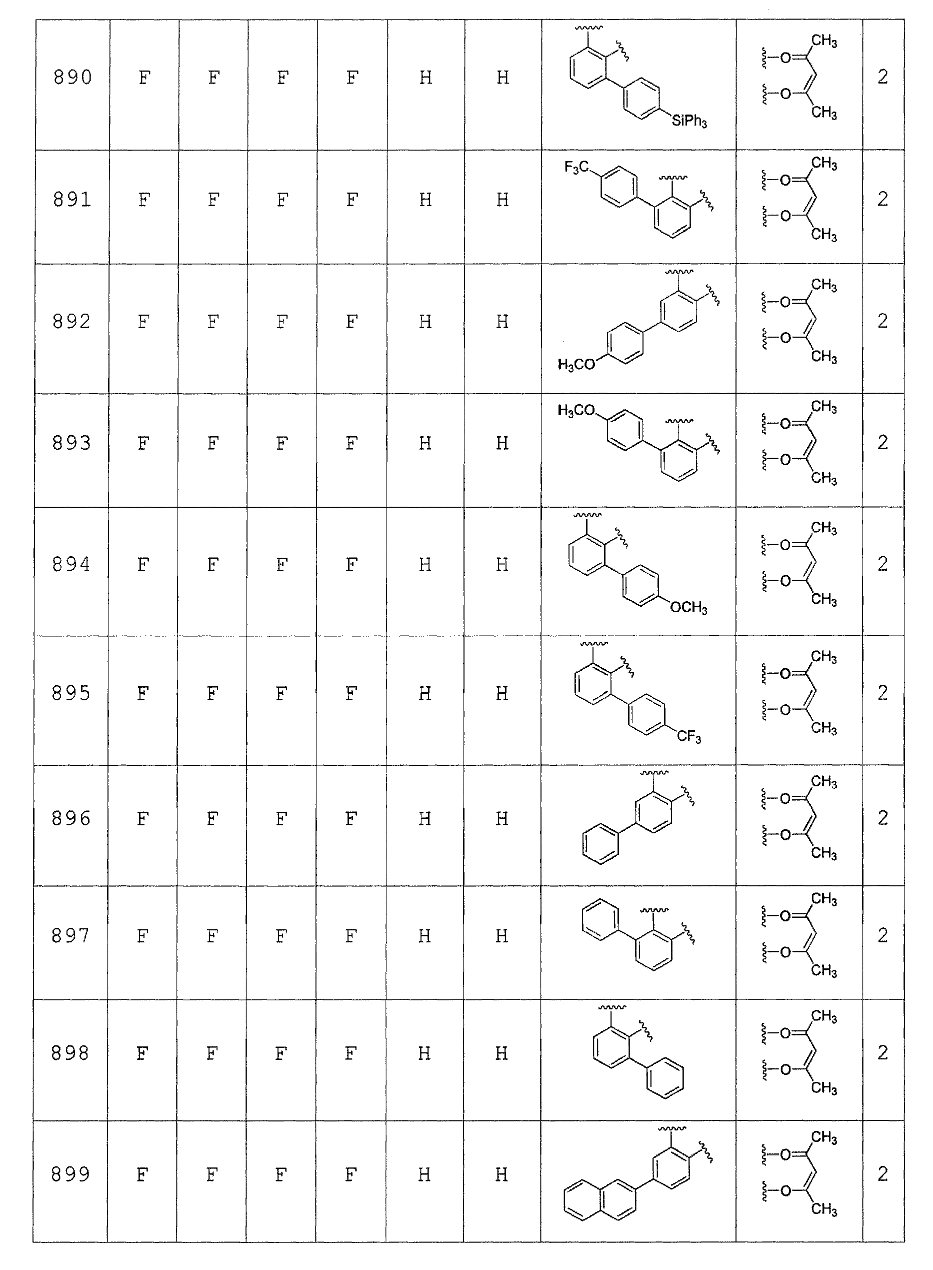

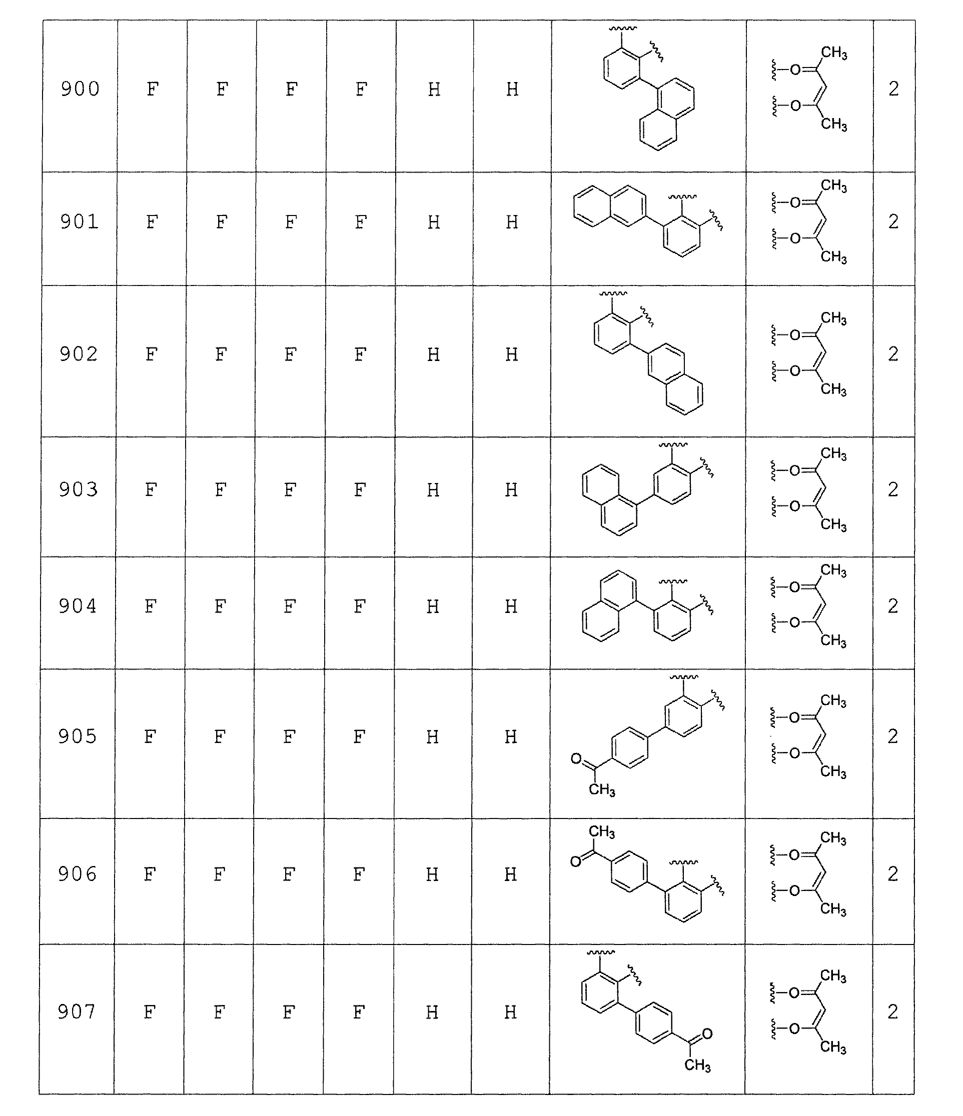

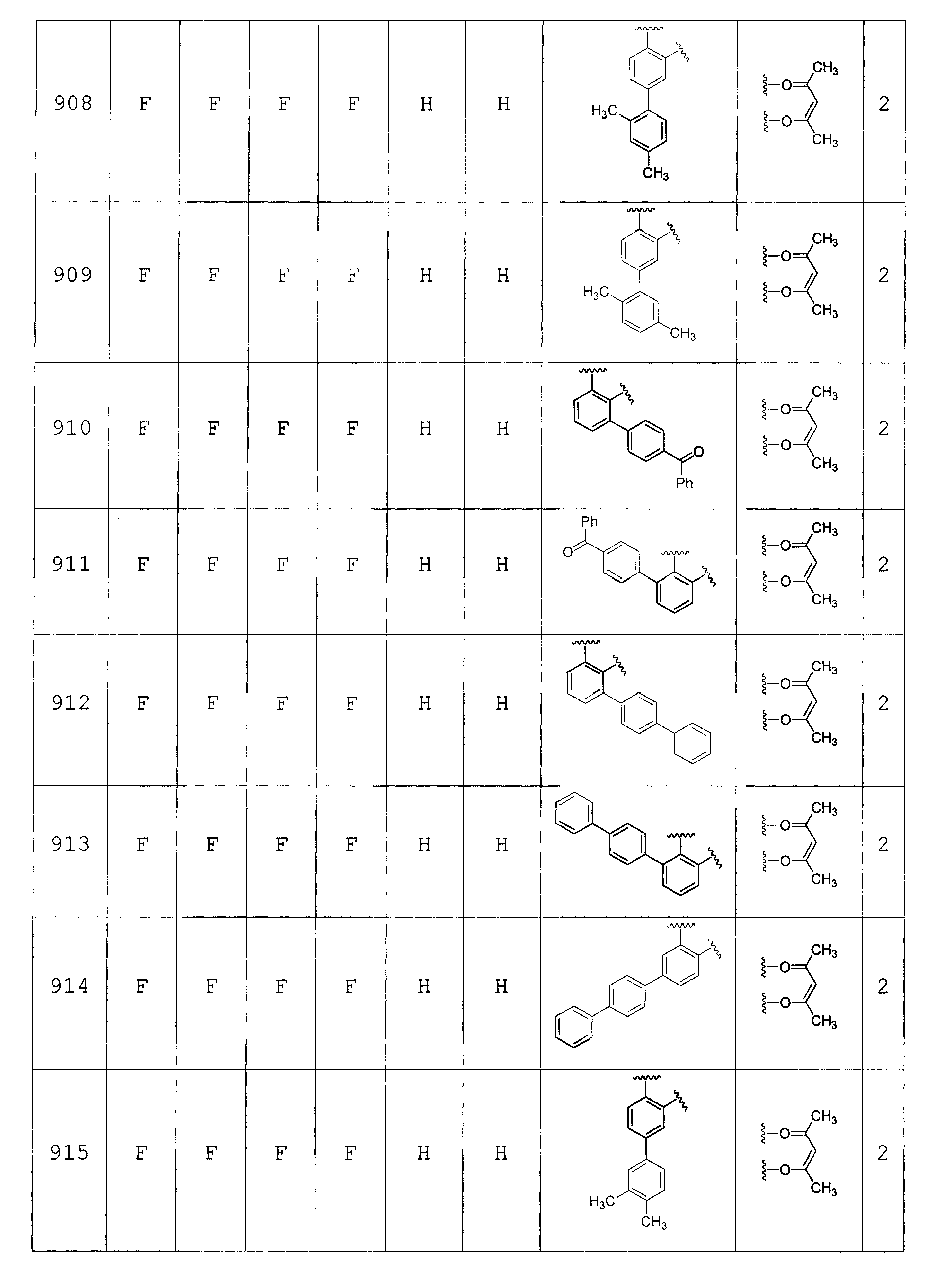

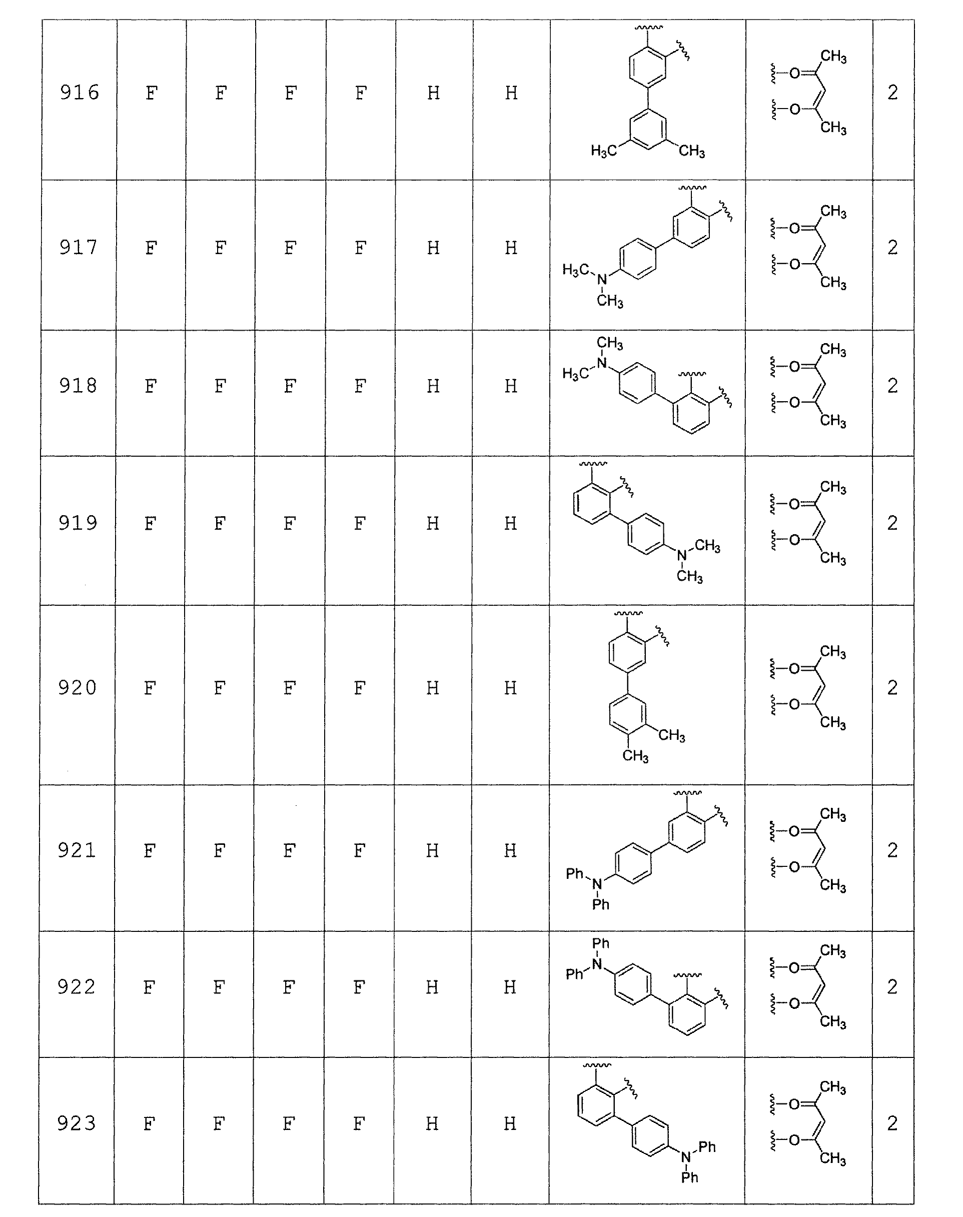

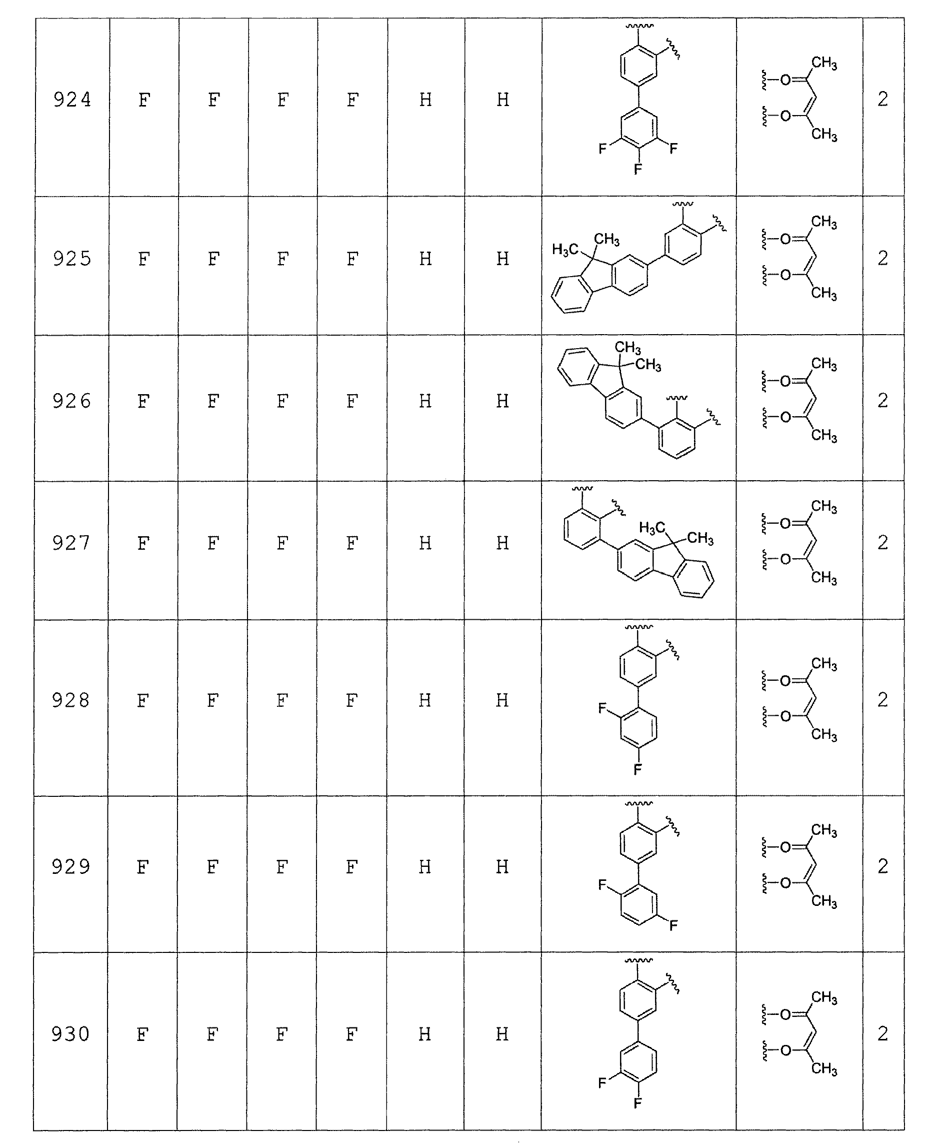

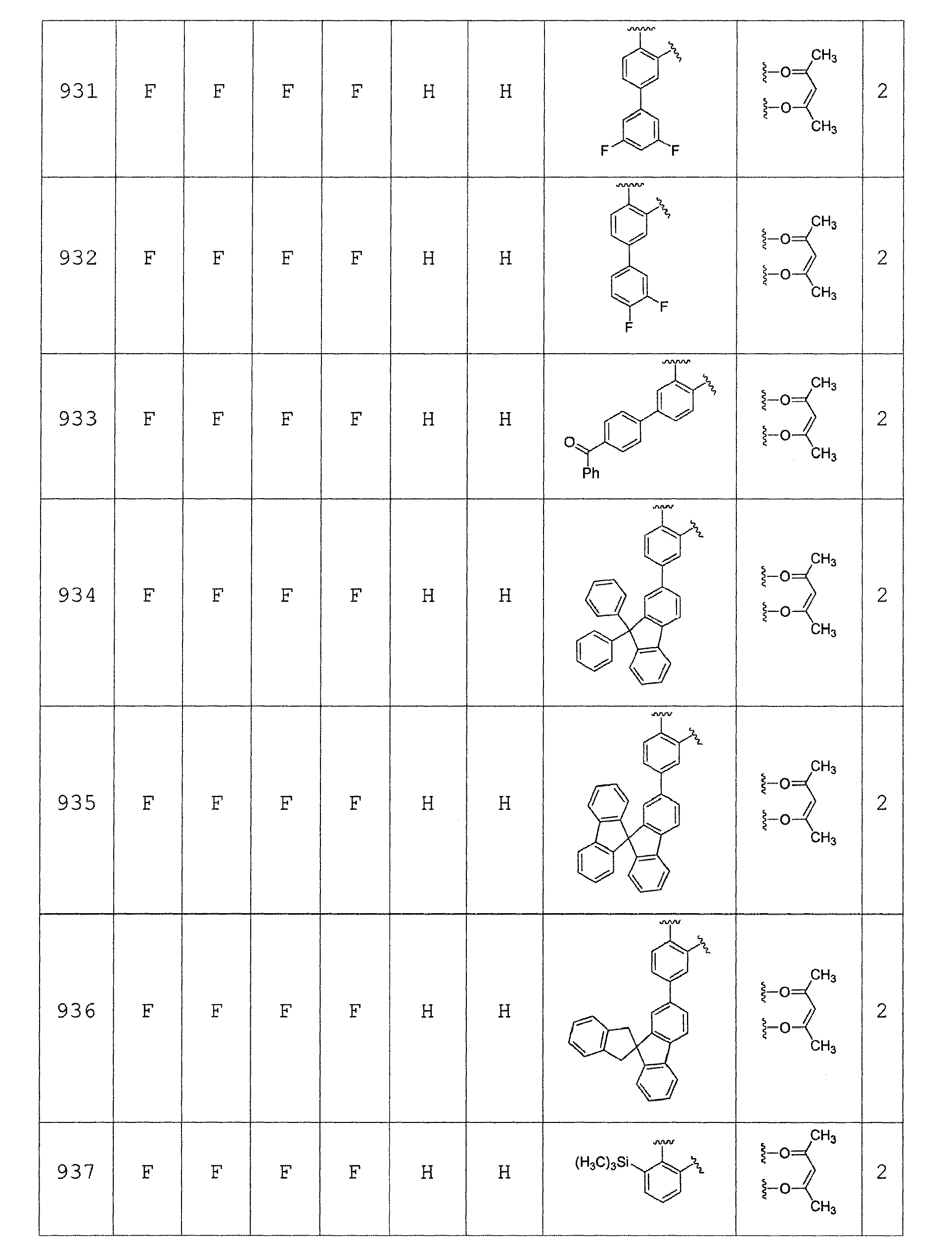

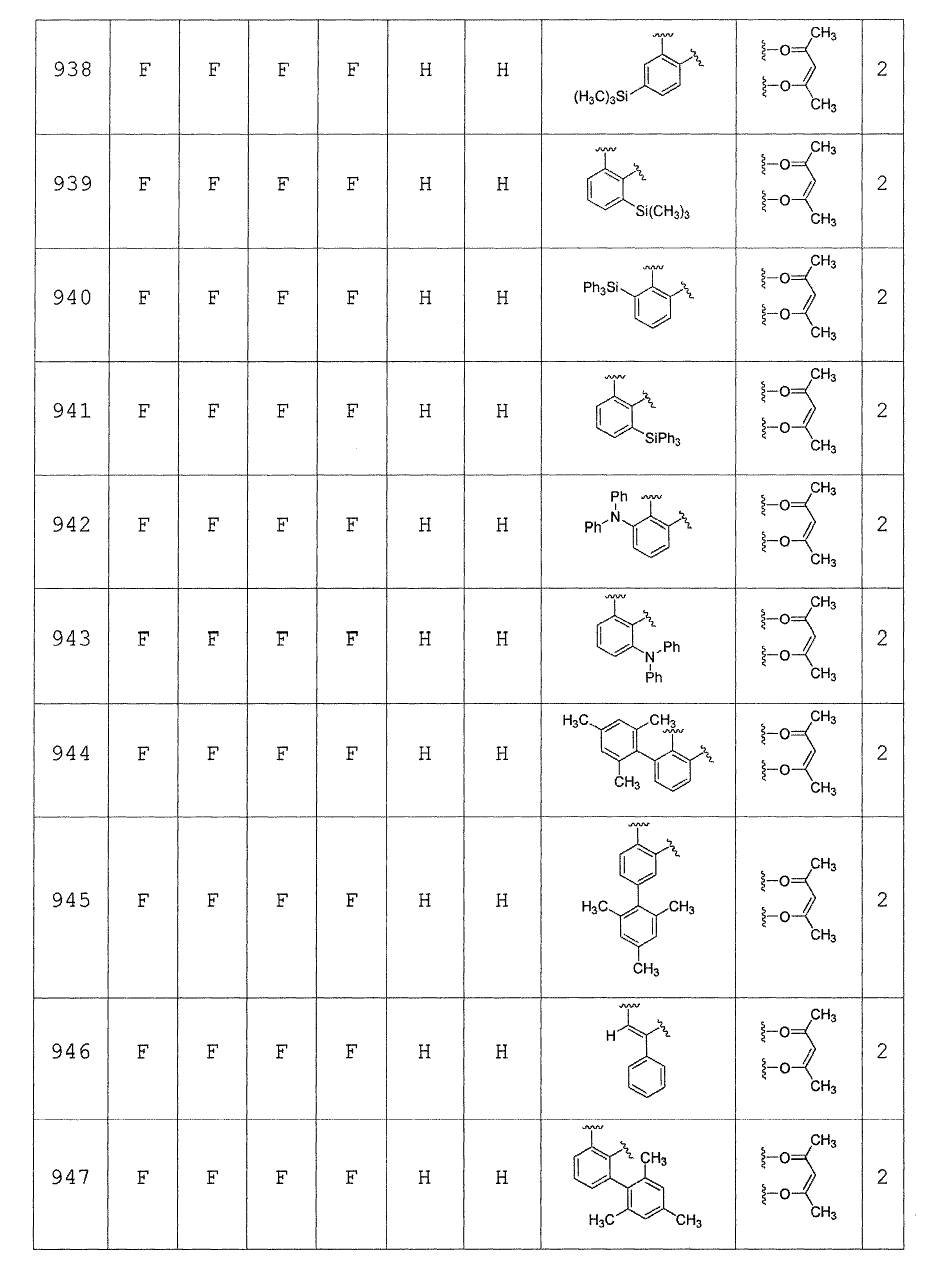

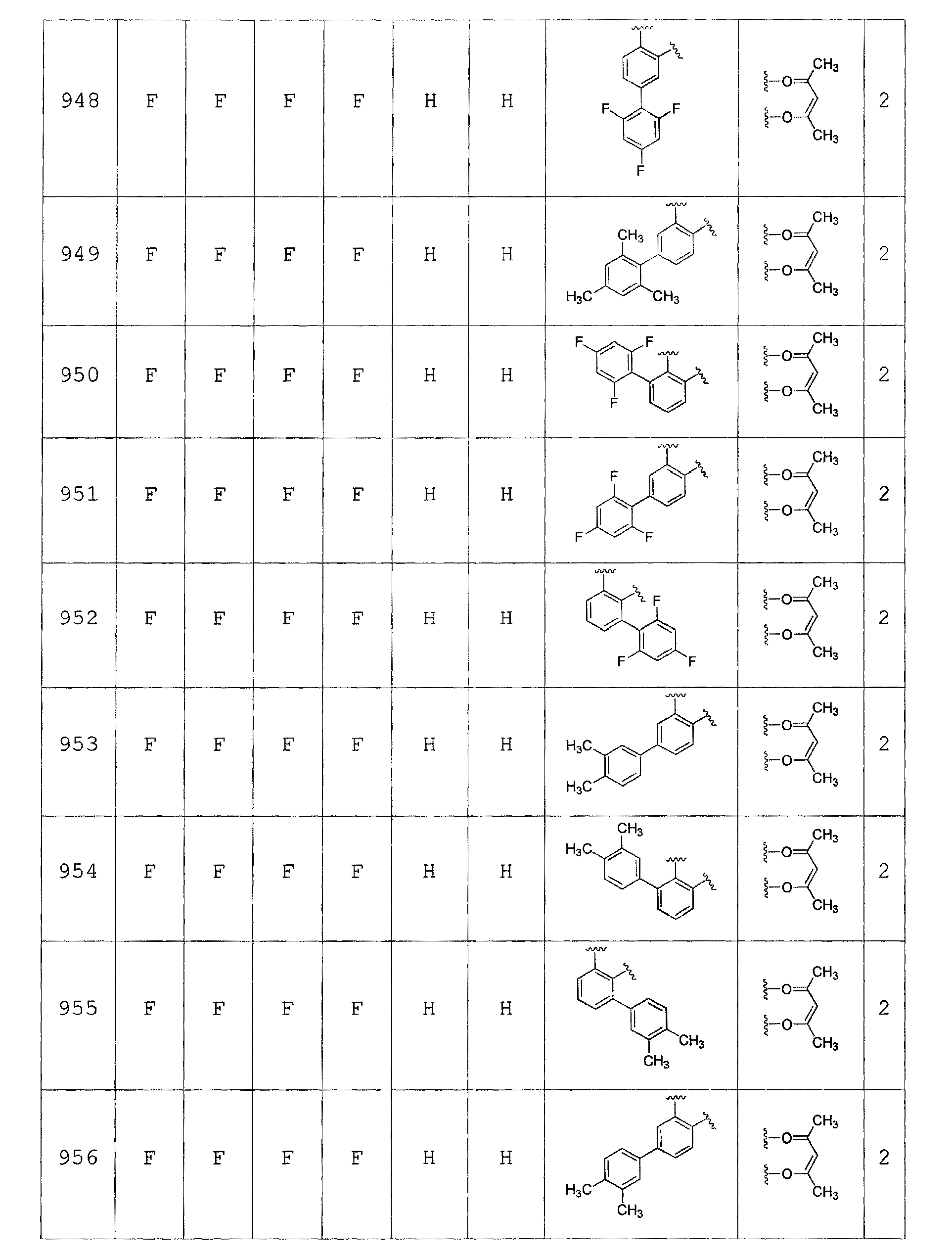

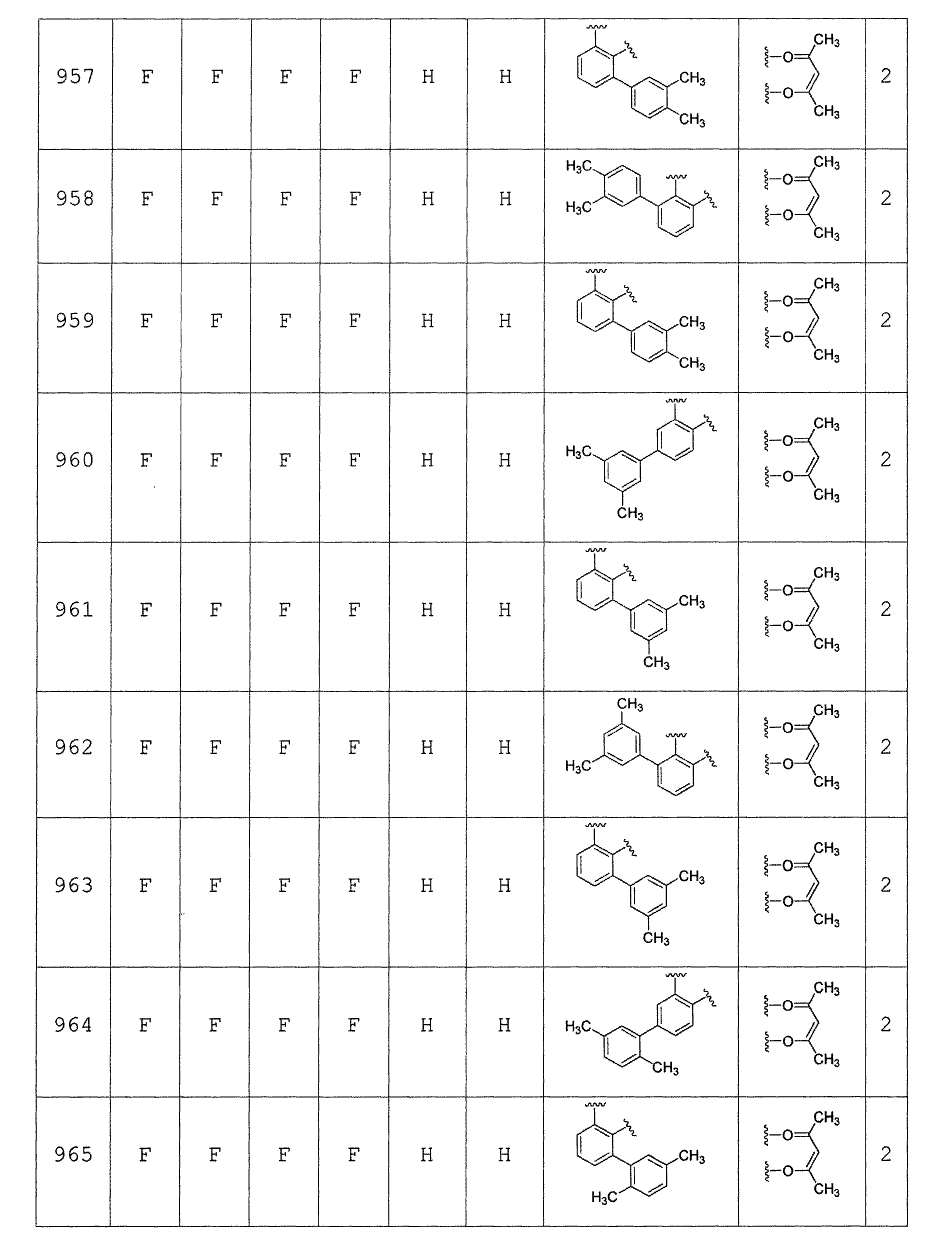

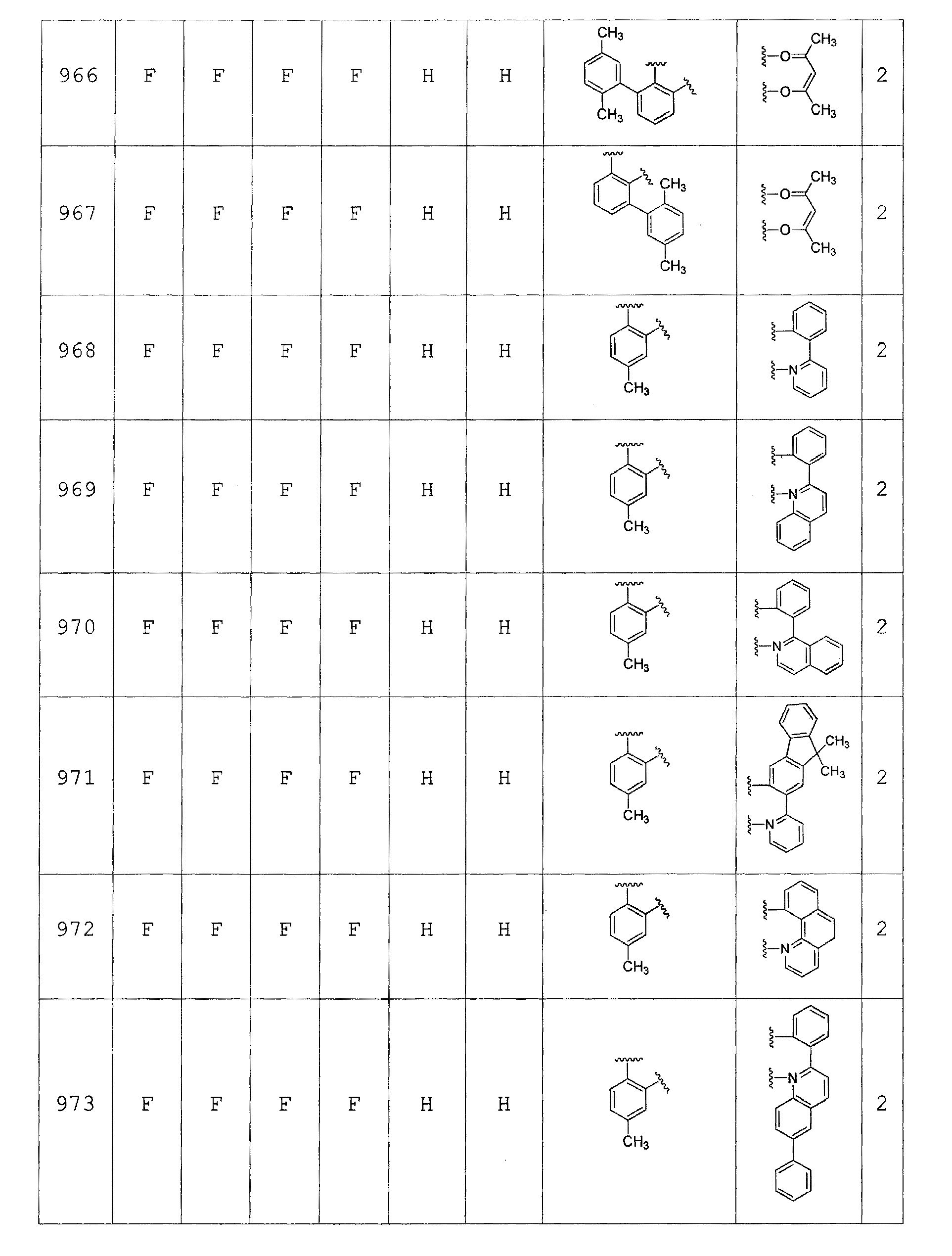

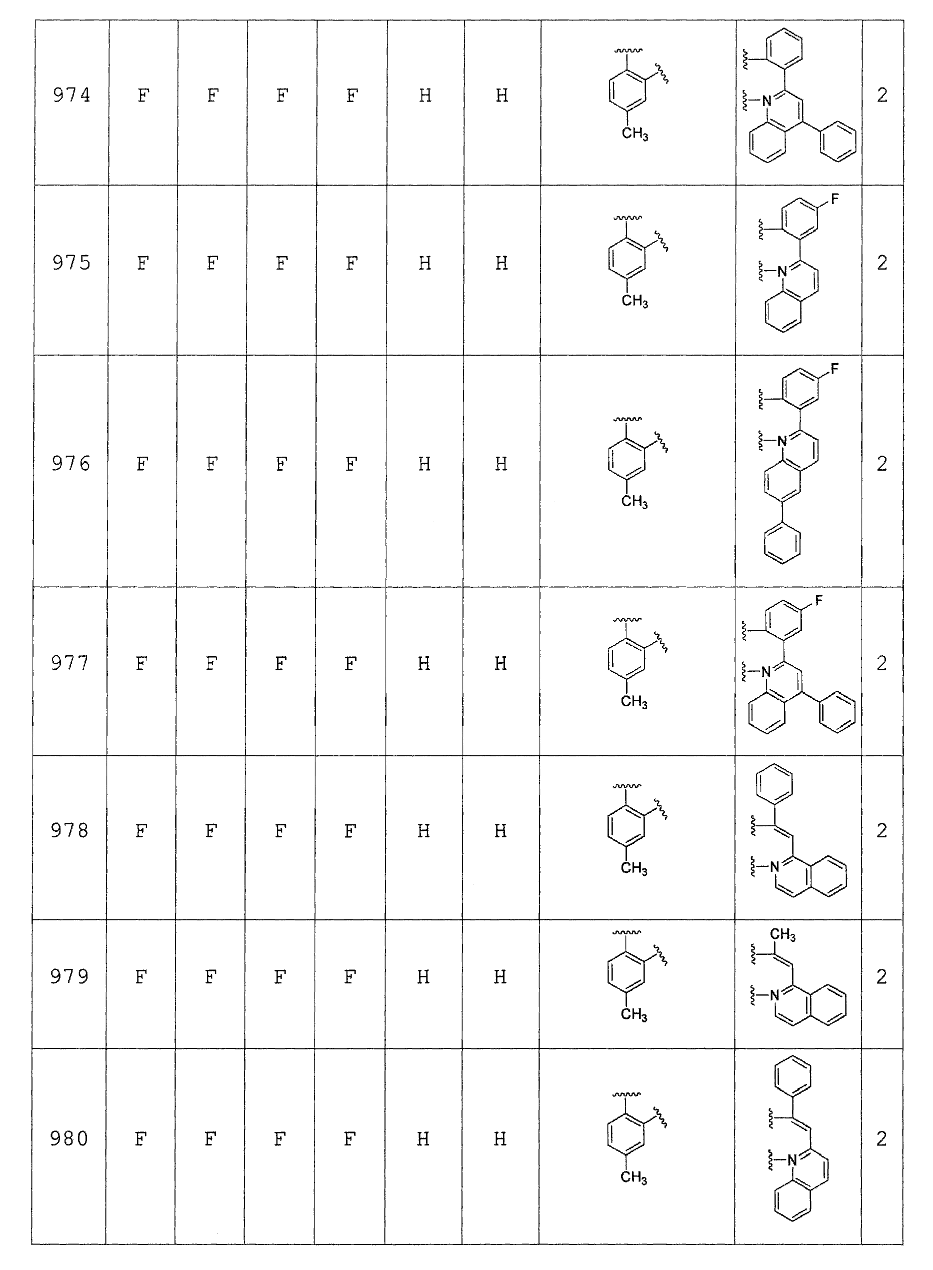

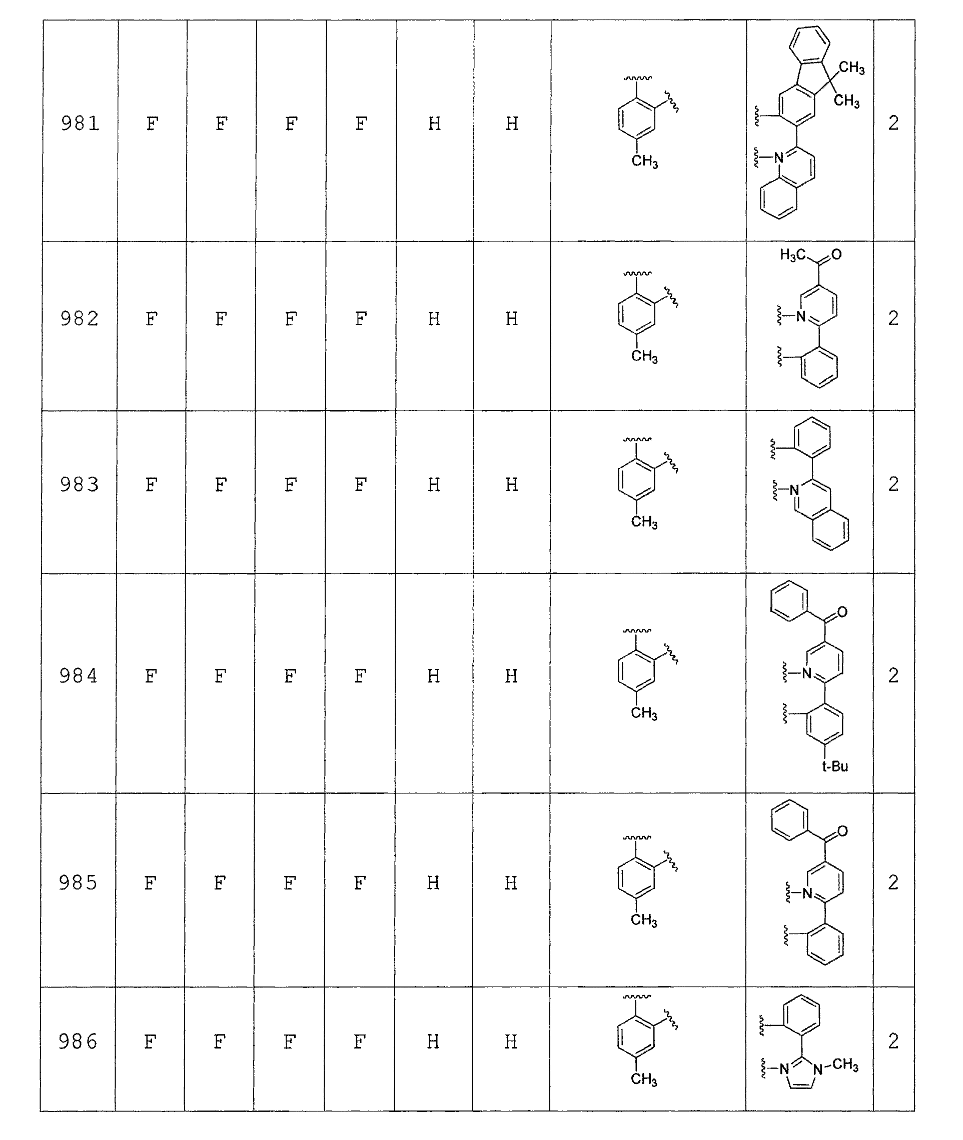

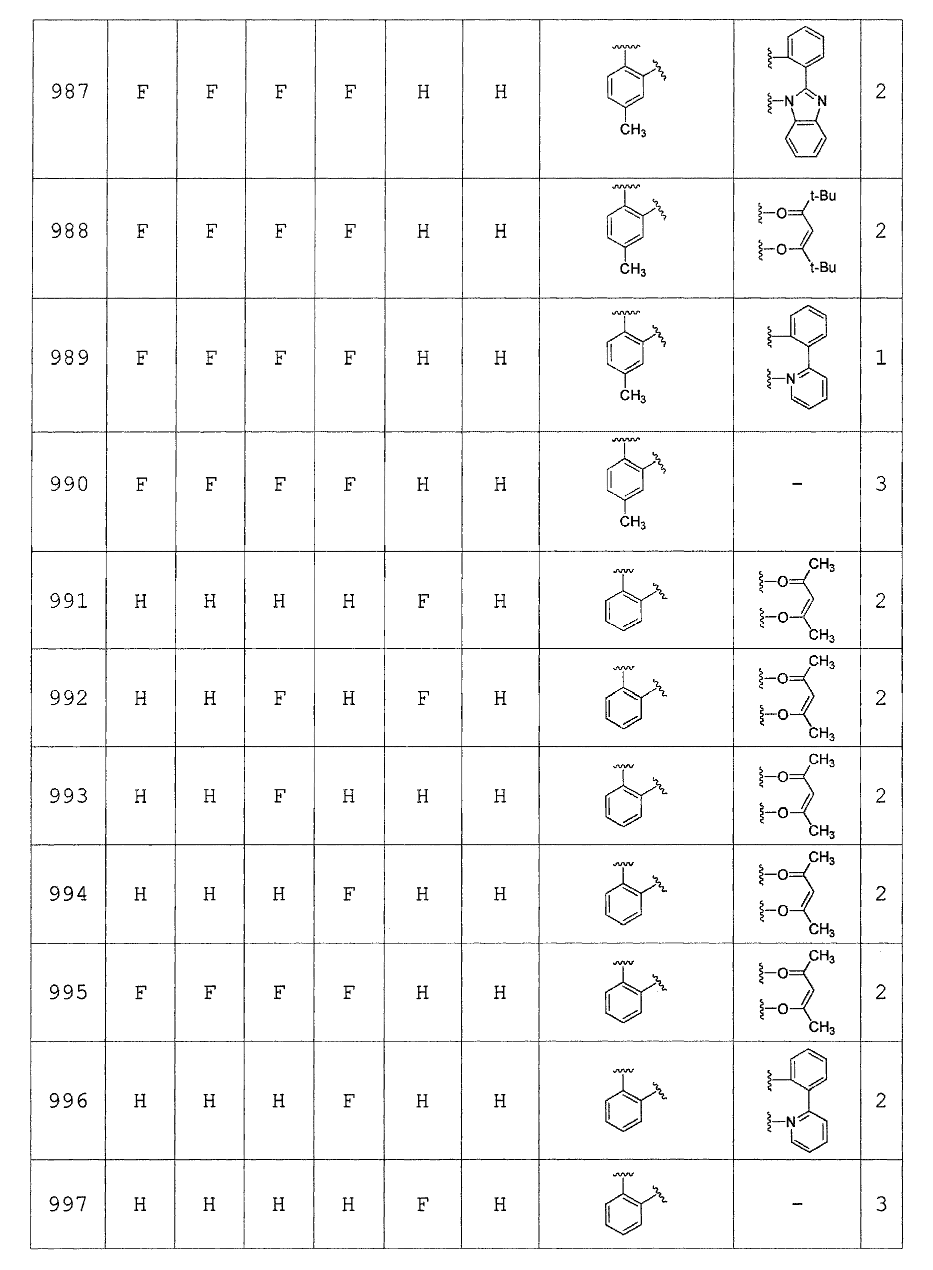

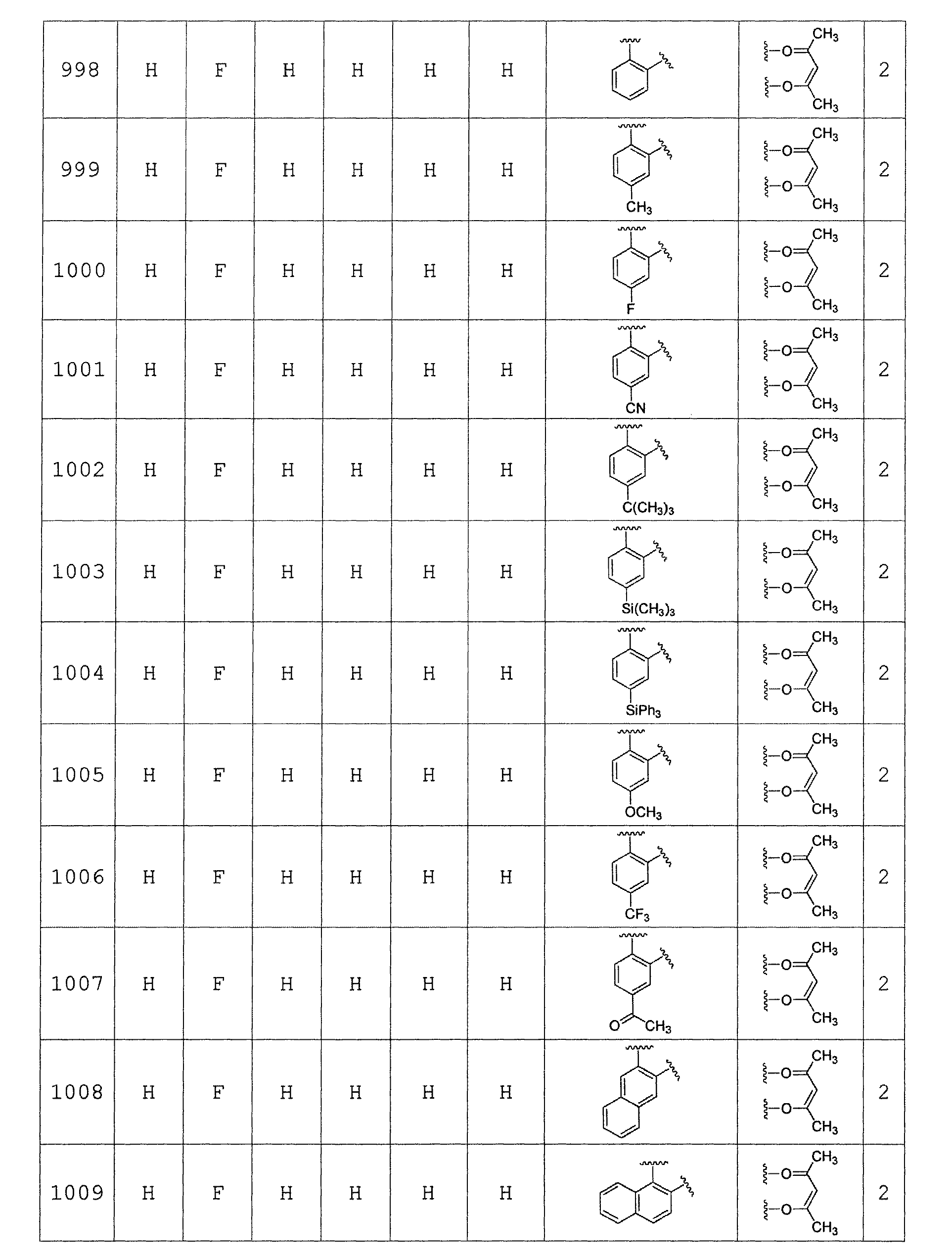

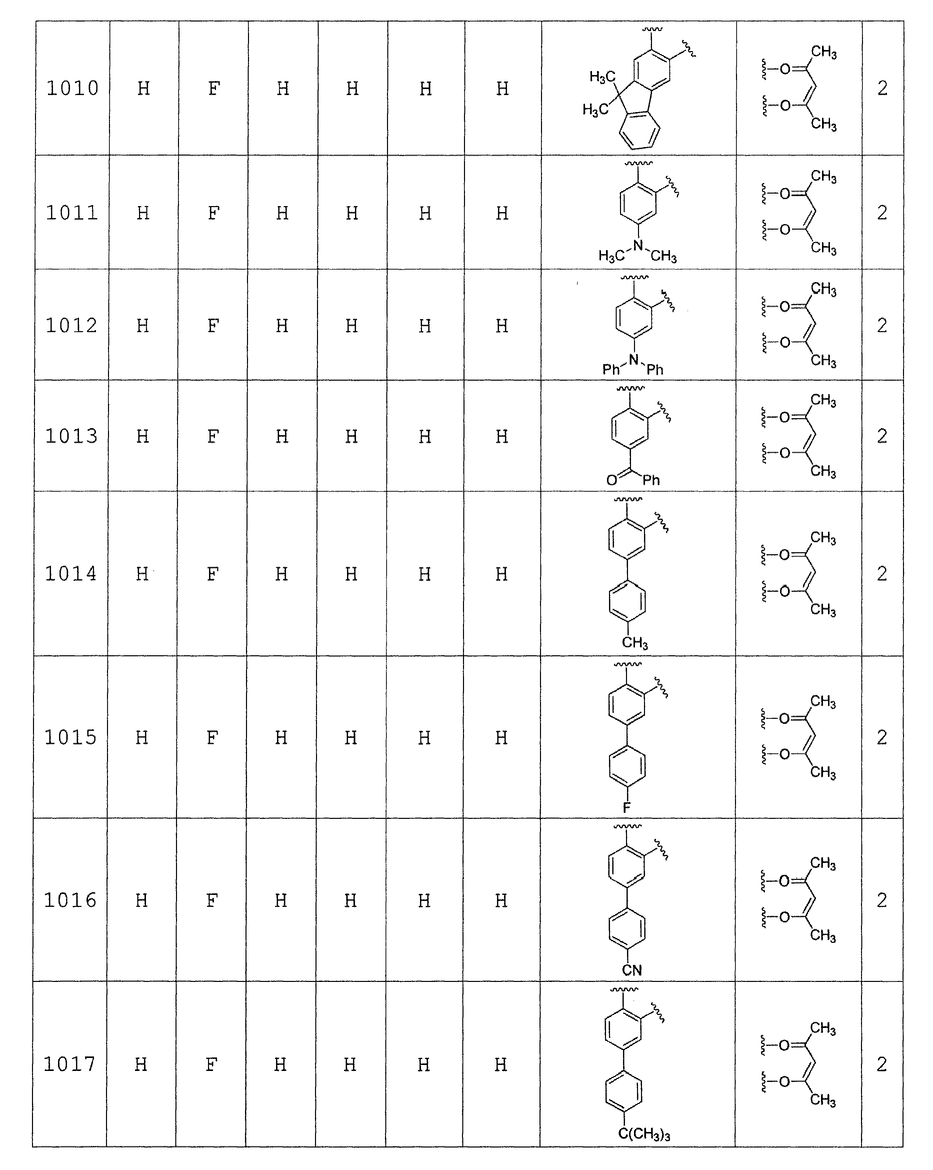

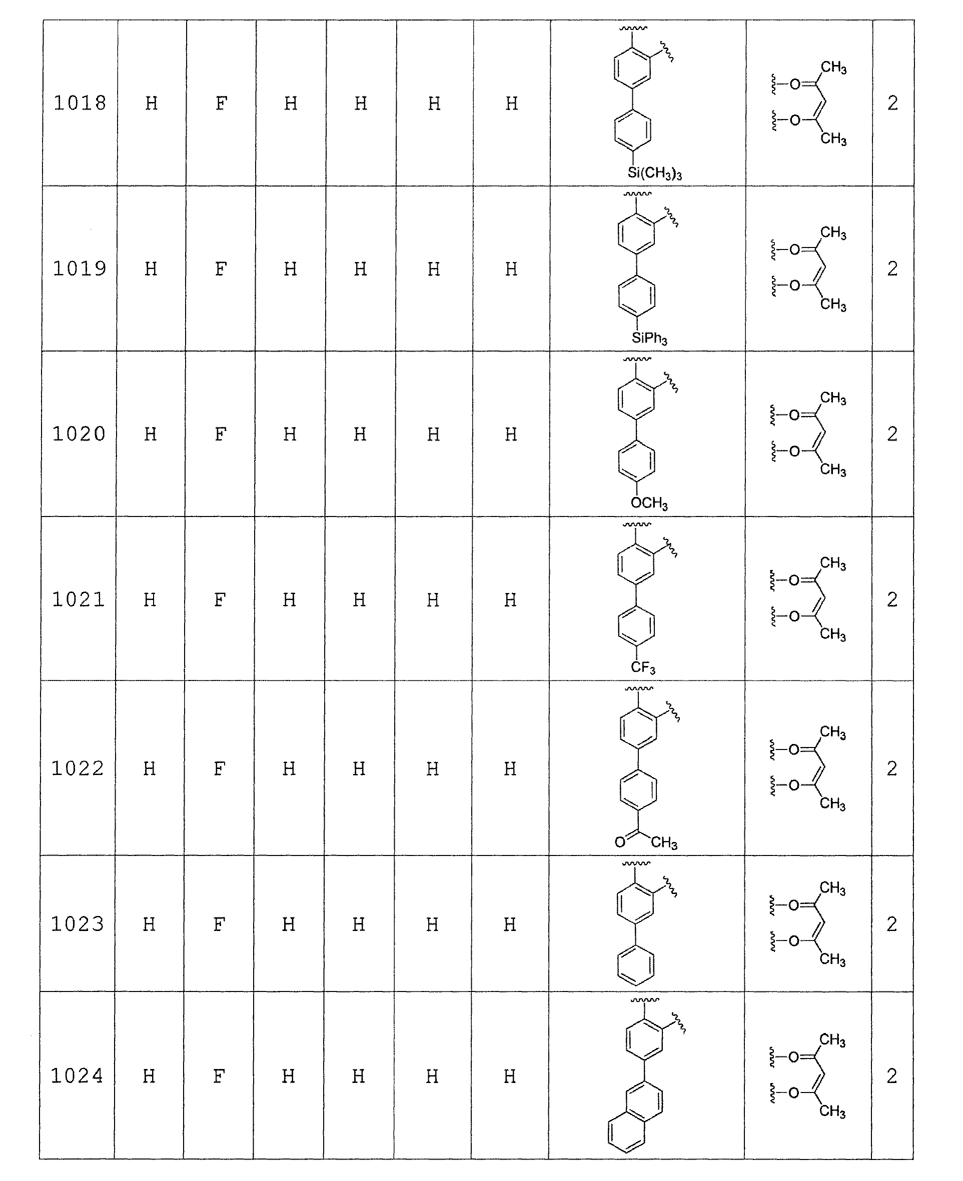

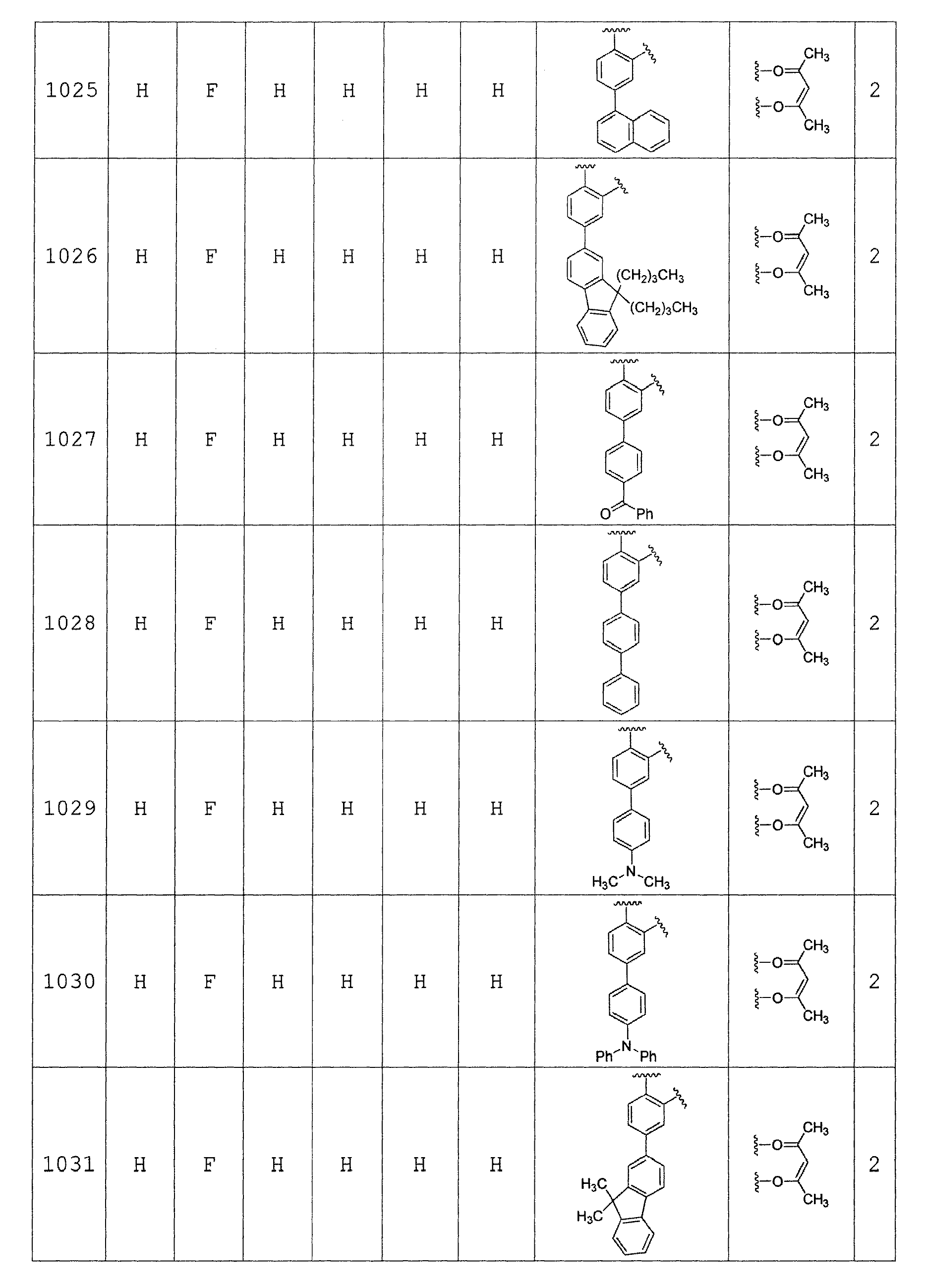

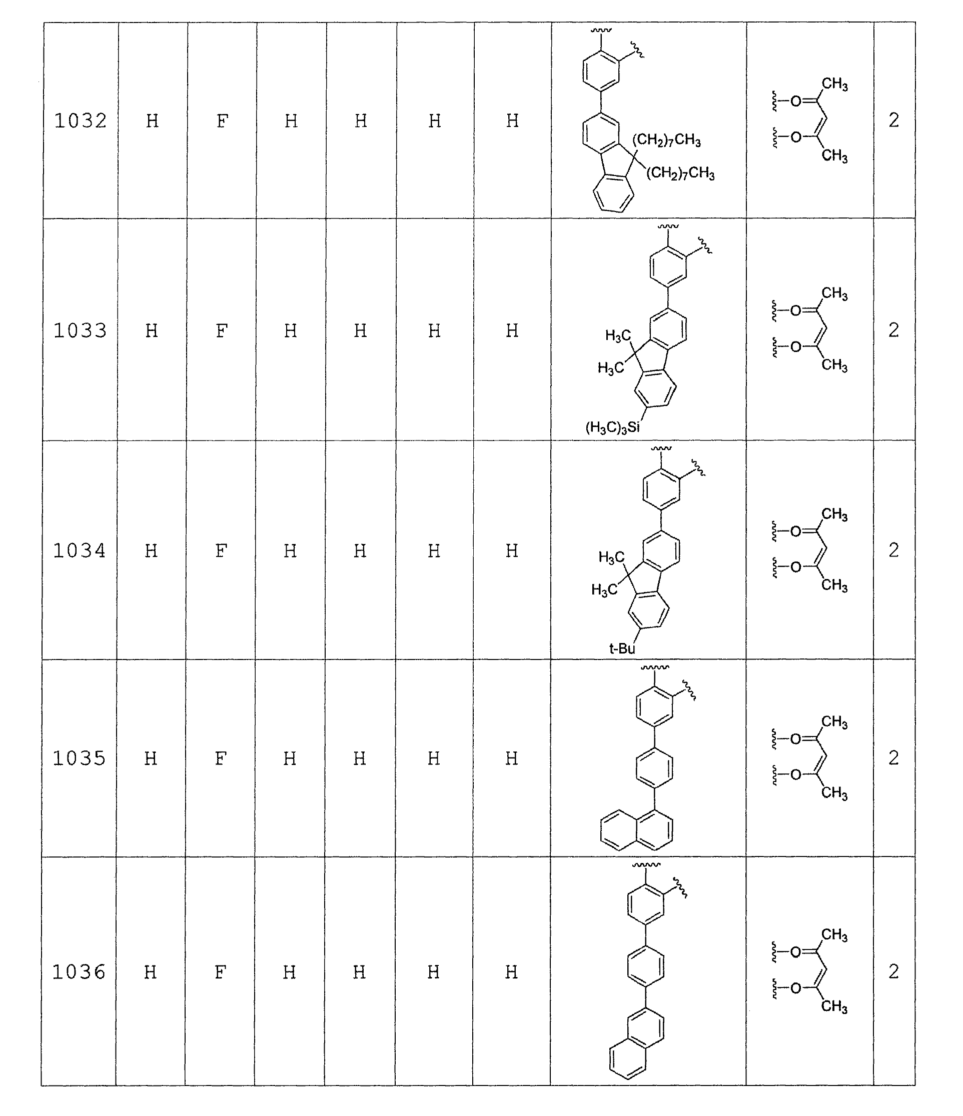

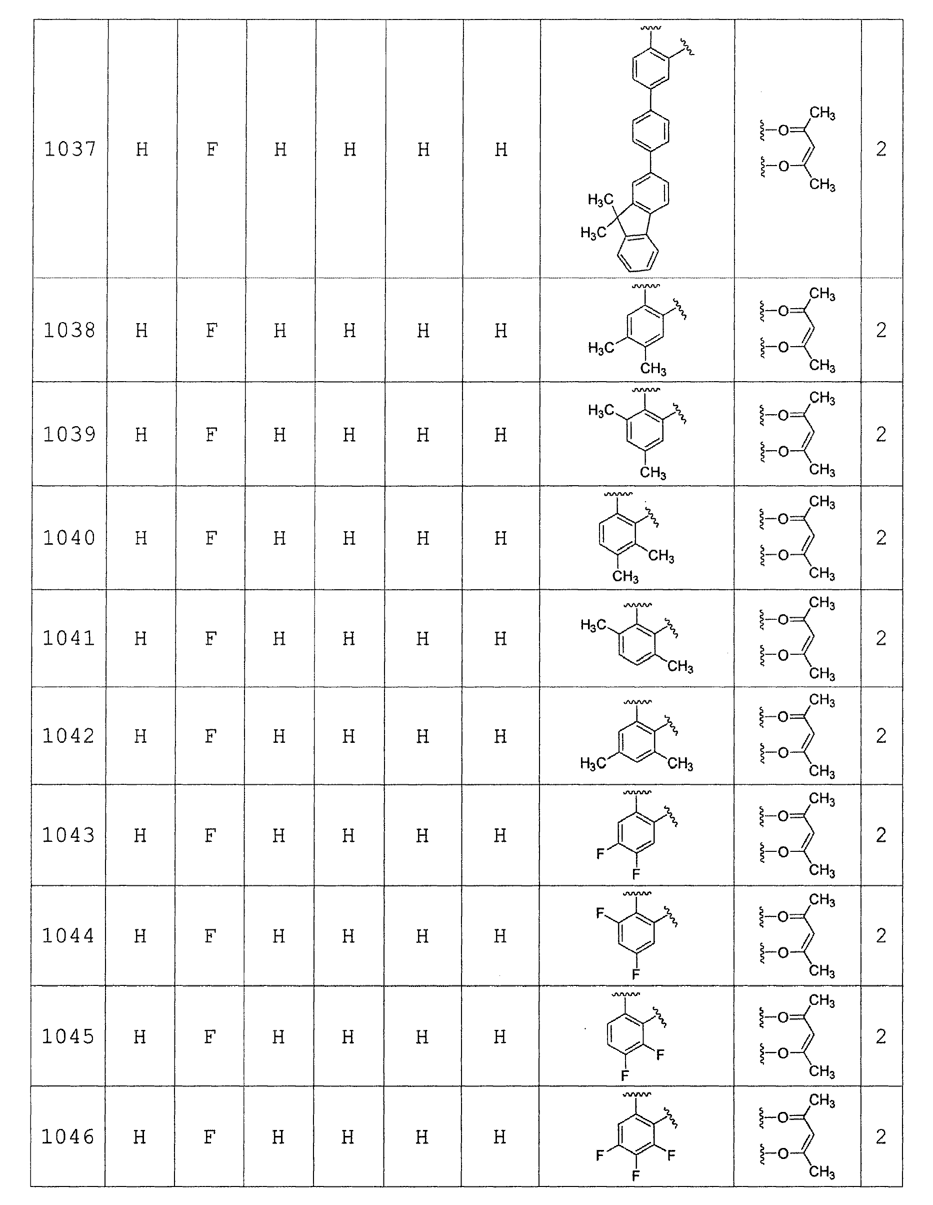

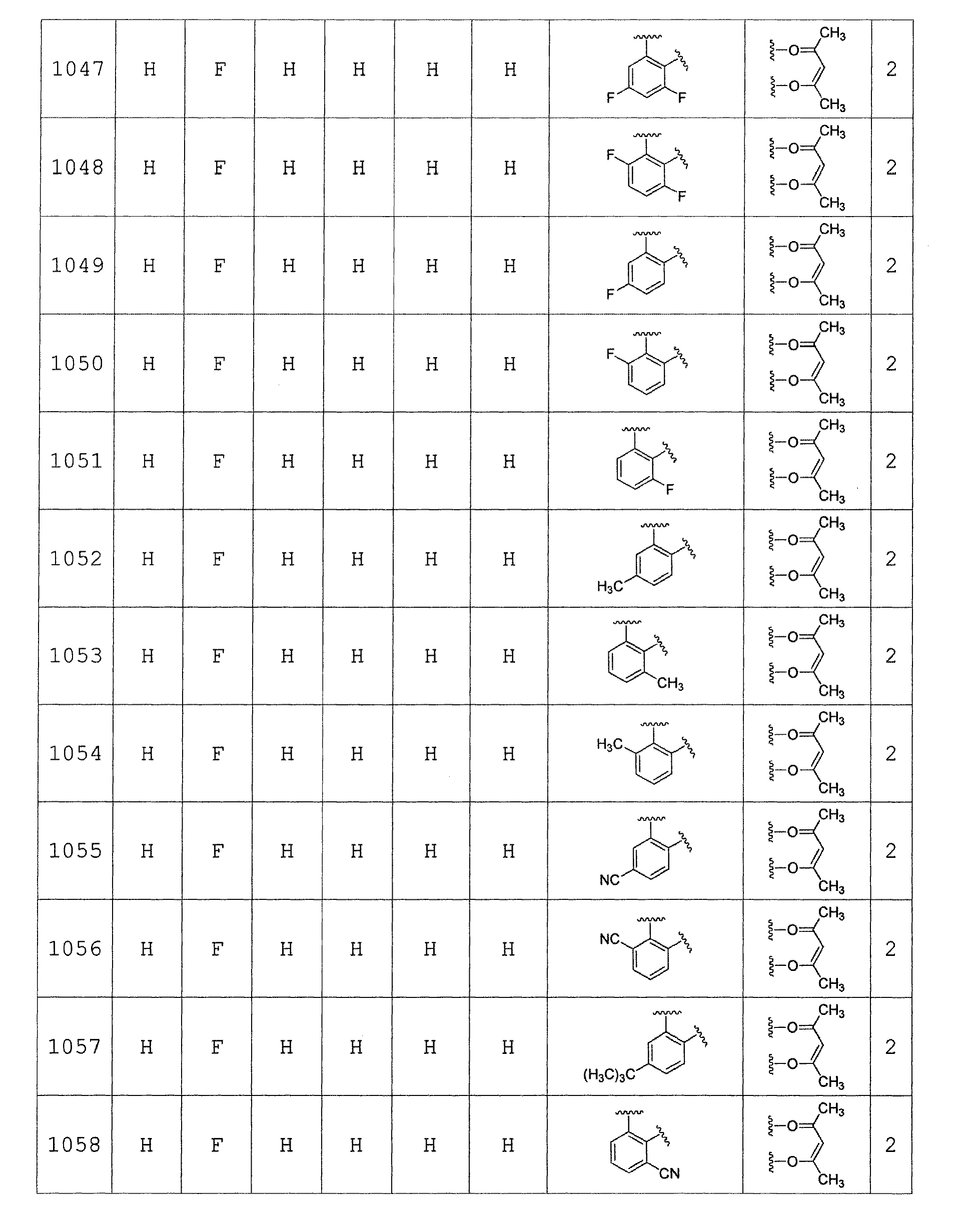

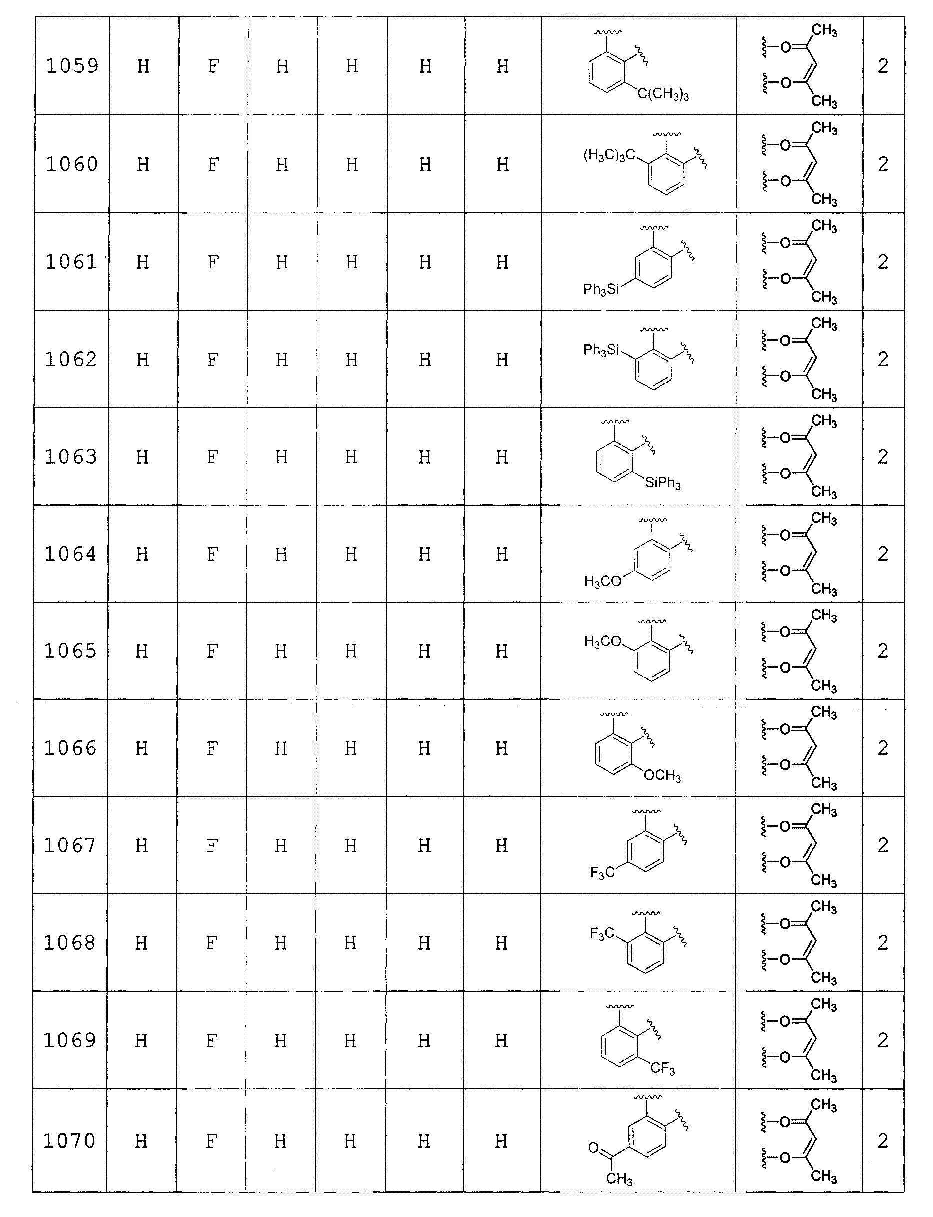

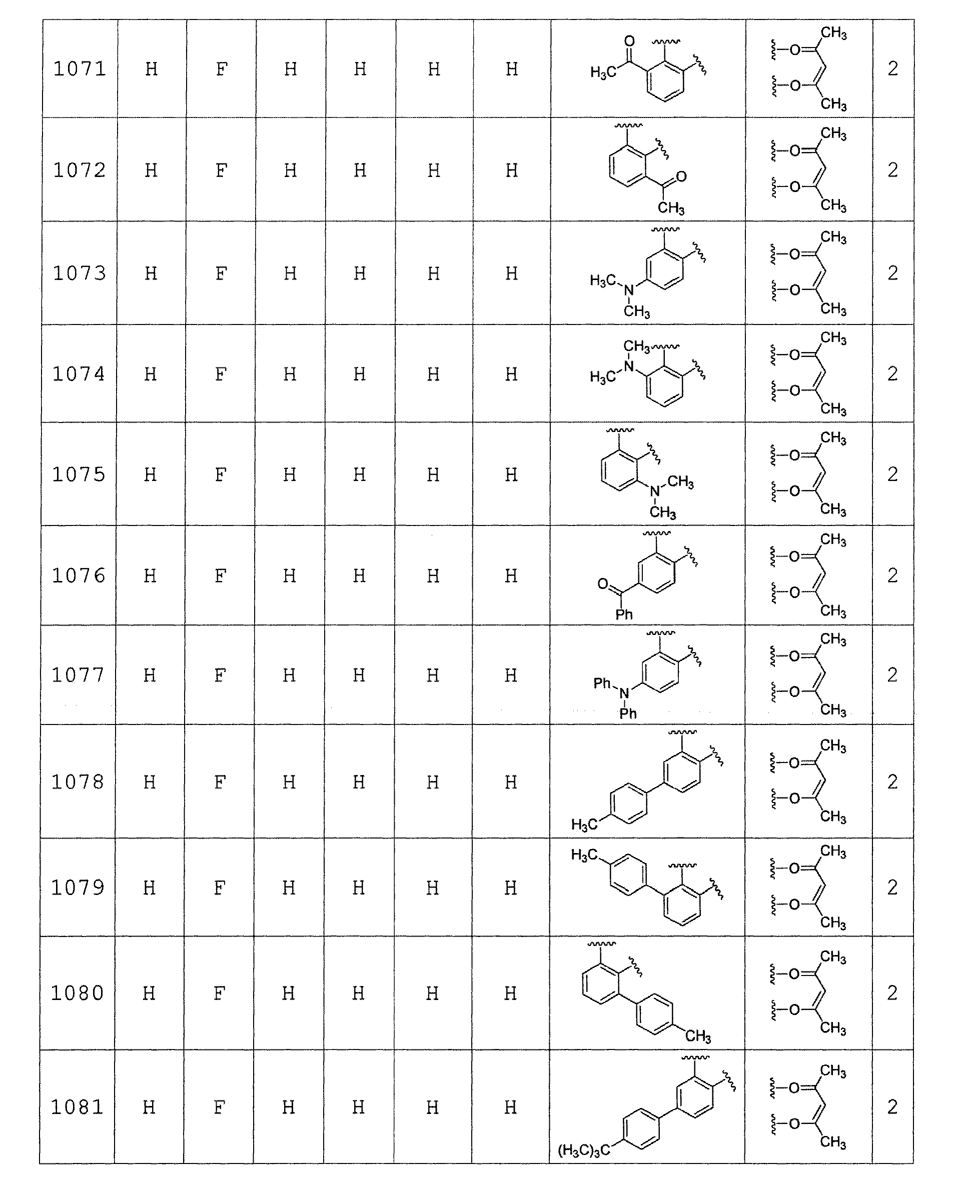

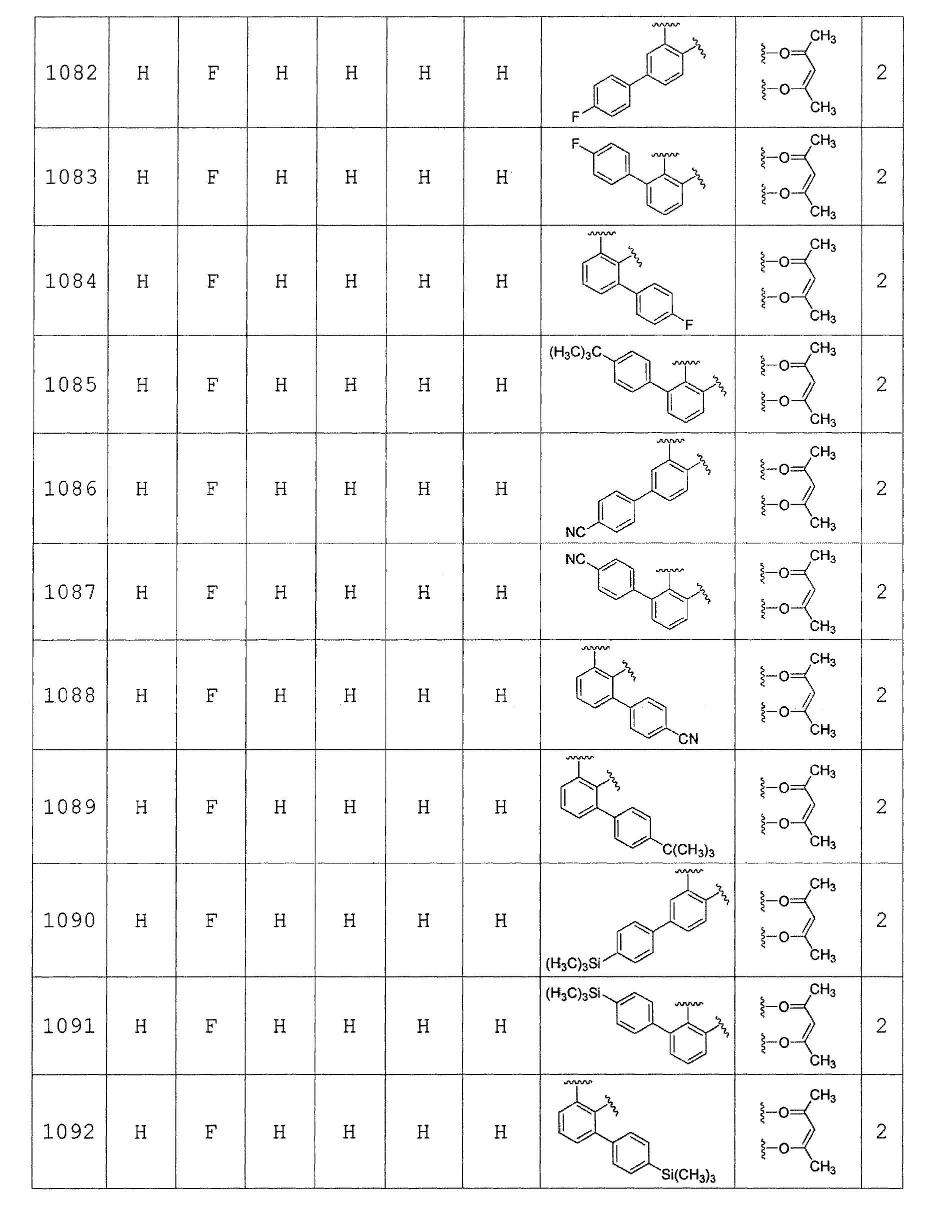

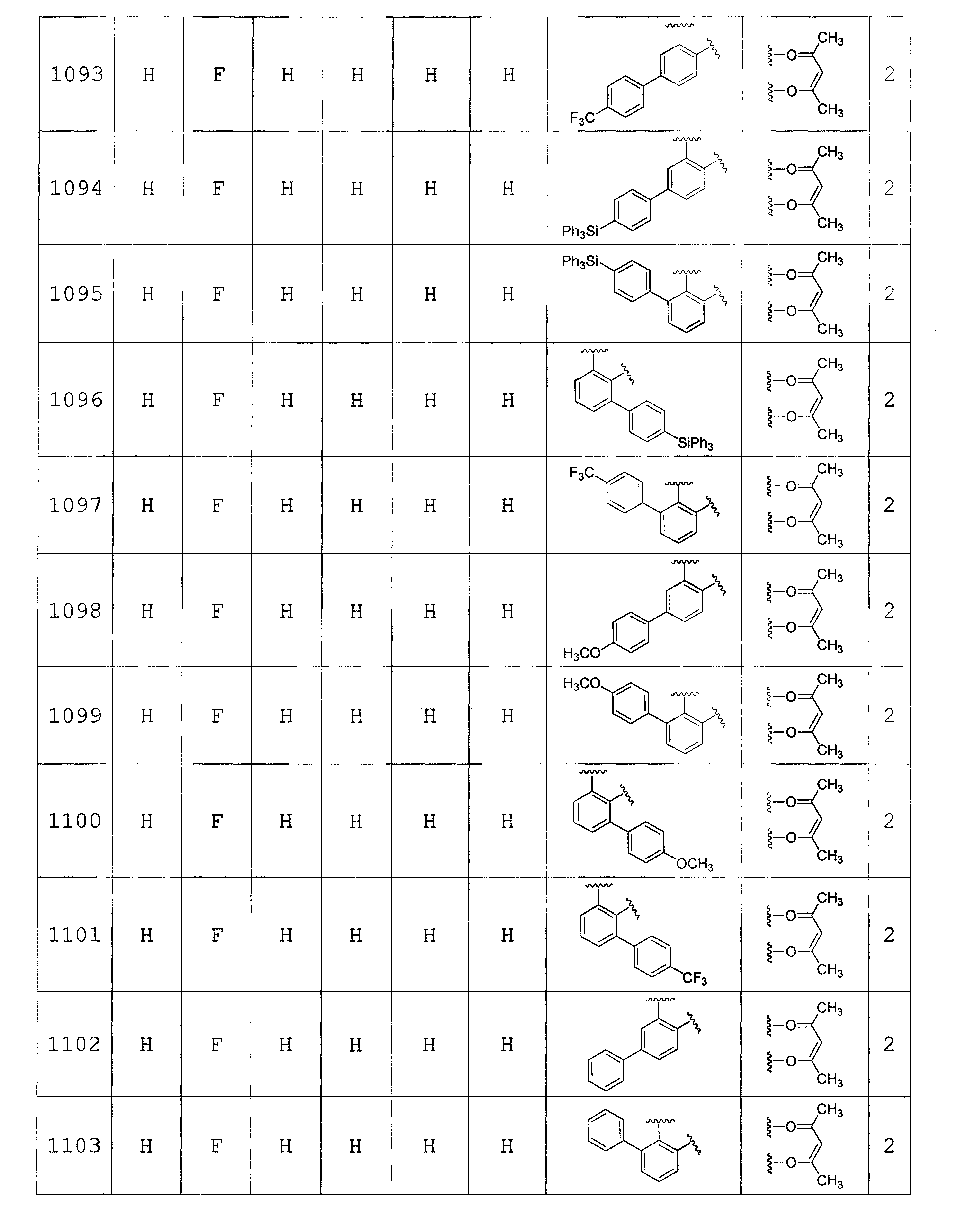

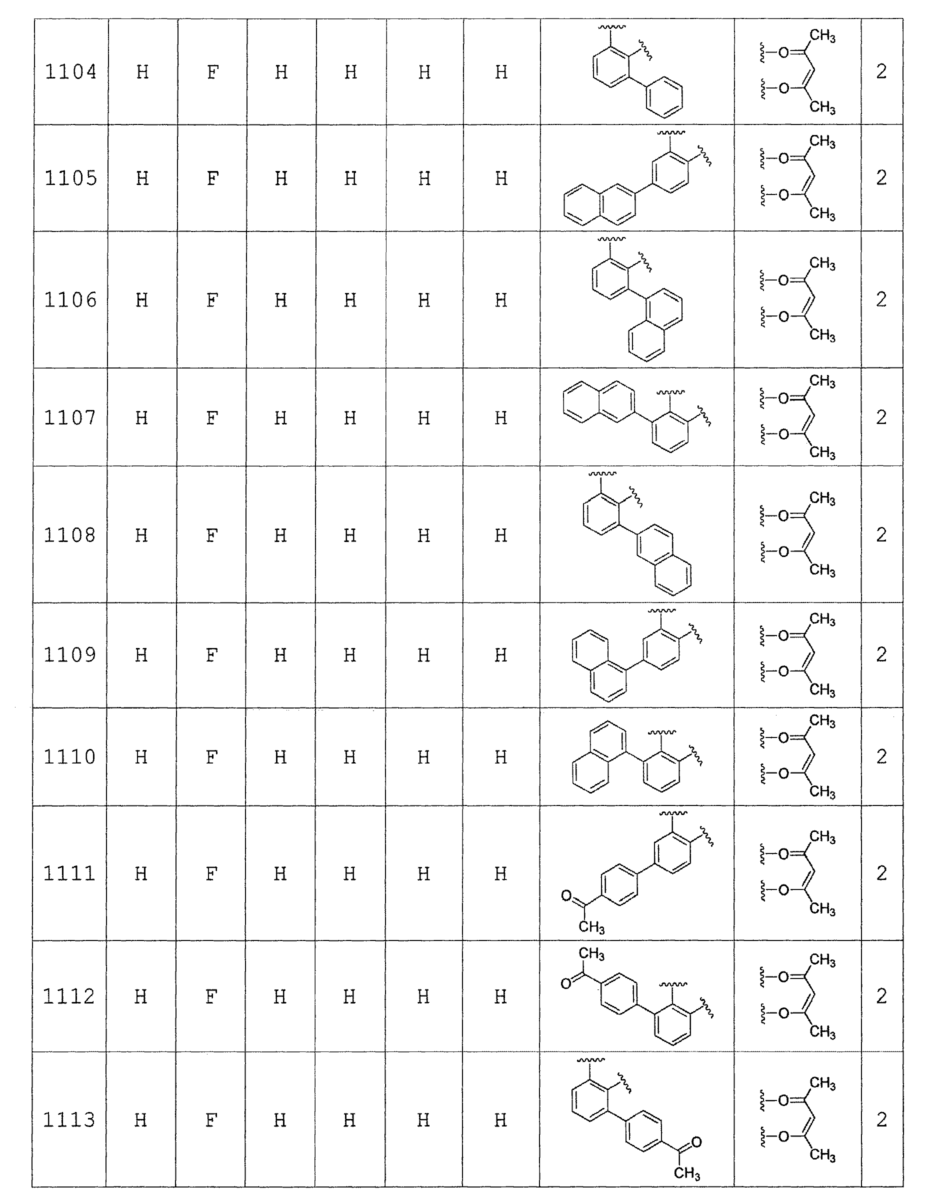

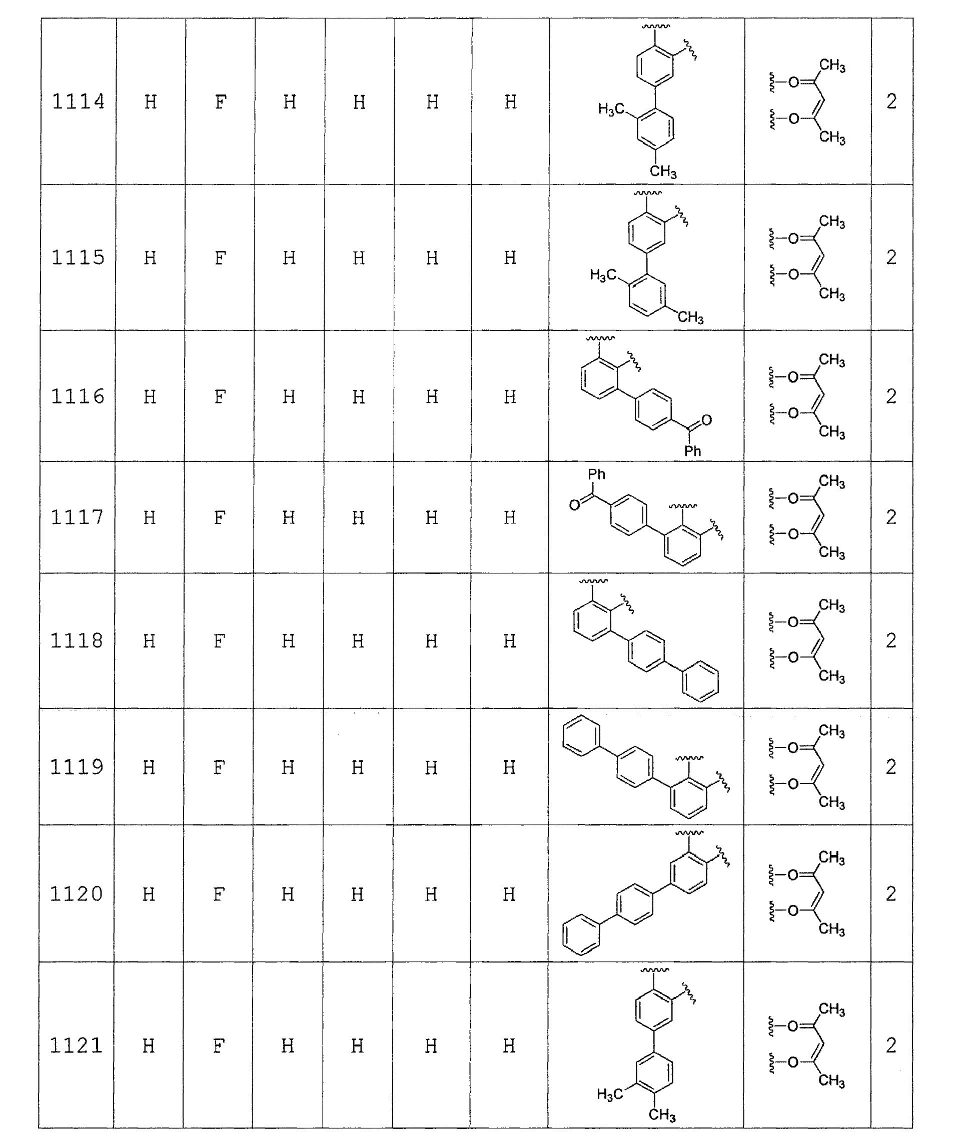

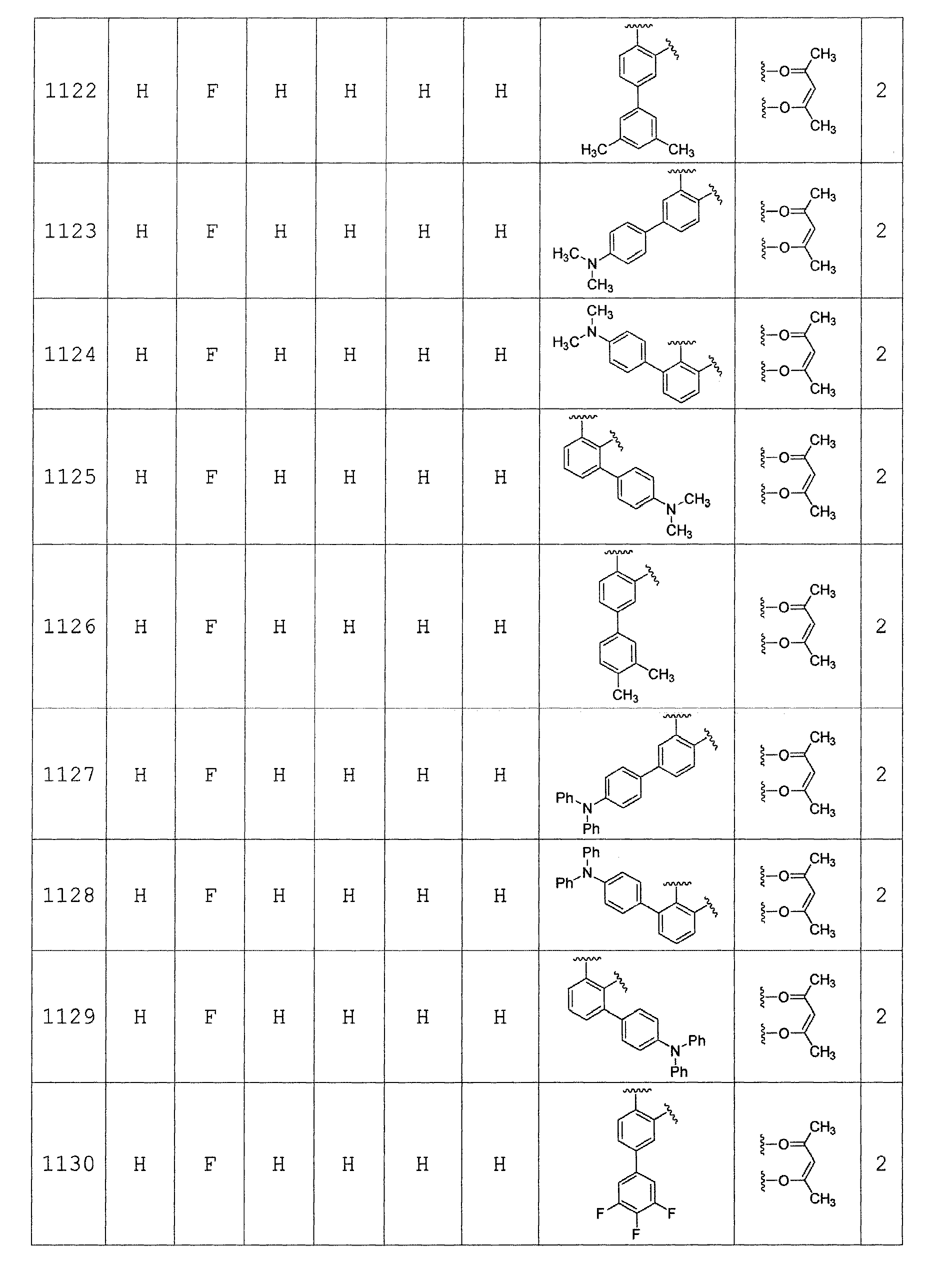

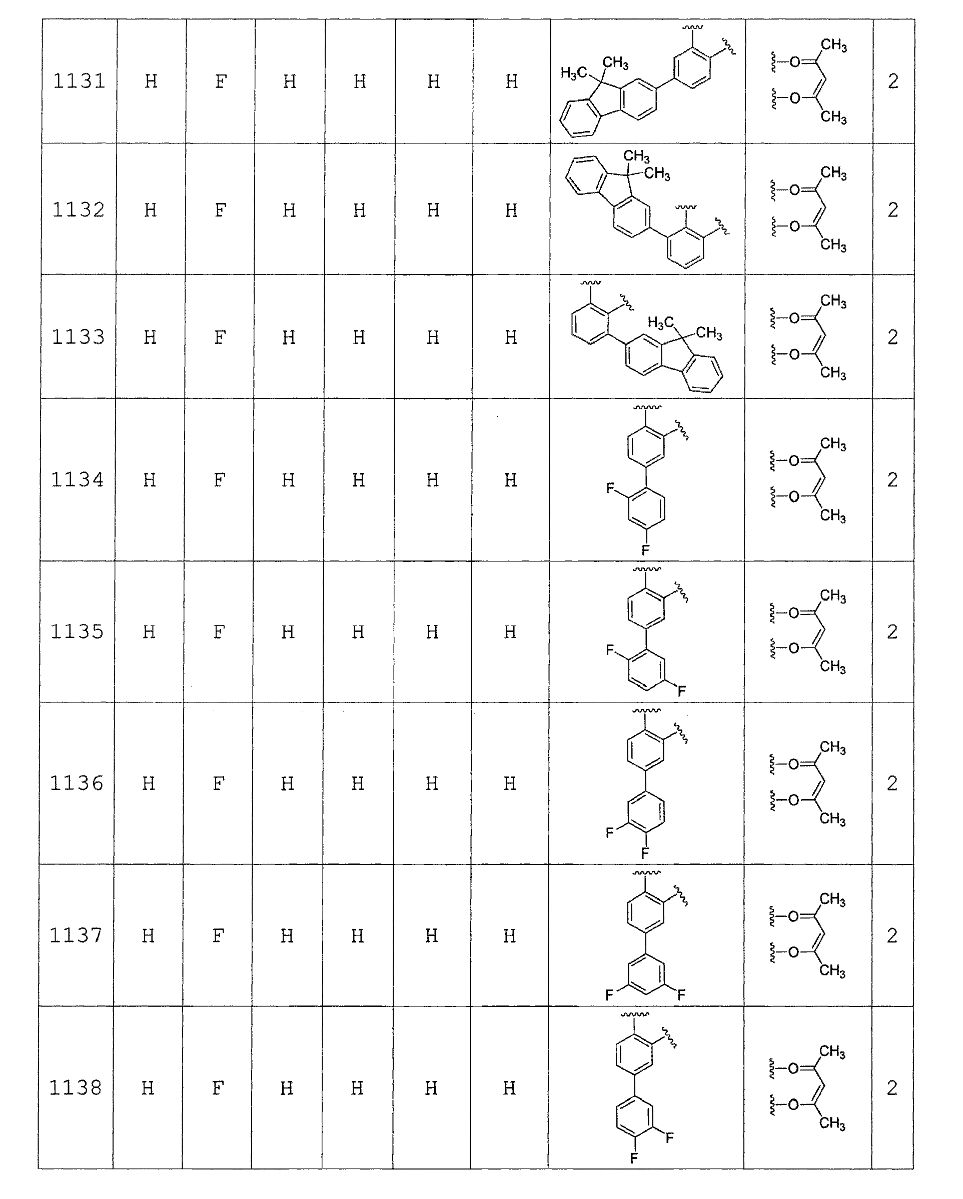

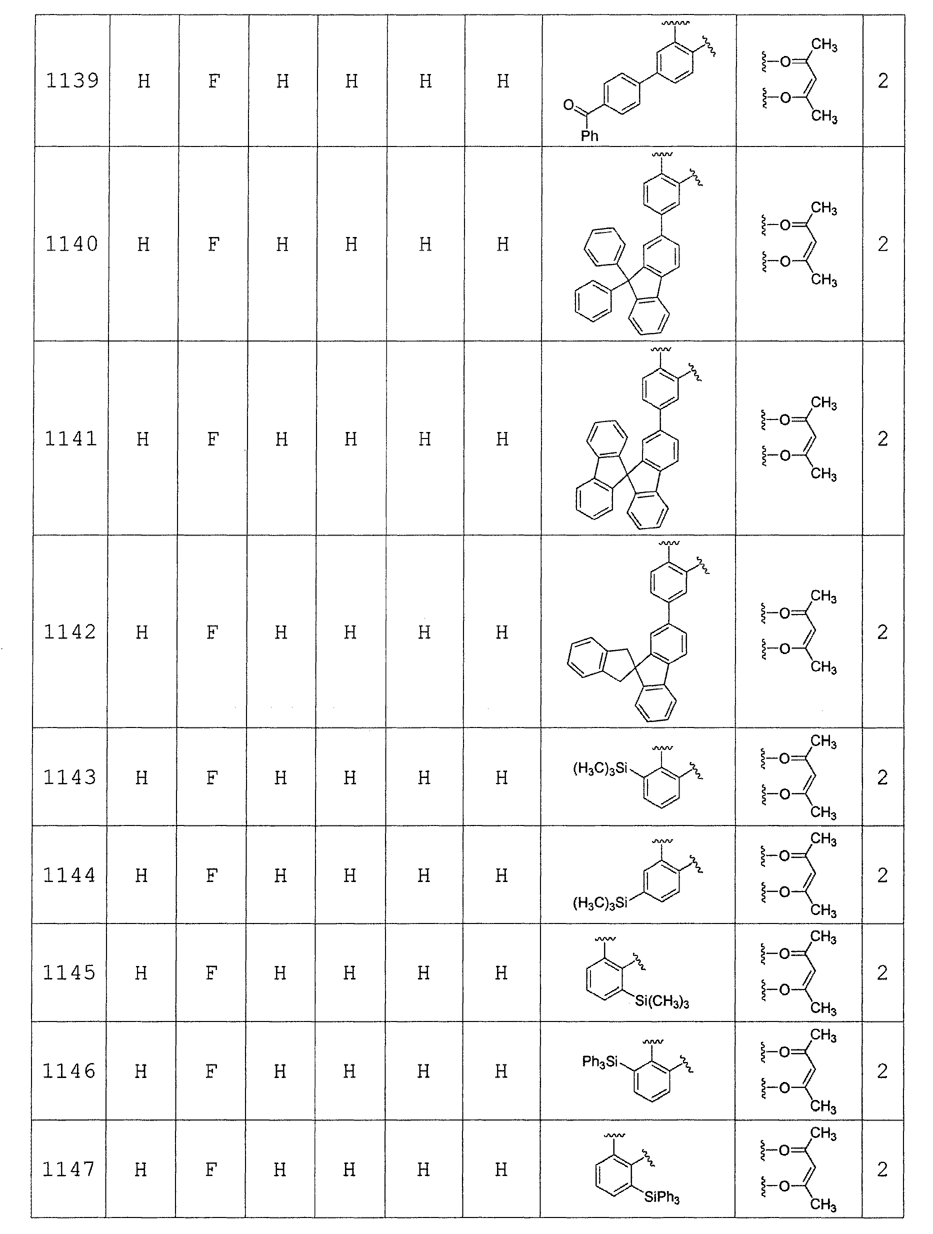

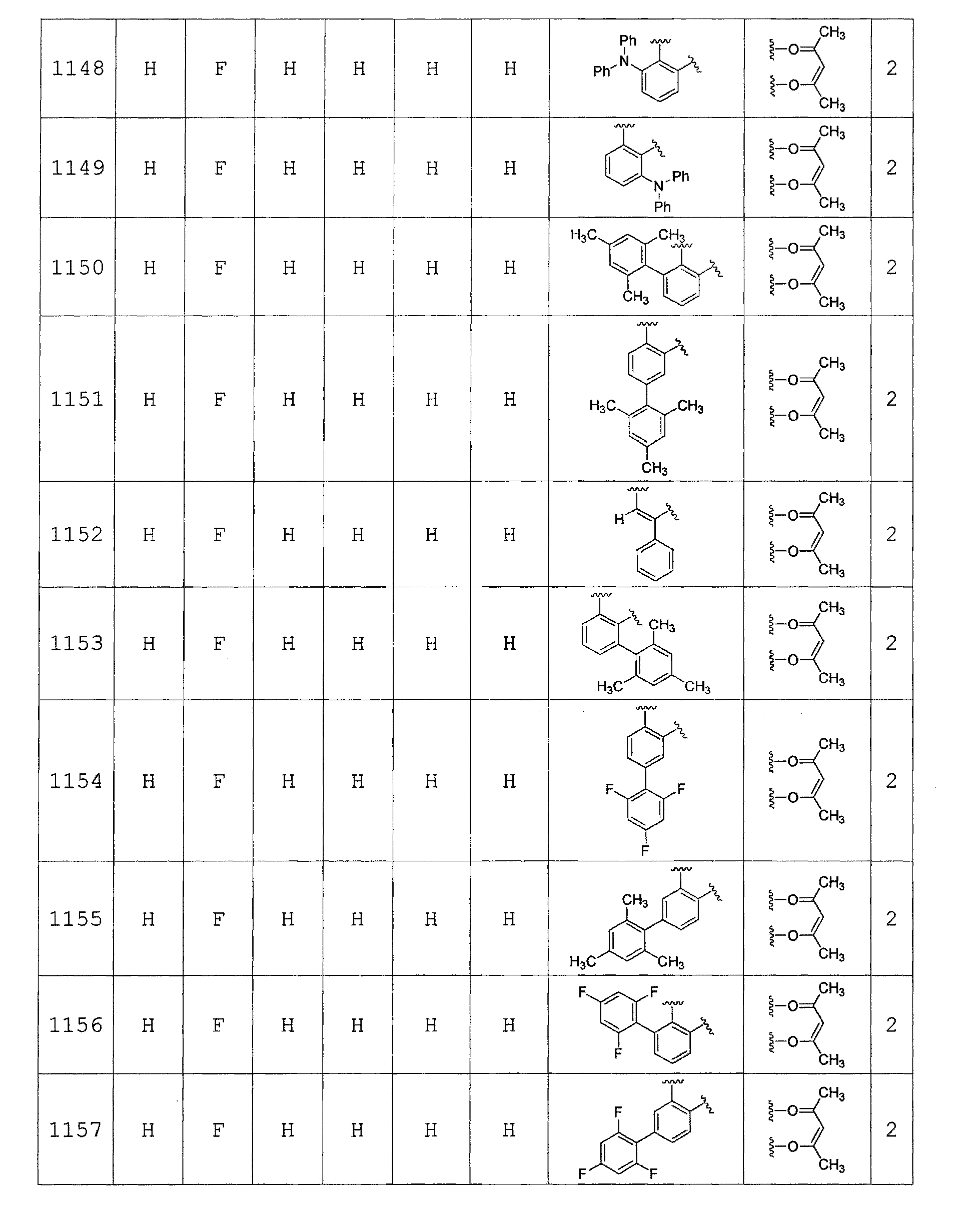

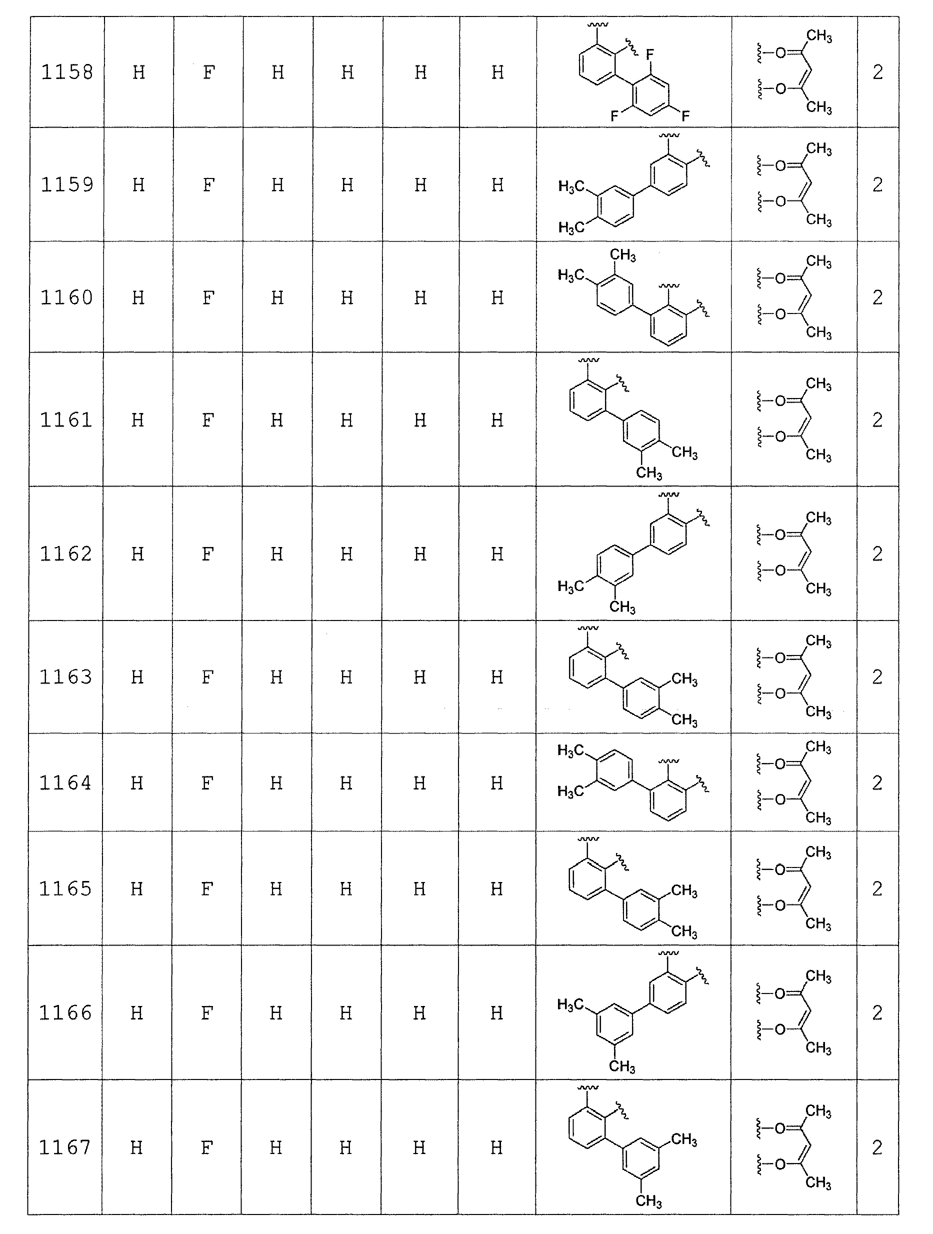

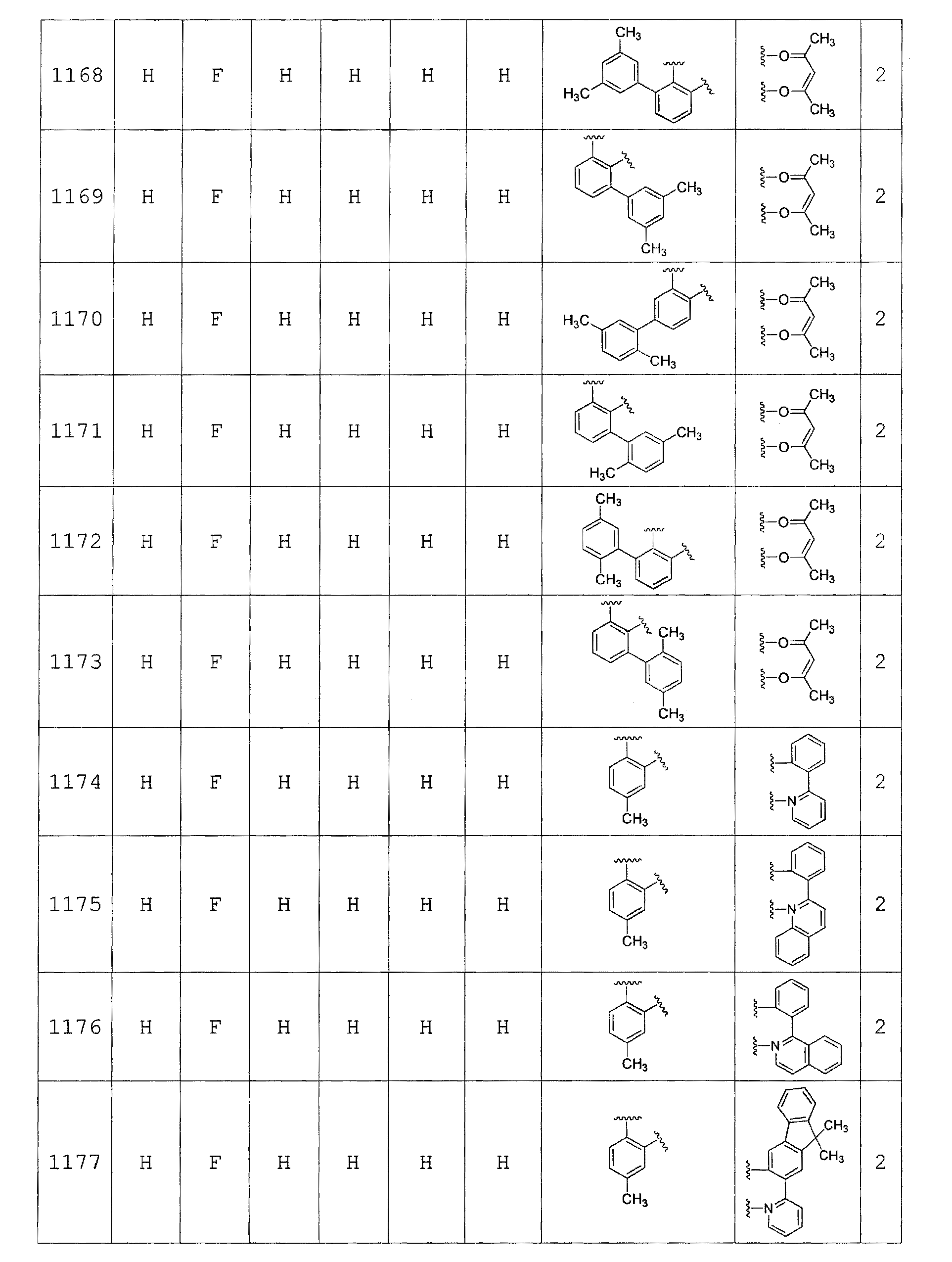

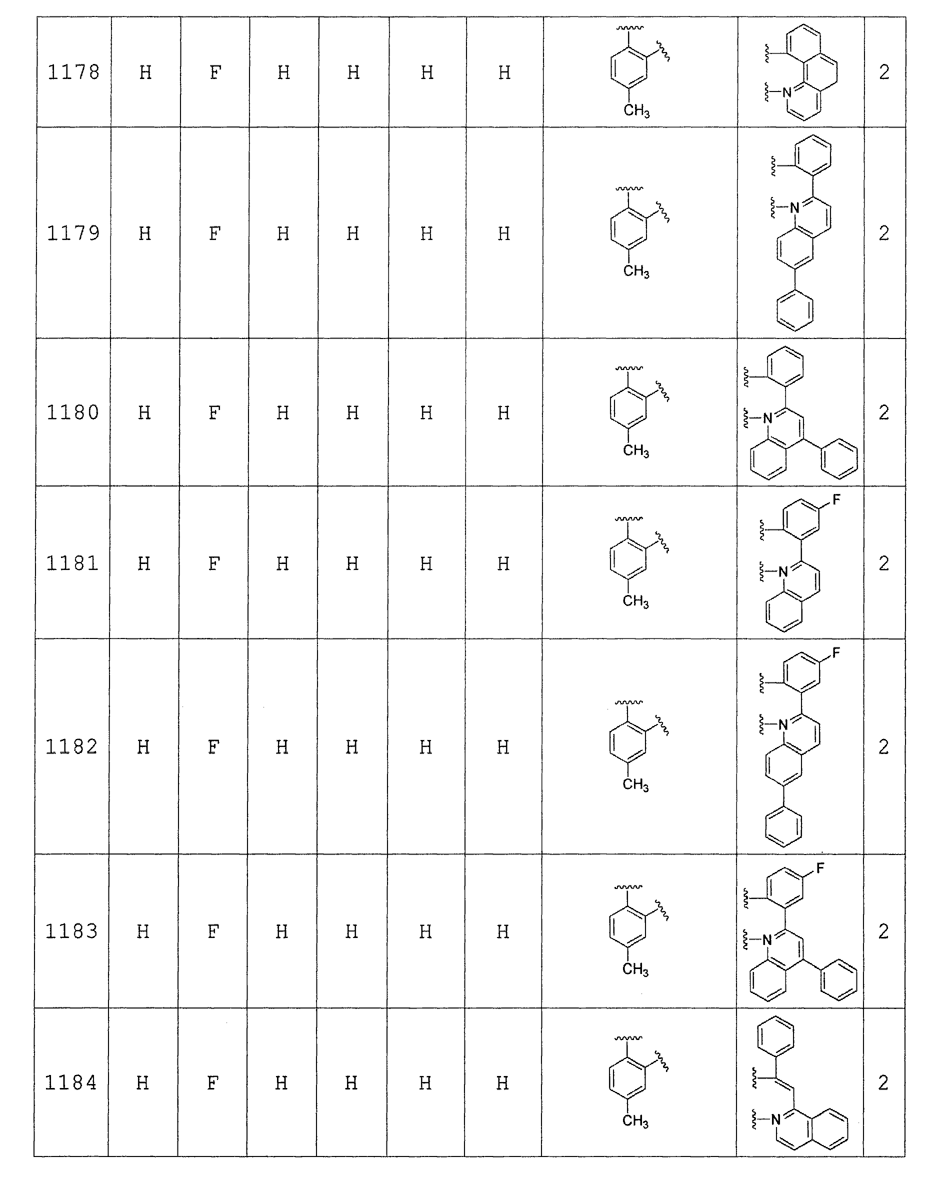

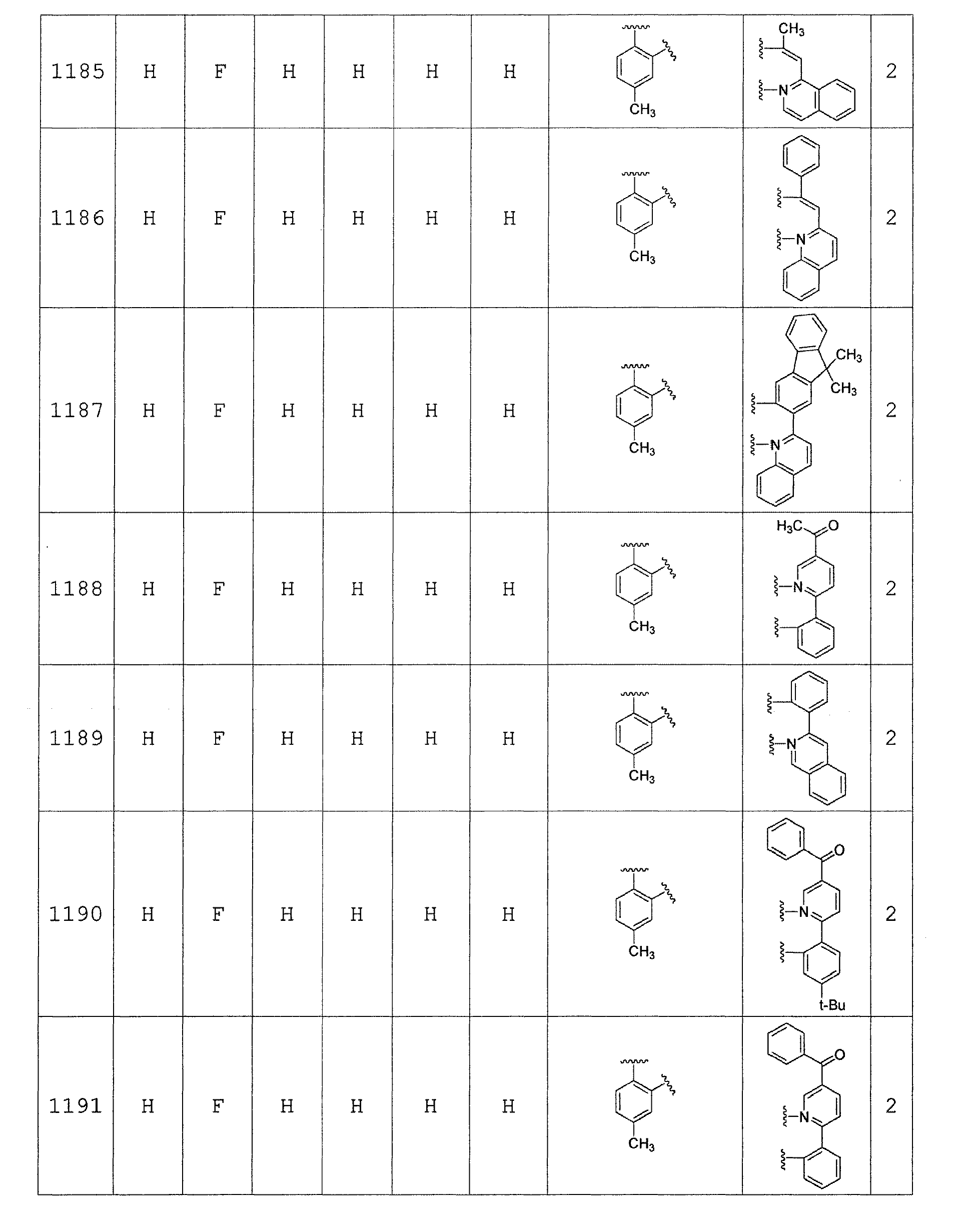

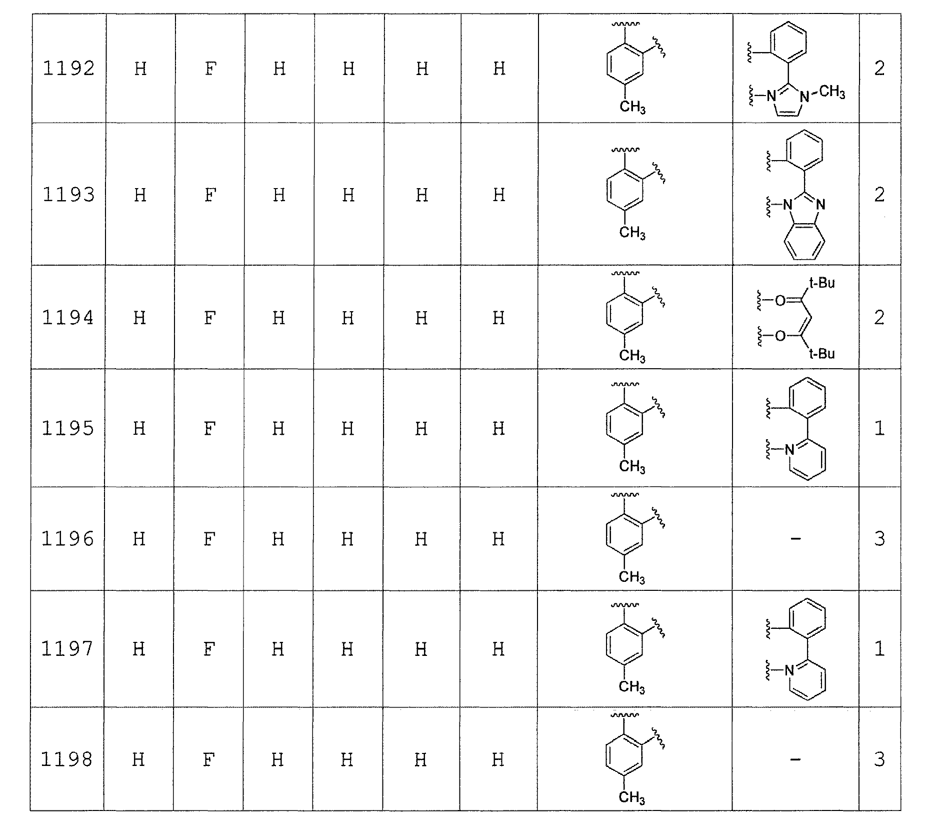

**Table 2**

| Comp. No. | ¹H NMR(CDCl₃, 200 MHz) | MS/FAB | |
|---|---|---|---|
| | | found | calculated |
| 1 | δ = 7.87 (m, 2H), 7.72 (m, 2H), 7.53 (m, | 763 | 764.18 |
| | 2H), 7.45 (m, 4H), 7.19 (m, 2H), 7.10 (m, | | |
| | 2H), 6.12 (s, 1H), 2.38 (s, 6H), 2.31 (s, | | |
| | 3H), 1.71 (s, 3H) | | |
| **2** | δ 8.12 (m, 2H), 7.76 (m, 4H), 7.42 (m, | 771 | 772.13 |
| | 4H), 7.21 (m, 4H), 7.11 (m, 2H), 6.10 (s, | | |
| | 1H), 2.28 (s, 3H), 1.72 (s, 3H) | | |
| **4** | δ = 7.81 (m, 2H), 7.67 (m, 4H), 7.41 (m, | 847 | 848.27 |
| | 4H), 7.23 (m, 2H), 7.15 (m, 2H), 6.11 (s, | | |
| | 1H), 2.25 (s, 3H), 1.70 (s, 3H), 1.45 (s, | | |
| | 18H) | | |
| **10** | δ = 8.03 (m, 2H), 7.74 (m, 4H), 7.61 (m, | 835 | 836.18 |
| | 4H), 7.39 (m, 4H), 7.27 (m, 4H), 7.02 (m, | | |
| | 2H), 6.11 (s, 1H), 2.30 (s, 3H), 1.70 (s, | | |
| | 3H) | | |
| **11** | δ = 8.12 (m, 2H), 7.81 (m, 4H), 7.71 (m, | 835 | 836.18 |
| | 2H), 7.59 (m, 2H), 7.41 (m, 4H), 7.22 (m, | | |
| | 4H), 7.02 (m, 2H), 6.11 (s, 1H), 2.30 (s, | | |
| | 3H), 1.70 (s, 3H) | | |
| **12** | δ = 8.02 (m, 2H), 7.90 (m, 2H), 7.81 (m, | 967 | 968.27 |
| | 2H), 7.59 (m, 4H), 7.43 (m, 4H), 7.30 (m, | | |
| | 4H), 7.21 (m, 2H), 6.11 (s, 1H), 2.30 (s, | | |
| | 3H), 1.98 (s, 12H), 1.70 (s, 3H) | | |
| **25** | δ = 8.10 (m, 2H), 7.81 (m, 4H), 7.62 (m, | 887 | 888.21 |
| | 4H), 7.49 (m, 4H), 7.31 (m, 6H), 7.15 (m, | | |
| | 2H), 7.03 (m, 2H), 6.10 (s, 1H), 2.31 (s, | | |
| | 3H), 1.71 (s, 3H) | | |
| **51** | δ = 8.03 (m, 2H), 7.85 (m, 2H), 7.67 (m, | 771 | 772.13 |
| | 2H), 7.55 (m, 2H), 7.43 (m, 2H), 7.34 (m, | | |
| | 2H), 7.23 (m, 2H), 7.09 (m, 2H), 6.11 (s, | | |
| | 1H), 2.31 (s, 3H), 1.70 (s, 3H) | | |
| **56** | δ = 7.81 (m, 2H), 7.68 (m, 2H), 7.57 (m, | 763 | 764.18 |
| | 2H), 7.41 (m, 4H), 7.31 (m, 2H), 7.08 (m, | | |
| | 2H), 6.11 (s, 1H), 2.45 (s, 6H), 2.25 (s, | | |
| | 3H), 1.70 (s, 3H) | | |
| **83** | δ = 8.04 (m, 2H), 7.91 (m, 2H), 7.73 (m, | 999 | 1000.33 |
| | 4H), 7.67 (m, 2H), 7.53 (m, 4H), 7.42 (m, | | |
| | 6H), 7.06 (m, 2H), 6.10 (s, 1H), 2.31 (s, | | |
| | 3H), 1.70 (s, 3H), 1.48 (s, 18H) | | |
| **84** | δ = 8.12 (m, 2H), 7.88 (m, 2H), 7.72 (m, | 923 | 924.15 |
| | 4H), 7.57 (m, 6H), 7.38 (m, 4H), 7.23 (m, | | |
| | 2H), 7.03 (m, 2H), 6.11 (s, 1H), 2.30 (s, | | |
| | 3H), 1.72 (s, 3H) | | |
| **104** | δ = 8.04 (m, 2H), 7.78 (m, 4H), 7.67 (m, | 887 | 888.21 |
| | 4H), 7.52 (m, 4H), 7.43 (m, 6H), 7.11 (m, | | |
| | 2H), 7.02 (m, 2H), 6.11 (s, 1H), 2.30 (s, | | |
| | 3H), 1.68 (s, 3H) | | |
| **178** | δ = 8.42(m, 1H), 7.99(m, 1H), 7.87- | 676 | 876.79 |
| | 7.82(m, 5H), 7.72(m, 3H), 7.59-7.28(m, | | |
| | 9H), 7.15-7.10(m, 5H), 2.36(s, 6H) | | |
| **185** | δ = 8.05(m, 2H), 7.87-7.59(m, 12H), 7.48- | 770 | 770.88 |
| | 7.32(m, 8H), 7.22-7.14(m, 7H), 6.99(m, | | |
| | 1H), 2.40(s, 6H) | | |
| **192** | δ = 9.03(s, 1H), 8.01(m, 1H), 7.91- | 781 | 781.95 |
| | 7.82(m, 8H), 7.72(m, 2H), 7.59-7.38(m, | | |
| | 9H), 7.15(m, 6H), 2.45(s, 6H), 1.35(s, | | |
| | 9H) | | |
| **210** | δ = 8.09 (m, 2H), 7.94 (m, 2H), 7.85 (m, | 987 | 988.27 |
| | 2H), 7.75 (m, 2H), 7.52 (m, 2H), 7.40 (m, | | |
| | 4H), 7.29 (m, 6H), 6.11 (s, 1H), 2.30 (s, | | |
| | 3H), 1.98 (s, 12H), 1.70 (s, 3H) | | |
| **241** | δ = 8.05(m, 2H), 7.68-7.61(m, 4H), | 599 | 599.72 |
| | 7.43(m, 2H), 7.13(m, 2H), 7.03(m, 2H), | | |
| | 6.96(m, 2H), 4.58(s, 1H), 2.45(s, 12H), | | |
| | 2.09(s, 6H) | | |
| **248** | δ = 8.05(m, 2H), 7.68-7.61(m, 4H), | 615 | 615.58 |
| | 7.43(m, 2H), 7.13(d, 2H), 7.04-6.97(m, | | |
| | 4H), 4.59(s, 1H), 2.10(s, 6H) | | |
| **302** | δ = 8.09 (m, 2H), 7.82 (m, 4H), 7.74 (m, | 887 | 888.21 |
| | 4H), 7.61 (m, 4H), 7.32 (m, 6H), 7.10 (m, | | |
| | 2H), 7.01 (m, 2H), 6.11 (s, 1H), 2.30 (s, | | |
| | 3H), 1.70 (s, 3H) | | |
| **408** | 6 = 8.11 (m, 2H), 7.91 (m, 2H), 7.83 (m, | 967 | 968.27 |
| | 2H), 7.52 (m, 4H), 7.41 (m, 4H), 7.32 (m, | | |
| | 6H), 6.10 (s, 1H), 2.31 (s, 3H), 1.97 (s, | | |
| | 12H), 1.71 (s, 3H) | | |
| **500** | δ = 8.11 (m, 2H), 7.82 (m, 2H), 7.71 (m, | 887 | 888.21 |
| | 2H), 7.63 (m, 2H), 7.55 (m, 2H), 7.41 (m, | | |
| | 6H), 7.21 (m, 4H), 7.09 (m, 2H), 6.99 (m, | | |
| | 2H), 6.10 (s, 1H), 2.30 (s, 3H), 1.71 (s, | | |
| | 3H) | | |
| **635** | 5 = 8.05(m, 2H), 7.40-4.35(m, 4H), | 635 | 635.70 |
| | 7.13(m, 2H), 6.95(m, 4H), 4.60(s, 1H), | | |
| | 2.62(s, 12H), 2.01(s, 6H) | | |
| **637** | 5 = 8.03(m, 2H), 7.39-7.32(m, 4H), | 635 | 635.70 |
| | 7.13(m, 2H), 7.03-6.96(m, 4H), 4.58(s, | | |
| | 1H), 2.45(s, 12H), 2.05(s, 6H) | | |
| **644** | δ = 8.03(m, 2H), 7.39-7.30(m, 4H), 7.13- | 651 | 651.56 |
| | 6.97(m, 6H), 4.60(s, 1H), 2.15(s, 6H) | | |
| **802** | δ = 8.40(m, 2H), 7.76-7.67(m, 8H), | 751 | 751.68 |
| | 7.42(m, 2H), 7.32(m, 4H), 4.56(s, 1H), | | |
| | 2.08(s, 6H) | | |
| **991** | δ = 8.11 (m, 2H), 7.74 (m, 2H), 7.65 (m, | 735 | 736.15 |
| | 2H), 7.54 (m, 2H), 7.31 (m, 2H), 7.20 (m, | | |
| | 6H), 7.08 (m, 2H), 6.10 (s, 1H), 2.14 (s, | | |
| | 3H), 1.71 (s, 3H) | | |
| **993** | δ = 8.00 (m, 2H), 7.77 (m, 4H), 7.45 (m, | 735 | 736.15 |
| | 4H), 7.27 (m, 6H), 7.07 (m, 2H), 6.10 (s, | | |
| | 1H), 2.32 (s, 3H), 1.71 (s, 3H) | | |
| **994** | δ = 8.02 (m, 2H), 7.85 (m, 2H), 7.72 (m, | 735 | 736.15 |
| | 2H), 7.56 (m, 2H), 7.34 (m, 2H), 7.23 (m, | | |
| | 6H), 7.12 (m, 2H), 6.11 (s, 1H), 2.21 (s, | | |
| | 3H), 1.81 (s, 3H) | | |
| **999** | δ = 8.10 (m, 2H), 7.85 (m, 2H), 7.64 (m, | 735 | 736.15 |
| | 4H), 7.37 (m, 4H), 7.21 (m, 4H), 7.08 (m, | | |
| | 2H), 6.10 (s, 1H), 2.31 (s, 3H), 1.90 (s, | | |
| | 3H) | | |
| **1010** | δ = 8.02 (m, 2H), 7.91 (m, 2H), 7.82 (m, | 967 | 968.27 |
| | 2H), 7.72 (m, 2H), 7.57 (m, 2H), 7.41 (m, | | |
| | 4H), 7.31 (m, 2H), 7.22 (m, 2H), 7.02 (m, | | |
| | 2H), 6.10 (s, 1H), 2.31 (s, 3H), 1.99 (s, | | |
| | 12H), 1.71 (s, 3H) | | |
| **1102** | δ = 8.02 (m, 2H), 7.92 (m, 2H), 7.83 (m, | 887 | 888.21 |
| | 2H), 7.72 (m, 4H), 7.63 (m, 2H), 7.53 (m, | | |
| | 2H), 7.21 (m, 6H), 7.00 (m, 4H), 6.10 (s, | | |
| | 1H), 2.30 (s, 3H), 1.72 (s, 3H) | | |

### [Example 1] Manufacture of an OLED (1)

An OLED device was manufactured by using an organic electroluminescent compound according to the invention.

First, a transparent electrode ITO thin film (15 Ω/□) (2) prepared from glass for OLED (produced by Samsung Corning) (1) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

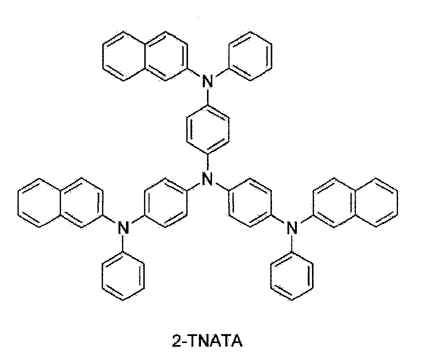

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm of thickness on the hole injection layer.

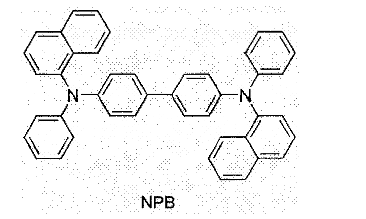

To another cell of said vacuum vapor-deposit device, charged was 4,4'-N,N'-dicarbazole-biphenyl (CBP) as an electroluminescent host material, and an organic electroluminescent compound (Compound 43) according to the present invention was charged to still another cell. The two materials were evaporated at different rates to carry out doping to vapor-deposit an electroluminescent layer (5) having 30 nm of thickness on the hole transport layer. The suitable doping concentration is 4 to 10 wt% on the basis of CBP.

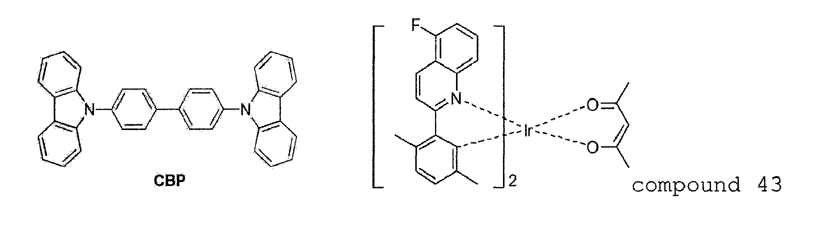

Then, on the electroluminescent layer, bis(2-methyl-8-quinolinato)(p-phenylphenolato)aluminum (III) (BAlq) was vapor-deposited as a hole blocking layer with a thickness of 10 nm in the same manner for NPB, tris(8-hydroxyquinoline)aluminum (III) (Alq) was vapor-deposited as an electron transport layer (6) with a thickness of 20 nm, and then lithium quinolate (Liq) was vapor-deposited as an electron injection layer (7) with a thickness of 1 to 2 nm. Thereafter, an Al cathode (8) was vapor-deposited with a thickness of 150 nm by using another vacuum vapor-deposit device to manufacture an OLED.

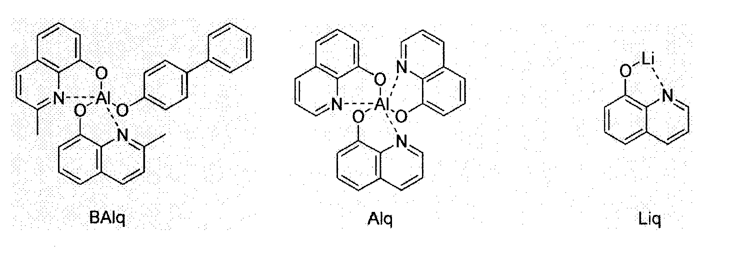

### [Example 2] Manufacture of an OLED (2)

A hole injection layer and a hole transport layer were formed according to the procedure of Example 1, and an electroluminescent layer was vapor-deposited thereon as follows. To another cell of said vacuum vapor-deposit device, charged was H-6 as an electroluminescent host material according to the invention, and an organic electroluminescent compound (Compound 51) according to the present invention was charged to still another cell. The two materials were evaporated at different rates to carry out doping to vapor-deposit an electroluminescent layer (5) having 30 nm of thickness on the hole transport layer. The suitable doping concentration is 4 to 10 wt% on the basis of the host. Then, a hole blocking layer, an electron transport layer and an electron injection layer were vapor-deposited according to the same procedure as in Example 1, and then Al cathode was vapor-deposited in a thickness of 150 nm by using another vacuum vapor-deposit device to manufacture an OLED.

### [Example 3] Manufacture of an OLED (3)

A hole injection layer, a hole transport layer and an electroluminescent layer were formed according to the same procedure as in Example 2, and then an electron transport layer and an electron injection layer were vapor-deposited. Thereafter, Al cathode was vapor-deposited in a thickness of 150 nm by using another vacuum vapor-deposit device to manufacture an OLED.

In order to confirm the performance of the OLED's prepared according to Examples 1 to 3, the luminous efficiencies of the OLED's were measured at 10 mA/cm². Various properties are shown in Tables 3.

**Table 3**

| | Material | Host | Hole blocking layer | EL color | Operation voltage | Max. luminous efficiency (cd/A) |
|---|---|---|---|---|---|---|
| Ex. 1 | Compound 43 | CBP | BAlq | Red | 7.5 | 10.8 |
| | Compound 51 | CBP | BAlq | Red | 7.3 | 12.7 |
| | Compound 125 | CBP | BAlq | Red | 7.6 | 10.9 |
| | Compound 177 | CBP | BAlq | Red | 7.2 | 11.7 |
| | Compound 193 | CBP | BAlq | Red | 7.2 | 13.1 |
| | Compound 302 | CBP | BAlq | Red | 7.3 | 10.2 |
| | Compound 379 | CBP | BAlq | Red | 7.4 | 11.5 |
| | Compound 406 | CBP | BAlq | Red | 7.7 | 9.7 |
| | Compound 437 | CBP | BAlq | Red | 7.5 | 10.4 |
| | Compound 624 | CBP | BAlq | Red | 7.9 | 9.6 |
| | Compound 647 | CBP | BAlq | Red | 7.4 | 11.0 |
| | Compound 734 | CBP | BAlq | Red | 7.1 | 12.0 |
| | Compound 770 | CBP | BAlq | Red | 7.2 | 12.9 |
| | Compound 841 | CBP | BAlq | Red | 7.4 | 11.0 |
| | Compound 895 | CBP | BAlq | Red | 7.6 | 9.9 |
| | Compound 938 | CBP | BAlq | Red | 7.8 | 9.5 |
| | Compound 960 | CBP | BAlq | Red | 7.4 | 10.3 |
| | Compound 1026 | CBP | BAlq | Red | 7.5 | 10.2 |
| Ex. 2 | Compound 51 | H-6 | BAlq | Red | 7.3 | 12.9 |
| | Compound 193 | H-17 | BAlq | Red | 7.1 | 12.9 |
| | Compound 379 | H-18 | BAlq | Red | 7.1 | 11.6 |
| Ex. 3 | Compound 51 | H-6 | - | Red | 6.2 | 12.4 |
| | Compound 624 | H-28 | - | Red | 6.7 | 10.0 |
| | Compound 841 | H-52 | - | Red | 6.4 | 12.4 |

The addition of fluorine (F) to the primary ligand of the compounds according to the present invention lowered the LUMO level, thereby improving the color coordinate. An appropriate combination of electron-withdrawing and electron-donating groups in the HOMO level resulted in a phosphorescent dopant having high efficiency with good color coordinate.

Compound 51, in which F was introduced, and Compounds 177, 193 and 770, in which phenylpyridine, 2-phenylquinoline and phenyl(6-phenylpyridin-3-yl)methanone were introduced as subsidiary ligand, respectively, made dopants with good efficiency.

With identical device structure, using the host according to the present invention instead of CBP in an EL device did not provide significant change in efficiency, color coordinate and operation voltage from those of CBP. Thus it is anticipated that those hosts can be employed as a phosphorescent host, when being used with dopants according to the invention, instead of CBP as a conventional electroluminescent host. When the host according to the invention is employed without using a hole blocking layer, the device exhibits comparable or higher luminous efficiency as compared to that using a conventional host, and provides decreased power consumption of the OLED because the operation voltage is lowered by 1.0 to 1.2 V or more. If the invention is applied to mass production of OLED's, the time for mass production can be also shortened to give great benefit on the commercialization.

While the exemplary embodiments have been shown and described, it will be understood by those skilled in the art that various changes in form and details may be made thereto without departing from the spirit and scope of the invention as defined by the appended claims.

In addition, many modifications can be made to adapt a particular situation or material to the teachings of this disclosure without departing from the essential scope thereof. Therefore, it is intended that this invention not be limited to the particular exemplary embodiments disclosed as the best mode contemplated for carrying out this invention, but that this invention will include all embodiments falling within the scope of the appended claims.

## Claims

1. An organic electroluminescent compound represented by Chemical Formula (1): 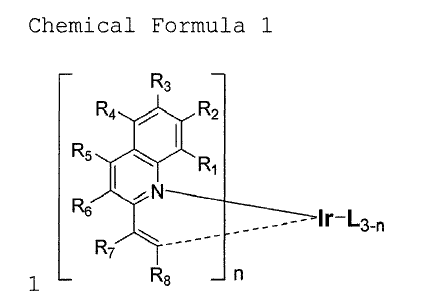 wherein, L is an organic ligand;
R₁ through R₆ independently represent hydrogen, deuterium, fluorine-substituted (C1-C60)alkyl, fluorine-substituted (C1-C60)alkoxy, fluorine-substituted (C3-C60)cycloalkyl or fluorine;
R₇ and R₈ independently represent hydrogen, deuterium, (C1-C60)alkyl with or without halogen substituent(s), (C6-C60)aryl, halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino or mono- or di(C6-C60)arylamino, or R₇ and R₈ may may be linked via (C3-C12)alkylene or (C3-C12)alkenylene with or without a fused ring to form an alicyclic ring, or a monocyclic or polycyclic aromatic ring;
the alkyl or aryl of R₇ and R₈, or the alicyclic ring, or the monocyclic or polycyclic aromatic ring formed therefrom by linkage via (C3-C12) alkylene or (C3-C12)alkenylene with or without a fused ring may be further substituted by one or more substituent(s) selected from deuterium, (C1-C60)alkyl with or without halogen substituent(s), halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino, mono- or di(C6-C60)arylamino, phenyl, naphthyl, anthryl, fluorenyl, spirobifluorenyl and 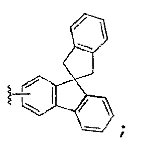 and
n is an integer from 1 to 3;
provided that R₁ through R₆ are not hydrogens at the same time.

2. The organic electroluminescent compound according to claim 1, which is selected from the compounds represented by one of Chemical Formulas (2) to (7): 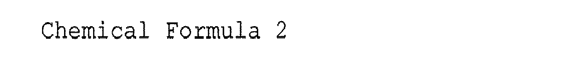 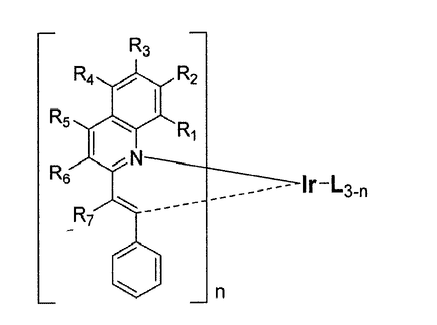 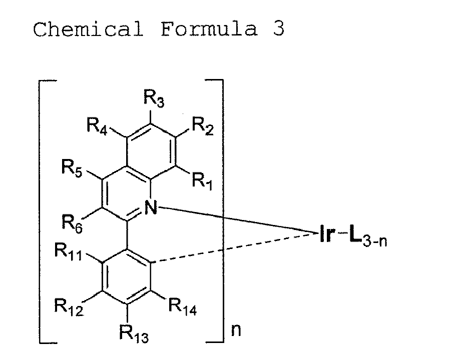 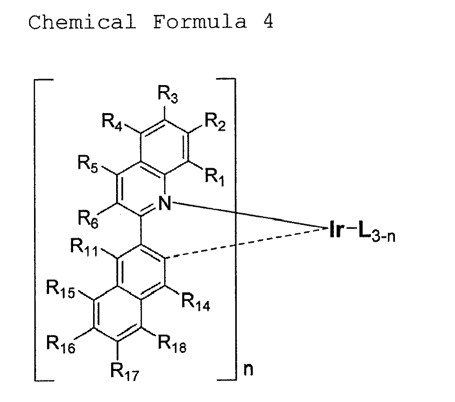 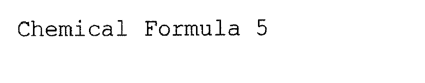 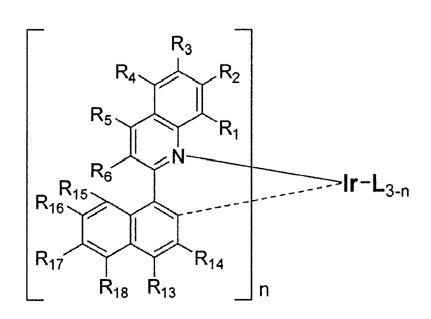 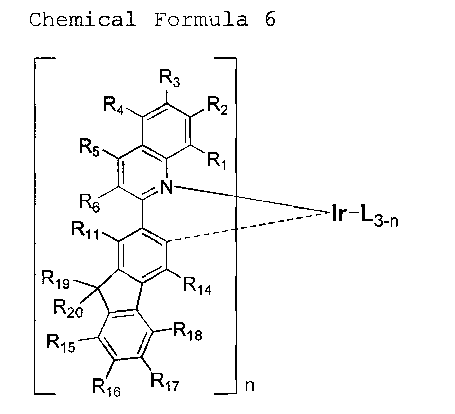 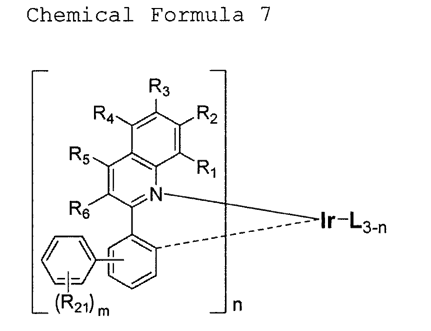 wherein, L, R₁, R₂, R₃, R₄, R₅, R₆, R₇ and n are defined as in Chemical Formula (1) of claim 1;
R₁₁ through R₁₈ independently represent hydrogen, deuterium, (C1-C60)alkyl, halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino, mono- or di(C6-C60)arylamino, phenyl, naphthyl, anthryl, fluorenyl, spirobifluorenyl or 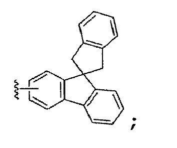 the alkyl, phenyl, naphthyl, anthryl or fluorenyl of R₁₁ through R₁₈ may be further substituted by one or more substituent(s) selected from deuterium, (C1-C60)alkyl with or without halogen substituent(s), (C1-C60)alkoxy, halogen, tri(C1-C60)alkylsilyl, tri(C6-C60)arylsilyl, (C1-C60)alkylcarbonyl, (C6-C60)arylcarbonyl, mono- or di(C1-C60)alkylamino, mono- or di(C6-C60)arylamino and (C6-C60)aryl;
R₁₉ and R₂₀ independently represent hydrogen, deuterium, (C1-C60)alkyl or (C6-C60)aryl, or R₁₉ and R₂₀ may be linked via (C3-C12)alkylene or (C3-C12)alkenylene with or without a fused ring to form an alicyclic ring, a monocyclic or polycyclic aromatic ring;
R₂₁ represents deuterium, (C1-C60)alkyl, halogen, cyano, tri(C1-C60)alkylsilyl, tri(C6-C60)arylsilyl, (C1-C60)alkoxy, (C1-C60)alkylcarbonyl, (C6-C60)arylcarbonyl, phenyl, mono- or di(C1-C60)alkylamino, mono- or di(C6-C60)arylamino, naphthyl, 9,9-di(C1-C60)alkylfluorenyl or 9,9-di(C6-C60)arylfluorenyl; and
m is an integer from 1 to 5.

3. The organic electroluminescent compound according to claim 1, wherein the ligand (L) has a structure represented by one of the following chemical formulas: 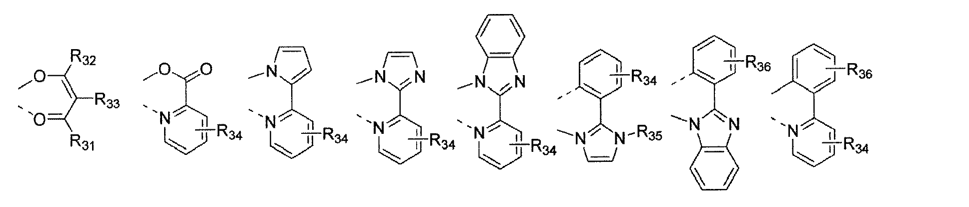 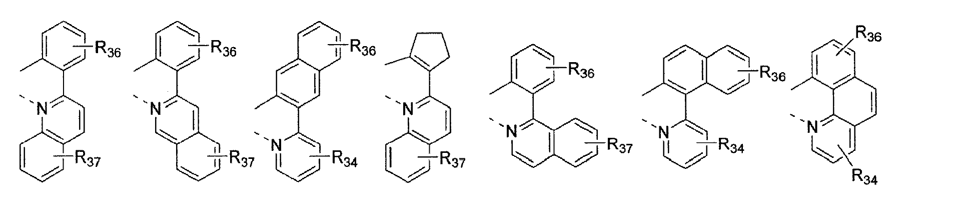 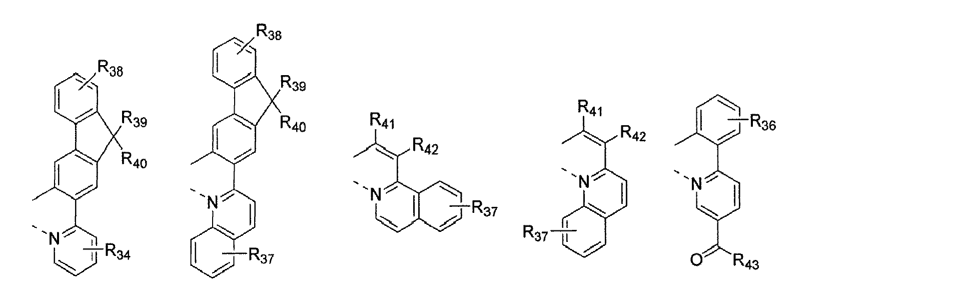 wherein, R₃₁ and R₃₂ independently represent hydrogen, deuterium, (C1-C60)alkyl with or without halogen substituent(s), phenyl with or without (C1-C60)alkyl substituent(s), or halogen;
R₃₃ through R₃₈ independently represent hydrogen, deuterium, (C1-C60)alkyl, phenyl with or without (C1-C60)alkyl substituent(s), tri(C1-C60)alkylsilyl or halogen;
R₃₉ through R₄₂ independently represent hydrogen, deuterium, (C1-C60)alkyl, phenyl with or without (C1-C60)alkyl substituent(s); and
R₄₃ represents deuterium, (C1-C60)alkyl, phenyl with or without (C1-C60)alkyl substituent(s), or halogen.

4. An organic electroluminescent device comprised of a first electrode; a second electrode; and at least one organic layer(s) interposed between the first electrode and the second electrode; wherein the organic layer comprises an electroluminescent region comprising one or more compound(s) according to any one of claims 1 to 3, and one or more host(s) selected from 1,3,5-tricarbazolylbenzene, polyvinylcarbazole, m-biscarbazolylphenyl, 4,4'4"-tri(N-carbazolyl)triphenylamine, 1,3,5-tri(2-carbazolylphenyl)benzene, 1,3,5-tris(2-carbazolyl-5-methoxyphenyl)benzene, bis(4-carbazolylphenyl)silane and one or more host(s) selected from the compounds represented by one of Chemical Formulas (8) to (11): 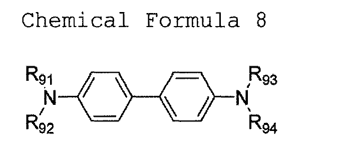 In Chemical Formula (8), R₉₁ through R₉₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₉₁ through R₉₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino, or arylamino of R₉₁ through R₉₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl. 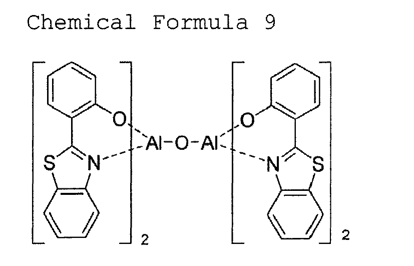 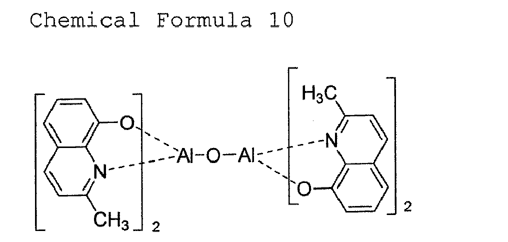
Chemical Formula 11 **L¹L²M¹ (Q)_{y}**
In Chemical Formula (11), the ligands, L¹ and L² are independently selected from the following structures: 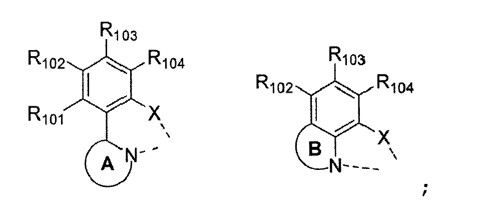 M¹ is a bivalent or trivalent metal;
y is 0 when M¹ is a bivalent metal, while y is 1 when M¹ is a trivalent metal;
Q represents (C6-C60)aryloxy or tri(C6-C60)arylsilyl, and the aryloxy and triarylsilyl of Q may be further substituted by (C1-C60)alkyl or (C6-C60)aryl;
X represents O, S or Se;
ring A represents oxazole, thiazole, imidazole, oxadiazole, thiadiazole, benzoxazole, benzothiazole, benzimidazole, pyridine or quinoline;
ring B represents pyridine or quinoline, and ring B may be further substituted by deuterium, (C1-C60)alkyl, or phenyl or naphthyl with or without (C1-C60)alkyl substituent(s);
R₁₀₁ through R₁₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₁₀₁ through R₁₀₄ may be linked to an adjacent substituent via (C3-C60)alkylene or (C3-C60)alkenylene with or without a fused ring to form an alicyclic ring, or a monocyclic or polycyclic aromatic ring; and the pyridine or quinoline may form a chemical bond with R₁₀₁ to form a fused ring;
the ring A and alkyl, alkenyl, alkynyl, cycloalkyl, heterocycloalkyl, aryl, heteroaryl, arylsilyl, alkylsilyl, alkylamino, or arylamino of R₁₀₁ through R₁₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, mono- or di(C1-C60)alkylamino, mono- or di(C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro and hydroxyl.
5. The organic electroluminescent device according to claim 4, wherein the organic layer comprises one or more compound(s) selected from a group consisting of arylamine compounds and styrylarylamine compounds, or one or more metal(s) selected from a group consisting of organic metals of Group 1, Group 2, 4^{th} period and 5^{th} period transition metals, lanthanide metals and d-transition elements.
6. The organic electroluminescent device according to claim 4, having the electroluminescent peak with wavelength of blue or green at the same time.
7. The organic electroluminescent device according to claim 4, wherein the organic layer comprises an electroluminescent layer and a charge generating layer.
8. The organic electroluminescent device according to claim 4, wherein a mixed region of reductive dopant and organic substance, or a mixed region of oxidative dopant and organic substance is placed on the inner surface of one or both electrode(s) among the pair of electrodes.
9. An organic solar cell which comprises an organic electroluminescent compound comprising an organic electroluminescent compound represented by Chemical Formula (1): 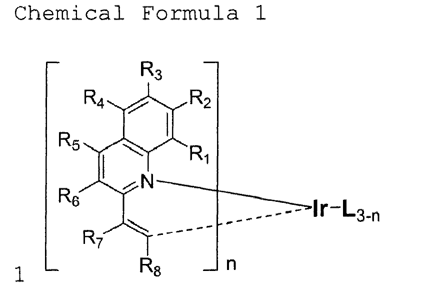 wherein, L is an organic ligand;
R₁ through R₆ independently represent hydrogen, deuterium, fluorine-substituted (C1-C60)alkyl, fluorine-substituted (C1-C60)alkoxy, fluorine-substituted (C3-C60)cycloalkyl or fluorine;
R₇ and R₈ independently represent hydrogen, deuterium, (C1-C60)alkyl with or without halogen substituent(s), (C6-C60)aryl, halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino or mono- or di(C6-C60)arylamino, or R₇ and R₈ may may be linked via (C3-C12)alkylene or (C3-C12)alkenylene with or without a fused ring to form an alicyclic ring, or a monocyclic or polycyclic aromatic ring;
the alkyl or aryl of R₇ and R₈, or the alicyclic ring, or the monocyclic or polycyclic aromatic ring formed therefrom by linkage via (C3-C12) alkylene or (C3-C12)alkenylene with or without a fused ring may be further substituted by one or more substituent(s) selected from deuterium, (C1-C60)alkyl with or without halogen substituent(s), halogen, cyano, tri(C1-C60)alkylsilyl, tri(C6-C60)arylsilyl, (C1-C60)alkoxy, (C1-C60)alkylcarbonyl, (C6-C60)arylcarbonyl, mono- or di(C1-C60)alkylamino, mono- or di(C6-C60)arylamino, phenyl, naphthyl, anthryl, fluorenyl, spirobifluorenyl and 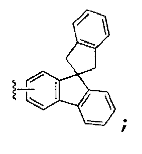 and
n is an integer from 1 to 3;
provided that R₁ through R₆ are not hydrogens at the same time.
